# EUROPEAN PATENT SPECIFICATION

(11) **EP 3 882 253 B1**
(45) Date of publication and mention of the grant of the patent: **27.11.2024**
(21) Application number: 21162949.8
(22) Date of filing: 16.03.2021
(51) Int. Cl.: H10K 85/30, H10K 85/40, H10K 85/60, H10K 101/00, C07F 15/06, C09K 11/06, C07F 15/00

(54) **ORGANOMETALLIC COMPOUND AND ORGANIC LIGHT-EMITTING DEVICE INCLUDING THE SAME**
ORGANOMETALLISCHE VERBINDUNG UND ORGANISCHE LICHTEMITTIERENDE VORRICHTUNG DAMIT
COMPOSÉ ORGANOMÉTALLIQUE ET DISPOSITIF ÉLECTROLUMINESCENT ORGANIQUE L'INCLUANT

(30) Priority: 17.03.2020 KR 20200032850
(43) Date of publication of application: 22.09.2021
(73) Proprietor: Samsung Display Co., Ltd., Yongin-si, Gyeonggi-Do 17113 (KR)
(72) Inventor: SHIN, Sujin, 17113 Yongin-si (KR); KO, Soobyung, 17113 Yongin-si (KR); KIM, Haejin, 17113 Yongin-si (KR); AHN, Eunsoo, 17113 Yongin-si (KR); LEE, Jaesung, 17113 Yongin-si (KR); HAN, Junghoon, 17113 Yongin-si (KR)
(74) Representative: Marks & Clerk LLP

(56) References cited:
- US-A1- 2019 010 178
- US-A1- 2019 010 179
- US-A1- 2019 153 308

## Description

### BACKGROUND

### 1. Field

One or more aspects of embodiments of the present disclosure relate to an organometallic compound and an organic light-emitting device including the same.

### 2. Description of Related Art

Organic light-emitting devices (OLEDs) are self-emission devices that have wide viewing angles, high contrast ratios, short response times, and/or excellent characteristics in terms of brightness, driving voltage, and/or response speed, as compared with conventional devices, and produce full-color images.

An example OLED includes a first electrode on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers (such as holes and electrons) may recombine in the emission layer to produce excitons. These excitons may transition from an excited state to the ground state to thereby generate light.

US 2019/153308 A1 relates to a dinuclear organometallic complex and an application for using such a complex.

US 2019/010179 A1 relates to multidentate dinuclear cyclometallated platinum complexes containing N-(pyrimidin-2-yl)-carbazole and its analogues.

US 2019/010178 A1 relates to multidentate dinuclear cyclometallated platinum complexes containing phenylpyridine and its analogues.

### SUMMARY

One or more aspects of embodiments of the present disclosure are directed toward a novel organometallic compound and an organic light-emitting device including the same.

Additional aspects will be set forth in part in the following description, and will, in part, be apparent from the description, or may be learned by practice of the presented embodiments of the disclosure.

One or more example embodiments of the present disclosure provide an organometallic compound represented by Formula 1: 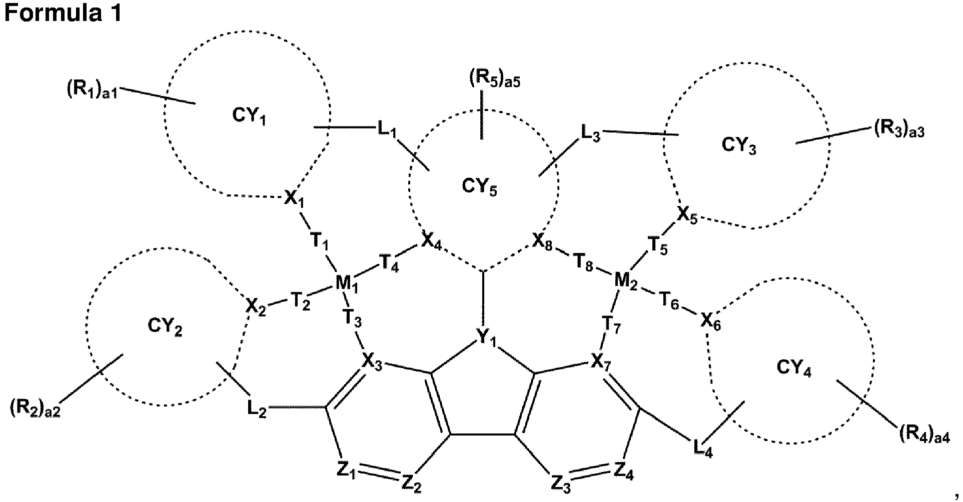 wherein, in Formula 1,
M₁ and M₂ are each independently platinum (Pt) or palladium (Pd),
X₁ to X₈ are each independently N or C,
Y₁ is selected from C(R₆), Si(R₆), N, and P,
Z₁ to Z₄ are each independently N or C(R₇),
T₁ to T₈ are each independently a chemical bond (e.g., a direct linkage), O, S, B(R'), N(R'), P(R'), C(R')(R"), Si(R')(R"), Ge(R')(R"), C(=O), B(R')(R"), N(R')(R"), or P(R')(R"), wherein, when T₁ is a chemical bond, X₁ and M₁ are directly linked to each other, when T₂ is a chemical bond, X₂ and M₁ are directly linked to each other, when T₃ is a chemical bond, X₃ and M₁ are directly linked to each other, when T₄ is a chemical bond, X₄ and M₁ are directly linked to each other, when T₅ is a chemical bond, X₅ and M₂ are directly linked to each other, when T₆ is a chemical bond, X₆ and M₂ are directly linked to each other, when T₇ is a chemical bond, X₇ and M₂ are directly linked to each other, and when T₈ is a chemical bond, X₈ and M₂ are directly linked to each other,
two bonds selected from a bond between M₁ and either X₁ or T₁, a bond between M₁ and either X₂ or T₂, a bond between M₁ and either X₃ or T₃, and a bond between M₁ and either X₄ or T₄ are each a coordination (dative) bond, and the other two bonds are each a covalent bond,
two bonds selected from a bond between M₂ and either X₅ or T₅, a bond between M₂ and either X₆ or T₆, a bond between M₂ and either X₇ or T₇, and a bond between M₂ and either X₈ or T₈ are each a coordination (dative) bond, and the other two bonds are each a covalent bond,
L₁ to L₄ are each independently selected from a single bond, a double bond, *-N(Rs)-*', *-B(Rs)-*', *-P(R₈)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*^{'}, *-C(=O)-*', *-S(=O)-*', *-S(=O)₂-*', *-C(R₈)=*' , *=C(R₈)-*', *-C(R₈ₐ)=C(R_{8b})-*', *-C(=S)-*', and *-C≡C-*',
ring CY₁ to ring CY₅ are each independently selected from a C₅-C₃₀ carbocyclic group and a C₁-C₃₀ heterocyclic group,
R₁ to R₈, R₈ₐ, R_{8b}, R', and R" are each independently selected from hydrogen, deuterium, -F, -Cl, -Br, -I, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), -P(=O)(Q₁)(Q₂), and a bidentate organic ligand,
a1 to a5 are each independently an integer from 0 to 20,
i) two groups among the a1 R₁(s), ii) two groups among the a2 R₂(s), iii) two groups among the a3 R₃(s), iv) two groups among the a4 R₄(s), v) two groups among the a5 R₅(s), vi) R₈ₐ and R_{8b}, and vii) two groups among R₁ to R₈, R₈ₐ, R_{8b}, R', and R" are each independently optionally linked to each other via a single bond, a double bond, or a first linking group, so as to form a C₅-C₃₀ carbocyclic group, which is unsubstituted or substituted with at least one R₁₀ₐ, or a C₁-C₃₀ heterocyclic group, which is unsubstituted or substituted with at least one R₁₀ₐ,
R₁₀ₐ is the same as described in connection with R₁,
* and *' each indicate a binding site to a neighboring atom, and
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group is selected from:
   deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, and a C₁-C₆₀ alkoxy group;
   a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - CI, -Br, -I, a hydroxyl group, a cyano group, a nitro group, an amidino group, a hydrazine group, a hydrazone group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -O(Q₁₁), -S(Q₁₁), -Si(Q₁₁)(Q₁₂)(Q₁₃), -N(Q₁₁)(Q₁₂), -B(Q₁₁)(Q₁₂), -P(Q₁₁)(Q₁₂), -C(=O)(Q₁₁), -S(=O)₂(Q₁₁), and -P(=O)(Q₁₁)(Q₁₂);
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, and a monovalent non-aromatic condensed heteropolycyclic group;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, - O(Q₂₁), -S(Q₂₁), -Si(Q₂₁)(Q₂₂)(Q₂₃), -N(Q₂₁)(Q₂₂), -B(Q₂₁)(Q₂₂), -P(Q₂₁)(Q₂₂), - C(=O)(Q₂₁), -S(=O)₂(Q₂₁), and -P(=O)(Q₂₁)(Q₂₂); and
   O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), and -P(=O)(Q₃₁)(Q₃₂), and
   Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₉ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a C₁-C₆₀ alkyl group that is substituted with at least one selected from deuterium, -F, a cyano group, a C₁-C₆₀ alkyl group, a phenyl group, and a biphenyl group, and a C₆-C₆₀ aryl group that is substituted with at least one selected from deuterium, -F, a cyano group, a C₁-C₁₀ alkyl group, a phenyl group, and a biphenyl group.

One or more example embodiments of the present disclosure provide an organic light-emitting device including a first electrode, a second electrode facing the first electrode, an organic layer located between the first electrode and the second electrode and including an emission layer, and at least one organometallic compound described above.

One or more example embodiments of the present disclosure provide an organic light-emitting device including a first electrode,
a second electrode facing the first electrode, and
an emission layer between the first electrode and the second electrode,
wherein the emission layer includes a first compound, a second compound, and a third compound,
the first compound, the second compound, and the third compound are different from each other,
the first compound is represented by Formula 1,
the second compound is represented by Formula 2-1 or 2-2, and
the third compound includes a group represented by Formula 3: 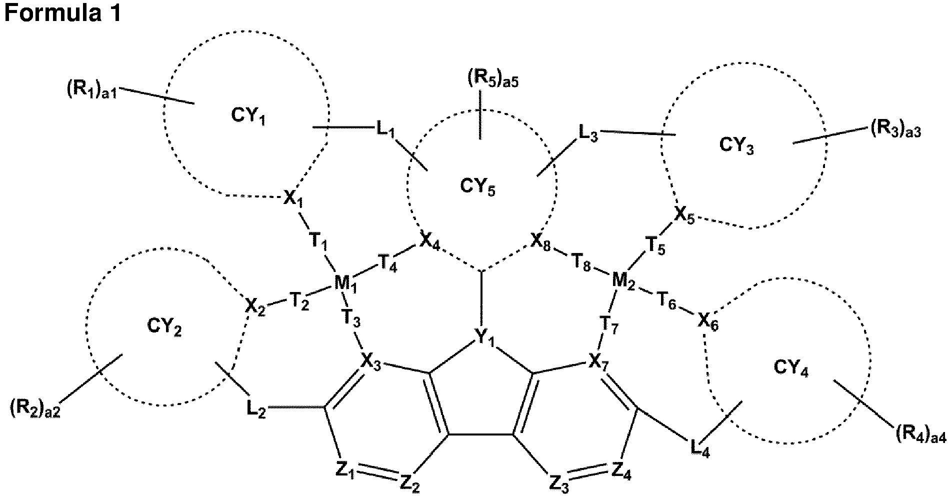 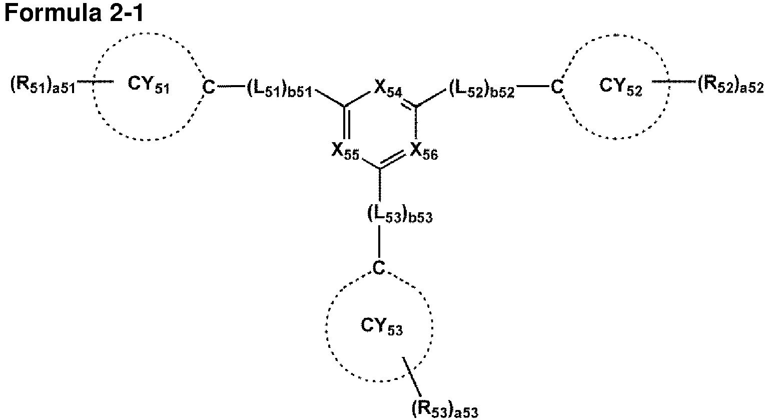 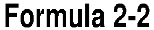 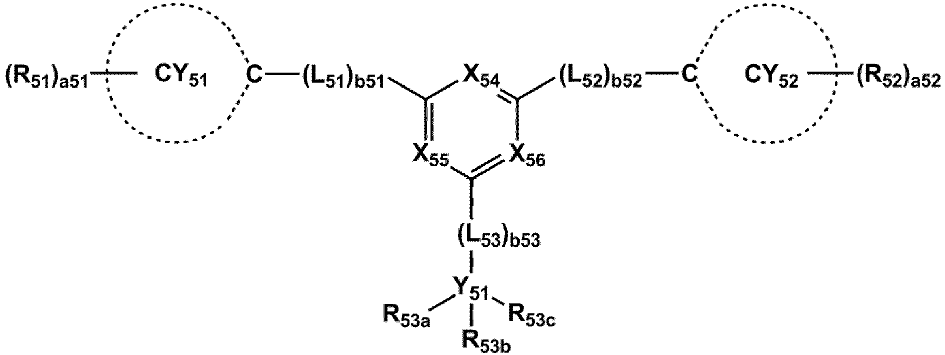 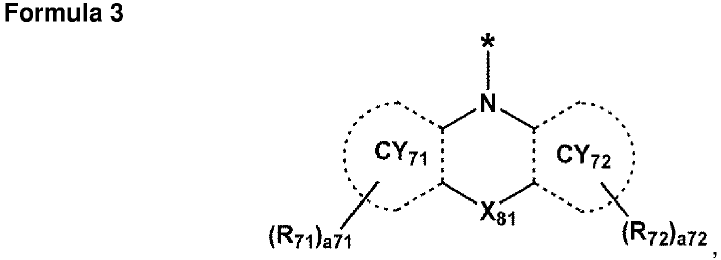
wherein, in Formulae 1 to 3,
   M₁ and M₂ are each independently platinum (Pt) or palladium (Pd),
   X₁ to X₈ are each independently N or C,
   Y₁ is selected from C(R₆), Si(R₆), N, and P,
   Z₁ to Z₄ are each independently N or C(R₇),
   T₁ to T₈ are each independently a chemical bond (e.g., direct linkage), O, S, B(R'), N(R'), P(R'), C(R')(R"), Si(R')(R"), Ge(R')(R"), C(=O), B(R')(R"), N(R')(R"), or P(R')(R"), wherein, when T₁ is a chemical bond, X₁ and M₁ are directly linked to each other, when T₂ is a chemical bond, X₂ and M₁ are directly linked to each other, when T₃ is a chemical bond, X₃ and M₁ are directly linked to each other, when T₄ is a chemical bond, X₄ and M₁ are directly linked to each other, when T₅ is a chemical bond, X₅ and M₂ are directly linked to each other, when T₆ is a chemical bond, X₆ and M₂ are directly linked to each other, when T₇ is a chemical bond, X₇ and M₂ are directly linked to each other, and when T₈ is a chemical bond, X₈ and M₂ are directly linked to each other,
   two bonds selected from a bond between M₁ and either X₁ or T₁, a bond between M₁ and either X₂ or T₂, a bond between M₁ and either X₃ or T₃, and a bond between M₁ and either X₄ or T₄ are each a coordination (dative) bond, and the other two bonds are each a covalent bond,
   two bonds selected from a bond between M₂ and either X₅ or T₅, a bond between M₂ and either X₆ or T₆, a bond between M₂ and either X₇ or T₇, and a bond between M₂ and either X₈ or T₈ are each a coordination (dative) bond, and the other two bonds are each a covalent bond,
   L₁ to L₄ are each independently selected from a single bond, a double bond, *-N(Rs)-*', *-B(Rs)-*', *-P(R₈)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*', *-C(R₈)=*' , *=C(R₈)-*', *-C(R₈ₐ)=C(R_{8b})-*', *-C(=S)-*', and *-C≡C-*',
   ring CY₁ to ring CY₅, ring CY₅₁ to ring CY₅₃, ring CY₇₁, and ring CY₇₂ are each independently selected from a C₅-C₃₀ carbocyclic group and a C₁-C₃₀ heterocyclic group,
   L₅₁ to L₅₃ are each independently selected from a substituted or unsubstituted C₅-C₃₀ carbocyclic group and a substituted or unsubstituted C₁-C₃₀ heterocyclic group,
   a bond between L₅₁ and ring CY₅₁, a bond between L₅₂ and ring CY₅₂, a bond between L₅₃ and ring CY₅₃, a bond between two or more L₅₁(s), a bond between two or more L₅₂(s), a bond between two or more L₅₃(s), a bond between L₅₁ and carbon between X₅₄ and X₅₅ in Formulae 2-1 and 2-2, a bond between L₅₂ and carbon between X₅₄ and X₅₆ in Formulae 2-1 and 2-2, and a bond between L₅₃ and carbon between X₅₅ and X₅₆ in Formulae 2-1 and 2-2 are each a carbon-carbon single bond,
   b51 to b53 are each independently an integer from 0 to 5, wherein, when b51 is 0, *-(L₅₁)_{b51}-*' is a single bond, when b52 is 0, *-(L₅₂)_{b52}-*' is a single bond, and when b53 is 0, *-(L₅₃)_{b53}-*' is a single bond,
   X₅₄ is N or C(R₅₄), X₅₅ is N or C(R₅₅), and X₅₆ is N or C(R₅₆), wherein at least one selected from X₅₄ to X₅₆ is N,
   Y₅₁ is C or Si,
   X₈₁ is a single bond, O, S, N(R₈₁), B(R₈₁), C(R₈₁ₐ)(R_{81b}), or Si(R₈₁ₐ)(R_{81b}),
   R₁ to R₈, R₈ₐ, R_{8b}, R', R", R₅₁ to R₅₆, R₅₃ₐ to R_{53c}, R₇₁, R₇₂, R₈₁, R₈₁ₐ, and R_{81b} are each independently selected from hydrogen, deuterium, -F, -Cl, -Br, -I, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -C(Q₁)(Q₂)(Q₃), -Si(Q₁)(Q₂)(Q₃), -N(Q₁)(Q₂), -B(Q₁)(Q₂), - C(=O)(Q₁), -S(=O)₂(Q₁), -P(=O)(Q₁)(Q₂), and a bidentate organic ligand,
   a1 to a5, a51 to a53, a71, and a72 are each independently an integer from 0 to 20,
   i) two groups among the a1 R₁(s), ii) two groups among the a2 R₂(s), iii) two groups among the a3 R₃(s), iv) two groups among the a4 R₄(s), v) two groups among the a5 R₅(s), vi) R₈ₐ and R_{8b}, and vii) two groups among R₁ to R₈, R₈ₐ, R_{8b}, R', and R" are each independently optionally linked to each other via a single bond, a double bond, or a first linking group, so as to form a C₅-C₃₀ carbocyclic group, which is unsubstituted or substituted with at least one R₁₀ₐ, or a C₁-C₃₀ heterocyclic group, which is unsubstituted or substituted with at least one R₁₀ₐ,
   R₁₆ₐ is the same as described in connection with R₁,
   * and *' each indicate a binding site to a neighboring atom, and
   at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group is selected from:
      deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, and a C₁-C₆₀ alkoxy group;
      a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - CI, -Br, -I, a hydroxyl group, a cyano group, a nitro group, an amidino group, a hydrazine group, a hydrazone group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -O(Q₁₁), -S(Q₁₁), -Si(Q₁₁)(Q₁₂)(Q₁₃), -N(Q₁₁)(Q₁₂), -B(Q₁₁)(Q₁₂), -P(Q₁₁)(Q₁₂), -C(=O)(Q₁₁), -S(=O)₂(Q₁₁), and -P(=O)(Q₁₁)(Q₁₂);
      a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, and a monovalent non-aromatic condensed heteropolycyclic group;
      a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, - O(Q₂₁), -S(Q₂₁), -Si(Q₂₁)(Q₂₂)(Q₂₃), -N(Q₂₁)(Q₂₂), -B(Q₂₁)(Q₂₂), -P(Q₂₁)(Q₂₂), - C(=O)(Q₂₁), -S(=O)₂(Q₂₁), and -P(=O)(Q₂₁)(Q₂₂); and
      -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), and -P(=O)(Q₃₁)(Q₃₂), and
      Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a C₁-C₆₀ alkyl group that is substituted with at least one selected from deuterium, -F, a cyano group, a C₁-C₆₀ alkyl group, a phenyl group, and a biphenyl group, and a C₆-C₆₀ aryl group that is substituted with at least one selected from deuterium, -F, a cyano group, a C₁-C₁₀ alkyl group, a phenyl group, and a biphenyl group.

At least some of the above and other features of the invention are set out in the claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view of an embodiment of an organic light-emitting device;
FIG. 2 is a schematic cross-sectional view of an embodiment of an organic light-emitting device;
FIG. 3 is a schematic cross-sectional view of an embodiment of an organic light-emitting device; and
FIG. 4 is a schematic cross-sectional view of an embodiment of an organic light-emitting device.

### DETAILED DESCRIPTION

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described below, by referring to the drawings, to explain aspects of the present description. As used herein, the term "and/or" includes any and all combinations of one or more of the associated listed items. Throughout the disclosure, the expression "at least one of a, b or c" may refer to only a, only b, only c, both a and b, both a and c, both b and c, all of a, b, and c, or variations thereof.

As used herein, the singular forms "a," "an," and "the" are intended to include the plural forms as well, unless the context clearly indicates otherwise. It will be further understood that the terms "includes," "including," "comprises," and/or "comprising," when used in this specification, specify the presence of stated features, steps, operations, elements, and/or components, but do not preclude the presence or addition of one or more other features, steps, operations, elements, components, and/or groups thereof.

As used herein, expressions such as "at least one of," "one of," and "selected from," when preceding a list of elements, modify the entire list of elements and do not modify the individual elements of the list. Further, the use of "may" when describing embodiments of the present disclosure refers to "one or more embodiments of the present disclosure".

It will be understood that when an element is referred to as being "on," "connected to," or "coupled to" another element, it may be directly on, connected, or coupled to the other element or one or more intervening elements may also be present. When an element is referred to as being "directly on," "directly connected to," or "directly coupled to" another element, there are no intervening elements present. Similarly, when two atoms are described as being "directly linked", no intervening atoms or moieties are present.

One or more example embodiments of the present disclosure provide an organometallic compound represented by Formula 1:

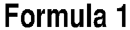

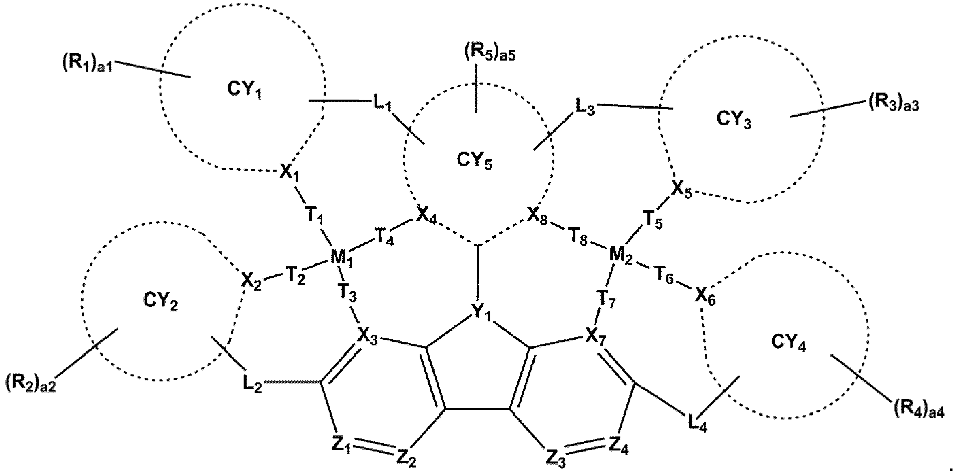

In Formula 1, M₁ and M₂ are each independently selected from platinum (Pt) and palladium (Pd).

For example, M₁ and M₂ may each independently be Pt, or M₁ and M₂ may each independently be Pd, but embodiments of the present disclosure are not limited thereto.

In Formula 1, X₁ to X₈ are each independently N or C.

In one embodiment, i) X₁ to X₈ may each be C; or ii) X₁ and X₅ may each be N, and X₂ to X₄ and X₆ to X₈ may each be C.

In Formula 1, Y₁ is selected from C(R₆), Si(R₆), N, and P.

In one embodiment, Y₁ may be C(R₆), N, or P.

In Formula 1, Z₁ to Z₄ are each independently N or C(R₇).

In one embodiment, Z₁ and Z₄ may be identical to each other, and Z₂ and Z₃ may be identical to each other.

For example, i) Z₁ to Z₄ may each be C(R₇); or ii) Z₁ and Z₄ may each be N, and Z₂ and Z₃ may each be C(R₇).

In Formula 1, T₁ to T₈ are each independently a chemical bond, O, S, B(R'), N(R'), P(R'), C(R')(R"), Si(R')(R"), Ge(R')(R"), C(=O), B(R')(R"), N(R')(R"), or P(R')(R"), wherein, when T₁ is a chemical bond, X₁ and M₁ are directly linked to each other, when T₂ is a chemical bond, X₂ and M₁ are directly linked to each other, when T₃ is a chemical bond, X₃ and M₁ are directly linked to each other, when T₄ is a chemical bond, X₄ and M₁ are directly linked to each other, when T₅ is a chemical bond, X₅ and M₂ are directly linked to each other, when T₆ is a chemical bond, X₆ and M₂ are directly linked to each other, when T₇ is a chemical bond, X₇ and M₂ are directly linked to each other, and when T₈ is a chemical bond, X₈ and M₂ are directly linked to each other,

two bonds selected from a bond between M₁ and either X₁ or T₁, a bond between M₁ and either X₂ or T₂, a bond between M₁ and either X₃ or T₃, and a bond between M₁ and either X₄ or T₄ are each a coordination bond, and the other two bonds are each a covalent bond, and

two bonds selected from a bond between M₂ and either X₅ or T₅, a bond between M₂ and either X₆ or T₆, a bond between M₂ and either X₇ or T₇, and a bond between M₂ and either X₈ or T₈ may each be a coordination (dative) bond, and the other two bonds may each be a covalent bond.

In one embodiment, T₁ to T₄ in Formula 1 may each be a chemical bond, where at least one of a bond between X₁ and M₁ and a bond between X₂ and M₁ (e.g., at least one of T₁ and T₂) may be a coordination bond, and T₅ to T₈ in Formula 1 may each be a chemical bond, where at least one of a bond between X₅ and M₂ and a bond between X₆ and M₂ (e.g., at least one of T₅ and T₆) may be a coordination bond.

For example, T₁ to T₈ may each be a single bond.

In Formula 1, L₁ to L₄ are each independently selected from a single bond, a double bond, *-N(Rs)-*', *-B(Rs)-*', *-P(R₈)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*', *-C(R₈)=*', *=C(Rs)-*', *-C(R₈ₐ)=C(R_{8b})-*', *-C(=S)-*', and *-C≡C-*'.

In one embodiment, i) L₁ to L₄ may be identical to each other; or ii) L₁ and L₃ may be identical to each other, and L₂ and L₄ may be identical to each other.

In one embodiment, i) L₁ to L₄ may each be a single bond; or ii) L₁ and L₃ may each be *-O-*', and L₂ and L₄ may each be a single bond.

In one embodiment, when ring CY₁ (which is linked to L₁) is a 5-membered ring, L₁ may be a single bond, and when ring CY₃ (which is linked to L₃) is a 5-membered ring, L₃ may be a single bond.

In one embodiment, when ring CY₁ (which is linked to L₁) is a 6-membered ring, L₁ may be *-O-*', and when ring CY₃ (which is linked to L₃) is a 6-membered ring, L₃ may be *-O-*'.

In Formula 1, ring CY₁ to ring CY₅ are each independently selected from a C₅-C₃₀ carbocyclic group and a C₁-C₃₀ heterocyclic group. For example, ring CY₁ to ring CY₅ may each independently be selected from a C₅-C₂₀ carbocyclic group and a C₁-C₂₀ heterocyclic group.

In one embodiment, ring CY₁ to ring CY₅ may each independently be selected from a benzene group, a naphthalene group, an anthracene group, a phenanthrene group, an azulene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indenopyridine group, an indolopyridine group, a benzofuropyridine group, a benzothienopyridine group, a benzosilolopyridine group, an indenopyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isooxazole group, a thiazole group, an isothiazole group, an oxadiazole group, a thiadiazole group, a benzopyrazole group, a pyrazolopyridine group, a furopyrazole group, a thienopyrazole group, a benzimidazole group, a 2,3-dihydrobenzimidazole group, an imidazopyridine group, a 2,3-dihydroimidazopyridine group, a furoimidazole group, a thienoimidazole group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline group.

In one embodiment, one or both of ring CY₁ and ring CY₂ may each independently be a 5-membered ring including two or more N atoms, or a condensed cyclic ring including a 5-membered ring including two or more N atoms.

In one embodiment, one or both of ring CY₃ and ring CY₄ may each independently be a 5-membered ring including two or more N atoms, or a condensed cyclic ring including a 5-membered ring including two or more N atoms.

In one embodiment, each of rings CY₁ to CY₄ may be identical to each other.

In one or more embodiments, ring CY₁ and ring CY₃ may each be a 6-membered ring including one or more N atom or a condensed cyclic group including a 6-membered ring including one or more N atom, and ring CY₂ and ring CY₄ may each be a 5-membered ring including two or more N atoms or a condensed cyclic ring including a 5-membered ring including two or more N atoms.

In one embodiment, ring CY₅ may be a 6-membered ring.

In one embodiment, the atom linked to Y₁ in ring CY₅ may be C.

In one embodiment, the atom linked to L₁ in ring CY₅ and the atom linked to L₃ in ring CY₅ may each be C.

In one embodiment, the atom linked to L₁ in ring CY₁, the atom linked to L₂ in ring CY₂, the atom linked to L₃ in ring CY₃, and the atom linked to L₄ in ring CY₄ may each be N. In one embodiment, the atom linked to L₁ in ring CY₁ and the atom linked to L₃ in ring CY₃ may each be C, and the atom linked to L₂ in ring CY₂ and the atom linked to L₄ in ring CY₄ may each be N.

In one embodiment, ring CY₁ to ring CY₄ may each independently be selected from groups represented by Formulae 4-1 to 4-35:

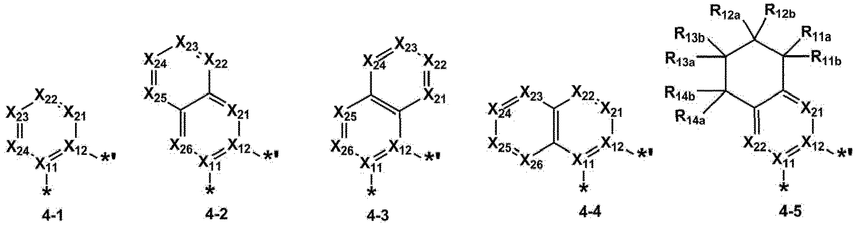

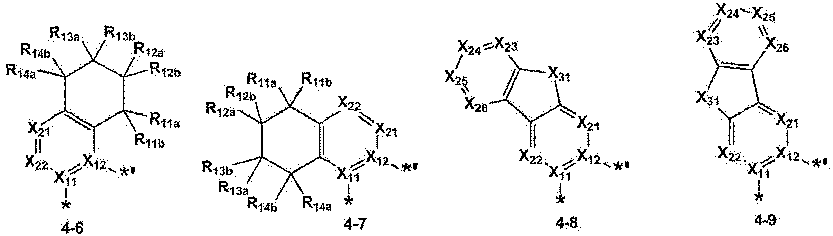

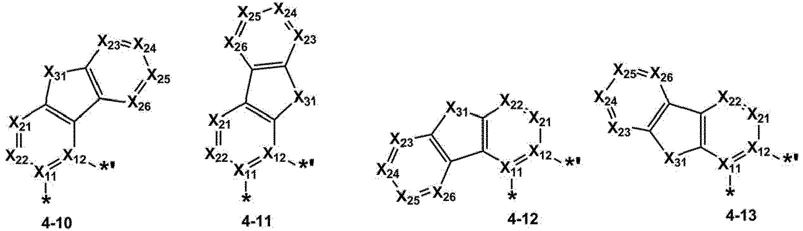

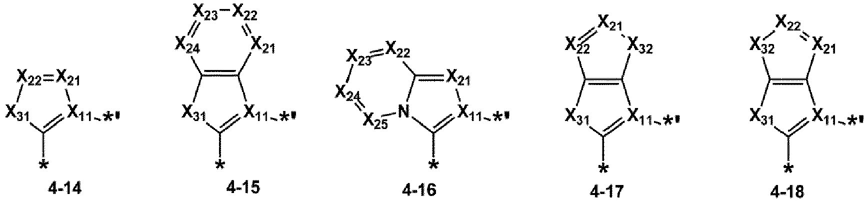

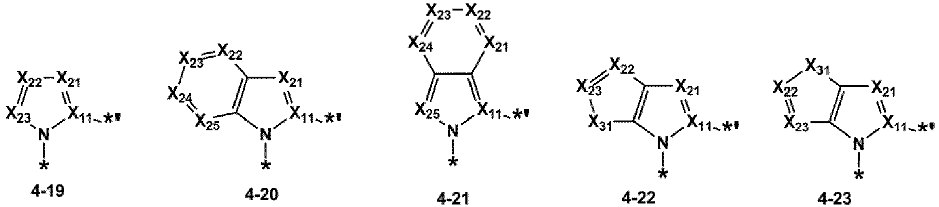

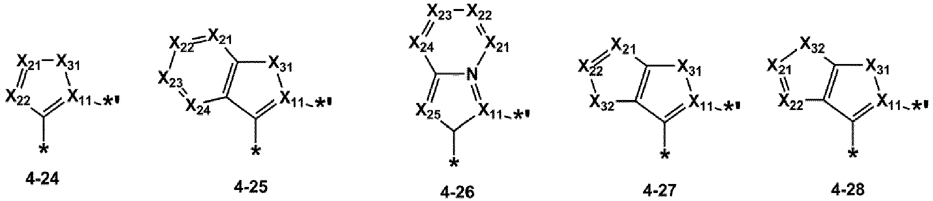

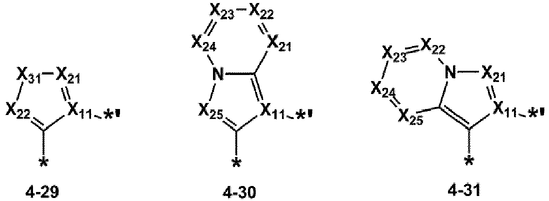

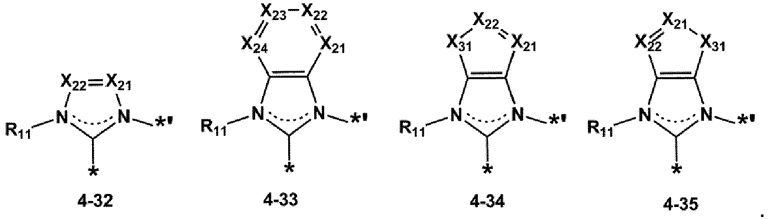

In Formulae 4-1 to 4-35,
X₁₁ and X₁₂ are each independently a carbon atom or a nitrogen atom,
X₂₁ is N or C(R₂₁), X₂₂ is N or C(R₂₂), X₂₃ is N or C(R₂₃), X₂₄ is N or C(R₂₄), X₂₅ is N or C(R₂₅), X₂₆ is N or C(R₂₆),
X₃₁ is C(R₃₁ₐ)(R_{31b}), Si(R₃₁ₐ)(R_{31b}), N(R₃₁), O, or S,
X₃₂ is C(R₃₂ₐ)(R_{32b}), Si(R₃₂ₐ)(R_{32b}), N(R₃₂), O, or S,
R₁₁, R₁₁ₐ, R_{11b}, R₁₂ₐ, R_{12b}, R₁₃ₐ, R_{13b}, R₁₄ₐ, R_{14b}, R₂₁ to R₂₆, R₃₁ to R₃₂, R₃₁ₐ to R_{31b}, and R₃₂ₐ to R_{32b} are each independently the same as described in connection with R₁ to R₄ in Formula 1,
* indicates a binding site to T₁, T₂, T₃, T₄, T₅, T₆, T₇, or T₈, and
*' indicates a binding site to L₁, L₂, L₃, or L₄.

In Formula 1, R₁ to R₈, R₈ₐ, R_{8b}, R', and R" are each independently selected from hydrogen, deuterium, -F, -Cl, -Br, -I, a hydroxyl group, a cyano group, a nitro group, an amidino group, a hydrazine group, a hydrazone group, a substituted or unsubstituted C₁-C₆₀ (*e.g*. C₁-C₂₀) alkyl group, a substituted or unsubstituted C₂-C₆₀ (*e.g.* C₂-C₂₀) alkenyl group, a substituted or unsubstituted C₂-C₆₀ (*e.g.* C₂-C₂₀) alkynyl group, a substituted or unsubstituted C₁-C₆₀ (*e.g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₇-C₆₀ (*e.g.* C₇-C₃₀) alkyl aryl group, a substituted or unsubstituted C₆-C₆₀ (*e.g.* C₆-C₃₀) aryloxy group, a substituted or unsubstituted C₆-C₆₀ (*e.g*. C₆-C₃₀) arylthio group, a substituted or unsubstituted C₁-C₆₀ (*e.g*. C₁-C₂₀) heteroaryl group, a substituted or unsubstituted C₂-C₆₀ (*e.g*. C₂-C₂₀) alkyl heteroaryl group, a substituted or unsubstituted monovalent non-aromatic condensed polycyclic group, a substituted or unsubstituted monovalent non-aromatic condensed heteropolycyclic group, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), -P(=O)(Q₁)(Q₂), and a bidentate organic ligand,
a1 to a5 are each independently an integer from 0 to 20,
i) two groups among the a1 R₁(s), ii) two groups among the a2 R₂(s), iii) two groups among the a3 R₃(s), iv) two groups among the a4 R₄(s), v) two groups among the a5 R₅(s), vi) R₈ₐ and R_{8b}, and vii) two groups among R₁ to R₈, R₈ₐ, R_{8b}, R', and R" are each independently optionally linked to each other via a single bond, a double bond, or a first linking group, so as to form a C₅-C₃₀ (*e.g*. C₅-C₂₀) carbocyclic group that is unsubstituted or substituted with at least one R₁₀ₐ, or a C₁-C₃₀ (*e.g.* C₁-C₂₀) heterocyclic group that is unsubstituted or substituted with at least one R₁₀ₐ,
R₁₀ₐ is the same as described in connection with R₁,
* and *' each indicate a binding site to a neighboring atom, and
Q₁ to Q₃ are each independently selected from hydrogen, deuterium, -F, -Cl, -Br, -I, a hydroxyl group, a cyano group, a nitro group, an amidino group, a hydrazine group, a hydrazone group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, a C₁-C₆₀ (*e.g*. C₁-C₂₀) alkyl group that is substituted with at least one selected from deuterium, -F, a cyano group, a C₁-C₆₀ (*e.g.* C₁-C₂₀) alkyl group, a phenyl group, and a biphenyl group, and a C₆-C₆₀ (*e.g*. C₆-C₃₀) aryl group that is substituted with at least one selected from deuterium, -F, a cyano group, a C₁-C₁₀ alkyl group, a phenyl group, and a biphenyl group.

In one embodiment, R₁ to R₈, R₈ₐ, R_{8b}, R', and R" may each independently be selected from: hydrogen, deuterium, -F, -Cl, -Br, -I, a cyano group, a C₁-C₂₀ *(e.g.* C₁-C₁₀) alkyl group, and a C₁-C₂₀ (*e.g.* C₁-C₁₀) alkoxy group;
a C₁-C₂₀ (*e.g.* C₁-C₁₀) alkyl group and a C₁-C₂₀ (*e.g.* C₁-C₁₀) alkoxy group, each substituted with at least one selected from deuterium, -F, -Cl, -Br, -I, a cyano group, a C₁-C₂₀ (*e.g.* C₁-C₁₀) alkyl group, a C₁-C₂₀ (*e.g.* C₁-C₁₀) alkoxy group, a phenyl group, and a biphenyl group;
a phenyl group, a biphenyl group, a terphenyl group, a naphthyl group, a fluorenyl group, a spiro-bifluorenyl group, a phenanthrenyl group, an anthracenyl group, a pyridinyl group, a pyrimidinyl group, a carbazolyl group, and a triazinyl group;
a phenyl group, a biphenyl group, a terphenyl group, a naphthyl group, a fluorenyl group, a spiro-bifluorenyl group, a phenanthrenyl group, an anthracenyl group, a pyridinyl group, a pyrimidinyl group, a carbazolyl group, and a triazinyl group, each substituted with at least one selected from deuterium, -F, -Cl, -Br, -I, a cyano group, a C₁-C₂₀ (*e.g.* C₁-C₁₀) alkyl group, a C₁-C₂₀ (*e.g.* C₁-C₁₀) alkoxy group, a phenyl group, a biphenyl group, a terphenyl group, a naphthyl group, a fluorenyl group, a spiro-bifluorenyl group, a phenanthrenyl group, an anthracenyl group, a pyridinyl group, a pyrimidinyl group, a carbazolyl group, and a triazinyl group; and
-C(Q₁)(Q₂)(Q₃) and -N(Q₁)(Q₂), and
Q₁ to Q₃ may each independently be selected from hydrogen, deuterium, -F, -Cl, -Br, -I, a C₁-C₂₀ (*e.g.* C₁-C₁₀) alkyl group, a C₂-C₂₀ (*e.g.* C₂-C₁₀) alkenyl group, a C₂-C₂₀ (*e.g.* C₂-C₁₀) alkynyl group, a C₁-C₂₀ (*e.g.* C₁-C₁₀) alkoxy group, a C₆-C₂₀ aryl group, a C₁-C₂₀ heteroaryl group, a monovalent non-aromatic condensed polycyclic group, a monovalent non-aromatic condensed heteropolycyclic group, a C₁-C₂₀ (*e.g.* C₁-C₁₀) alkyl group substituted with at least one selected from deuterium, -F, a cyano group, a C₁-C₁₀ alkyl group, a phenyl group, and a biphenyl group, and a C₆-C₂₀ aryl group substituted with at least one selected from deuterium, -F, a cyano group, a C₁-C₁₀ alkyl group, a phenyl group, and a biphenyl group.

For example, R₁ to R₈, R₈ₐ, R_{8b}, R', and R" may each independently be selected from hydrogen, deuterium, -F, -Cl, -Br, -I, a cyano group, a methyl group, an ethyl group, a propyl group, an isopropyl group, an n-butyl group, an isobutyl group, a sec-butyl group, a tert-butyl group, -CD₃, a phenyl group, a p-tolyl group, a 2,4,6-trimethylphenyl group, a pyridinyl group, and -N(Q₁)(Q₂), and Q₁ and Q₂ may each independently be selected from hydrogen, deuterium, a C₁-C₁₀ alkyl group, a phenyl group, a C₁-C₁₀ alkyl group substituted with deuterium, and a phenyl group substituted with deuterium.

For example, the first linking group may be selected from *-N(R₉₅)-*', *-B(R₉₅)-*', *-P(R₉₅)-*', *-C(R₉₅ₐ)(R_{95b})-*', *-Si(R₉₅ₐ)(R_{95b})-*', *-Ge(R₉₅ₐ)(R_{95b})-*', *-S-*', *-Se-*', *-O-*', *-C(=O)-*', *-S(=O)-*', *-S(=O)₂-*', *-C(R₉₅)=*', *₌C(R₉₅)-*', *-C(R₉₅ₐ)=C(R_{95b})-*', *-C(=S)-*' and *-C≡C-*'. R₉₅, R₉₅ₐ, and R_{95b} may each independently be the same as described in connection with R₁ to R₈, R₈ₐ, R_{8b}, R', and R".

In one embodiment, the organometallic compound represented by Formula 1 may be represented by Formula 1-1 :

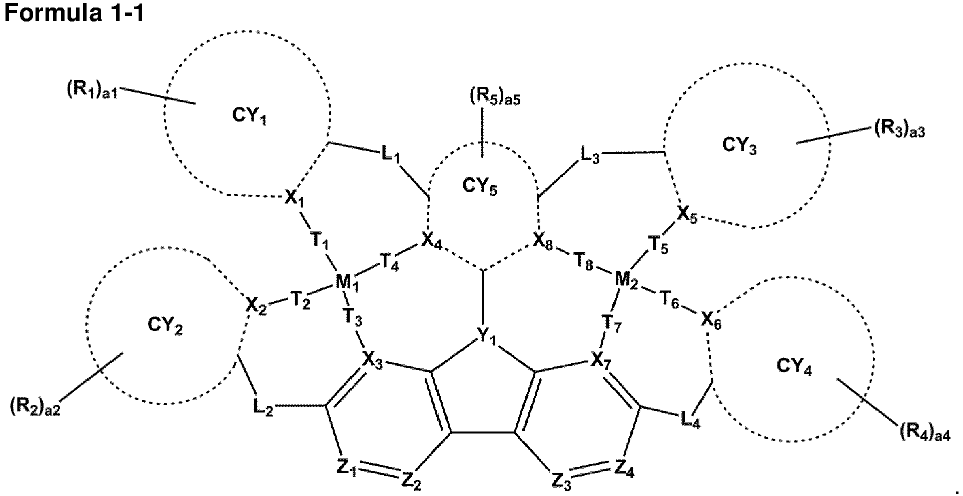

In Formula 1-1, M₁, M₂, X₁ to Xs, Y₁, Z₁ to Z₄, T₁ to T₈, L₁ to L₄, ring CY₁ to ring CY₅, R₁ to R₅, and a1 to a5 are each independently the same as described in connection with Formula 1.

In one embodiment, the compound represented by Formula 1 may have a symmetrical structure. As used herein, the term "symmetrical structure" may refer to a chemical structure having at least one mirror plane or rotational axis of symmetry. For example, the compound having a symmetrical structure may have a mirror plane containing the bond between Y₁ and ring CY₅, the mirror plane being normal to a plane containing ring CY₅.

In one embodiment, the organometallic compound may be selected from Compounds 1 to 120, but embodiments are not limited thereto:

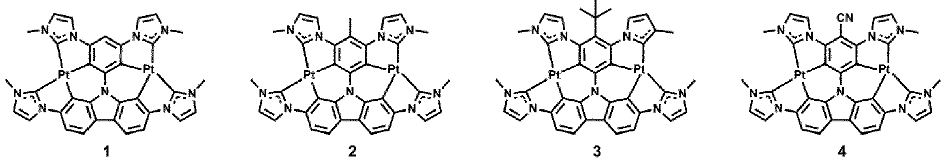

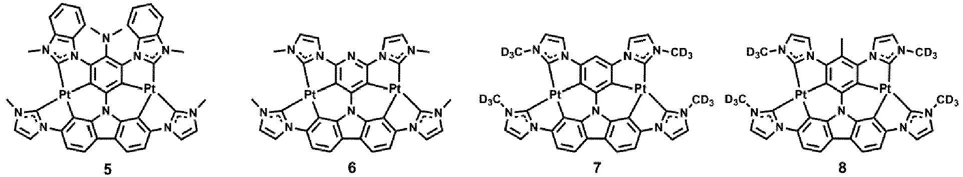

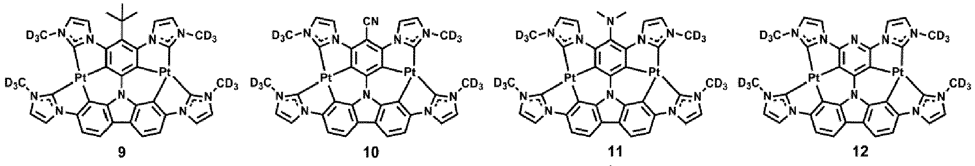

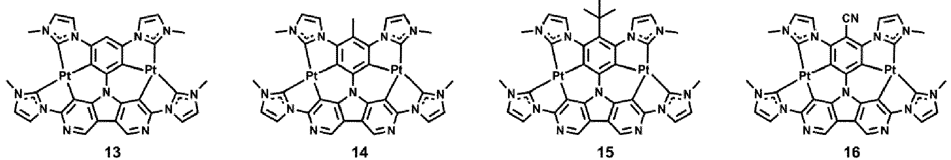

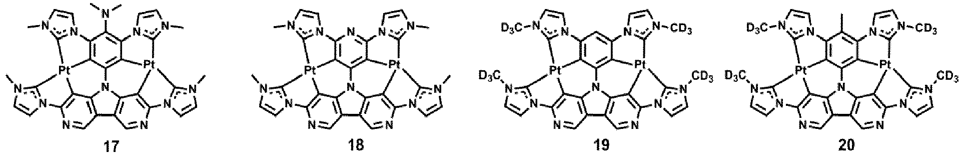

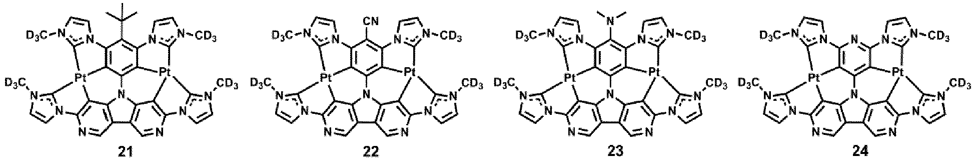

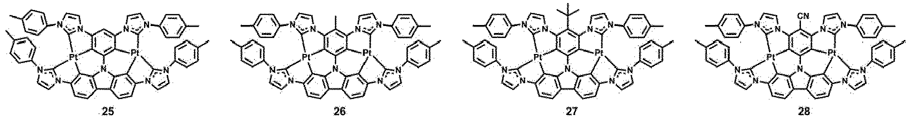

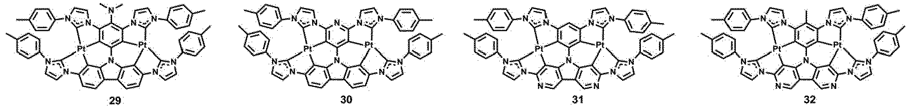

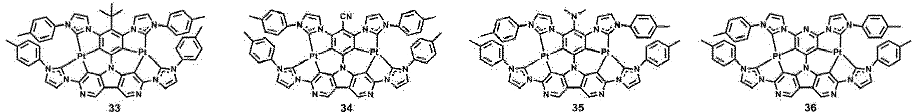

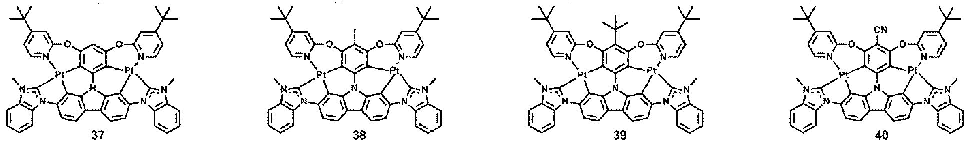

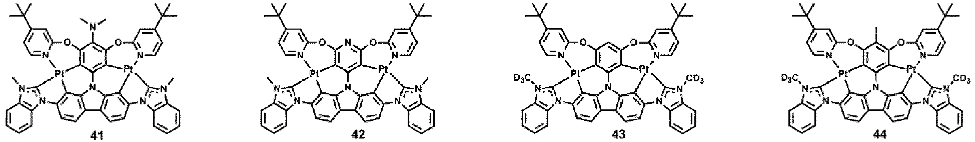

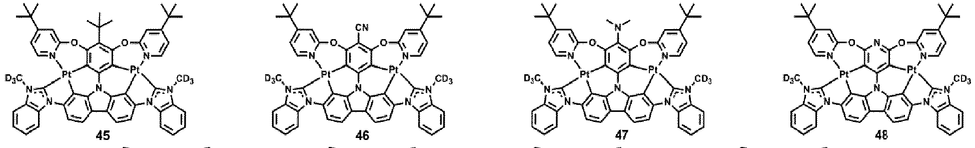

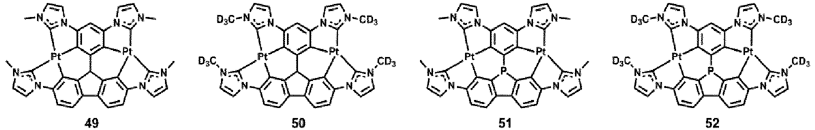

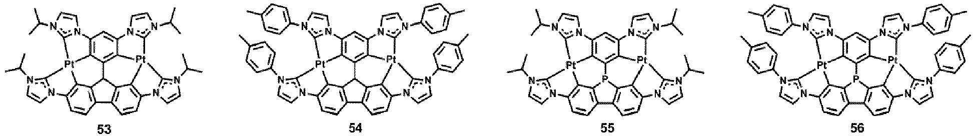

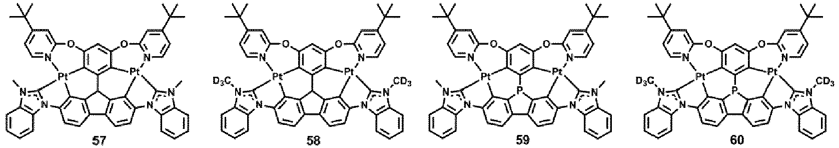

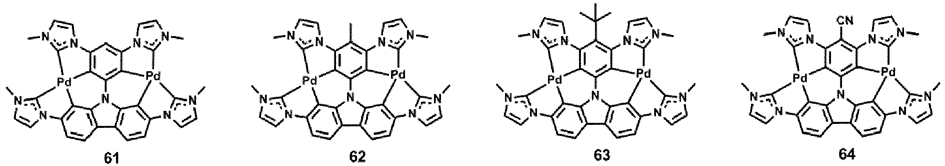

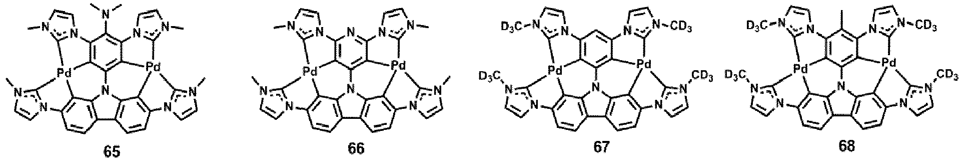

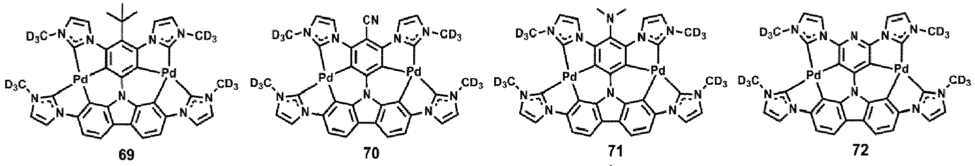

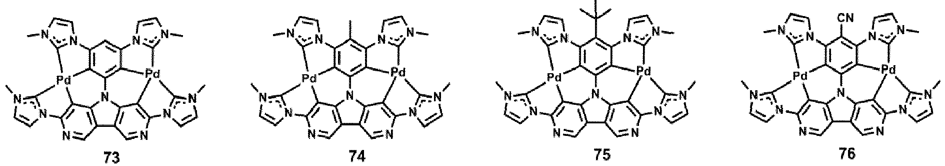

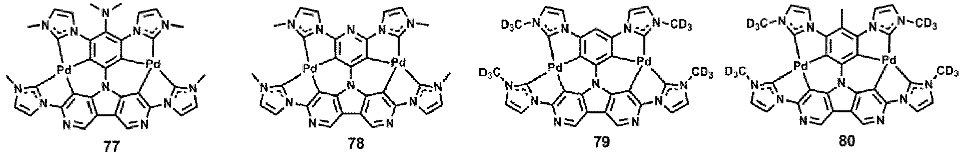

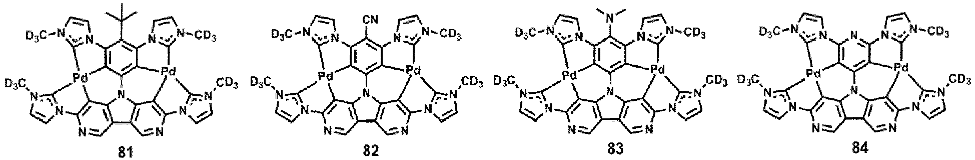

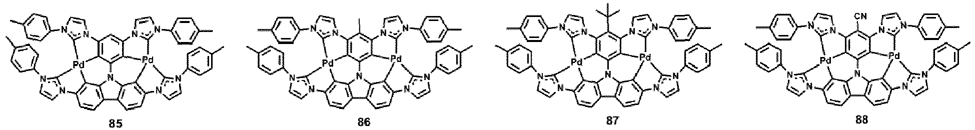

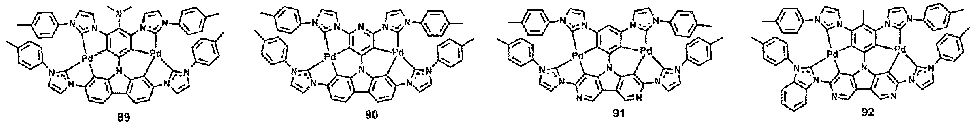

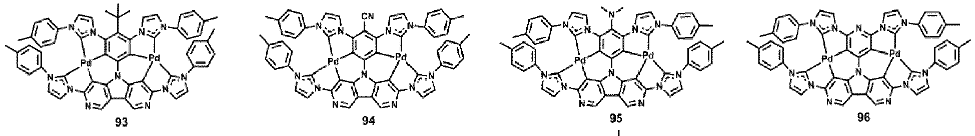

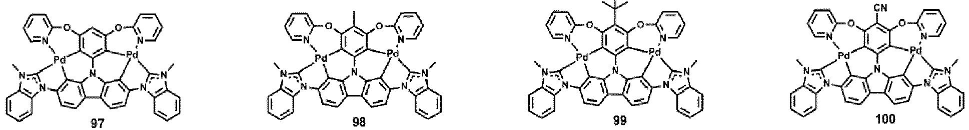

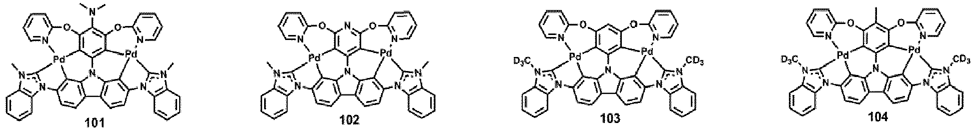

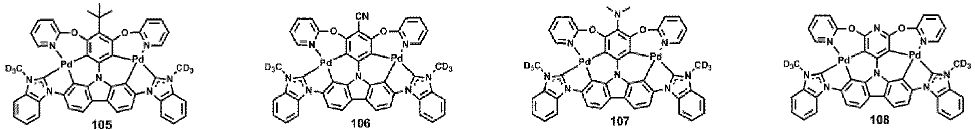

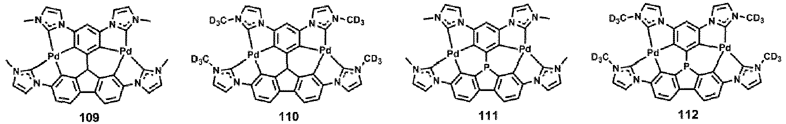

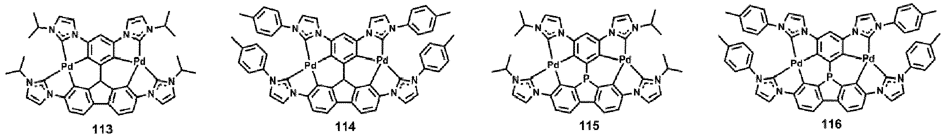

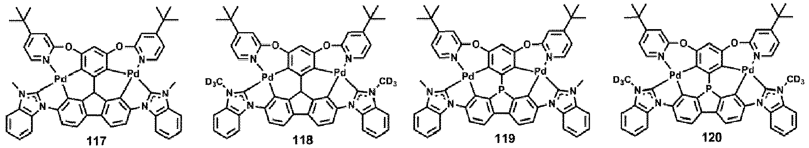

The organometallic compound represented by Formula 1 is a bimetallic complex, which may exhibit a heavy effect, resulting in excellent luminescence efficiency with respect to the absorption energy. As used herein, the term "heavy effect" may refer to the "heavy atom effect", in which atoms having a higher atomic number promote intersystem crossing via spin-orbit coupling, thereby resulting in increased phosphorescent efficiency.

In addition, the organometallic compound represented by Formula 1 has a structure in which rings CY₁ and CY₃ are linked to ring CY₅, but rings CY₁ and ring CY₂ are not linked to each other, and rings CY₃ and CY₄ are not linked to each other. The ligand structure is thereby slightly tilted around the center instead of being completely flat (e.g., around ring CY₅), which may reduce formation of excimer complexes between compounds. Accordingly, the lifespan of a device may be increased.

In addition, the organometallic compound represented by Formula 1 may have a dual ligand structure, in which the bimetallic structure is linked (e.g., the two metal atoms are linked) via a ring rather than a single bond, and accordingly, the compound structure may have increased rigidity, thereby increasing compound stability and reducing formation of excimers by increasing the tilt (dihedral) angle between left and right sides of the ligand around the central metals. Accordingly, a phosphorescent organic light-emitting device having high efficiency and/or long lifespan may be implemented.

An organic light-emitting device including the organometallic compound represented by Formula 1 may have high durability, resulting in long lifespan.

The organometallic compound may be to emit blue light. For example, the organometallic compound may be to emit blue light having a maximum emission wavelength of 440 nm or more and less than 520 nm, for example, 460 nm or more and 520 nm or less (and additionally with a bottom emission CIE_{x,y} color coordinate of 0.17 to 0.35, for example, 0.17), but embodiments are not limited thereto. Accordingly, the organometallic compound represented by Formula 1 may be useful for the manufacturing of an organic light-emitting device.

Synthesis methods of the organometallic compound represented by Formula 1 may be understood by one of ordinary skill in the art by referring to Examples provided below.

At least one organometallic compound represented by Formula 1 may be used in a layer between a pair of electrodes in an organic light-emitting device. For example, the organometallic compound may be included in an emission layer. The organometallic compound included in the emission layer may act as a dopant. In one or more embodiments, the organometallic compound of Formula 1 may be used as a material for a capping layer located outside a pair of electrodes of an organic light-emitting device.

Accordingly, another aspect of embodiments of the present disclosure provides an organic light-emitting device including: a first electrode; a second electrode facing the first electrode; an organic layer located between the first electrode and the second electrode and including an emission layer; and at least one organometallic compound represented by Formula 1.

The expression "(an organic layer) includes at least one organometallic compound" as used herein may include a case in which "(an organic layer) includes identical organometallic compounds (e.g., only one compound structure) represented by Formula 1" as well as a case in which "(an organic layer) includes two or more different organometallic compounds (e.g., two or more compound structures) represented by Formula 1".

For example, the organic layer may include, as the organometallic compound, only Compound 1 (e.g., a first organometallic compound). In one embodiment, Compound 1 may be included in the emission layer of the organic light-emitting device. In one or more embodiments, the organic layer may include, as the organometallic compound, Compound 1 and Compound 2 (e.g., a first organometallic compound and a second organometallic compound). In this regard, Compound 1 and Compound 2 may exist in the same layer (for example, Compound 1 and Compound 2 may both exist in an emission layer), or in different layers (for example, Compound 1 may exist in an emission layer and Compound 2 may exist in an electron transport region).

In one embodiment,
the first electrode of the organic light-emitting device may be an anode,
the second electrode of the organic light-emitting device may be a cathode, and
the organic layer may further include a hole transport region between the first electrode and the emission layer and an electron transport region between the emission layer and the second electrode,
the hole transport region may include a hole injection layer, a hole transport layer, an emission auxiliary layer, an electron blocking layer, or any combination thereof, and
the electron transport region may include a hole blocking layer, an electron transport layer, an electron injection layer, or any combination thereof.

The term an "organic layer" as used herein may refer to a single layer and/or (any of) a plurality of layers located between the first electrode and the second electrode of an organic light-emitting device. Materials included in the "organic layer" are not limited to being organic materials.

In one embodiment, the emission layer may include the organometallic compound.

One or more example embodiments of the present disclosure provide an organic light-emitting device including: a first electrode; a second electrode facing the first electrode; and an emission layer located between the first electrode and the second electrode, the emission layer including a first compound, a second compound, and a third compound, wherein the first compound, the second compound, and the third compound are different from each other, the first compound is represented by Formula 1, the second compound is represented by Formula 2-1 or 2-2, and the third compound includes a group represented by Formula 3:

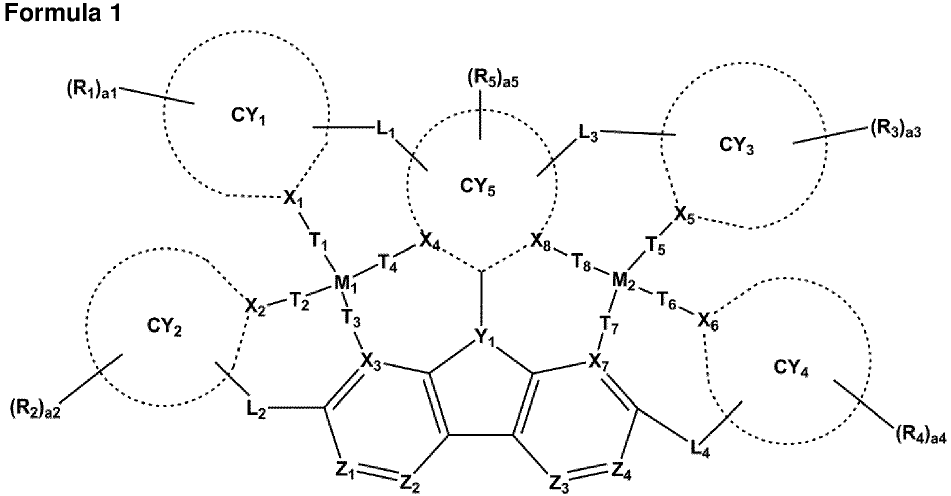

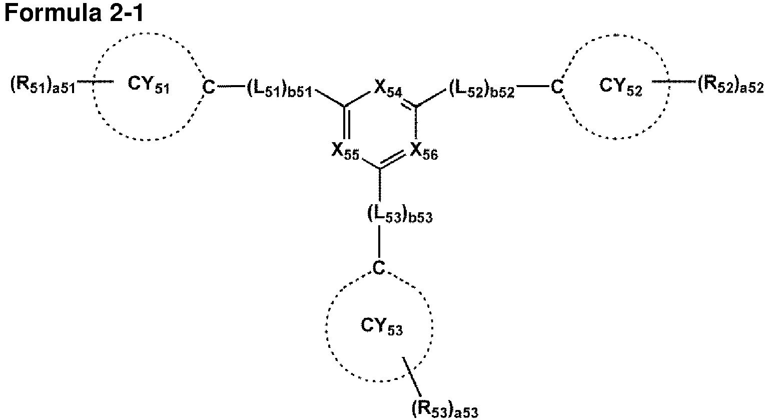

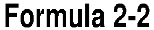

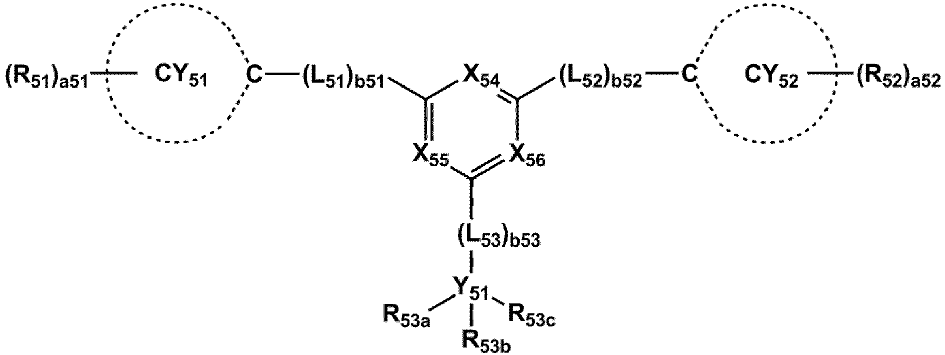

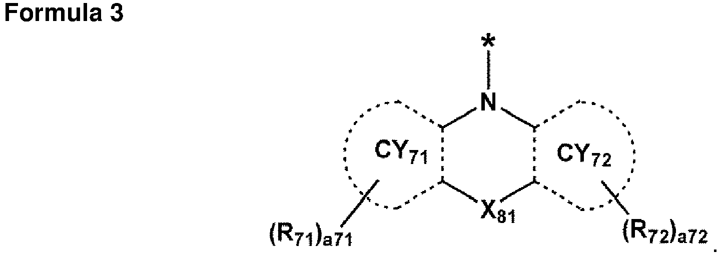

Formula 1 is the same as described above.

In Formulae 1 to 3, ring CY₁ to ring CY₅, ring CY₅₁ to ring CY₅₃, ring CY₇₁, and ring CY₇₂ are each independently selected from a C₅-C₃₀ carbocyclic group and a C₁-C₃₀ heterocyclic group. For example, in Formulae 1 to 3, ring CY₁ to ring CY₅, ring CY₅₁ to ring CY₅₃, ring CY₇₁, and ring CY₇₂ may each independently be selected from a C₅-C₂₀ carbocyclic group and a C₁-C₂₀ heterocyclic group.

For example, in Formulae 1 to 3, ring CY₅₁ to ring CY₅₃, ring CY₇₁, and ring CY₇₂ may each independently be i) a first ring (e.g., a ring selected from a first group as defined below, e.g., a five-membered ring), ii) a second ring (e.g., a ring selected from a second group as defined below, e.g., a six-membered ring or a bridge ring system including one or more six-membered rings), iii) a condensed ring in which two or more first rings are condensed with each other, iv) a condensed ring in which two or more second rings are condensed with each other, or v) a condensed ring in which one or more first rings and one or more second rings are condensed with each other,
wherein the first ring may be selected from a cyclopentane group, a cyclopentadiene group, a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group, and
the second ring may be selected from an adamantane group, a norbornane group, a norbornene group, a cyclohexane group, a cyclohexene group, a benzene group, a pyridine group, a pyrimidine group, a pyrazine group, a pyridazine group, a triazine group, an oxasiline group, a thiasiline group, a dihydroazasiline group, a dihydrodisiline group, a dihydrosiline group, a dioxine group, an oxathiine group, an oxazine group, a pyran group, a dithiine group, a thiazine group, a thiopyran group, a cyclohexadiene group, a dihydropyridine group, and a dihydropyrazine group.

In one or more embodiments, in Formulae 2-1, 2-2 and 3, ring CY₅₁ to ring CY₅₃, ring CY₇₁, and ring CY₇₂ may each independently be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group, but embodiments of the present disclosure are not limited thereto.

In Formulae 2-1 and 2-2, L₅₁ to L₅₃ are each independently selected from a substituted or unsubstituted C₅-C₃₀ carbocyclic group and a substituted or unsubstituted C₁-C₃₀ heterocyclic group. For example, in Formulae 2-1 and 2-2, L₅₁ to L₅₃ may each independently be selected from a substituted or unsubstituted C₅-C₂₀ carbocyclic group and a substituted or unsubstituted C₁-C₂₀ heterocyclic group.

For example, L₅₁ to L₅₃ may each independently be selected from:
a benzene group, a naphthalene group, an anthracene group, a phenanthrene group, a triphenylene group, a pyrene group, a chrysene group, cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group; and
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group, each substituted with at least one selected from deuterium, -F, -Cl, -Br, -I, a hydroxyl group, a cyano group, a nitro group, an amidino group, a hydrazine group, a hydrazone group, a C₁-C₂₀ (*e.g*. C₁-C₁₀) alkyl group, a C₁-C₂₀ (*e.g.* C₁-C₁₀) alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), and -P(=O)(Q₃₁)(Q₃₂), and
Q₃₁ to Q₃₃ may each independently be selected from hydrogen, deuterium, a C₁-C₂₀ *(e.g.* C₁-C₁₀) alkyl group, a C₁-C₂₀ *(e.g.* C₁-C₁₀) alkoxy group, a phenyl group, a biphenyl group, a terphenyl group, a pyridinyl group, a pyrimidinyl group, a pyridazinyl group, a pyrazinyl group, and a triazinyl group, but embodiments of the present disclosure are not limited thereto.

In Formulae 2-1 and 2-2, a bond between L₅₁ and ring CY₅₁, a bond between L₅₂ and ring CY₅₂, a bond between L₅₃ and ring CY₅₃, a bond between two or more L₅₁(s), a bond between two or more L₅₂(s), a bond between two or more L₅₃(s), a bond between L₅₁ and the carbon atom between X₅₄ and X₅₅ in Formulae 2-1 and 2-2, a bond between L₅₂ and the carbon atom between X₅₄ and X₅₆ in Formulae 2-1 and 2-2, and a bond between L₅₃ and the carbon atom between X₅₅ and X₅₆ in Formulae 2-1 and 2-2 are each a "carbon-carbon single bond".

In Formulae 2-1 and 2-2, b51 to b53 respectively indicate the number of L₅₁(s), L₅₂(s), and L₅₃(s), and are each independently an integer from 0 to 5. When b51 is 0, *-(L₅₁)_{b51}-*' is a single bond; when b52 is 0, *-(L₅₂)_{b52}-*' is a single bond; when b53 is 0, *-(L₅₃)_{b53}-*' is a single bond; when b51 is 2 or more, two or more L₅₁(s) may be identical to or different from each other; when b52 is 2 or more, two or more L₅₂(s) may be identical to or different from each other; and when b53 is 2 or more, two or more L₅₃(s) may be identical to or different from each other. For example, b51 to b53 may each independently be 0, 1, or 2.

In Formulae 2-1 and 2-2, X₅₄ is N or C(R₅₄), X₅₅ is N or C(R₅₅), X₅₆ is N or C(R₅₆), and at least one of X₅₄ to X₅₆ is N. R₅₄ to R₅₆ may each independently be the same as described below.

In Formula 2-2, Y₅₁ may be C or Si.

In Formula 3, X₈₁ is a single bond, O, S, N(R₈₁), B(R₈₁), C(R₈₁ₐ)(R_{81b}), or Si(R₈₁ₐ)(R_{81b}). R₈₁, R₈₁ₐ, and R_{81b} may each independently be the same as described below.

R₅₁ to R₅₆, R₅₃ₐ to R_{53c}, R₇₁, R₇₂, R₈₁, R₈₁ₐ, and R_{81b} are each independently selected from hydrogen, deuterium, -F, -Cl, -Br, -I, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), and - P(=O)(Q₁)(Q₂). Q₁ to Q₃ are each independently the same as described in the present specification.

For example, R₅₁ to R₅₆, R₅₃ₐ to R_{53c}, R₇₁, R₇₂, R₈₁, R₈₁ₐ, and R_{81b} may each independently be selected from: hydrogen, deuterium, -F, -Cl, -Br, -I, a hydroxyl group, a cyano group, a nitro group, an amidino group, a hydrazine group, a hydrazone group, a C₁-C₂₀ *(e.g.* C₁-C₁₀) alkyl group, and a C₁-C₂₀ *(e.g.* C₁-C₁₀) alkoxy group;
a C₁-C₂₀ *(e.g.* C₁-C₁₀) alkyl group and a C₁-C₂₀ *(e.g.* C₁-C₁₀) alkoxy group, each substituted with at least one selected from deuterium, -F, -Cl, -Br, -I, -CD₃, - CD₂H, -CDH₂, -CF₃, -CF₂H, -CFH₂, a hydroxyl group, a cyano group, a nitro group, an amidino group, a hydrazine group, a hydrazone group, a C₁-C₁₀ alkyl group, a cyclopentyl group, a cyclohexyl group, a cycloheptyl group, a cyclooctyl group, an adamantyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group;
a cyclopentyl group, a cyclohexyl group, a cycloheptyl group, a cycloctyl group, an adamantyl group, a norbornanyl group, a norbornenyl group, a cyclopentenyl group, a cyclohexenyl group, a cycloheptenyl group, a phenyl group, a biphenyl group, a C₁-C₁₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, and a group represented by Formula 91;
a cyclopentyl group, a cyclohexyl group, a cycloheptyl group, a cycloctyl group, an adamantyl group, a norbornanyl group, a norbornenyl group, a cyclopentenyl group, a cyclohexenyl group, a cycloheptenyl group, a phenyl group, a biphenyl group, a C₁-C₁₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, and a group represented by Formula 91, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a C₁-C₂₀ (e.g. C₁-C₁₀) alkyl group, a C₁-C₂₀ (e.g. C₁-C₁₀) alkoxy group, a cyclopentyl group, a cyclohexyl group, a cycloheptyl group, a cycloctyl group, an adamantyl group, a norbornanyl group, a norbornenyl group, a cyclopentenyl group, a cyclohexenyl group, a cycloheptenyl group, a phenyl group, a biphenyl group, a C₁-C₁₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), and -P(=O)(Q₃₁)(Q₃₂); and
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂), and
Q₁ to Q₃ and Q₃₁ to Q₃₃ may each independently be selected from:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CH₃, -CD₂CD₃, -CD₂CD₂H, and - CD₂CDH₂;
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, and a triazinyl group; and
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, and a triazinyl group, each substituted with at least one selected from deuterium, a C₁-C₁₀ alkyl group, a phenyl group, a biphenyl group, a pyridinyl group, a pyrimidinyl group, a pyridazinyl group, a pyrazinyl group, and a triazinyl group,
   but embodiments of the present disclosure are not limited thereto:

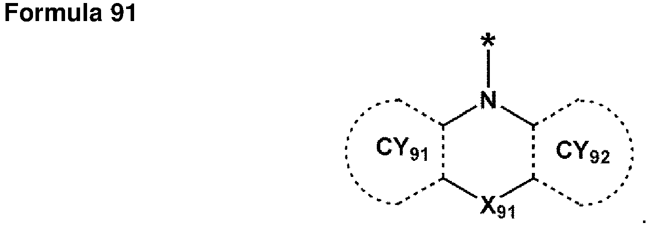

In Formula 91,
ring CY₉₁ and ring CY₉₂ are each independently selected from a C₅-C₃₀ (*e*.*g*. C₅-C₂₀) carbocyclic group and a C₁-C₃₀ (e.g. C₁-C₂₀) heterocyclic group,
X₉₁ is a single bond, O, S, N(R₉₁), B(R₉₁), C(R₉₁ₐ)(R_{91b}), or Si(R₉₁ₐ)(R_{91b}),
R₉₁, R₉₁ₐ, and R_{91b} are each independently the same as described in connection with R₈₁, R₈₁ₐ, and R_{81b}, respectively, and
* indicates a binding site to a neighboring atom.

For example, in Formula 91,
ring CY₉₁ and ring CY₉₂ may each independently be selected from a benzene group, a pyridine group, a pyrimidine group, a pyrazine group, a pyridazine group, and a triazine group,
R₉₁, R₉₁ₐ, and R_{91b} may each independently be selected from:
   hydrogen and a C₁-C₁₀ alkyl group;
   a phenyl group, a biphenyl group, a pyridinyl group, a pyrimidinyl group, a pyridazinyl group, a pyrazinyl group, and a triazinyl group; and
   a phenyl group, a pyridinyl group, a pyrimidinyl group, a pyridazinyl group, a pyrazinyl group, and a triazinyl group, each substituted with at least one selected from deuterium, a C₁-C₁₀ alkyl group, a phenyl group, a biphenyl group, a pyridinyl group, a pyrimidinyl group, a pyridazinyl group, a pyrazinyl group, and a triazinyl group,
   but embodiments of the present disclosure are not limited thereto.

In one or more embodiments, R₅₁ to R₅₆, R₅₃ₐ to R_{53c}, R₇₁, R₇₂, R₈₁, R₈₁ₐ, R_{81b}, and R₁₀ₐ may each independently be selected from hydrogen, deuterium, -F, a cyano group, a nitro group, -CH₃, -CD₃, -CD₂H, -CDH₂, -CF₃, -CF₂H, -CFH₂, groups represented by Formulae 9-1 to 9-21, groups represented by Formulae 10-1 to 10-243, -C(Q₁)(Q₂)(Q₃), -Si(Q₁)(Q₂)(Q₃), and -P(=O)(Q₁)(Q₂) (wherein Q₁ to Q may each independently be the same as described above), but embodiments of the present disclosure are not limited thereto:

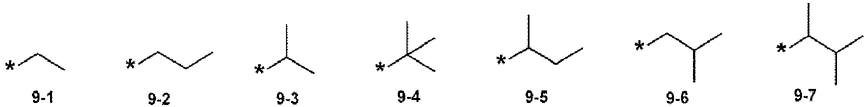

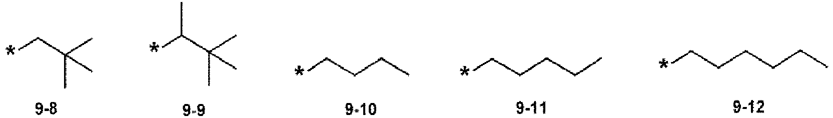

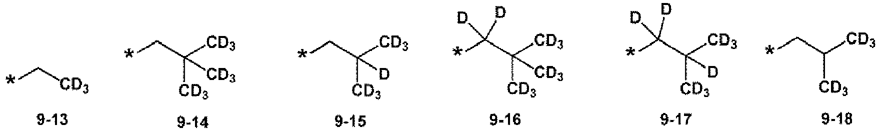

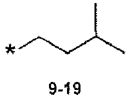

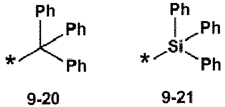

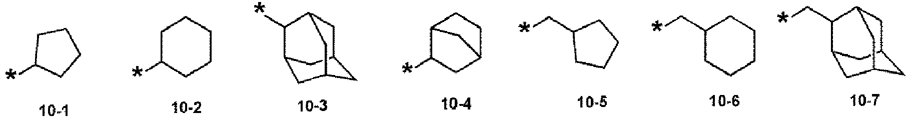

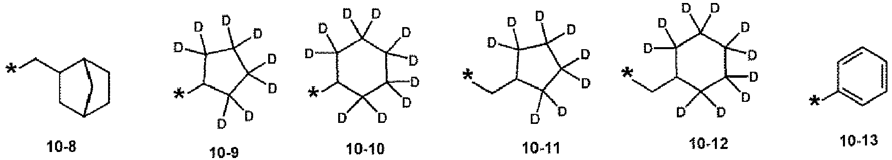

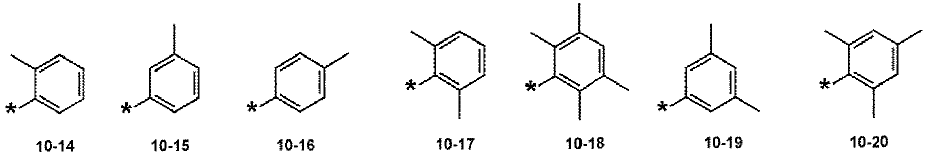

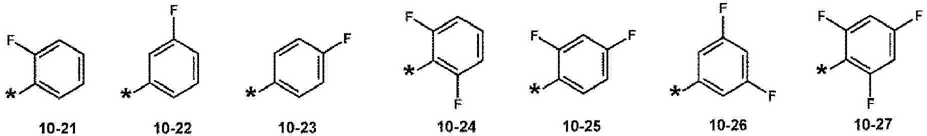

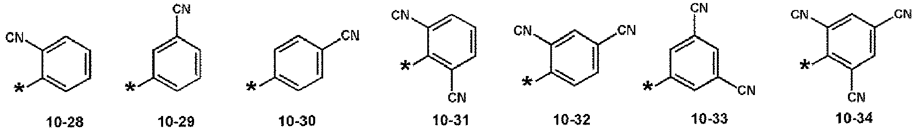

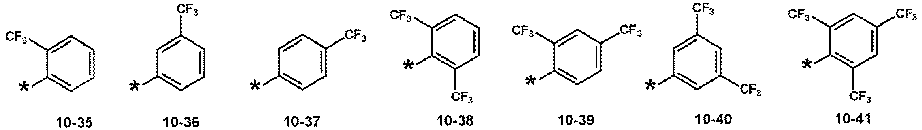

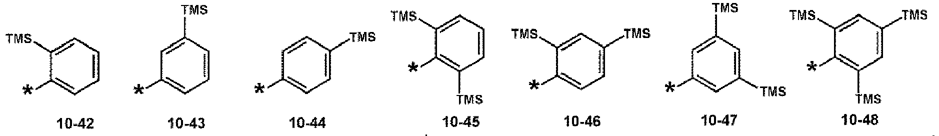

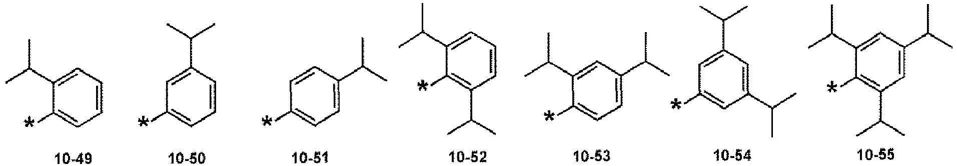

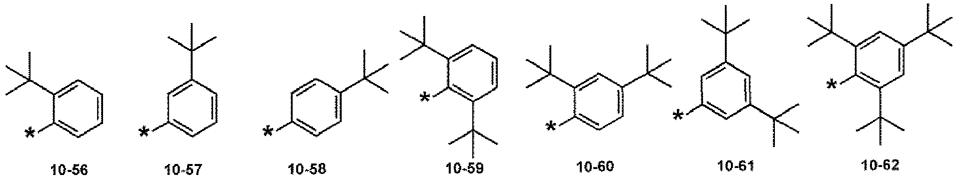

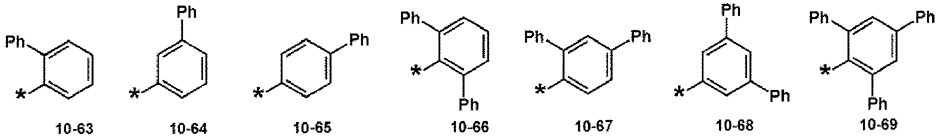

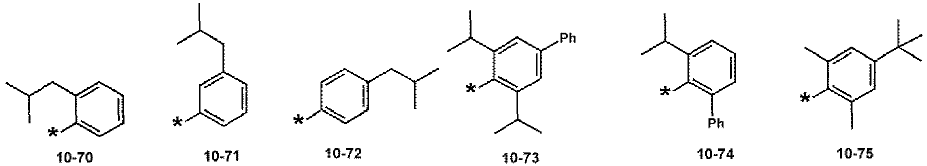

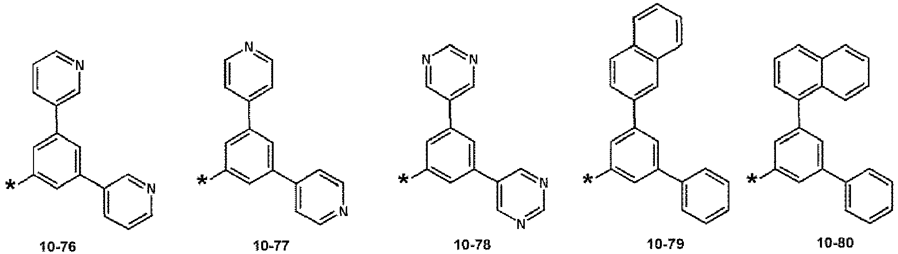

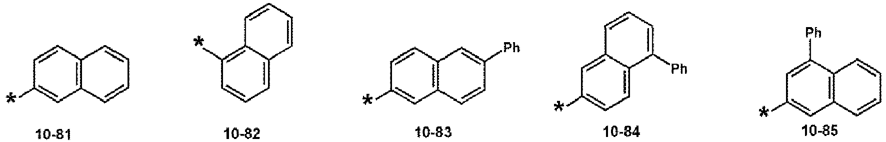

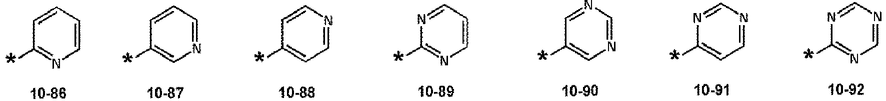

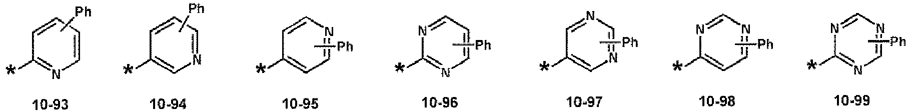

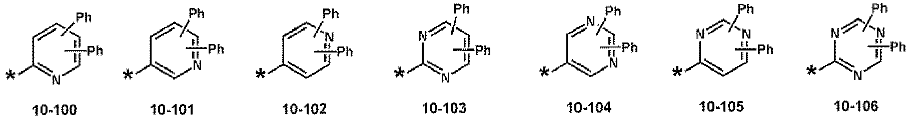

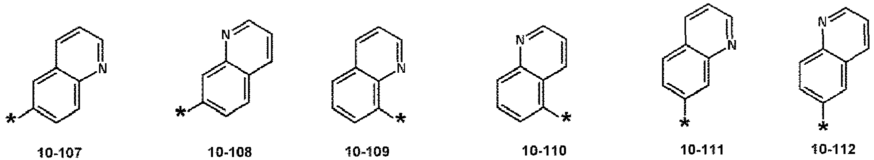

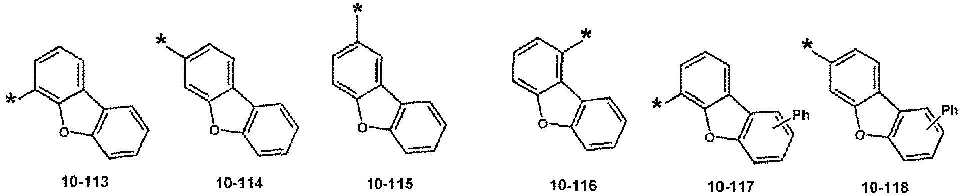

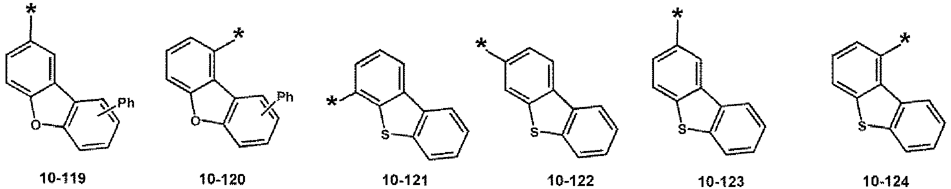

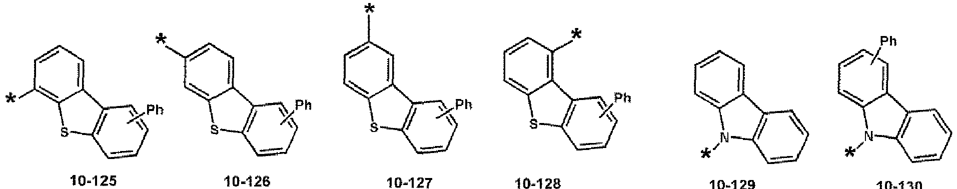

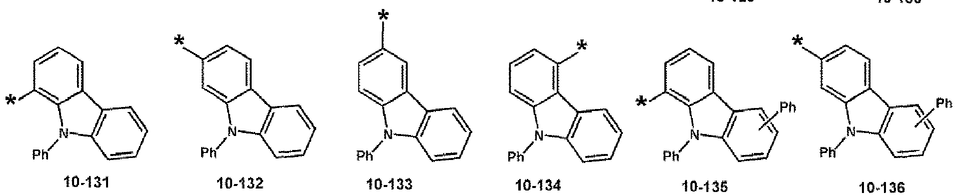

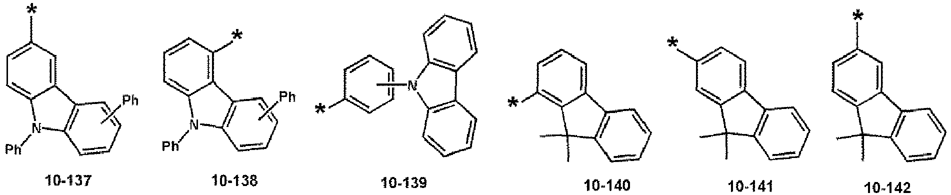

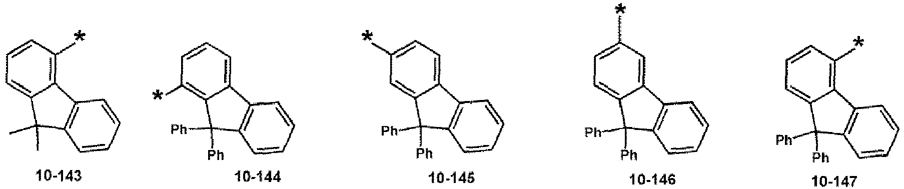

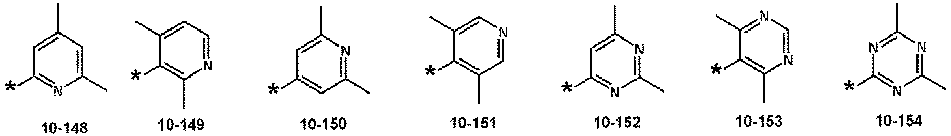

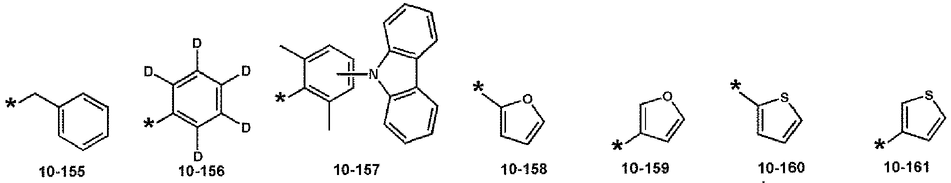

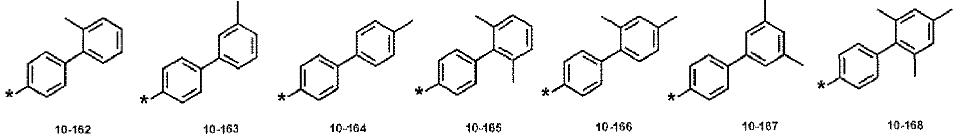

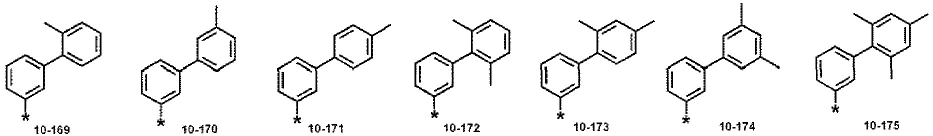

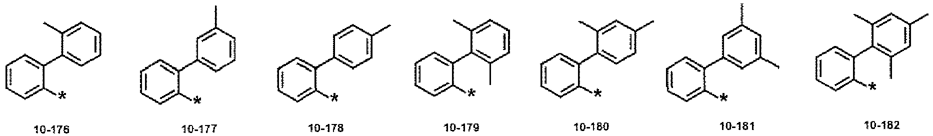

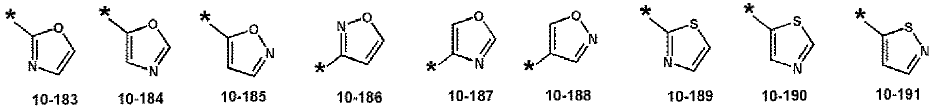

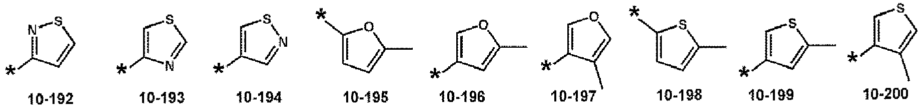

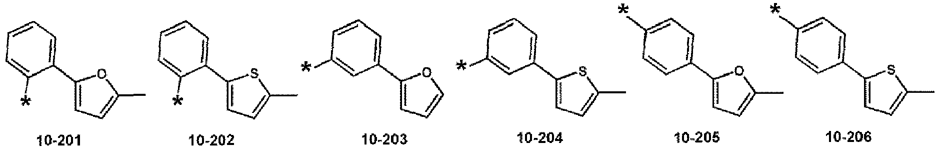

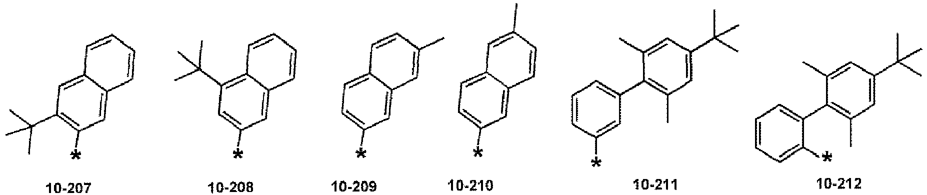

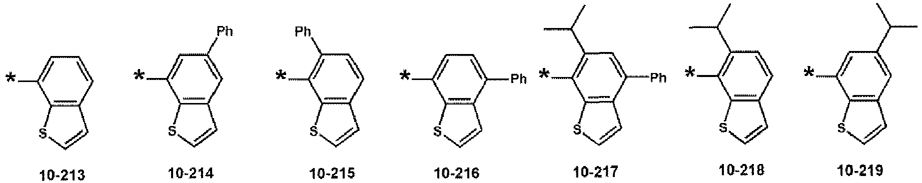

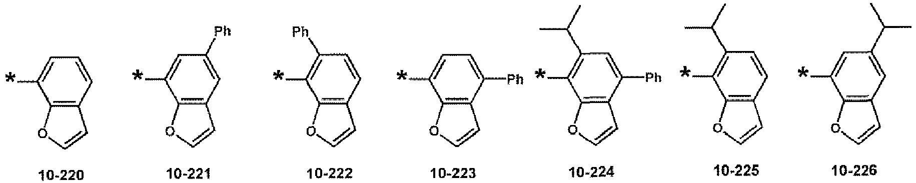

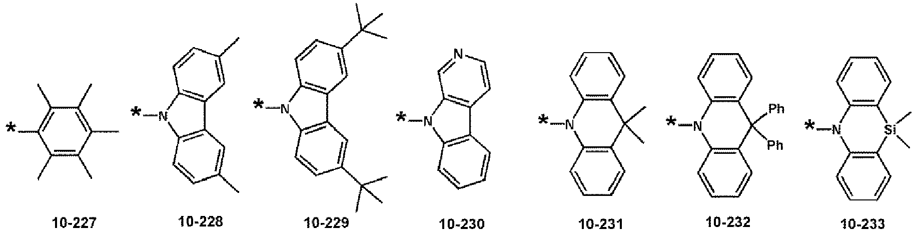

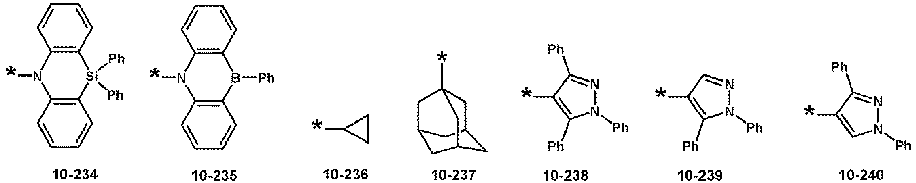

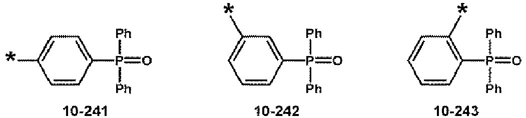

In Formulae 9-1 to 9-21 and 10-1 to 10-243, * indicates a binding site to a neighboring atom, Ph indicates a phenyl group, and TMS indicates a trimethylsilyl group.

a51 to a53, a71, and a72 respectively indicate the number of R₅₁(s), R₅₂(s), R₅₃(s), R₇₁(s), and R₇₂(s), and are each independently an integer from 0 to 20 (for example, an integer from 0 to 5). When a51 is 2 or more, two or more R₅₁(s) may be identical to each other or different from each other, and a52 to a53, a71, a72, R₅₂ to R₅₃, R₇₁, and R₇₂ may each be understood in the same manner.

In one or more embodiments, in Formulae 2-1 and 2-2, a group represented by 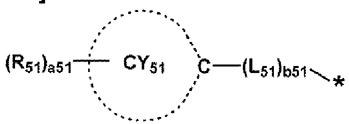 and a group represented by 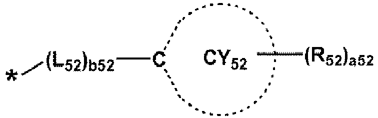 may each not be a phenyl group.

In one or more embodiments, in Formulae 2-1 and 2-2, a group represented by 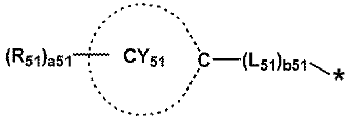 and a group represented by 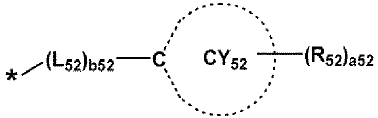 may be identical to each other.

In one or more embodiments, in Formulae 2-1 and 2-2, ring CY₅₁ and ring CY₅₂ may each independently be selected from a benzene group, a pyridine group, a pyrimidine group, a pyridazine group, a pyrazine group, and a triazine group,

R₅₁ and R₅₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₀) aryl group, a substituted or unsubstituted C₇-C₆₀ *(e.g.* C₇-C₃₀) alkyl aryl group, a substituted or unsubstituted C₆-C₆₀ *(e.g.* C₆-C₃₀) aryloxy group, a substituted or unsubstituted C₆-C₆₀ (e.g. C₆-C₃₀) arylthio group, a substituted or unsubstituted C₁-C₆₀ (*e.g*. C₁-C₂₀) heteroaryl group, a substituted or unsubstituted C₂-C₆₀ (*e.g.* C₂-C₂₀) alkyl heteroaryl group, a substituted or unsubstituted monovalent non-aromatic condensed polycyclic group, a substituted or unsubstituted monovalent non-aromatic condensed heteropolycyclic group, -C(Q₁)(Q₂)(Q₃), and -Si(Q₁)(Q₂)(Q₃),

Q₁ to Q₃ may each independently be selected from a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ *(e.g.* C₆-C₃₀) aryl group, a C₆-C₆₀ *(e.g.* C₆-C₃₀) aryloxy group, a C₆-C₆₀ *(e.g.* C₆-C₃₀) arylthio group, a C₁-C₆₀ *(e.g.* C₁-C₂₀) heteroaryl group, a monovalent non-aromatic condensed polycyclic group, a monovalent non-aromatic condensed heteropolycyclic group and a C₆-C₆₀ (*e.g*. C₆-C₃₀) aryl group that is substituted with at least one selected from deuterium, -F, a cyano group, a C₁-C₁₀ alkyl group, a phenyl group, and a biphenyl group, and
a51 and a52 may each independently be 1, 2, or 3.

In one or more embodiments, in Formulae 2-1 and 2-2, a moiety represented by 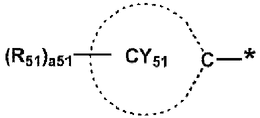 may be selected from groups represented by Formulae CY51-1 to CY51-19, and/or
a moiety represented by 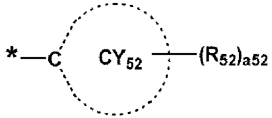 may be selected from groups represented by Formulae CY52-1 to CY52-19, and/or
a moiety represented by 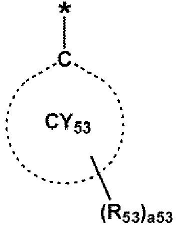 in Formula 2-1 may be selected from groups represented by Formulae CY53-1 to CY53-18:

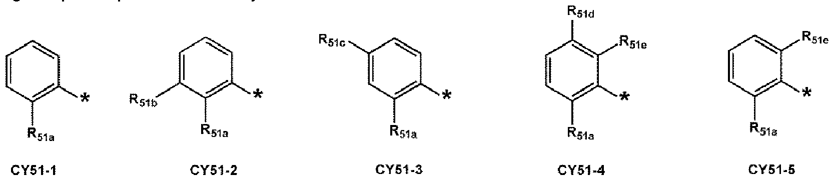

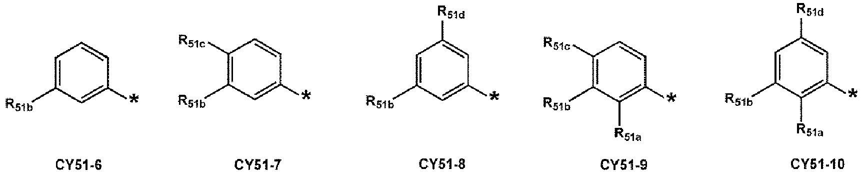

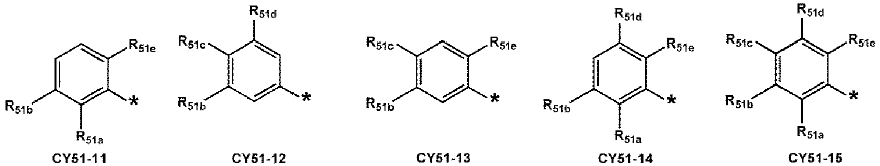

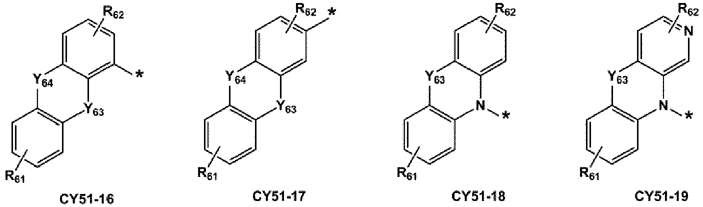

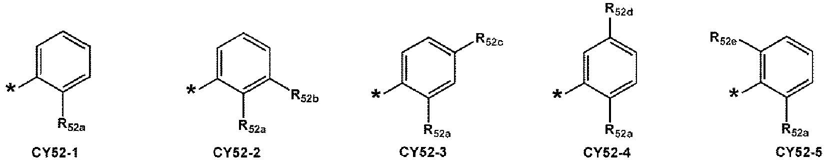

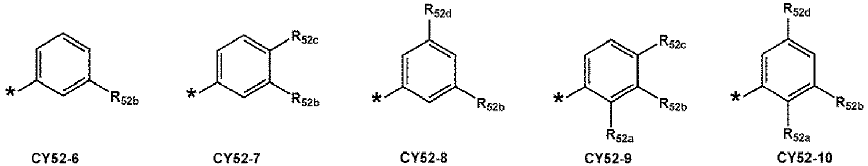

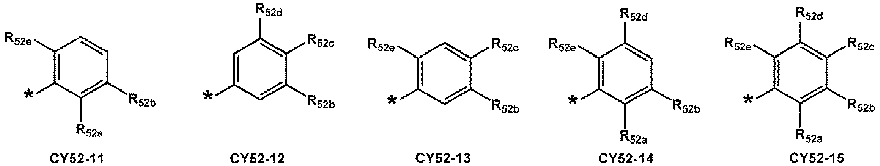

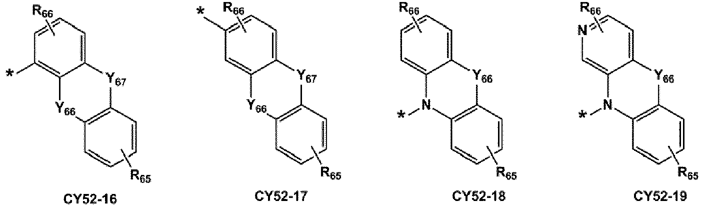

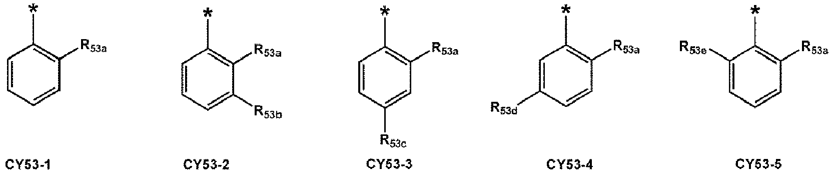

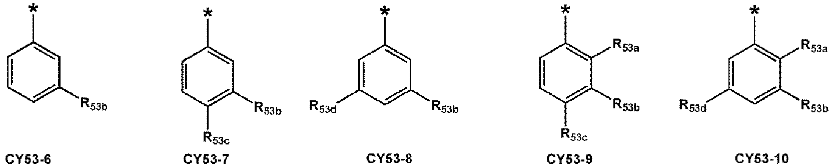

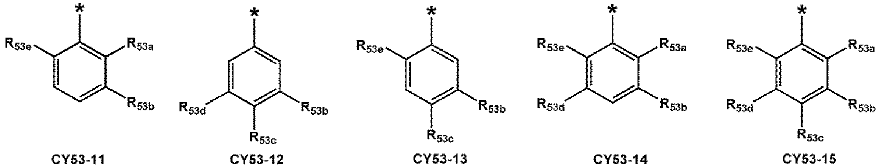

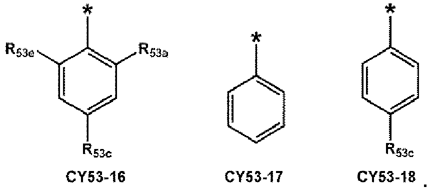

In Formulae CY51-1 to CY51-19, CY52-1 to CY52-19, and CY53-1 to CY53-18,
Y₆₃ is a single bond, O, S, N(R₆₃), B(R₆₃), C(R₆₃ₐ)(R_{63b}), or Si(R₆₃ₐ)(R_{63b}),
Y₆₄ is a single bond, O, S, N(R₆₄), B(R₆₄), C(R₆₄ₐ)(R_{64b}), or Si(R₆₄ₐ)(R_{64b}),
Y₆₆ is a single bond, O, S, N(R₆₆), B(R₆₆), C(R₆₆ₐ)(R_{66b}), or Si(R₆₆ₐ)(R_{66b}),
Y₆₇ is a single bond, O, S, N(R₆₇), B(R₆₇), C(R₆₇ₐ)(R_{67b}), or Si(R₆₇ₐ)(R_{67b}),
Y₆₃ and Y₆₄ in Formulae CY51-16 and CY51-17 are not each a single bond at the same time (e.g., simultaneously),
Y₆₆ and Y₆₇ in Formulae CY52-16 and CY52-17 are not each a single bond at the same time (e.g., simultaneously),
R₅₁ₐ to R₅₁ₑ, R₆₁ to R₆₄, R₆₃ₐ, R_{63b}, R₆₄ₐ, and R_{64b} are each independently the same as described in connection with R₅₁ in the present specification, wherein R₅₁ₐ to R₅₁ₑ are each not hydrogen,
R₅₂ₐ to R₅₂ₑ, R₆₅ to R₆₇, R₆₆ₐ, R_{66b}, R₆₇ₐ, and R_{67b} are each independently be the same as described in connection with R₅₂ in the present specification, wherein R₅₂ₐ to R₅₂ₑ are each not hydrogen,
R₅₃ₐ to R₅₃ₑ are each independently the same as described in connection with R₅₃ in the present specification, wherein R₅₃ₐ to R₅₃ₑ are each not hydrogen, and
* indicates a binding site to a neighboring atom.

In Formulae CY51-1 to CY51-19 and CY52-1 to 52-19, R₅₁ₐ to R₅₁ₑ and R₅₂ₐ to R₅₂ₑ may each independently be selected from:
a cyclopentyl group, a cyclohexyl group, a cycloheptyl group, a cycloctyl group, an adamantyl group, a norbornanyl group, a norbornenyl group, a cyclopentenyl group, a cyclohexenyl group, a cycloheptenyl group, a phenyl group, a biphenyl group, a C₁-C₁₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, and a group represented by Formula 91;
a cyclopentyl group, a cyclohexyl group, a cycloheptyl group, a cycloctyl group, an adamantyl group, a norbornanyl group, a norbornenyl group, a cyclopentenyl group, a cyclohexenyl group, a cycloheptenyl group, a phenyl group, a biphenyl group, a C₁-C₁₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, and a group represented by Formula 91, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a C₁-C₂₀ (*e.g*. C₁-C₁₀) alkyl group, a C₁-C₂₀ (*e.g*. C₁-C₁₀) alkoxy group, a cyclopentyl group, a cyclohexyl group, a cycloheptyl group, a cycloctyl group, an adamantyl group, a norbornanyl group, a norbornenyl group, a cyclopentenyl group, a cyclohexenyl group, a cycloheptenyl group, a phenyl group, a biphenyl group, a C₁-C₁₀ alkyl phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
-C(Q₁)(Q₂)(Q₃) and -Si(Q₁)(Q₂)(Q₃), and
Q₁ to Q₃ may each independently be selected from:
   a phenyl group, a naphthyl group, a pyridinyl group, a pyrimidinyl group, a pyridazinyl group, a pyrazinyl group, and a triazinyl group; and
   a phenyl group, a naphthyl group, a pyridinyl group, a pyrimidinyl group, a pyridazinyl group, a pyrazinyl group, and a triazinyl group, each substituted with at least one selected from deuterium, a C₁-C₁₀ alkyl group, a phenyl group, a biphenyl group, a pyridinyl group, a pyrimidinyl group, a pyridazinyl group, a pyrazinyl group, and a triazinyl group,
   in Formulae CY51-16 and CY51-17, i) Y₆₃ may be O or S, and Y₆₄ may be Si(R₆₄ₐ)(R_{64b}), or ii) Y₆₃ may be Si(R₆₃ₐ)(R_{63b}), and Y₆₄ may be O or S, and
   in Formulae CY52-16 and CY52-17, i) Y₆₆ may be O or S, and Y₆₇ may be Si(R₆₇ₐ)(R_{67b}), or ii) Y₆₆ may be Si(R₆₆ₐ)(R_{66b}), and Y₆₇ may be O or S, but embodiments of the present disclosure are not limited thereto.

In one or more embodiments, the third compound may be represented by one of Formulae 3-1 to 3-5:

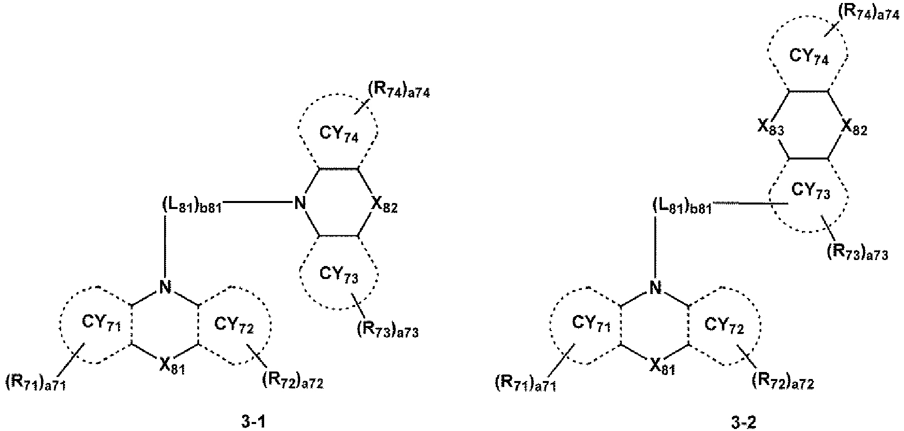

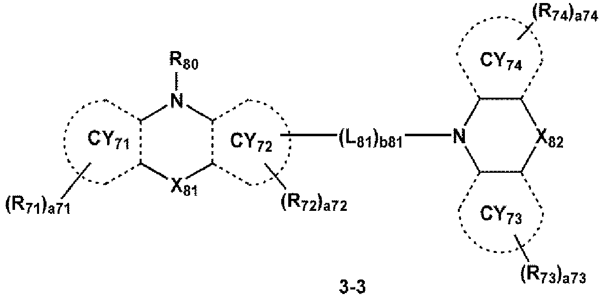

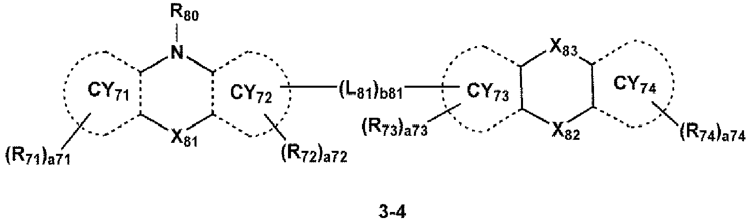

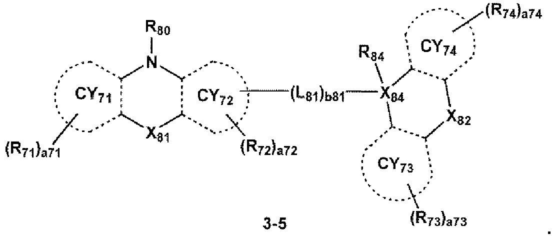

In Formulae 3-1 to 3-5,
ring CY₇₁, ring CY₇₂, X₈₁, R₇₁, R₇₂, a71, and a72 are each independently the same as described in the present specification,
ring CY₇₃, ring CY₇₄, R₇₃, R₇₄, a73, and a74 are each independently the same as described in connection with ring CY₇₁, ring CY₇₂, R₇₁, R₇₂, a71, and a72 in the present specification, respectively,
L₈₁ is selected from *-C(Q₄)(Q₅)-*', *-Si(Q₄)(Q₅)-*', a substituted or unsubstituted C₅-C₃₀ (e.g. C₅-C₂₀) carbocyclic group, and a substituted or unsubstituted C₁-C₃₀ (*e.g.* C₁-C₂₀) heterocyclic group, wherein Q₄ and Q₅ are each independently the same as described in connection with Q₁ in the present specification,
b81 is an integer from 0 to 5, wherein, when b81 is 0, *-(L₈₁)_{b81}-*' is a single bond, and when b81 is 2 or more, two or more L₈₁(s) are identical to or different from each other,
X₈₂ is a single bond, O, S, N(R₈₂), B(R₈₂), C(R₈₂ₐ)(R_{82b}), or Si(R₈₂ₐ)(R_{82b}),
X₈₃ is a single bond, O, S, N(R₈₃), B(R₈₃), C(R₈₃ₐ)(R_{83b}), or Si(R₈₃ₐ)(R_{83b}),
in Formulae 3-2 and 3-4, X₈₂ and X₈₃ are each not a single bond at the same time (e.g., simultaneously),
X₈₄ is C or Si,
R₈₀, R₈₂, R₈₃, R₈₂ₐ, R_{82b}, R₈₃ₐ, R_{83b}, and R₈₄ are each independently the same as described in connection with R₈₁ in the present specification, and
* and *' each indicate a binding site to a neighboring atom.

For example, L₈₁ may be selected from:
*-C(Q₄)(Q₅)-*' and *-Si(Q₄)(Q₅)-*';
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group; and
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group, each substituted with at least one selected from deuterium, -F, -Cl, -Br, -I, a hydroxyl group, a cyano group, a nitro group, an amidino group, a hydrazine group, a hydrazone group, a C₁-C₂₀ (*e.g.* C₁-C₁₀) alkyl group, a C₁-C₂₀ (*e*.*g*. C₁-C₁₀) alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), and -P(=O)(Q₃₁)(Q₃₂), and
Q₄, Q₅, and Q₃₁ to Q₃₃ may each independently be selected from hydrogen, deuterium, a C₁-C₂₀ *(e.g.* C₁-C₁₀) alkyl group, a C₁-C₂₀ *(e.g.* C₁-C₁₀) alkoxy group, a phenyl group, a biphenyl group, a terphenyl group, a pyridinyl group, a pyrimidinyl group, a pyridazinyl group, a pyrazinyl group, and a triazinyl group, but embodiments of the present disclosure are not limited thereto.

For example, a moiety represented by 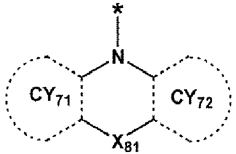 in Formulae 3-1 and 3-2 may be selected from groups represented by Formulae CY71-1(1) to CY71-1(8),
a moiety represented by 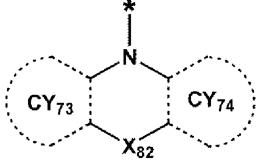 in Formulae 3-1 and 3-3 may be selected from groups represented by Formulae CY71-2(1) to CY71-2(8),
a moiety represented by 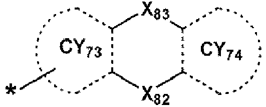 in Formulae 3-2 and 3-4 may be selected from groups represented by Formulae CY71-3(1) to CY71-3(32),
a moiety represented by 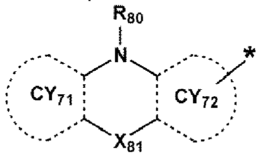 in Formulae 3-3 to 3-5 may be selected from groups represented by Formulae CY71-4(1) to CY71-4(32), and
a moiety represented by 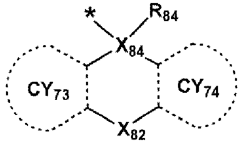 in Formula 3-5 may be selected from groups represented by Formulae CY71-5(1) to CY71-5(8), but embodiments of the present disclosure are not limited thereto:

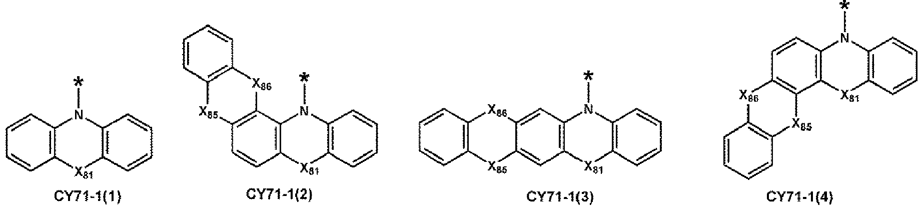

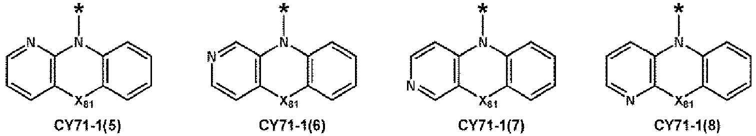

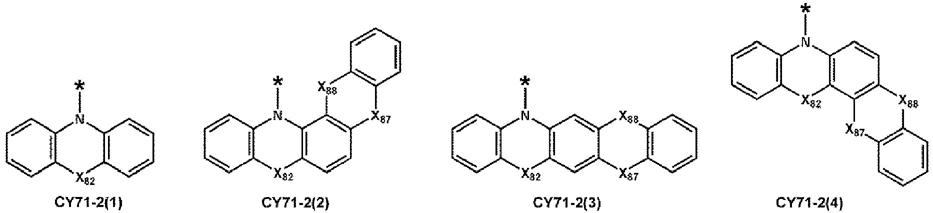

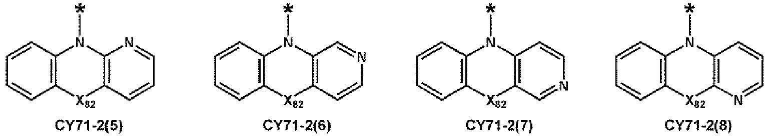

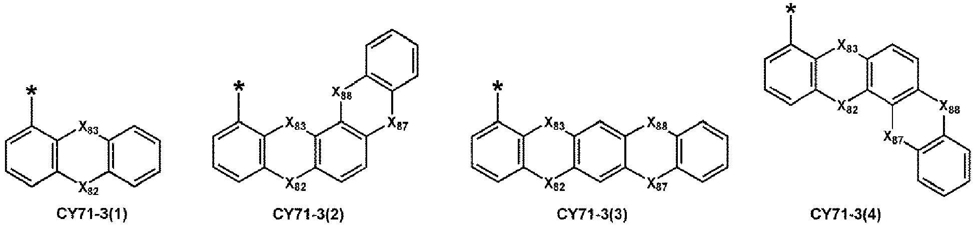

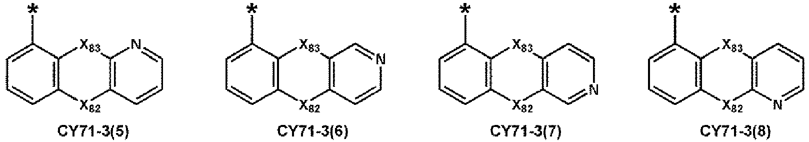

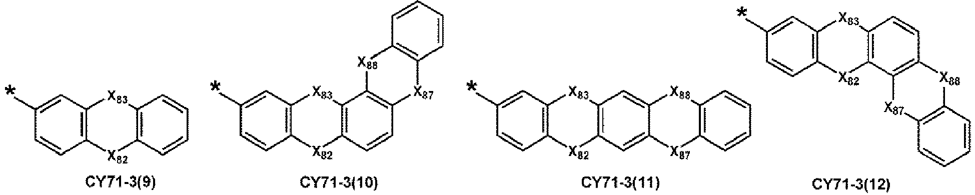

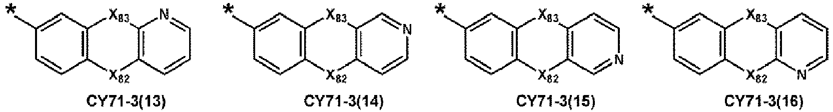

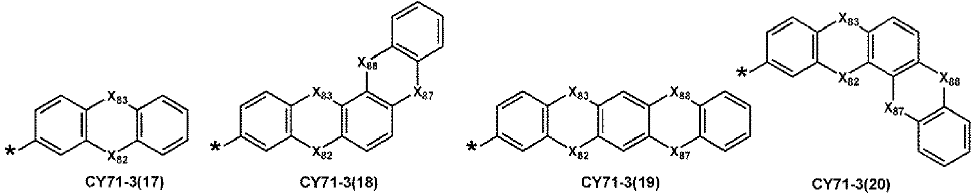

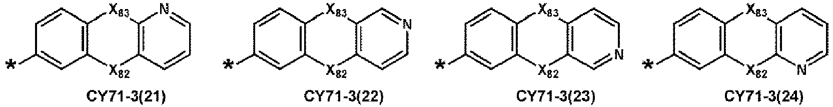

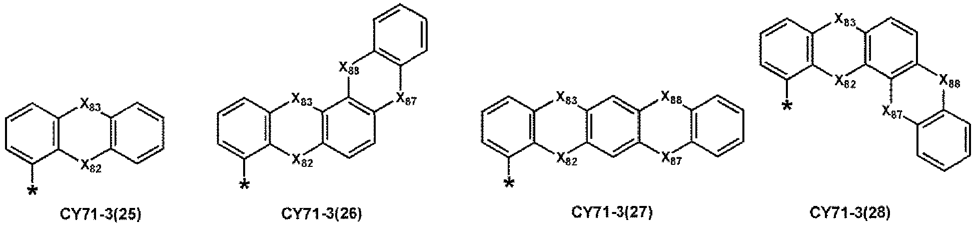

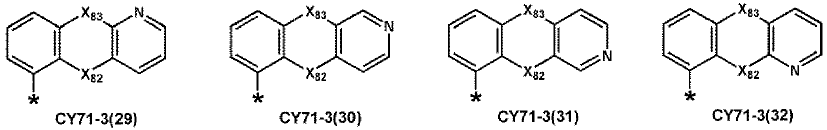

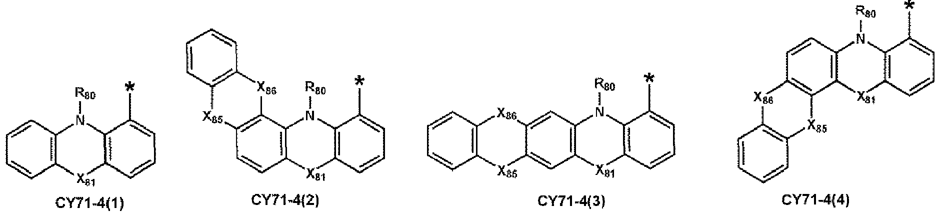

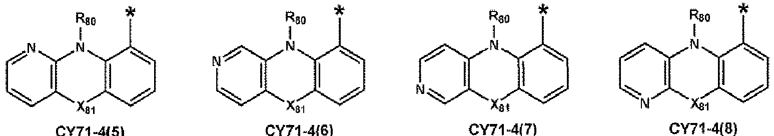

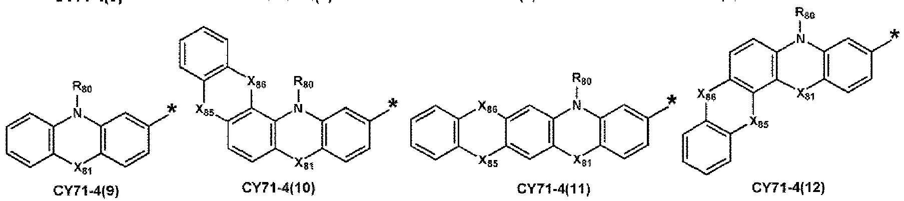

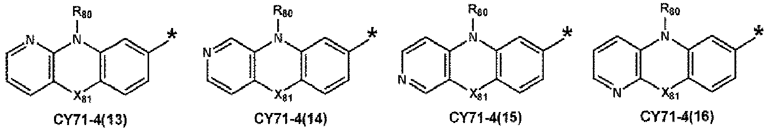

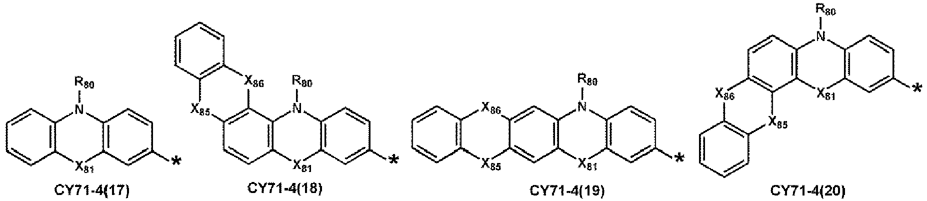

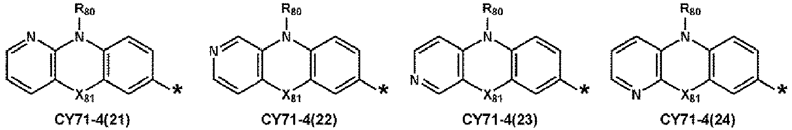

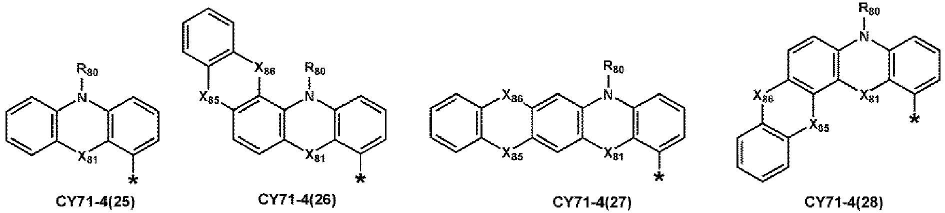

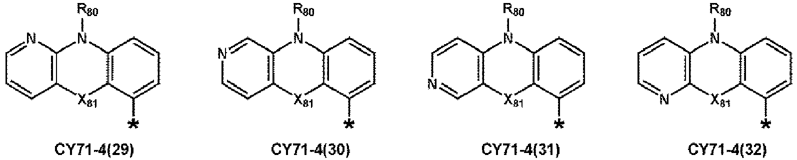

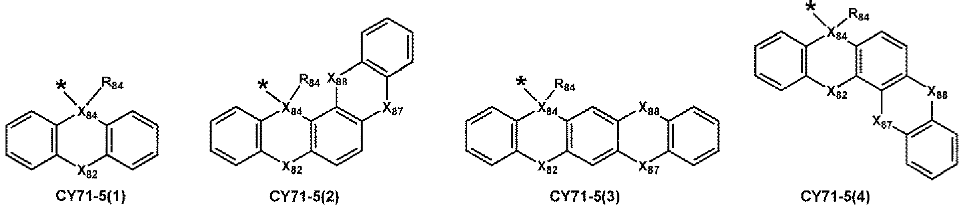

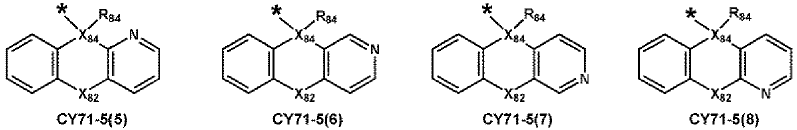

In Formulae CY71-1 (1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₄, R₈₀, and R₈₄ are each independently the same as described in the present specification,
X₈₅ is a single bond, O, S, N(R₈₅), B(R₈₅), C(R₈₅ₐ)(R_{85b}), or Si(R₈₅ₐ)(R_{85b}),
X₈₆ is a single bond, O, S, N(R₈₆), B(R₈₆), C(R₈₆ₐ)(R_{86b}), or Si(R₈₆ₐ)(R_{86b}),
in Formula CY71-1 (1) to CY71-1(8) and CY71-4(1) to CY71-4(32), X₈₅ and X₈₆ are each not a single bond at the same time (e.g., simultaneously),
X₈₇ is a single bond, O, S, N(R₈₇), B(R₈₇), C(R₈₇ₐ)(R_{87b}), or Si(R₈₇ₐ)(R_{87b}), and
X₈₈ is a single bond, O, S, N(R₈₈), B(R₈₈), C(R₈₈ₐ)(R_{88b}), or Si(R₈₈ₐ)(R_{88b}),
in Formulae CY71-2(1) to CY71-2(8), CY71-3(1) to CY71-3(32), and CY71-5(1) to CY71-5(8), X₈₇ and X₈₈ are each not a single bond at the same time (e.g., simultaneously), and
R₈₅ to R₈₈, R₈₅ₐ, R_{85b}, R₈₆ₐ, R_{86b}, R₈₇ₐ, R_{87b}, R₈₈ₐ, and R_{88b} are each independently the same as described in connection with R₈₁ in the present specification.

In one or more embodiments, the second compound may be selected from Comounds H2-1 to H2-80:

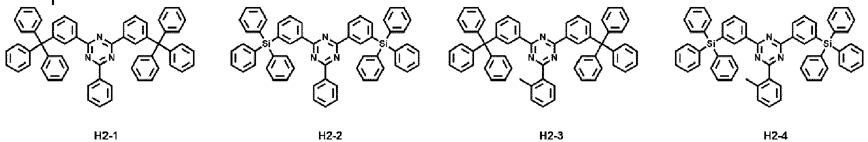

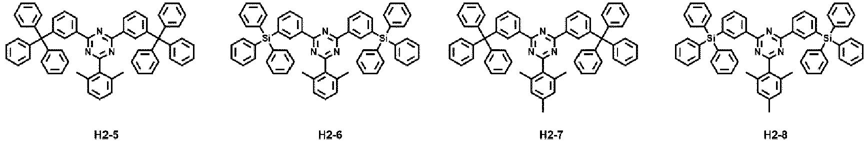

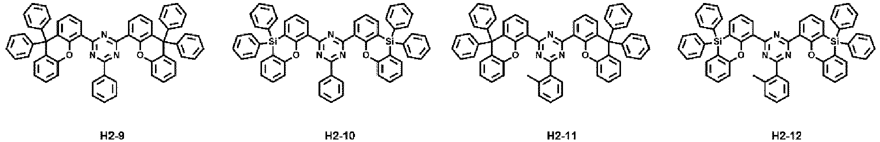

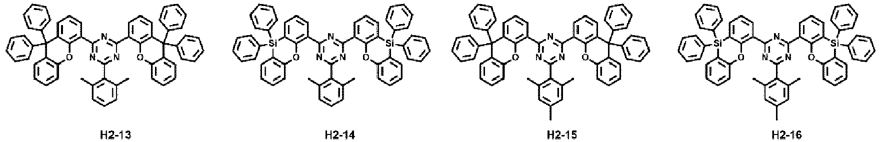

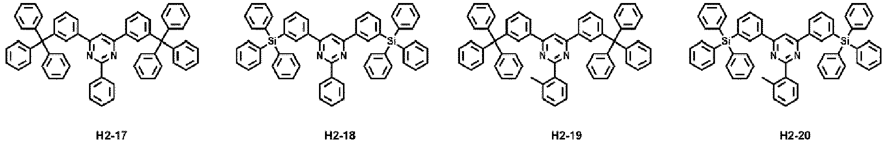

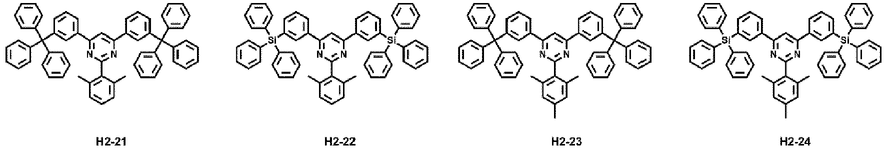

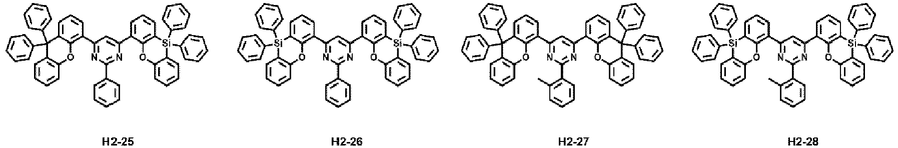

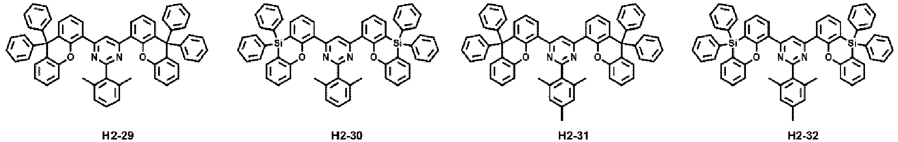

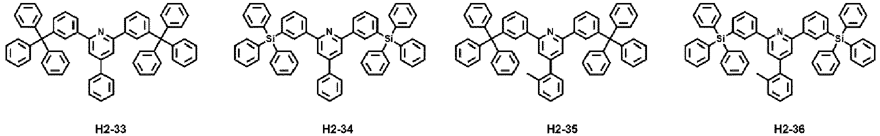

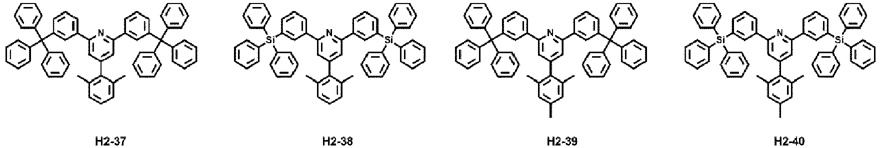

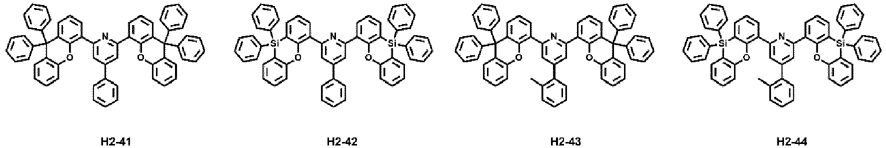

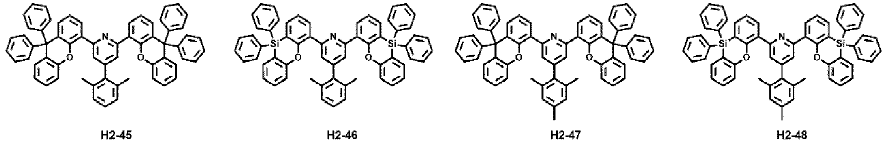

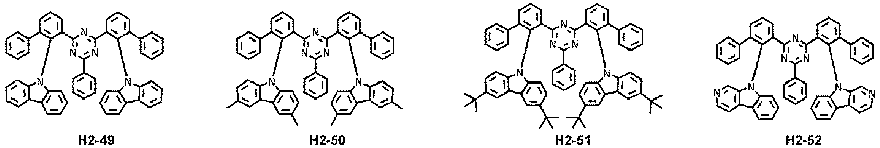

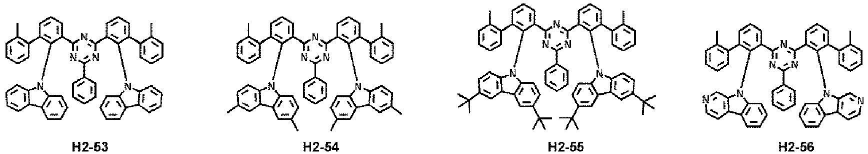

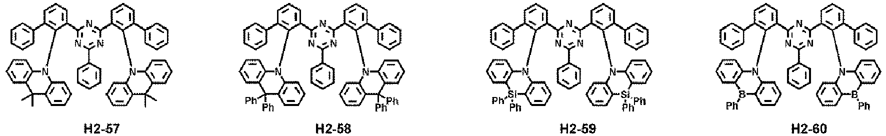

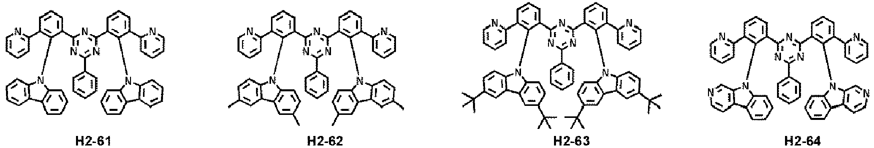

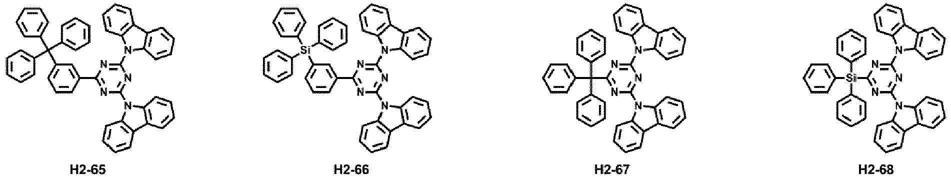

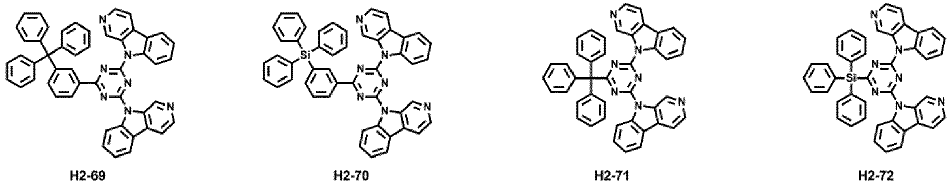

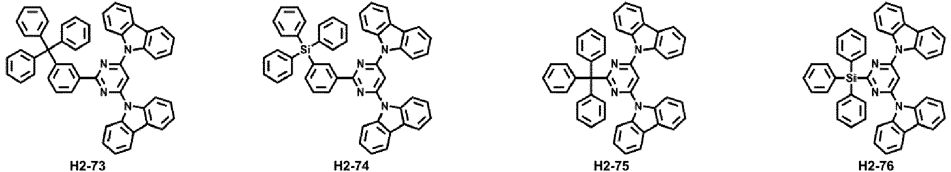

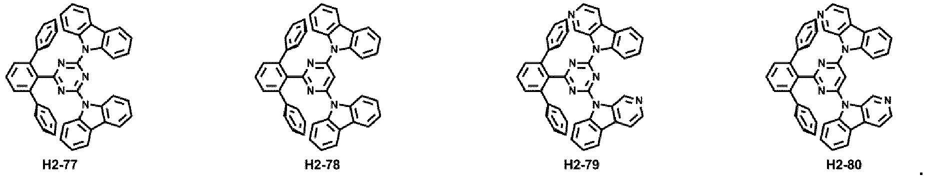

In one or more embodiments, the third compound may be selected from Compounds H3-1 to H3-28:

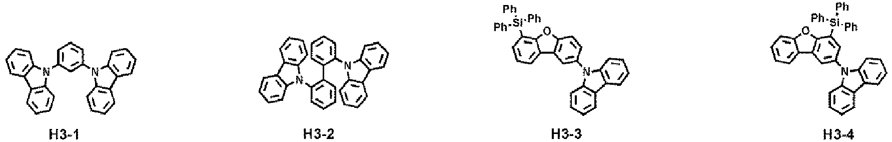

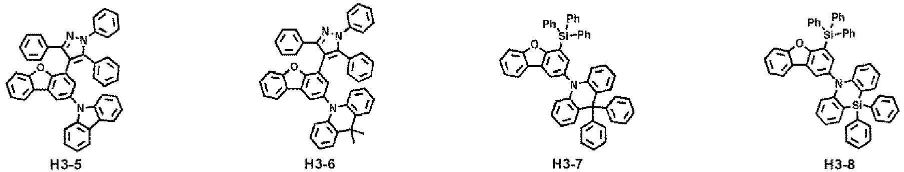

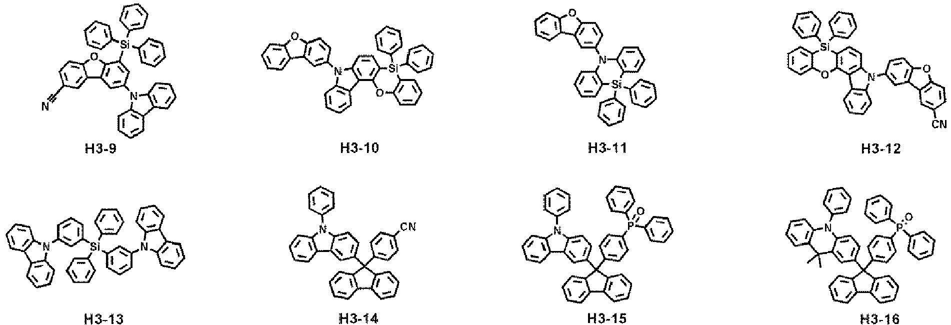

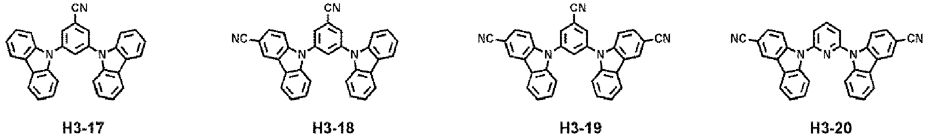

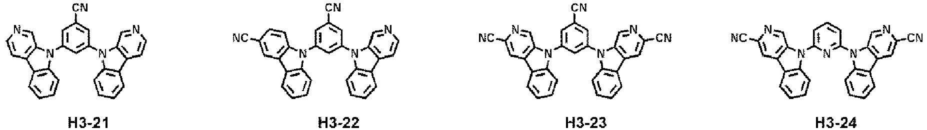

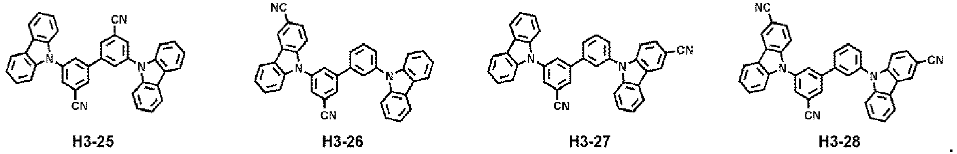

In one embodiment, the emission layer may have a maximum emission wavelength of 390 nm or more and 520 nm or less.

In one embodiment, the organic light-emitting device may satisfy one (e.g., at least one) of <Condition 1> to <Condition 4>:

### <Condition 1>

LUMO energy level (eV) of third compound > LUMO energy level (eV) of first compound

### <Condition 2>

LUMO energy level (eV) of first compound > LUMO energy level (eV) of second compound

### <Condition 3>

HOMO energy level (eV) of first compound > HOMO energy level (eV) of third compound

### <Condition 4>

HOMO energy level (eV) of third compound > HOMO energy level (eV) of second compound

The HOMO energy level and the LUMO energy level for each of the first compound, the second compound, and the third compound may each be a negative value, and may be measured according to any suitable method, for example, the method described in Table A.

**Table A**

| | |
|---|---|
| HOMO energy level evaluation method | Cyclic voltammetry (CV) (electrolyte: 0.1 M Bu₄NPF₆ / solvent: dimethylformamide (DMF) / electrode: 3-electrode system (working electrode: GC, reference electrode: Ag/AgCl, auxiliary electrode: Pt)) was used to obtain a voltage (V)-current (A) graph for each compound. Then, a HOMO energy level of each compound can be calculated from an oxidation onset of the graph. |
| LUMO energy level evaluation method | Cyclic voltammetry (CV) (electrolyte: 0.1 M Bu₄NPF₆ / solvent: dimethylformamide (DMF) / electrode: 3-electrode system (working electrode: GC, reference electrode: Ag/AgCl, auxiliary electrode: Pt)) was used to obtain a voltage (V)-current (A) graph for each compound. Then, a LUMO energy level of each compound can be calculated from a reduction onset of the graph. |

In one or more embodiments, an absolute value of the difference between the LUMO energy level of the first compound and the LUMO energy level of the second compound may be 0.1 eV or more and 1.0 eV or less, an absolute value of the difference between the LUMO energy level of the first compound and the LUMO energy level of the third compound may be 0.1 eV or more and 1.0 eV or less, an absolute value of the difference between the HOMO energy level of the first compound and the HOMO energy level of the second compound may be 1.25 eV or less (for example, 1.25 eV or less and 0.2 eV or more), or an absolute value of the difference between the HOMO energy level of the first compound and the HOMO energy level of the third compound may be 1.25 eV or less (for example, 1.25 eV or less and 0.2 eV or more).

When the relationships between LUMO energy level and HOMO energy level satisfy the conditions as described above, the balance between holes and electrons injected into the emission layer can be made.

The emission layer of the organic light-emitting device may include:
1) the first compound represented by Formula 1 (wherein Formula 1 includes a tetradentate ligand, and M₁ and M₂ in Formula 1 are each a transition metal (e.g. platinum (Pt) or palladium (Pd));
2) the second compound represented by Formula 2-1 or 2-2 (wherein, in Formulae 2-1 and 2-2, a bond between L₅₁ and ring CY₅₁, a bond between L₅₂ and ring CY₅₂, a bond between L₅₃ and ring CY₅₃, a bond between two or more L₅₁(s), a bond between two or more L₅₂(s), a bond between two or more L₅₃(s), a bond between L₅₁ and carbon between X₅₄ and X₅₅ in Formulae 2-1 and 2-2, a bond between L₅₂ and carbon between X₅₄ and X₅₆ in Formulae 2-1 and 2-2, and a bond between L₅₃ and carbon between X₅₅ and X₅₆ in Formulae 2-1 and 2-2 may each be a "carbon-carbon" single bond); and
3) the third compound, which is different from the compounds of Formulae 1, 2-1, and 2-2, and may include a group represented by Formula 3,
   and accordingly, an exciplex may be effectively formed from the second compound and the third compound, such that the organic light-emitting device may exhibit high luminescence efficiency and/or a long lifespan.

The decay time of delayed fluorescence in the time-resolved electroluminescence (TREL) spectrum of the organic light emitting device may be 50 ns or more, for example, 50 ns or more and 10 µs or less. In one embodiment, the decay time in the TREL spectrum of the organic light-emitting device may be 1.4 µs or more and 4 µs or less or 1.5 µs or more and 3 µs or less. When the decay time of the organic light-emitting device is satisfied within the ranges above, the time that the second compound remains in an excited state may be relatively reduced, so that the organic light-emitting device may have high luminescence efficiency and/or a long lifespan.

In one embodiment, the organic light-emitting device may have a non-resonant structure, and the electroluminescence (EL) spectrum of the organic light-emitting device may include a first peak and a second peak, wherein a maximum luminescence wavelength of the second peak may be greater than that of the first peak, a difference between the maximum luminescence wavelength of the second peak and the maximum luminescence wavelength of the first peak may be 5 nm or more and 10 nm or less, and an intensity of the second peak may be smaller than that of the first peak. When the difference between the maximum luminescence wavelength of the second peak and the maximum luminescence wavelength of the first peak is satisfied within the ranges above, the organic light-emitting device (for example, a blue organic light-emitting device) may have excellent color purity.

The maximum luminescence wavelength of the first peak may be 440 nm or more and 520 nm or less (for example, 460 nm or more and 520 nm or less). Accordingly, the organic light-emitting device may be to emit blue light (for example, dark blue light) with excellent color purity.

The first peak may be a luminescence peak corresponding to phosphorescence emitted from the first compound, and
the second peak may be a luminescence peak corresponding to an exciplex formed by the second compound and the third compound.

The intensity of the second peak may be 20% to 90% of the intensity of the first peak. When the intensity of the second peak and the intensity of the first peak are within the ranges above, the time that the second compound remains in an excited state may be efficiently controlled by the exciplex, which emits the light of the second peak, without reducing the luminescence efficiency of the phosphorescence emitted from the first compound. Accordingly, the organic light-emitting device may have high luminescence efficiency and/or a long lifespan.

One or more example embodiments of the present disclosure provide an organic light-emitting device including:
the first electrode,
the second electrode facing the first electrode; and
the emission layer between the first electrode and the second electrode,
wherein the emission layer includes the first compound, the second compound, and the third compound,
the first compound, the second compound, and the third compound are different from each other,
the amount of the first compound is smaller than the total amount of the second compound and the third compound,
the first compound is an organometallic compound,
the second compound includes at least one group selected from a pyridine group, a pyrimidine group, a pyridazine group, a pyrazine group, a triazine group, and a tetrazine group,
the second compound and the third compound form an exciplex, and
the decay time of delayed fluorescence in the TREL spectrum of the organic light-emitting device is 50 ns or more (for example, 50 ns or more and 10 µs or less, for example, 1.4 µs or more and 4 µs or less, or 1.5 µs or more and 3 µs or less). When the decay time of the organic light-emitting device is satisfied within the ranges above, the time that the second compound remains in an excited state is relatively reduced, such that the organic light-emitting device may have high luminescence efficiency and/or a long lifespan.

In the organic light-emitting device, the first compound is an organometallic compound including a tetradentate ligand and Pt or Pd as a central metal. For example, the first compound may be a bimetallic organometallic compound in which each metal center is tetradentately bonded to a multi-dentate shared ligand.

The first compound, the second compound, and the third compound may each independently be the same as described above.

One or more example embodiments of the present disclosure provide an electronic apparatus including the organic light-emitting device. The electronic apparatus may further include a thin-film transistor. For example, the electronic apparatus may further include a thin-film transistor including a source electrode and a drain electrode, wherein the first electrode of the organic light-emitting device is electrically connected to the source electrode or the drain electrode.

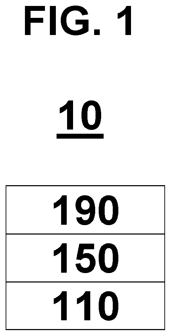

### Description of FIG. 1

FIG. 1 is a schematic cross-sectional view of an organic light-emitting device 10 according to an embodiment. The organic light-emitting device 10 includes a first electrode 110, an organic layer 150, and a second electrode 190.

Hereinafter, the structure of the organic light-emitting device 10 according to an embodiment and a method of manufacturing the organic light-emitting device 10 will be described in connection with FIG. 1.

### First electrode 110

In FIG. 1, a substrate may be additionally located under the first electrode 110 and/or above the second electrode 190. The substrate may be a glass substrate and/or a plastic substrate, each having excellent mechanical strength, thermal stability, transparency, surface smoothness, ease of handling, and/or water resistance.

The first electrode 110 may be formed by, for example, depositing or sputtering a material for forming the first electrode 110 on the substrate. When the first electrode 110 is an anode, the material for forming the first electrode 110 may be selected from materials with a high work function to facilitate hole injection.

The first electrode 110 may be a reflective electrode, a semi-transmissive electrode, or a transmissive electrode. When the first electrode 110 is a transmissive electrode, the material for forming the first electrode 110 may be selected from indium tin oxide (ITO), indium zinc oxide (IZO), tin oxide (SnO₂), zinc oxide (ZnO), and combinations thereof, but embodiments of the present disclosure are not limited thereto. In one or more embodiments, when the first electrode 110 is a semi-transmissive electrode or a reflective electrode, the material for forming the first electrode 110 may be selected from magnesium (Mg), silver (Ag), aluminium (Al), aluminium-lithium (Al-Li), calcium (Ca), magnesium-indium (Mg-In), magnesium-silver (Mg-Ag), and combinations thereof, but embodiments of the present disclosure are not limited thereto.

The first electrode 110 may have a single-layered structure or a multi-layered structure including two or more layers. For example, the first electrode 110 may have a three-layered structure of ITO/Ag/ITO, but the structure of the first electrode 110 is not limited thereto.

### Organic layer 150

The organic layer 150 is located on the first electrode 110. The organic layer 150 may include an emission layer.

The organic layer 150 may further include a hole transport region between the first electrode 110 and the emission layer, and an electron transport region between the emission layer and the second electrode 190.

### Hole transport region in organic layer 150

The hole transport region may have i) a single-layered structure including a single material, ii) a single-layered structure including a plurality of different materials, or iii) a multi-layered structure having a plurality of layers including a plurality of different materials.

The hole transport region may include at least one layer selected from a hole injection layer, a hole transport layer, an emission auxiliary layer, and an electron blocking layer.

For example, the hole transport region may have a single-layered structure including a plurality of different materials, or a multi-layered structure including a hole injection layer/hole transport layer, a hole injection layer/hole transport layer/emission auxiliary layer, a hole injection layer/emission auxiliary layer, a hole transport layer/emission auxiliary layer, or a hole injection layer/hole transport layer/electron blocking layer, wherein the constituting layers of each structure are sequentially stacked from the first electrode 110 in this stated order, but the structure of the hole transport region is not limited thereto.

The hole transport region may include at least one selected from m-MTDATA, TDATA, 2-TNATA, NPB(NPD), β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylene dioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201, and a compound represented by Formula 202:

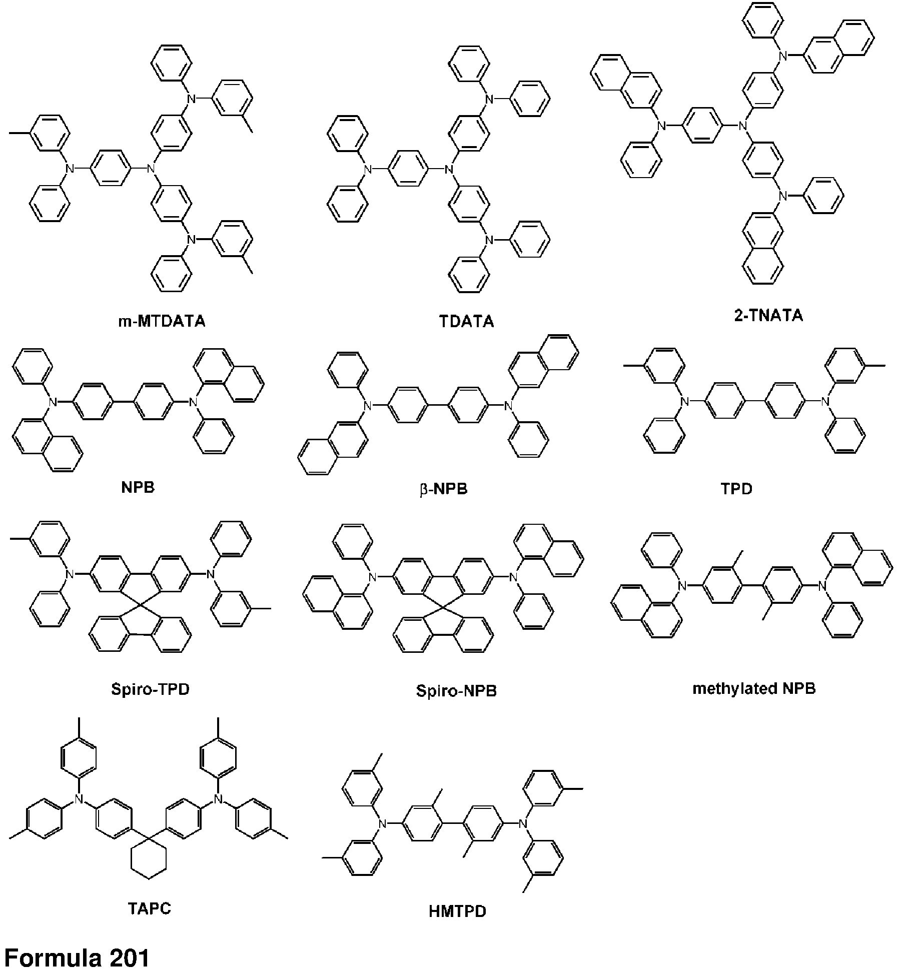

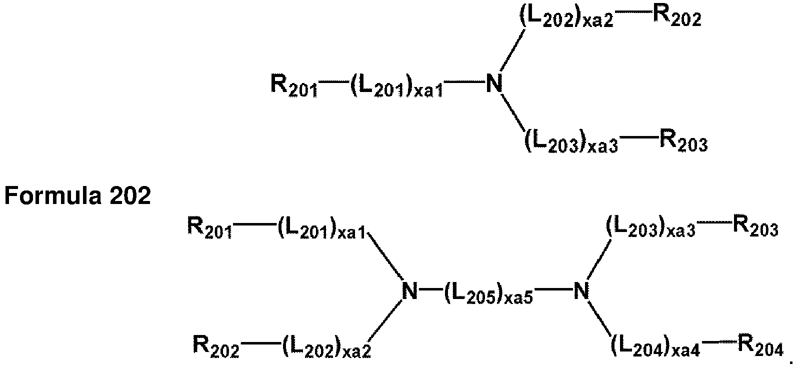

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (e.g. C₆-C₃₂) arylene group, a substituted or unsubstituted C₁-C₆₀ (e.g. C₁-C₂₀) heteroarylene group, a substituted or unsubstituted divalent non-aromatic condensed polycyclic group, and a substituted or unsubstituted divalent non-aromatic condensed heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₂) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 may each independently be an integer from 0 to 3,
xa5 may be an integer from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₂) aryl group, a substituted or unsubstituted C₆-C₆₀ (*e.g.* C₆-C₃₂) aryloxy group, a substituted or unsubstituted C₆-C₆₀ *(e.g.* C₆-C₃₂) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group.

For example, in Formula 202, R₂₀₁ and R₂₀₂ may optionally be linked to each other via a single bond, a dimethyl-methylene group, or a diphenyl-methylene group, and R₂₀₃ and R₂₀₄ may optionally be linked to each other via a single bond, a dimethyl-methylene group, or a diphenyl-methylene group.

In one embodiment, in Formulae 201 and 202,
L₂₀₁ to L₂₀₅ may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, R₂₀₁ to R₂₀₄ and Q₂₀₁ may each independently be selected from: a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ may each independently be the same as described above.

In one or more embodiments, at least one selected from R₂₀₁ to R₂₀₃ may each independently be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one or more embodiments, in Formula 202, i) R₂₀₁ and R₂₀₂ may be linked to each other via a single bond, and/or ii) R₂₀₃ and R₂₀₄ may be linked to each other via a single bond.

In one or more embodiments, at least one selected from R₂₀₁ to R₂₀₄ in Formula 202 may each independently be selected from:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one or more embodiments, the compound represented by Formula 201 may be represented by Formula 201A:

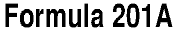

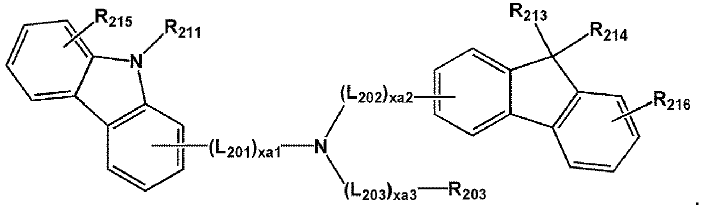

In one or more embodiments, the compound represented by Formula 201 may be represented by Formula 201A(1), but embodiments of the present disclosure are not limited thereto:

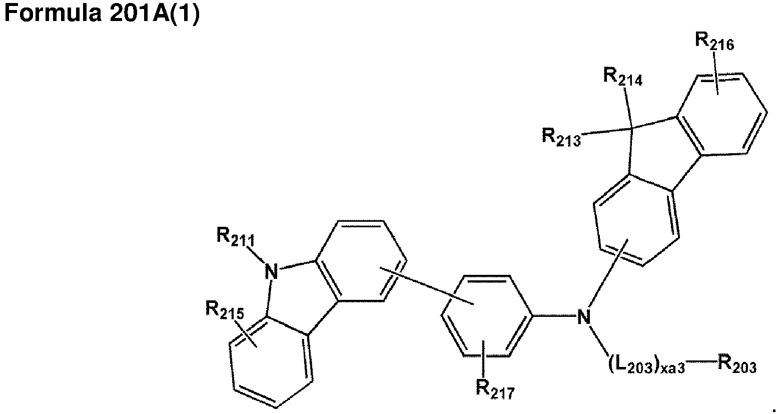

In one or more embodiments, the compound represented by Formula 201 may be represented by Formula 201A-1, but embodiments of the present disclosure are not limited thereto:

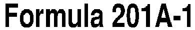

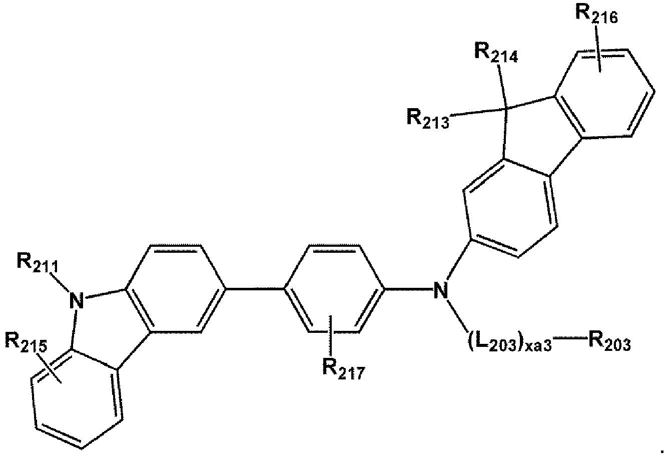

In one or more embodiments, the compound represented by Formula 202 may be represented by Formula 202A:

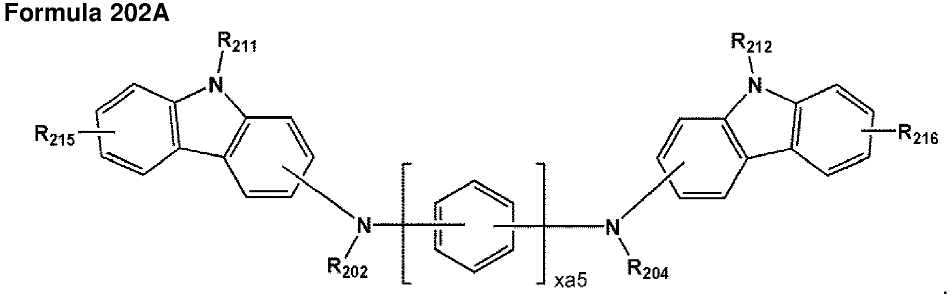

In one or more embodiments, the compound represented by Formula 202 may be represented by Formula 202A-1 :

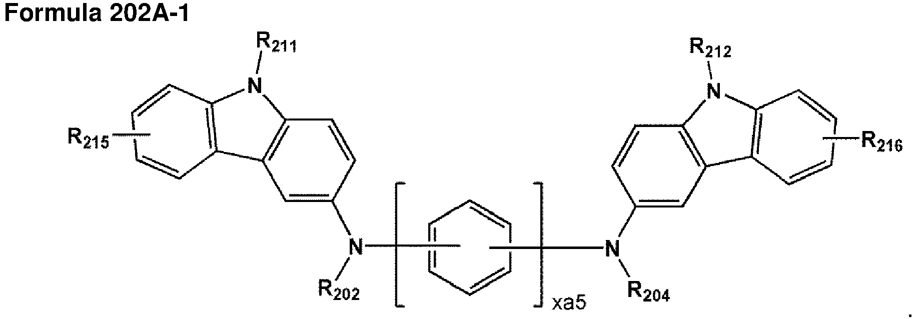

In Formulae 201A, 201A(1), 201A-1, 202A, and 202A-1,
L₂₀₁ to L₂₀₃, xa1 to xa3, xa5, and R₂₀₂ to R₂₀₄ may each independently be the same as described above,
R₂₁₁ and R₂₁₂ may each independently be the same as described in connection with R₂₀₃, and
R₂₁₃ to R₂₁₇ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from compounds HT1 to HT39, but compounds to be included in the hole transport region are not limited thereto:

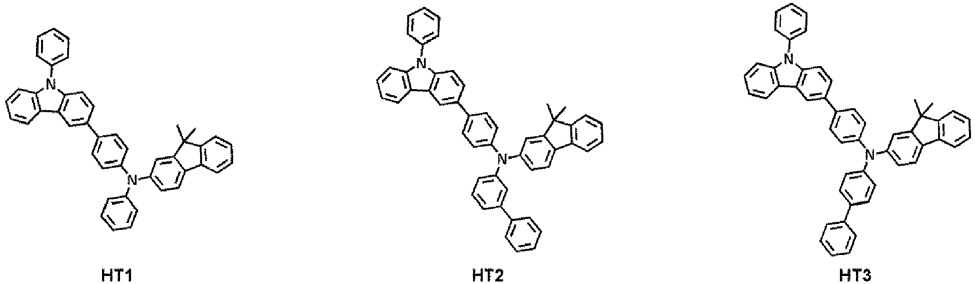

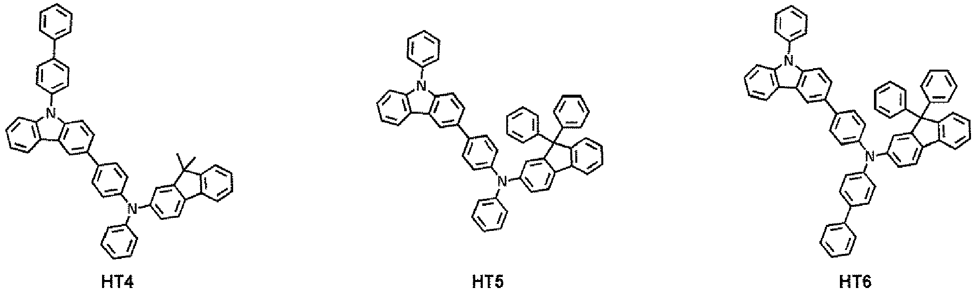

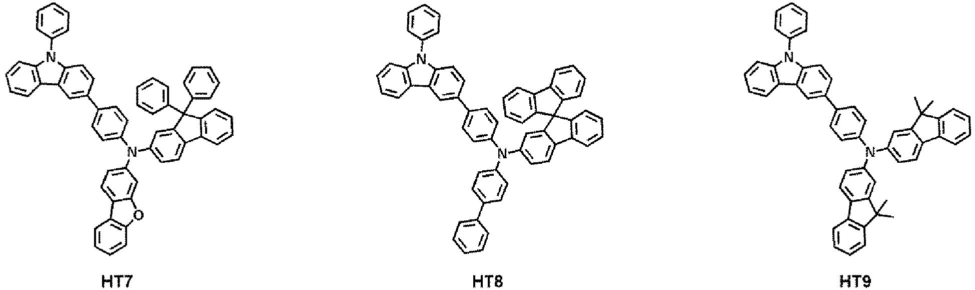

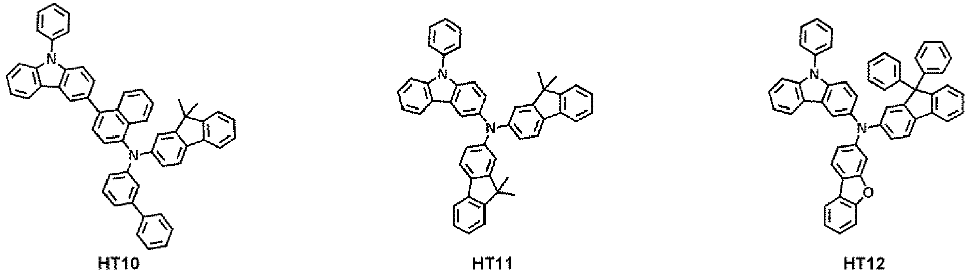

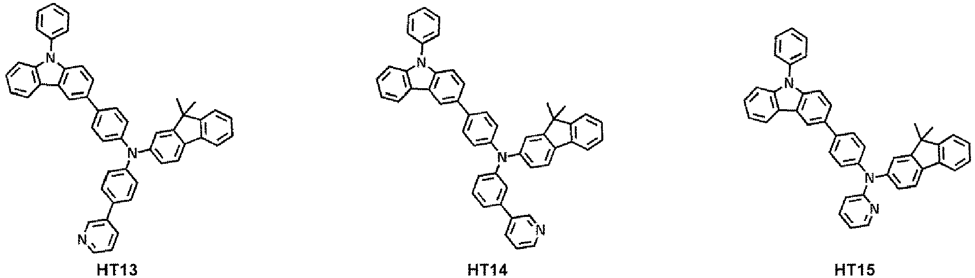

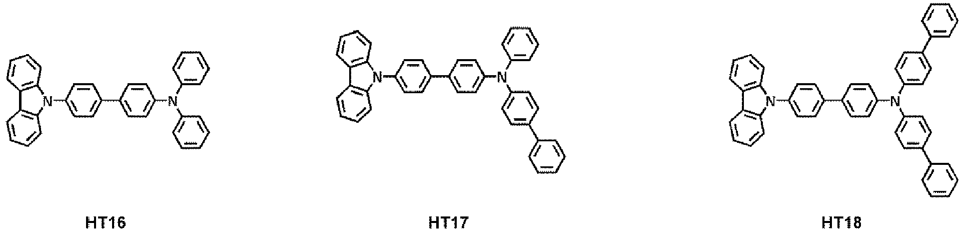

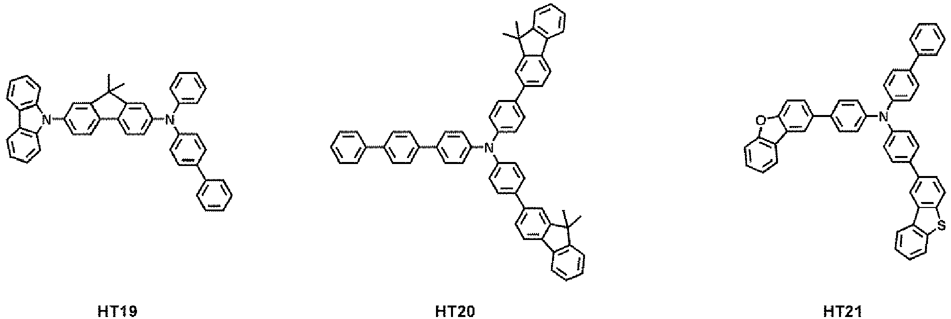

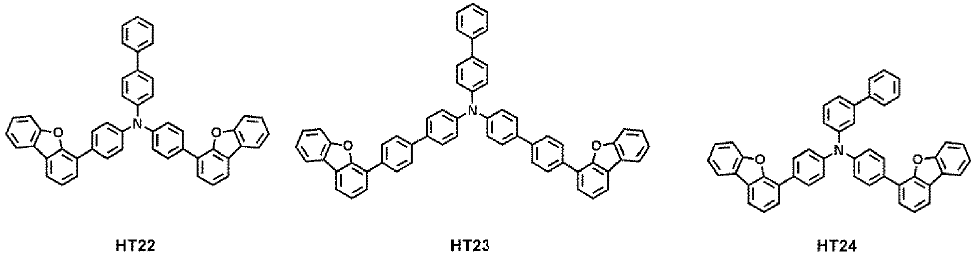

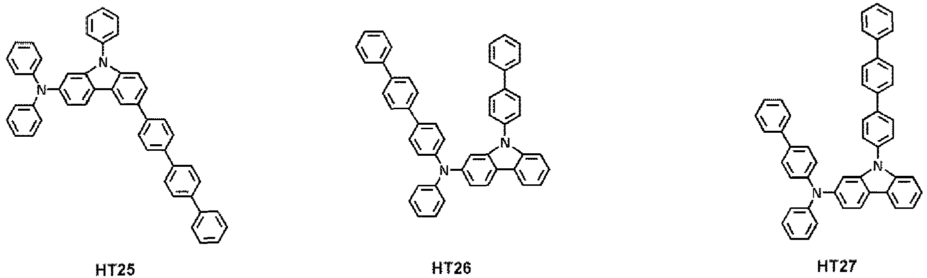

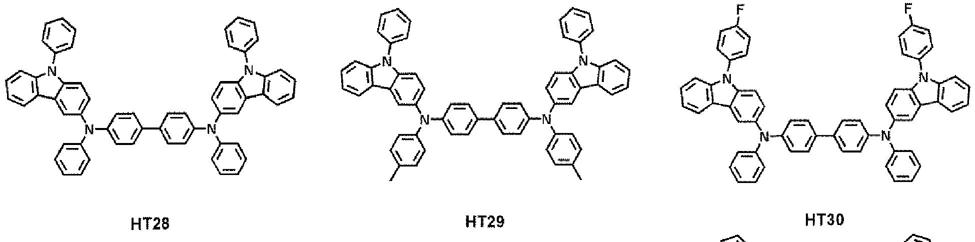

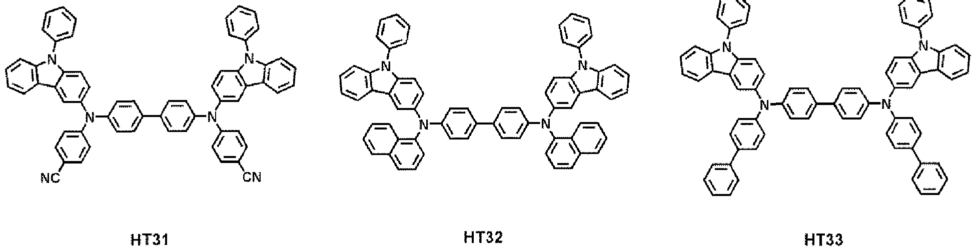

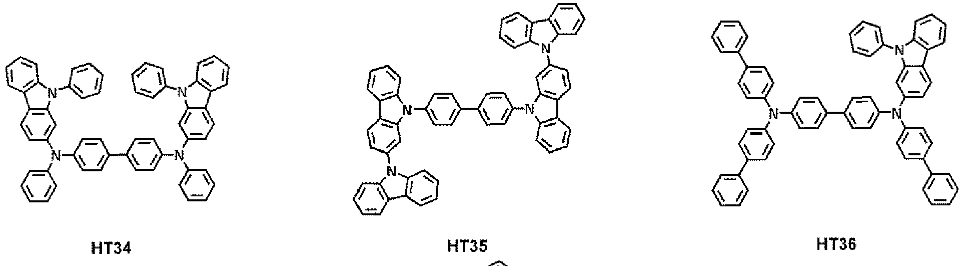

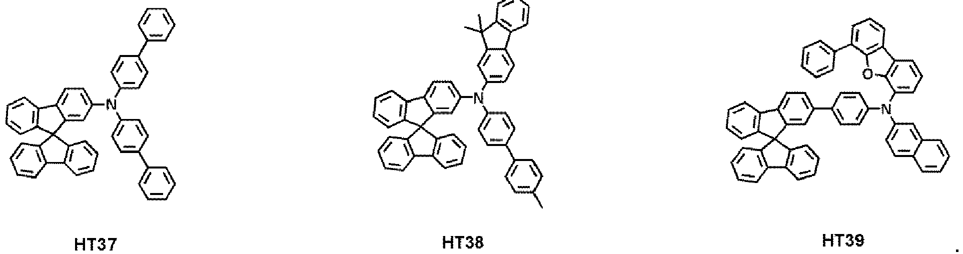

A thickness of the hole transport region may be about 100 Å to about 10,000 Å, for example, about 100 Å to about 7,000 Å, about 100 Å to about 5,000 Å, or about 100 Å to about 1,000 Å. When the hole transport region includes at least one selected from a hole injection layer and a hole transport layer, the thickness of the hole injection layer may be about 100 Å to about 9,000 Å, for example, about 100 Å to about 7,000 Å, about 100 Å to about 5,000 Å, about 100 Å to about 3,000 Å, about 100 Å to about 2,000 Å, about 100 Å to about 1,000 Å or about 500 Å to about 700 Å, and the thickness of the hole transport layer may be about 50 Å to about 2,000 Å, for example, about 100 Å to about 1,500 Å or about 200 Å to about 400 Å. When the thicknesses of the hole transport region, the hole injection layer and the hole transport layer are within these ranges, satisfactory hole transporting characteristics may be obtained without a substantial increase in driving voltage.

The emission auxiliary layer may increase the light-emission efficiency of the device by compensating for an optical resonance distance of the wavelength of light emitted by an emission layer, and the electron blocking layer may block the flow of electrons from an electron transport region. The emission auxiliary layer and the electron blocking layer may each include the materials described above.

### p-dopant

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant.

In one embodiment, the p-dopant may have a LUMO energy level of -3.5 eV or less.

The p-dopant may include at least one selected from a quinone derivative, a metal oxide, and a cyano group-containing compound, but embodiments of the present disclosure are not limited thereto.

In one embodiment, the p-dopant may include at least one selected from:
a quinone derivative (such as tetracyanoquinodimethane (TCNQ) and/or 2,3,5,6-tetrafluoro-7,7,8,8-tetracyanoquinodimethane (F4-TCNQ));
a metal oxide (such as tungsten oxide and/or molybdenum oxide);
1,4,5,8,9,12-hexaazatriphenylene-hexacarbonitrile (HAT-CN); and
a compound represented by Formula 221,
but embodiments of the present disclosure are not limited thereto:

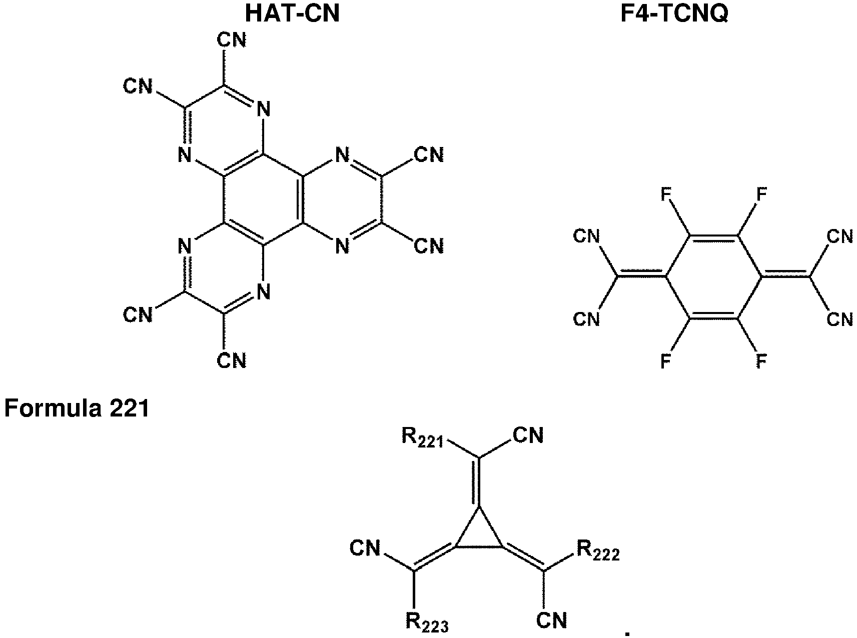

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₂) aryl group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group, and at least one selected from R₂₂₁ to R₂₂₃ may have at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Emission layer in organic layer 150

When the organic light-emitting device 10 is a full-color organic light-emitting device, the emission layer may be patterned into a red emission layer, a green emission layer, or a blue emission layer, according to a sub-pixel. In one or more embodiments, the emission layer may have a stacked structure of two or more layers selected from a red emission layer, a green emission layer, and a blue emission layer, where the two or more layers may contact each other or may be separated from each other. In one or more embodiments, the emission layer may include two or more materials selected from a red light-emitting material, a green light-emitting material, and a blue light-emitting material, in which the two or more materials are mixed with each other in a single layer to emit white light.

The emission layer may include a host and a dopant. The dopant may include at least one selected from a phosphorescent dopant and a fluorescent dopant. The phosphorescent dopant may be or include the organometallic compound represented by Formula 1.

An amount of the dopant in the emission layer may be about 0.01 parts by weight to about 15 parts by weight based on 100 parts by weight of the host, but embodiments of the present disclosure are not limited thereto.

A thickness of the emission layer may be about 100 Å to about 1,000 Å, for example, about 100 Å to about 800 Å, about 150 Å to about 800 Å, about 150 Å to about 700 Å, about 150 Å to about 650 Å, about 200 Å to about 600 Å or about 200 Å to about 400 Å. When the thickness of the emission layer is within this range, excellent light-emission characteristics may be obtained without a substantial increase in driving voltage.

### Host in emission layer

The host may be or include the second compound and the third compound.

In addition, the host may include a compound represented by Formula 301:

**Formula 301** [Ar₃₀₁]_{xb11}-[(L₃₀₁)_{xb1}-R₃₀₁]_{xb21}.

In Formula 301,
Ar₃₀₁ may be a substituted or unsubstituted C₅-C₃₀ carbocyclic group or a substituted or unsubstituted C₁-C₃₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xb1 may be an integer from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and - P(=O)(Q₃₀₁)(Q₃₀₂),
xb21 may be an integer from 1 to 5, and
Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

For example, Arsoi may be a substituted or unsubstituted C₅-C₃₀ carbocyclic group or a substituted or unsubstituted C₁-C₁₂ heterocyclic group, but embodiments are not limited thereto.

In one embodiment, Arsoi in Formula 301 may be selected from:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.
When xb11 in Formula 301 is two or more, the two or more Arsoi(s) may be linked via a single bond.

In one or more embodiments, the compound represented by Formula 301 may be represented by one of Formulae 301-1 and 301-2:

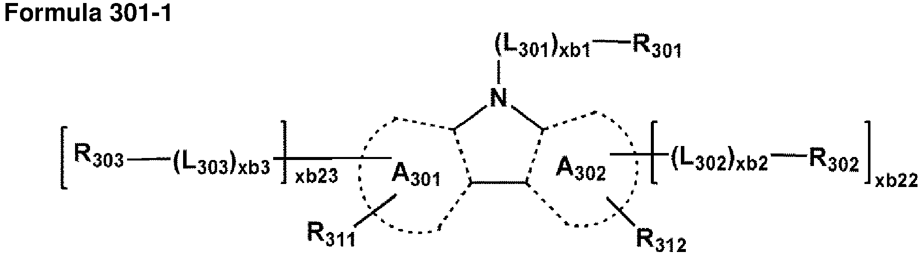

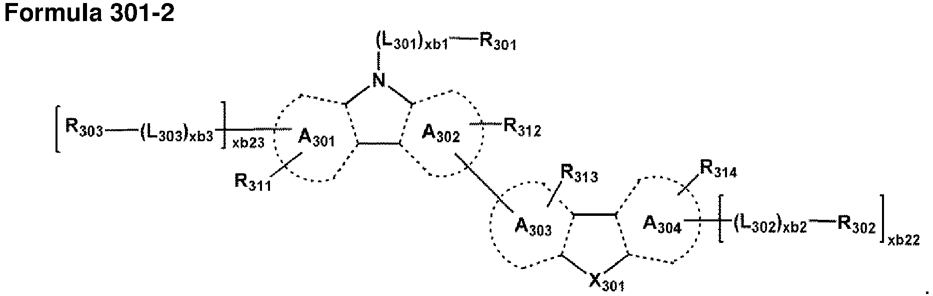

In Formulae 301-1 and 301-2,
A₃₀₁ to A₃₀₄ may each independently be selected from a benzene ring, a naphthalene ring, a phenanthrene ring, a fluoranthene ring, a triphenylene ring, a pyrene ring, a chrysene ring, a pyridine ring, a pyrimidine ring, an indene ring, a fluorene ring, a spiro-bifluorene ring, a benzofluorene ring, a dibenzofluorene ring, an indole ring, a carbazole ring, a benzocarbazole ring, a dibenzocarbazole ring, a furan ring, a benzofuran ring, a dibenzofuran ring, a naphthofuran ring, a benzonaphthofuran ring, a dinaphthofuran ring, a thiophene ring, a benzothiophene ring, a dibenzothiophene ring, a naphthothiophene ring, a benzonaphthothiophene ring, and a dinaphthothiophene ring,
X₃₀₁ may be O, S, or N-[(L₃₀₄)_{xb4}-R₃₀₄],
R₃₁₁ to R₃₁₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
xb22 and xb23 may each independently be 0, 1, or 2,
L₃₀₁, xb1, R₃₀₁, and Q₃₁ to Q₃₃ may each independently be the same as described above,
L₃₀₂ to L₃₀₄ may each independently be the same as described in connection with L₃₀₁,
xb2 to xb4 may each independently be the same as described in connection with xb1, and
R₃₀₂ to R₃₀₄ may each independently be the same as described in connection with R₃₀₁.

For example, L₃₀₁ to L₃₀₄ in Formulae 301, 301-1, and 301-2 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
Q₃₁ to Q₃₃ may each independently be the same as described above.

As another example, R₃₀₁ to R₃₀₄ in Formulae 301, 301-1, and 301-2 may each independently be selected from: deuterium, -F, -Cl, -Br, -I, a hydroxyl group, a cyano group, a nitro group, an amidino group, a hydrazino group, a hydrazono group, a substituted or unsubstituted C₁-C₆₀ (*e.g.* C₁-C₁₀) alkyl group, a substituted or unsubstituted C₂-C₆₀ (*e.g*. C₂-C₁₀) alkenyl group, a substituted or unsubstituted C₂-C₆₀ *(e.g.* C₂-C₁₀) alkynyl group, a substituted or unsubstituted C₁-C₆₀ *(e.g.* C₁-C₁₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), - B(Q₃₀₁)(Q₃₀₂), -C(=O)(Q₃₀₁), -S(=O)₂(Q₃₀₁), and -P(=O)(Q₃₀₁)(Q₃₀₂), but embodiments are not limited thereto.

In one embodiment, R₃₀₁ to R₃₀₄ in Formulae 301, 301-1, and 301-2 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
Q₃₁ to Q₃₃ may each independently be the same as described above.

In one or more embodiments, the host may include an alkaline earth metal complex. For example, the host may include a complex selected from a Be complex (for example, Compound H55), a Mg complex, and a Zn complex. For example, the host may be selected from a Be complex (for example, Compound H55) and an Mg complex. In some embodiments, the host may be or include a Zn complex.

The host may include at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and at least one selected from Compounds H1 to H55, but embodiments of the present disclosure are not limited thereto:

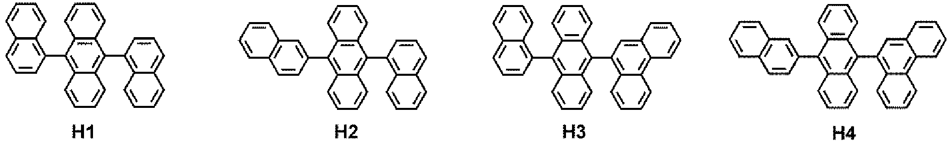

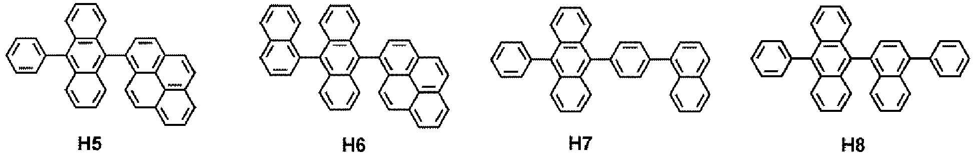

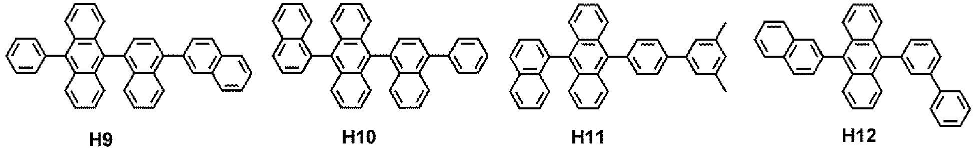

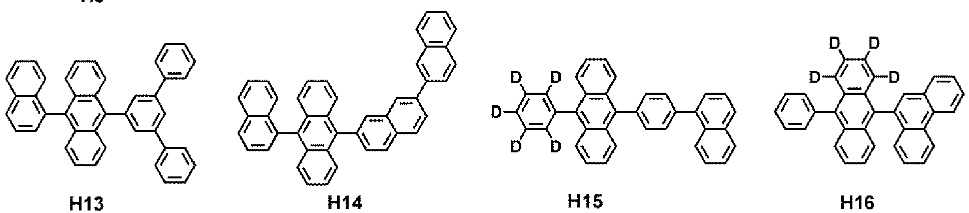

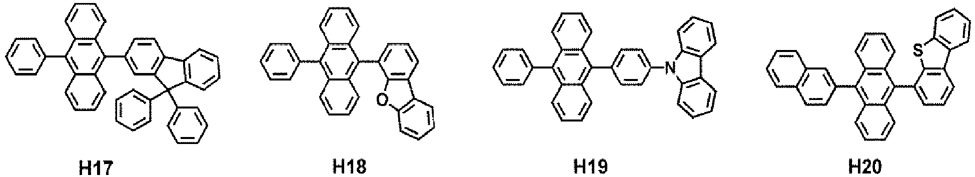

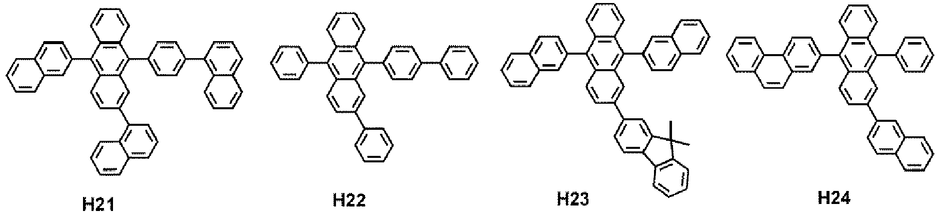

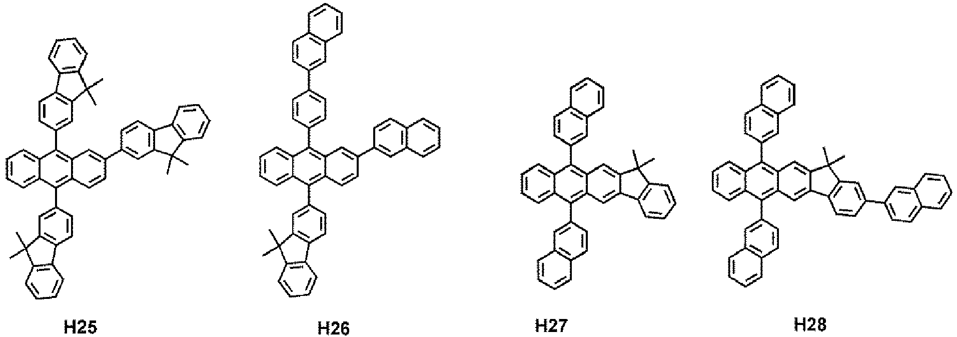

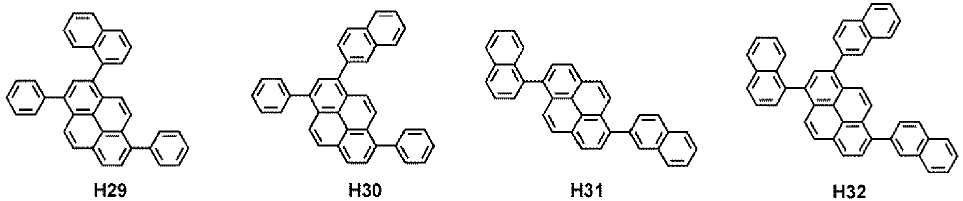

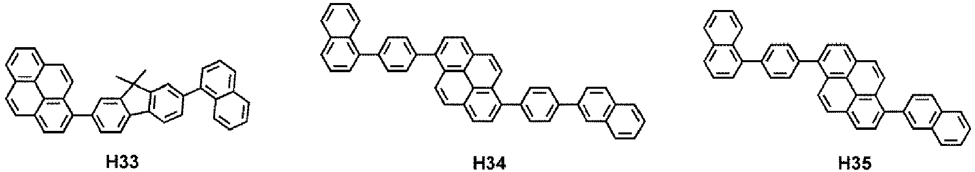

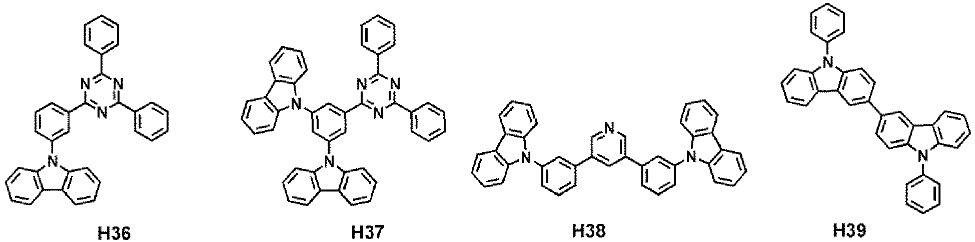

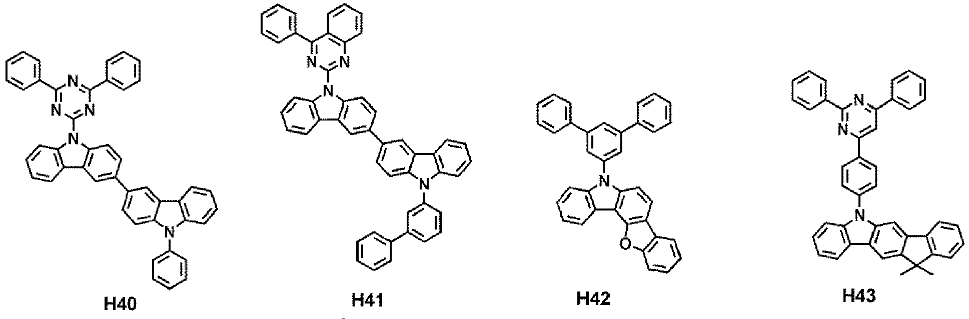

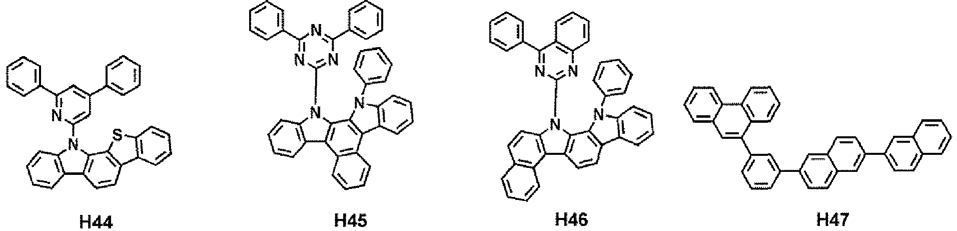

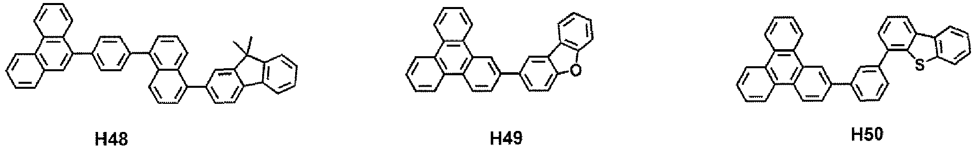

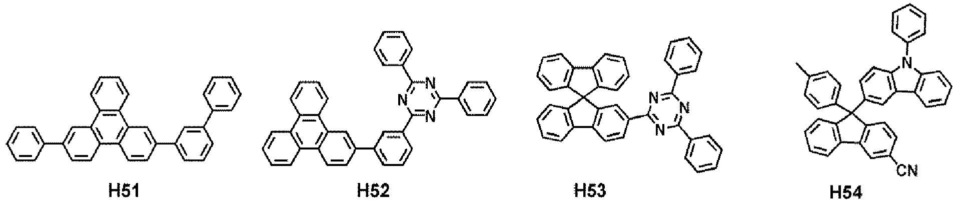

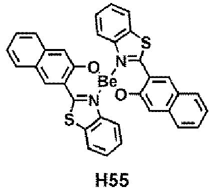

In one embodiment, the host may include at least one selected from a silicon-containing compound (for example, BCPDS and/or the like) and a phosphine oxide-containing compound (for example, POPCPA and/or the like).

The host may include only one compound, or may include two or more compounds that are different from each other. However, embodiments of the present disclosure are not limited thereto, and the host may instead have various other modifications.

### Phosphorescent dopant included in emission layer in organic layer 150

The phosphorescent dopant may include the organometallic compound represented by Formula 1:
In addition, the phosphorescent dopant may further include an organometallic complex represented by Formula 401:

**Formula 401** M(L₄₀₁)_{xc1}(L₄₀₂)_{xc2}

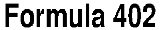

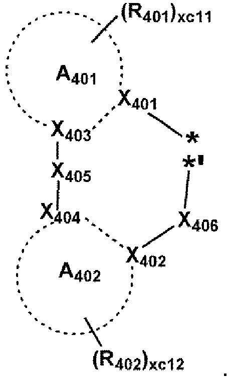

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
L₄₀₁ may be a ligand represented by Formula 402, and xc1 may be 1, 2, or 3, wherein, when xc1 is two or more, the two or more L₄₀₁(s) may be identical to or different from each other,
L₄₀₂ may be an organic ligand, and xc2 may be an integer from 0 to 4, wherein, when xc2 may be two or more, the two or more L₄₀₂(s) may be identical to or different from each other,
X₄₀₁ to X₄₀₄ may each independently be nitrogen or carbon,
X₄₀₁ and X₄₀₃ may be linked via a single bond or a double bond, and X₄₀₂ and X₄₀₄ may be linked via a single bond or a double bond,
A₄₀₁ and A₄₀₂ may each independently be a C₅-C₃₀ (*e.g.* C₅-C₂₀) carbocyclic group or a C₁-C₃₀ (*e.g.* C₁-C₂₀) heterocyclic group,
X₄₀₅ may be a single bond, *-O-*', *-S-*', *-C(=O)-*', *-N(Q₄₁₁)-*', *-C(Q₄₁₁)(Q₄₁₂)-*', *-C(Q411)=C(Q412)-*', *-C(Q411)=*' or *=C=*', wherein Q₄₁₁ and Q₄₁₂ may be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂), and Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer from 0 to 3, and
* and *' in Formula 402 each indicate a binding site to M in Formula 401.

In one embodiment, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen and X₄₀₂ may be carbon, or ii) X₄₀₁ and X₄₀₂ may each be nitrogen at the same time (e.g., simultaneously).

In one or more embodiments, R₄₀₁ and R₄₀₂ in Formula 402 may each independently be selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantyl group, a norbornanyl group, and a norbornenyl group;
a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), and -P(=O)(Q₄₀₁)(Q₄₀₂), and
Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, when xc1 in Formula 401 is two or more, two A₄₀₁(s) in the two or more L₄₀₁(s) may optionally be linked to each other via X₄₀₇, which is a linking group; and two A₄₀₂(s) may optionally be linked to each other via X₄₀₈, which is a linking group (see Compounds PD1 to PD4 and PD7). X₄₀₇ and X₄₀₈ may each independently be a single bond, *-O-*', *-S-*', *-C(=O)-*', *-N(Q₄₁₃)-*', *-C(Q₄₁₃)(Q₄₁₄)-*', or *-C(Q₄₁₃)=C(Q₄₁₄)-*' (where Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but embodiments of the present disclosure are not limited thereto.

L₄₀₂ in Formula 401 may be a monovalent, divalent, or trivalent organic ligand. For example, L₄₀₂ may be selected from halogen, diketone (for example, acetylacetonate), carboxylic acid (for example, picolinate), -C(=O), isonitrile, -CN, and a phosphorus-containing material (for example, phosphine and/or phosphite), but embodiments of the present disclosure are not limited thereto.

In one or more embodiments, the phosphorescent dopant may be selected from, for example, Compounds PD1 to PD25, but embodiments of the present disclosure are not limited thereto:

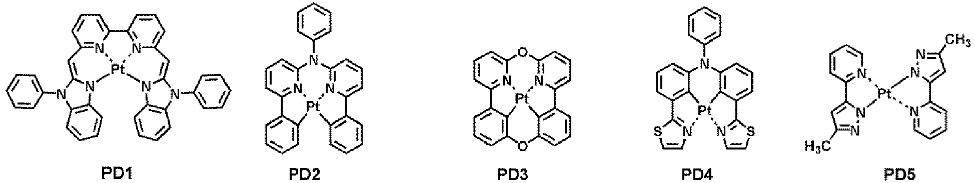

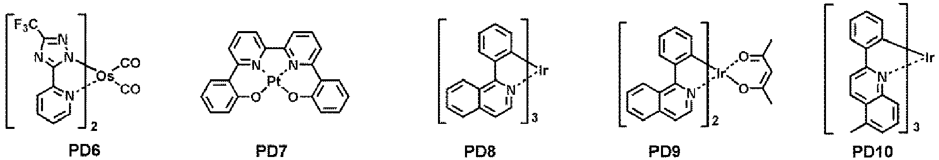

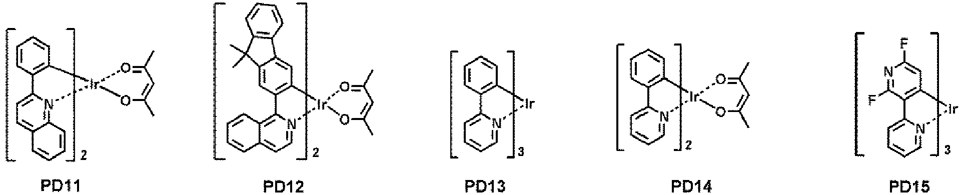

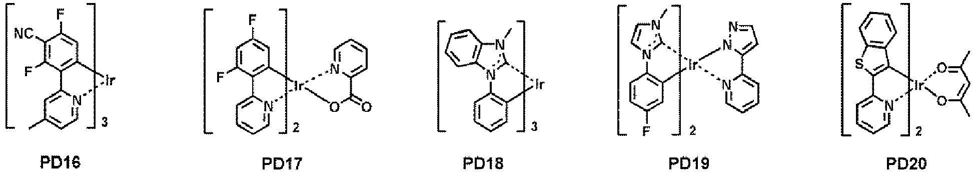

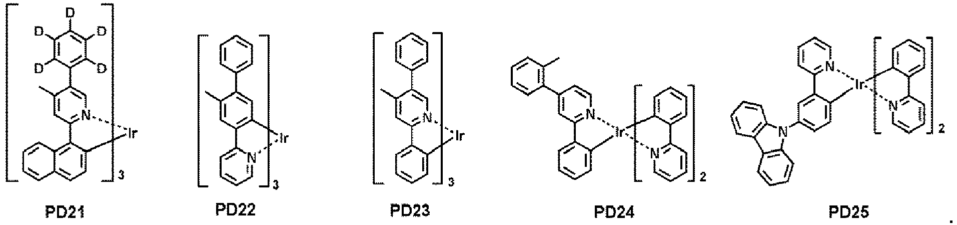

### Fluorescent dopant in emission layer

The fluorescent dopant may include an arylamine compound and/or a styrylamine compound.

The fluorescent dopant may include a compound represented by Formula 501:

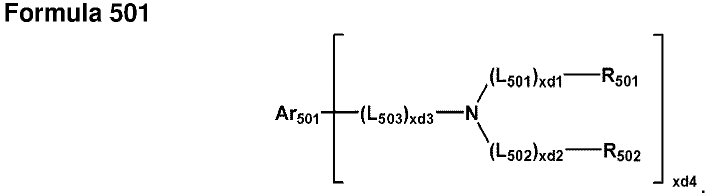

In Formula 501,
Ar₅₀₁ may be a substituted or unsubstituted C₅-C₃₀ carbocyclic group or a substituted or unsubstituted C₁-C₃₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₀) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, and
xd4 may be an integer from 1 to 6.

For example, Ar₅₀₁ may be a substituted or unsubstituted C₅-C₃₀ carbocyclic group or a substituted or unsubstituted C₁-C₂₀ heterocyclic group, but embodiments are not limited thereto.

In one embodiment, Ar₅₀₁ in Formula 501 may be selected from:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, L₅₀₁ to L₅₀₃ in Formula 501 may each independently be selected from:
a phenylene group, a naphthylene group, a fluorenylene group, a spirobifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spirobifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R₅₀₁ and R₅₀₂ in Formula 501 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

For example, the fluorescent dopant may be selected from Compounds FD1 to FD22:

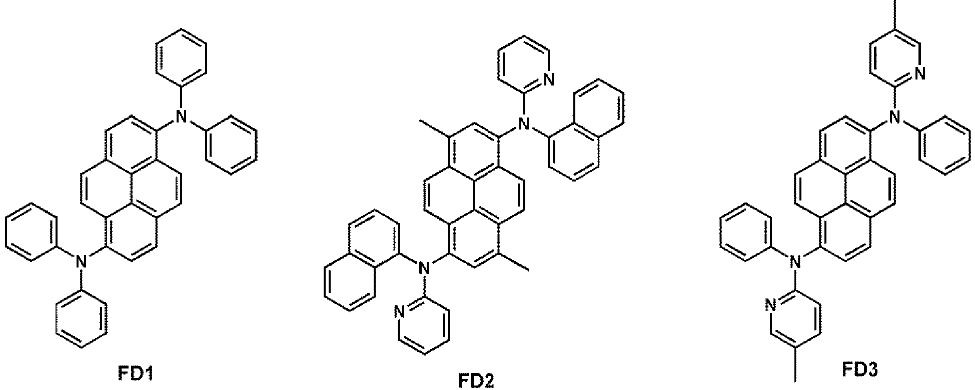

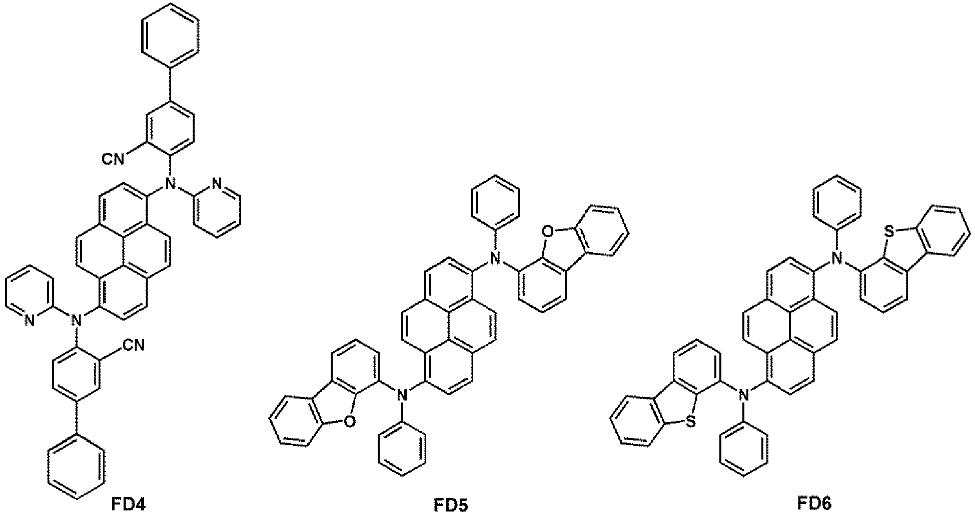

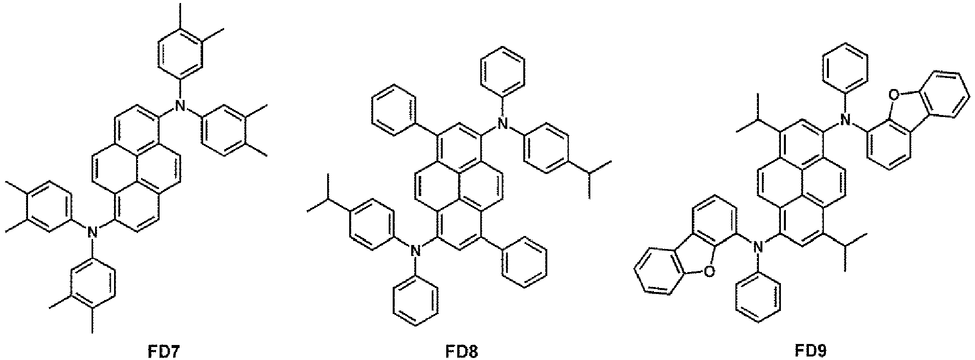

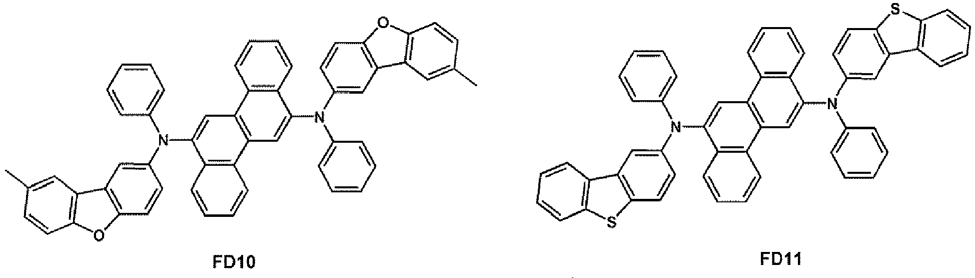

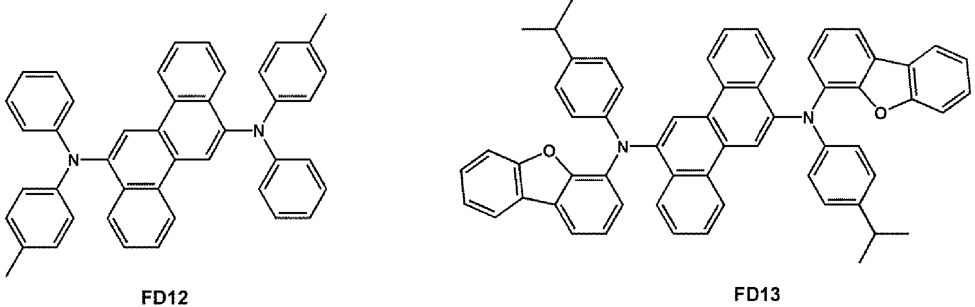

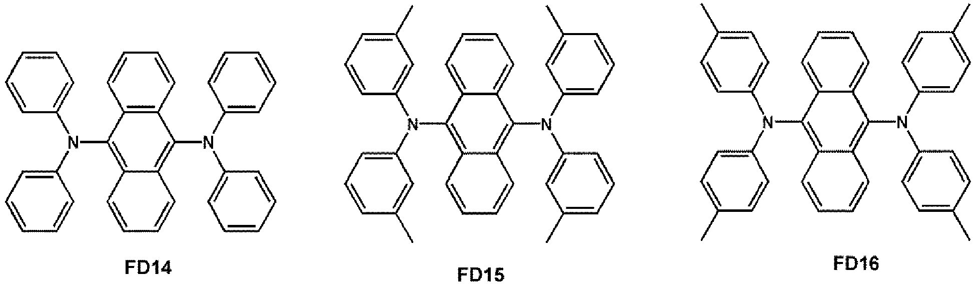

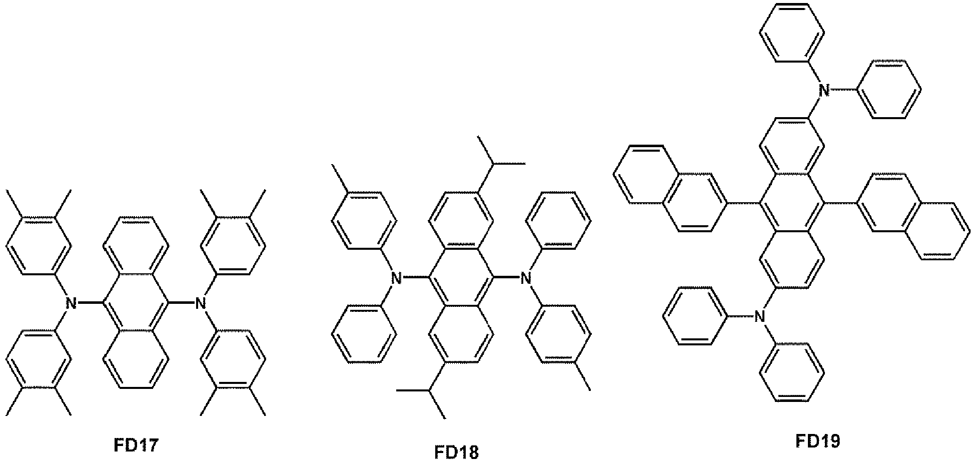

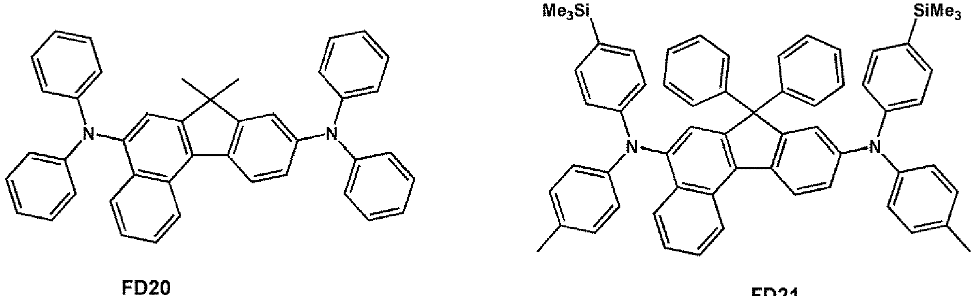

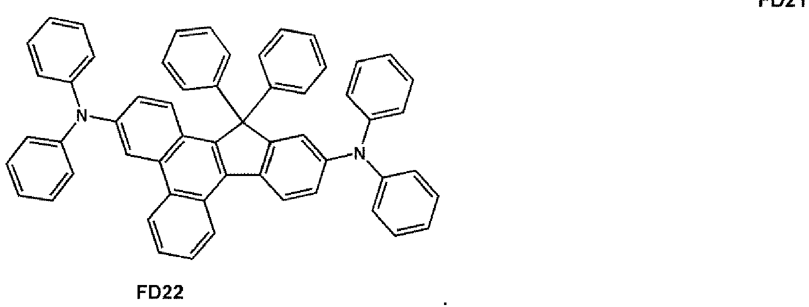

In one or more embodiments, the fluorescent dopant may be selected from the following compounds, but embodiments of the present disclosure are not limited thereto:

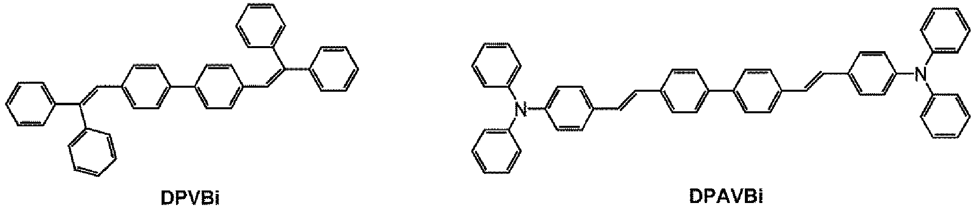

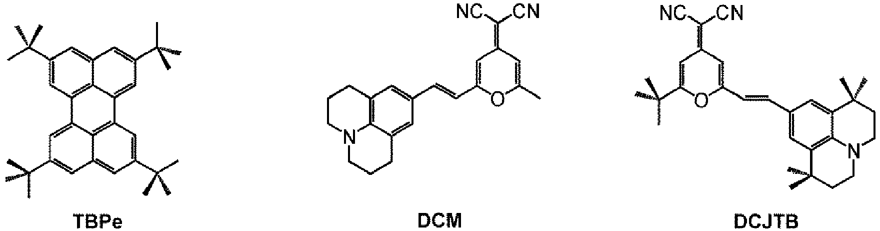

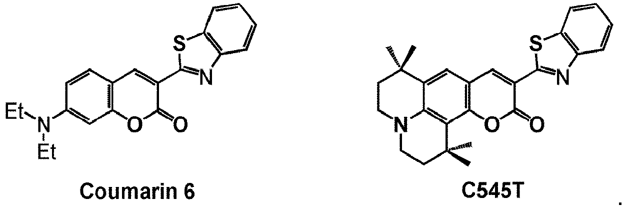

### Electron transport region in organic layer 150

The electron transport region may have i) a single-layered structure including a single material, ii) a single-layered structure including a plurality of different materials, or iii) a multi-layered structure having a plurality of layers including a plurality of different materials.

The electron transport region may include at least one selected from a buffer layer, a hole blocking layer, an electron control layer, an electron transport layer, and an electron injection layer, but embodiments of the present disclosure are not limited thereto.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein the constituting layers of each structure are sequentially stacked from an emission layer. However, embodiments of the structure of the electron transport region are not limited thereto.

The electron transport region (for example, a buffer layer, a hole blocking layer, an electron control layer, and/or an electron transport layer in the electron transport region) may include a metal-free compound containing at least one π electron-depleted nitrogen-containing ring.

The term "π electron-depleted nitrogen-containing ring" may refer to a C₁-C₃₀ (*e.g.* a C₁-C₂₀) heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups, each having at least one *-N=*' moiety, are condensed with each other, or iii) a heteropolycyclic group in which at least one 5-membered to 7-membered heteromonocyclic group, each having at least one *-N=*' moiety, is condensed with at least one C₅-C₃₀ (*e.g.* a C₅-C₂₀) carbocyclic group.

Non-limiting examples of the π electron-deficient nitrogen-containing ring include an imidazole ring, a pyrazole ring, a thiazole ring, an isothiazole ring, an oxazole ring, an isoxazole ring, a pyridine ring, a pyrazine ring, a pyrimidine ring, a pyridazine ring, an indazole ring, a purine ring, a quinoline ring, an isoquinoline ring, a benzoquinoline ring, a phthalazine ring, a naphthyridine ring, a quinoxaline ring, a quinazoline ring, a cinnoline ring, a phenanthridine ring, an acridine ring, a phenanthroline ring, a phenazine ring, a benzimidazole ring, an isobenzothiazole ring, a benzoxazole ring, an isobenzoxazole ring, a triazole ring, a tetrazole ring, an oxadiazole ring, a triazine ring, a thiadiazole ring, an imidazopyridine ring, an imidazopyrimidine ring, and an azacarbazole ring.

For example, the electron transport region may include a compound represented by Formula 601:

**Formula 601** [Ar₆₀₁]ₓₑ₁₁-[(L₆₀₁)ₓₑ₁-R₆₀₁]ₓₑ₂₁.

In Formula 601,
Ar₆₀₁ may be a substituted or unsubstituted C₅-C₃₀ carbocyclic group or a substituted or unsubstituted C₁-C₃₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 may be an integer from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer from 1 to 5.

In one embodiment, at least one of the xe11 Ar₆₀₁(s) and xe21 R₆₀₁(s) may include the π electron-deficient nitrogen-containing ring.

For example, Ar₆₀₁ may be a substituted or unsubstituted C₅-C₃₀ carbocyclic group or a substituted or unsubstituted C₁-C₂₀ heterocyclic group, but embodiments are not limited thereto.

In one embodiment, Ar₆₀₁ in Formula 601 may be selected from:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is two or more, two or more Ar₆₀₁(s) may be linked to each other via a single bond.

In one or more embodiments, Ar₆₀₁ in Formula 601 may be an anthracene group.

In one or more embodiments, the compound represented by Formula 601 may be represented by Formula 601-1 :

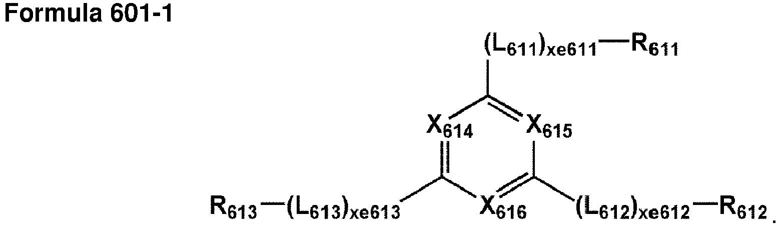

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁, and
R₆₁₄ to R₆₁₆ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For example, L₆₀₁ and L₆₁₁ to L₆₁₃ in Formulae 601 and 601-1 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

In one embodiment, L₆₀₁ and L₆₁₁ to L₆₁₃ in Formulae 601 and 601-1 may each independently be selected from:
a phenylene group, a naphthylene group, a fluorenylene group, a spirobifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spirobifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,
but embodiments of the present disclosure are not limited thereto.

In one or more embodiments, xe1 and xe611 to xe613 in Formulae 601 and 601-1 may each independently be 0, 1, or 2.

For example, R₆₀₁ and R₆₁₁ to R₆₁₃ in Formulae 601 and 601-1 may each independently be selected from: a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₆₁), and -P(=O)(Q₆₆₁)(Q₆₆₂).

In one or more embodiments, R₆₀₁ and R₆₁₁ to R₆₁₃ in Formulae 601 and 601-1 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂), and
Q₆₀₁ and Q₆₀₂ may each independently be the same as described above.

The electron transport region may include at least one compound selected from Compounds ET1 to ET36, but embodiments of the present disclosure are not limited thereto:

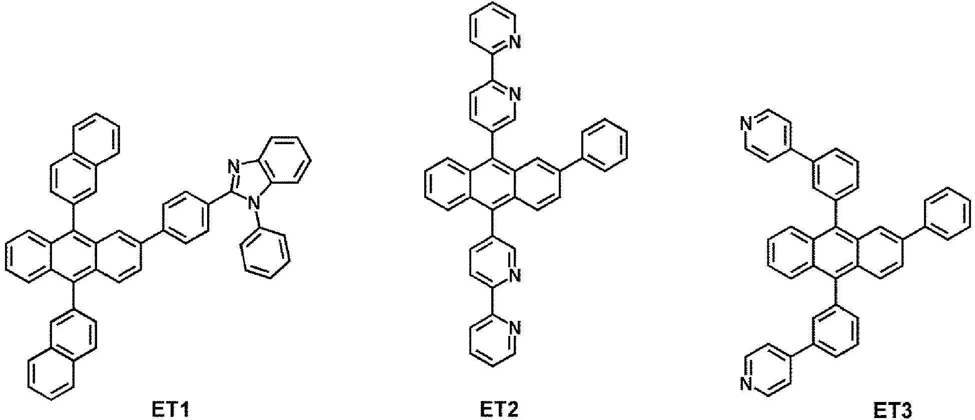

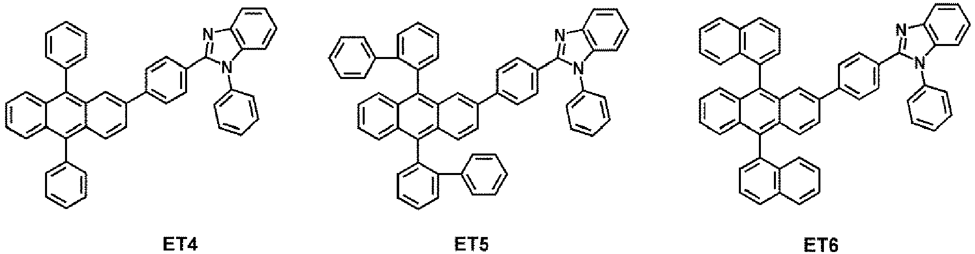

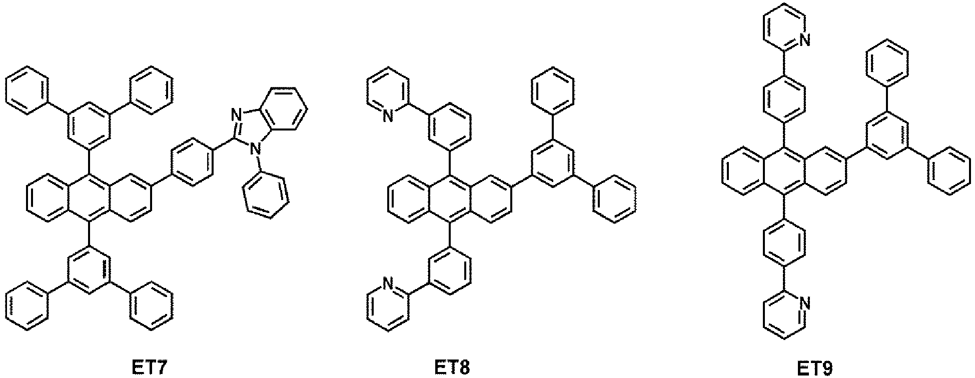

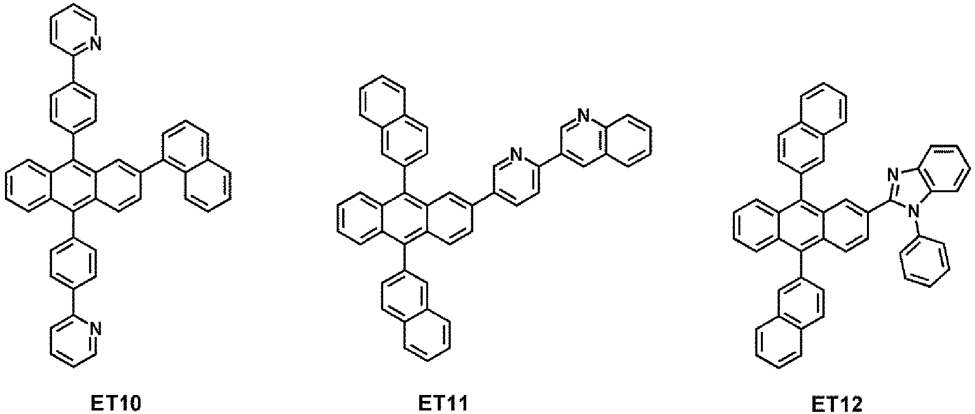

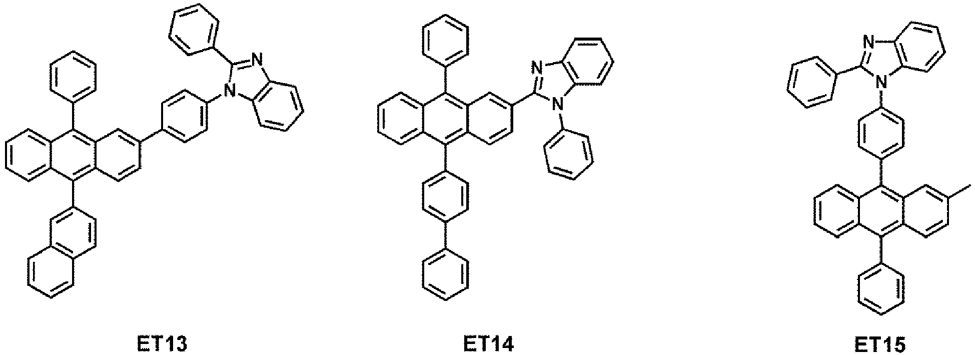

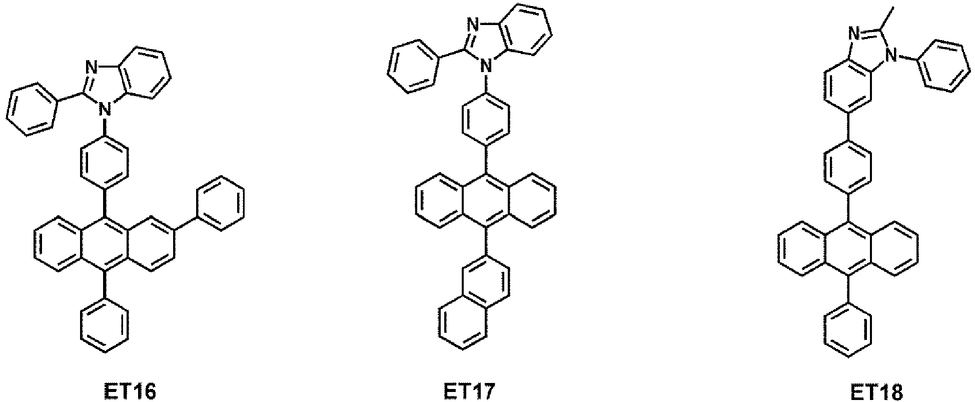

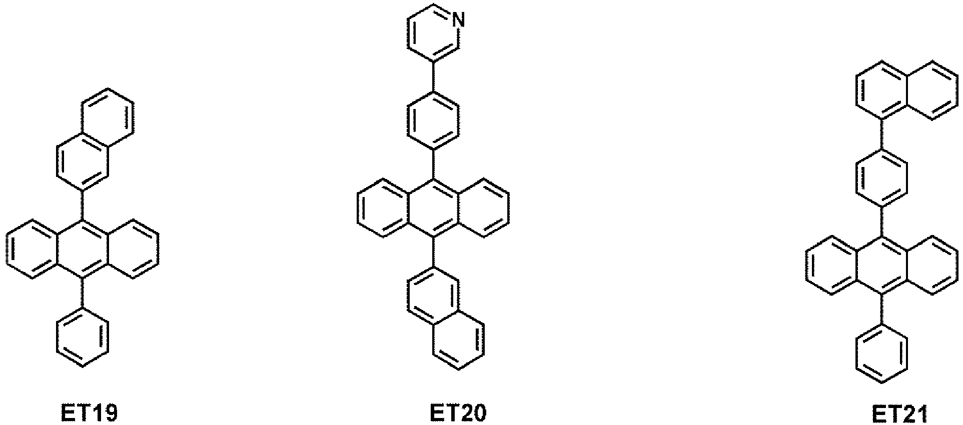

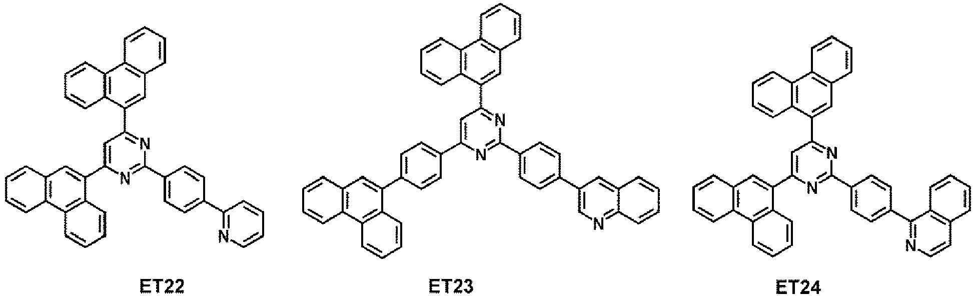

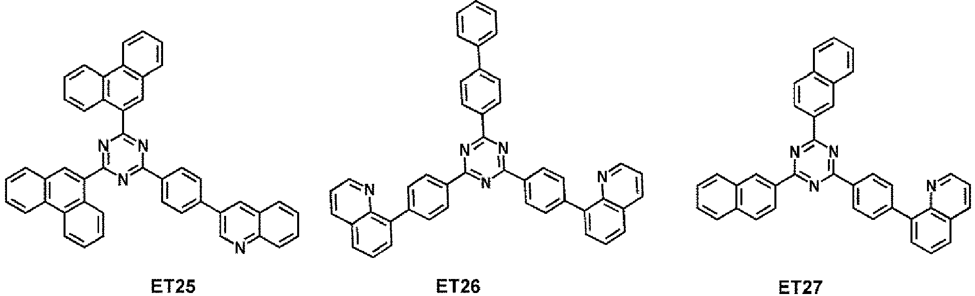

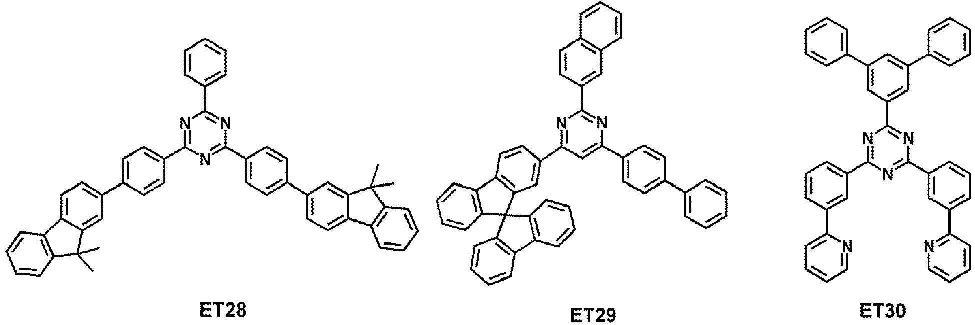

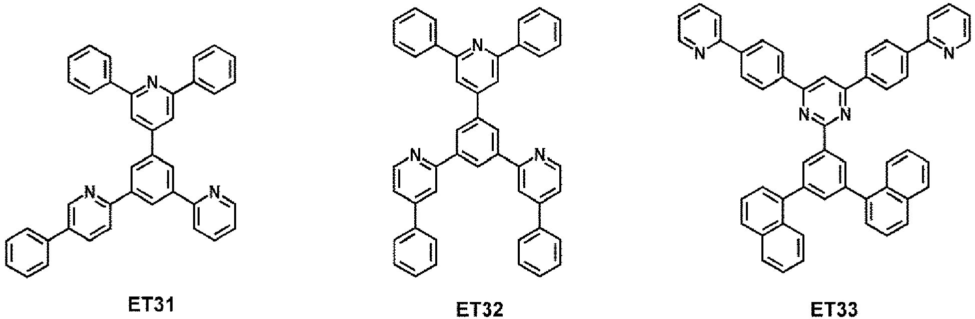

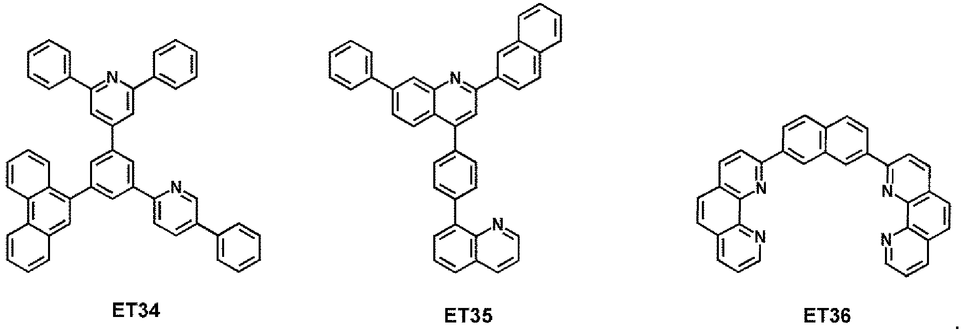

In one or more embodiments, the electron transport region may include at least one selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), and NTAZ:

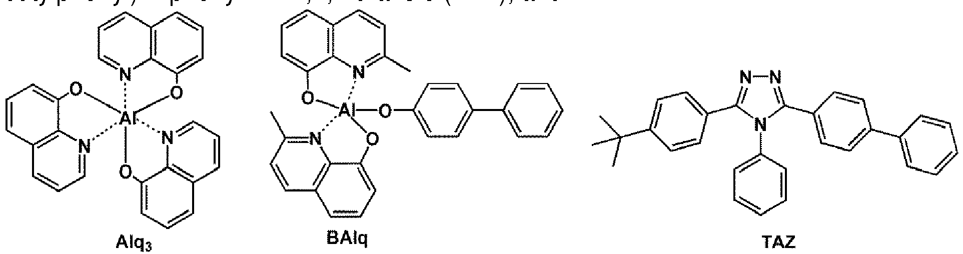

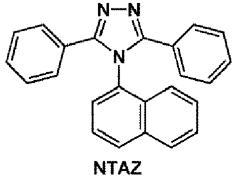

In one embodiment, the electron transport region may include a phosphine oxide-containing compound (for example, TSPO1 and/or the like), but embodiments of the present disclosure are not limited thereto. In one embodiment, the phosphine oxide-containing compound may be used in a hole blocking layer in the electron transport region, but embodiments of the present disclosure are not limited thereto.

The thicknesses of the buffer layer, the hole blocking layer, and the electron control layer may each independently be about 20 Å to about 1,000 Å, for example, about 20 Å to about 700 Å, about 20 Å to about 500 Å, about 20 Å to about 400 Å, about 30 Å to about 400 Å or about 30 Å to about 300 Å. When the thicknesses of the buffer layer, the hole blocking layer, and the electron control layer are within these ranges, excellent hole blocking characteristics or excellent electron control characteristics may be obtained without a substantial increase in driving voltage.

The thickness of the electron transport layer may be about 100 Å to about 1,000 Å, for example, about 100 Å to about 700 Å, about 100 Å to about 600 Å, about 150 Å to about 600 Å, about 150 Å to about 500 Å or about 200 Å to about 400 Å. When the thickness of the electron transport layer is within the range described above, satisfactory electron transport characteristics may be obtained without a substantial increase in driving voltage.

The electron transport region (for example, the electron transport layer in the electron transport region) may further include, in addition to the materials described above, a metal-containing material.

The metal-containing material may include at least one selected from an alkali metal complex and an alkaline earth-metal complex. The alkali metal complex may include a metal ion selected from a lithium (Li) ion, a sodium (Na) ion, a potassium (K) ion, a rubidium (Rb) ion, and a cesium (Cs) ion, and the alkaline earth-metal complex may include a metal ion selected from a beryllium (Be) ion, a magnesium (Mg) ion, a calcium (Ca) ion, a strontium (Sr) ion, and a barium (Ba) ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may include a Li complex. The Li complex may include, for example, Compound ET-D1 (lithium quinolate, LiQ) or ET-D2:

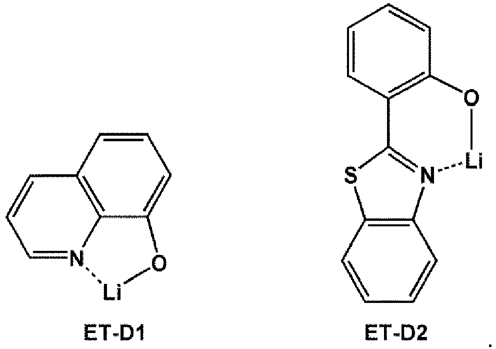

The electron transport region may include an electron injection layer that facilitates electron injection from the second electrode 190. The electron injection layer may directly contact the second electrode 190.

The electron injection layer may have i) a single-layered structure including a single material, ii) a single-layered structure including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof.

The alkali metal may be selected from Li, Na, K, Rb, and Cs. In one embodiment, the alkali metal may be Li, Na, or Cs. In one or more embodiments, the alkali metal may be Li or Cs, but embodiments of the present disclosure are not limited thereto.

The alkaline earth metal may be selected from magnesium (Mg), calcium (Ca), strontium (Sr), and barium (Ba).

The rare earth metal may be selected from scandium (Sc), yttrium (Y), cerium (Ce), terbium (Tb), ytterbium (Yb), and gadolinium (Gd).

The alkali metal compound, the alkaline earth-metal compound, and the rare earth metal compound may be selected from oxides and halides (for example, fluorides, chlorides, bromides, and/or iodides) of the alkali metal, the alkaline earth-metal, and the rare earth metal.

The alkali metal compound may be selected from alkali metal oxides (such as Li₂O, Cs₂O, and/or K₂O), and alkali metal halides (such as LiF, NaF, CsF, KF, Lil, Nal, Csl, and/or KI). In one embodiment, the alkali metal compound may be selected from LiF, Li₂O, NaF, Lil, Nal, Csl, and KI, but embodiments of the present disclosure are not limited thereto.

The alkaline earth-metal compound may be selected from alkaline earth-metal oxides (such as BaO, SrO, CaO, BaₓSr₁₋ₓO (0<x<1), and/or BaₓCa₁₋ₓO (0<x<1)). In one embodiment, the alkaline earth-metal compound may be selected from BaO, SrO, and CaO, but embodiments of the present disclosure are not limited thereto.

The rare earth metal compound may be selected from YbF₃, ScF₃, ScO₃, Sc₂O₃, Y₂O₃, Ce₂O₃, GdF₃, and TbF₃. In one embodiment, the rare earth metal compound may be selected from YbF₃, ScF₃, TbF₃, YbI₃, ScI₃, and TbI₃, but embodiments of the present disclosure are not limited thereto.

The alkali metal complex, the alkaline earth-metal complex, and the rare earth metal complex may respectively include an alkali metal ion, an alkaline earth-metal ion, and a rare earth metal ion as described above, and a ligand coordinated with the metal ion of the alkali metal complex, the alkaline earth-metal complex, or the rare earth metal complex may be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but embodiments of the present disclosure are not limited thereto.

The electron injection layer may include (e.g., consist of) an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof, as described above. In one or more embodiments, the electron injection layer may further include an organic material. When the electron injection layer further includes an organic material, the alkali metal, alkaline earth metal, rare earth metal, alkali metal compound, alkaline earth-metal compound, rare earth metal compound, alkali metal complex, alkaline earth-metal complex, rare earth metal complex, or combination thereof may be homogeneously or non-homogeneously dispersed in a matrix including the organic material.

A thickness of the electron injection layer may be about 1 Å to about 100 Å, for example, about 3 Å to about 90 Å or about 3 Å to about 20 Å. When the thickness of the electron injection layer is within the range described above, the electron injection layer may have satisfactory electron injection characteristics without a substantial increase in driving voltage.

### Second electrode 190

The second electrode 190 is located on the organic layer 150. The second electrode 190 may be a cathode (which is an electron injection electrode), and in this regard, a material for forming the second electrode 190 may be selected from a metal, an alloy, an electrically conductive compound, and a combination thereof, each having a relatively low work function.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layered structure or a multi-layered structure including two or more layers.

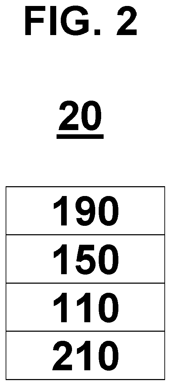

### Description of FIGS. 2 to 4

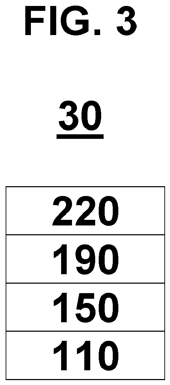

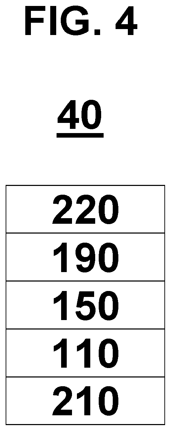

An organic light-emitting device 20 of FIG. 2 includes a first capping layer 210, a first electrode 110, an organic layer 150, and a second electrode 190 sequentially stacked in this stated order. An organic light-emitting device 30 of FIG. 3 includes a first electrode 110, an organic layer 150, a second electrode 190, and a second capping layer 220 sequentially stacked in this stated order. An organic light-emitting device 40 of FIG. 4 includes a first capping layer 210, a first electrode 110, an organic layer 150, a second electrode 190, and a second capping layer 220 sequentially stacked in this stated order.

Regarding FIGS. 2 to 4, the first electrode 110, the organic layer 150, and the second electrode 190 may each be understood by referring to the descriptions presented in connection with FIG. 1.

In the organic layer 150 of each of the organic light-emitting devices 20 and 40, light generated in the emission layer may pass through the first electrode 110 (which is a semi-transmissive electrode or a transmissive electrode) and the first capping layer 210 toward the outside, and in the organic layer 150 of each of the organic light-emitting devices 30 and 40, light generated in the emission layer may pass through the second electrode 190 (which is a semi-transmissive electrode or a transmissive electrode) and the second capping layer 220 toward the outside.

The first capping layer 210 and the second capping layer 220 may increase the external luminescent efficiency of the device according to the principle of constructive interference.

The first capping layer 210 and the second capping layer 220 may each independently be an organic capping layer including an organic material, an inorganic capping layer including an inorganic material, or a composite capping layer including an organic material and an inorganic material.

At least one selected from the first capping layer 210 and the second capping layer 220 may each independently include at least one material selected from suitable carbocyclic compounds, heterocyclic compounds, amine-based compounds, porphyrin derivatives, phthalocyanine derivatives, naphthalocyanine derivatives, alkali metal complexes, and alkaline earth-based complexes. The carbocyclic compound, the heterocyclic compound, and the amine-based compound may each optionally be substituted with a substituent containing at least one element selected from oxygen (O), nitrogen (N), sulfur (S), selenium (Se), silicon (Si), fluorine (F), chlorine (CI), bromine (Br), and iodine (I). In one embodiment, at least one of the first capping layer 210 and the second capping layer 220 may each independently include an amine-based compound.

In some embodiments, at least one of the first capping layer 210 and the second capping layer 220 may have a refractive index of 1.6 or more at a wavelength of 589 nm.

For example, the organic light-emitting device 30 or 40 may further include the second capping layer 220 on the second electrode 190, wherein the second capping layer 220 may have a refractive index of 1.6 or more at a wavelength of 589 nm.

In one embodiment, at least one of the first capping layer 210 and the second capping layer 220 may each independently include the compound represented by Formula 201 and/or the compound represented by Formula 202.

In one or more embodiments, at least one of the first capping layer 210 and the second capping layer 220 may each independently include a compound selected from Compounds HT28 to HT33 and Compounds CP1 to CP5, but embodiments of the present disclosure are not limited thereto:

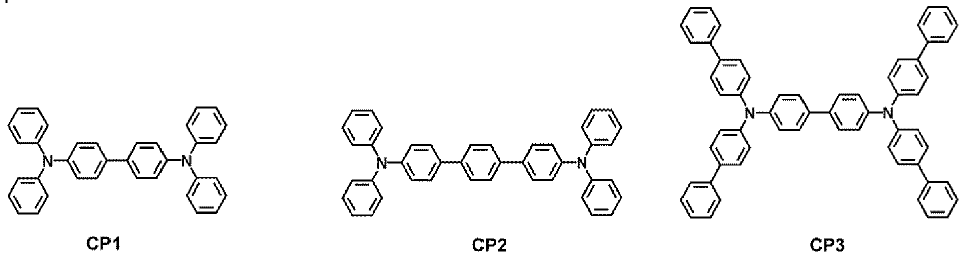

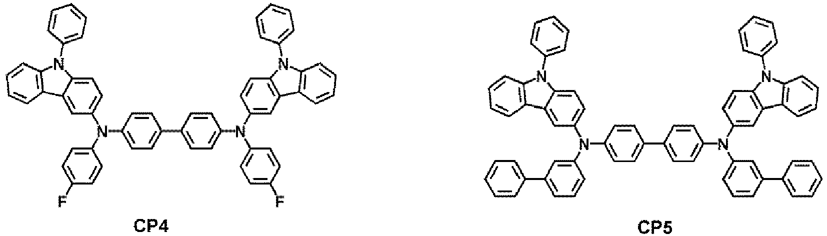

Hereinbefore, the organic light-emitting device according to an embodiment has been described in connection with FIGS. 1 to 4. However, embodiments of the present disclosure are not limited thereto.

The layers constituting the hole transport region, the emission layer, and the layers constituting the electron transport region may be formed in a set or predetermined region using one or more suitable methods selected from vacuum deposition, spin coating, casting, Langmuir-Blodgett (LB) deposition, ink-jet printing, laser-printing, and laser-induced thermal imaging.

When the layers constituting the hole transport region, the emission layer, and the layers constituting the electron transport region are formed by vacuum deposition, the deposition may be performed at a deposition temperature of about 100 °C to about 500 °C, a vacuum degree of about 10⁻⁸ torr (1.33 x 10⁻⁶ Pa) to about 10⁻³ torr (1.33 x 10⁻¹ Pa), and a deposition speed of about 0.01 Å/sec to about 100 Å/sec, depending on the material to be included and the structure of the layer to be formed.

When the layers constituting the hole transport region, the emission layer, and the layers constituting the electron transport region are formed by spin coating, the spin coating may be performed at a coating speed of about 2,000 rpm to about 5,000 rpm and at a heat treatment temperature of about 80 °C to 200 °C, depending on the material to be included and the structure of the layer to be formed.

### Display apparatus

The organic light-emitting device may be included in a display apparatus including a thin-film transistor. The thin-film transistor may include a source electrode, a drain electrode, and an activation layer, wherein any one of the source electrode and the drain electrode may be electrically connected to the first electrode of the light-emitting device.

The thin-film transistor may further include a gate electrode, a gate insulation layer, and/or the like.

The active layer may include crystalline silicon, amorphous silicon, organic semiconductor, oxide semiconductor, and/or the like, but embodiments of the present disclosure are not limited thereto.

The display apparatus may further include a sealing portion for sealing the organic light-emitting device. The sealing portion may allow the organic light-emitting device to form an image, and may block outside air and/or moisture from penetrating into the organic light-emitting device. The sealing portion may be a sealing substrate including a transparent glass and/or a plastic substrate. The sealing portion may be a thin film encapsulation layer including a plurality of organic layers and/or a plurality of inorganic layers. When the sealing portion is a thin-film encapsulation layer, the entire flat display apparatus may be flexible.

### General definition of substituents

The term "C₁-C₆₀ alkyl group" as used herein refers to a linear or branched aliphatic saturated hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, and a hexyl group. The term "C₁-C₆₀ alkylene group" as used herein refers to a divalent group having substantially the same structure as the C₁-C₆₀ alkyl group. Corresponding definitions apply to other ranges given for the number of carbon atoms in an alkyl/alkylene group.

The term "C₂-C₆₀ alkenyl group" as used herein refers to a hydrocarbon group having at least one carbon-carbon double bond in the middle or at the terminus of the C₂-C₆₆ alkyl group, and non-limiting examples thereof include an ethenyl group, a propenyl group, and a butenyl group. The term "C₂-C₆₀ alkenylene group" as used herein refers to a divalent group having substantially the same structure as the C₂-C₆₀ alkenyl group. Corresponding definitions apply to other ranges given for the number of carbon atoms in an alkenyl/alkenylene group.

The term "C₂-C₆₀ alkynyl group" as used herein refers to a hydrocarbon group having at least one carbon-carbon triple bond in the middle or at the terminus of the C₂-C₆₆ alkyl group, and non-limiting examples thereof include an ethynyl group and a propynyl group. The term "C₂-C₆₀ alkynylene group" as used herein refers to a divalent group having substantially the same structure as the C₂-C₆₀ alkynyl group. Corresponding definitions apply to other ranges given for the number of carbon atoms in an alkynyl/alkynylene group.

The term "C₁-C₆₀ alkoxy group" as used herein refers to a monovalent group represented by -OA₁₀₁ (wherein A₁₀₁ is a C₁-C₆₀ alkyl group), and non-limiting examples thereof include a methoxy group, an ethoxy group, and an isopropyloxy group. Corresponding definitions apply to other ranges given for the number of carbon atoms in an alkoxy group.

The term "C₃-C₁₀ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent monocyclic group having at least one heteroatom selected from N, O, Si, P, and S as a ring-forming atom and 1 to 10 carbon atoms, and non-limiting examples thereof include a 1 ,2,3,4-oxatriazolidinyl group, a tetrahydrofuranyl group, and a tetrahydrothiophenyl group. The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent monocyclic group that has 3 to 10 carbon atoms, at least one carbon-carbon double bond in the ring thereof, and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent monocyclic group that has at least one heteroatom selected from N, O, Si, P, and S as a ring-forming atom, 1 to 10 carbon atoms, and at least one double bond in its ring. Non-limiting examples of the C₁-C₁₀ heterocycloalkenyl group include a 4,5-dihydro-1 ,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system including 6 to 60 carbon atoms, and the term "C₆-C₆₀ arylene group" as used herein refers to a divalent group having a carbocyclic aromatic system including 6 to 60 carbon atoms. Non-limiting examples of the C₆-C₆₀ aryl group include a phenyl group, a naphthyl group, an anthracenyl group, a phenanthrenyl group, a pyrenyl group, a chrysenyl group, and a fluorenyl group. When the C₆-C₆₀ aryl group and the C₆-C₆₀ arylene group each include two or more rings, the two or more rings may be fused to each other. Corresponding definitions apply to other ranges given for the number of carbon atoms in an aryl/arylene group.

The term "C₁-C₆₀ heteroaryl group" as used herein refers to a monovalent group having a carbocyclic aromatic system that has at least one heteroatom selected from N, O, Si, P, and S as a ring-forming atom, in addition to 1 to 60 carbon atoms. The term "C₁-C₆₀ heteroarylene group" as used herein refers to a divalent group having a carbocyclic aromatic system that has at least one heteroatom selected from N, O, Si, P, and S as a ring-forming atom, in addition to 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, a carbazolyl group, a dibenzofuranyl group, and a dibenzothiofuranyl group. When the C₁-C₆₀ heteroaryl group and the C₁-C₆₀ heteroarylene group each include two or more rings, the two or more rings may be condensed with each other. Corresponding definitions apply to other ranges given for the number of carbon atoms in an heteroaryl/heteroarylene group.

The term "C₆-C₆₀ aryloxy group" as used herein refers to -OA₁₀₂ (wherein A₁₀₂ is a C₆-C₆₀ aryl group), and the term "C₆-C₆₀ arylthio group" as used herein refers to -SA₁₀₃ (wherein A₁₀₃ is a C₆-C₆₀ aryl group). Corresponding definitions apply to other ranges given for the number of carbon atoms in an aryloxy group and an arylthio group.

The term "monovalent non-aromatic condensed polycyclic group" as used herein refers to a monovalent group having two or more rings condensed with each other, only carbon atoms (for example, 8 to 60 carbon atoms) as ring-forming atoms, and no aromaticity in its entire molecular structure. Non-limiting examples of the monovalent non-aromatic condensed polycyclic group may include a fluorenyl group and an adamantyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group having two or more rings condensed to each other, at least one heteroatom selected from N, O, Si, P, and Sin addition to carbon atoms (for example, 1 to 60 carbon atoms), as ring-forming atoms, and no aromaticity in its entire molecular structure. Non-limiting examples of the monovalent non-aromatic condensed heteropolycyclic group may include a carbazolyl group and an azaadamantyl group. The term "divalent non-aromatic condensed heteropolycyclic group" as used herein refers to a divalent group having substantially the same structure as the monovalent non-aromatic condensed heteropolycyclic group.

The term "C₅-C₃₀ carbocyclic group" as used herein refers to a monocyclic or polycyclic group having 5 to 30 carbon atoms, in which the ring-forming atoms are carbon atoms only. The term " C₅-C₃₀ carbocyclic group" as used herein refers to an aromatic carbocyclic group or a non-aromatic carbocyclic group. The C₅-C₃₀ carbocyclic group may be a ring (such as benzene), a monovalent group (such as a phenyl group), or a divalent group (such as a phenylene group). In one or more embodiments, depending on the number of substituents connected to the C₅-C₃₀ carbocyclic group, the C₅-C₃₀ carbocyclic group may be a trivalent group or a quadrivalent group. Corresponding definitions apply to other ranges given for the number of carbon atoms in a carbocyclic group.

The term "C₁-C₃₀ heterocyclic group" as used herein refers to a group having substantially the same structure as the C₅-C₃₀ carbocyclic group, except that as a ring-forming atom, at least one heteroatom selected from N, O, Si, P, and S is used in addition to carbon (for example, 1 to 30 carbon atoms). Corresponding definitions apply to other ranges given for the number of carbon atoms in a heterocyclic group.

In the present specification, ring CY₁ to ring CY₅, ring CY₅₁ to ring CY₅₃, ring CY₇₁, ring CY₇₂, ring CY₉₁, ring CY₉₂, A₄₀₁ and A₄₀₂ may be monovalent groups, divalent groups or higher valence groups depending on the number of substituents connected thereto.

In the present specification, at least one substituent of the substituted C₅-C₃₀ (*e.g.* C₅-C₂₀) carbocyclic group, the substituted C₁-C₃₀ (*e.g.* C₁-C₂₀) heterocyclic group, the substituted C₁-C₂₀ alkylene group, the substituted C₂-C₂₀ alkenylene group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ (*e.g*. C₆-C₃₀) arylene group, the substituted C₁-C₆₀ (*e.g.* C₁-C₂₀) heteroarylene group, the substituted divalent non-aromatic condensed polycyclic group, the substituted divalent non-aromatic condensed heteropolycyclic group, the substituted C₁-C₆₀ (*e.g.* C₁-C₂₀) alkyl group, the substituted C₂-C₆₀ (*e.g.* C₂-C₂₀) alkenyl group, the substituted C₂-C₆₀ (*e.g.* C₂-C₂₀) alkynyl group, the substituted C₁-C₆₀ (*e.g.* C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g.* C₆-C₃₀) aryl group, the substituted C₇-C₆₀ (*e.g.* C₇-C₃₀) alkyl aryl group, the substituted C₆-C₆₀ (*e.g.* C₆-C₃₀) aryloxy group, the substituted C₆-C₆₀ (*e.g.* C₆-C₃₀) arylthio group, the substituted C₁-C₆₀ (*e.g.* C₁-C₂₀) heteroaryl group, the substituted C₂-C₆₀ (*e.g.* C₂-C₂₀) alkyl heteroaryl group, the substituted monovalent non-aromatic condensed polycyclic group, and the substituted monovalent non-aromatic condensed heteropolycyclic group may be selected from:

deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group;

a C₁-C₆₆ (*e.g.* C₁-C₂₀) alkyl group, a C₂-C₆₀ *(e.g.* C₂-C₂₀) alkenyl group, a C₂-C₆₀ (*e.g.* C₂-C₂₀) alkynyl group, and a C₁-C₆₀ *(e.g.* C₁-C₂₀) alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₇-C₆₀ (*e.g.* C₇-C₃₀) alkyl aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a C₂-C₆₀ (*e.g.* C₂-C₂₀) alkyl heteroaryl group, a monovalent non-aromatic condensed polycyclic group, a monovalent non-aromatic condensed heteropolycyclic group, -O(Q₁₁), -S(Q₁₁), - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), and - P(=O)(Q₁₁)(Q₁₂),

a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₇-C₆₀ (*e.g.* C₇-C₃₀) alkylaryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a C₂-C₆₀ (*e.g.* C₂-C₂₀) alkyl heteroaryl group, a monovalent non-aromatic condensed polycyclic group, and a monovalent non-aromatic condensed heteropolycyclic group;

a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₇-C₆₀ (*e.g.* C₇-C₃₀) alkyl aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a C₂-C₆₀ (*e.g.* C₂-C₂₀) alkyl heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₇-C₆₀ (*e.g.* C₇-C₃₀) alkyl aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a C₂-C₆₆ alkyl heteroaryl group, a monovalent non-aromatic condensed polycyclic group, a monovalent non-aromatic condensed heteropolycyclic group, -O(Q₂₁), -S(Q₂₁), -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and

-O(Q₃₁), -S(Q₃₁), -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂), and

Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, a C₁-C₆₀ (*e.g.* C₁-C₂₀) alkyl group substituted with at least one selected from deuterium, -F, and a cyano group, a C₁-C₆₀ (*e.g.* C₁-C₂₀) alkyl group, a phenyl group, and a biphenyl group, and a C₆-C₆₀ (*e.g.* C₆-C₃₀) aryl group substituted with at least one selected from deuterium, -F, and a cyano group, a C₁-C₁₀ alkyl group, a biphenyl group, and a terphenyl group.

The term "Ph" as used herein refers to a phenyl group, the term "Me" as used herein refers to a methyl group, the term "Et" as used herein refers to an ethyl group, the term "ter-Bu" or "Bu^{t}" as used herein refers to a tert-butyl group, and the term "OMe" as used herein refers to a methoxy group.

The term "biphenyl group" as used herein refers to "a phenyl group substituted with a phenyl group". In other words, the "biphenyl group" is a substituted phenyl group having a C₆-C₆₀ aryl group as a substituent.

The term "terphenyl group" as used herein refers to "a phenyl group substituted with a biphenyl group". In other words, the "terphenyl group" is a substituted phenyl group having, as a substituent, a C₆-C₆₀ aryl group substituted with a C₆-C₆₀ aryl group.

*, *', and *", as used herein, unless defined otherwise, each refer to a binding site to a neighboring atom in a corresponding formula.

Hereinafter, a compound according to embodiments and an organic light-emitting device according to embodiments will be described in more detail with reference to Synthesis Examples and Examples. The wording "B was used instead of A" used in describing Synthesis Examples indicates that an identical molar equivalent of B was used in place an identical molar equivalent of A.

### Synthesis Examples

### Synthesis Example 1: Synthesis of Compound 7

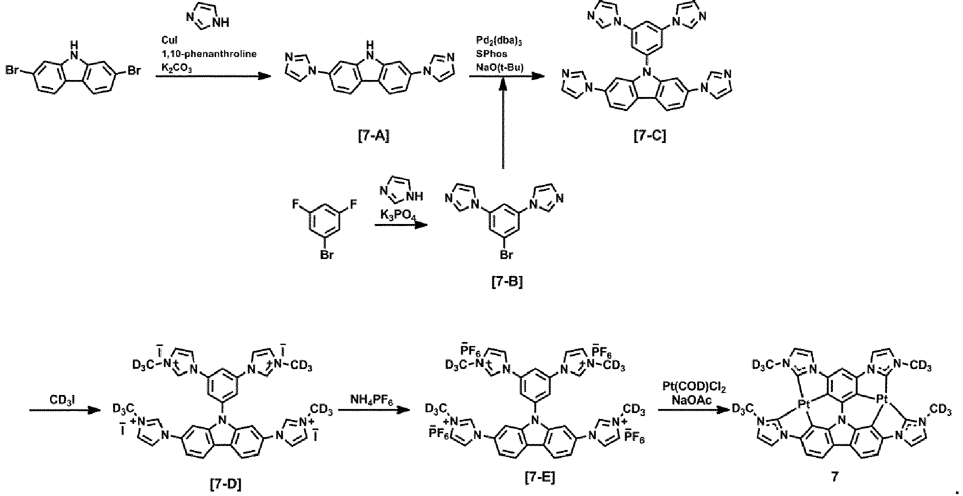

### Synthesis of Intermediate [7-A]

2,7-dibromo-9H-carbazole (1.0 eq), imidazole (2.6 eq), K₂CO₃ (4.0 eq), Cul (0.2 eq), and 1,10-phenanthroline (0.2 eq) were added to a reaction container and suspended in dimethylformamide (DMF, 0.25 M). The reaction mixture was heated and stirred at a temperature of 160 °C for 24 hours. After completion of the reaction, the resulting product was cooled to room temperature, and an extraction process was performed thereon using distilled water and ethyl acetate. An organic layer extracted therefrom was washed using a saturated NaCl aqueous solution, and then dried using anhydrous magnesium sulfate. A residue obtained by removing the solvent therefrom was separated by column chromatography to obtain Intermediate [7-A] (yield of 66%).

### Synthesis of Intermediate [7-B]

1-bromo-3,5-difluorobenzene (1.0 eq), imidazole (2.6 eq), and K₃PO₄ (4.0 eq) were added to a reaction container and suspended in DMF (0.25 M). The reaction mixture was heated and stirred at a temperature of 160 °C for 24 hours. After completion of the reaction, the resulting product was cooled to room temperature, and an extraction process was performed thereon using distilled water and ethyl acetate. An organic layer extracted therefrom was washed using a saturated NaCl aqueous solution, and then dried using anhydrous magnesium sulfate. A residue obtained by removing the solvent therefrom was separated by column chromatography to obtain Intermediate [7-B] (yield of 62%).

### Synthesis of Intermediate [7-C]

Intermediate [7-A] (1.0 eq), Intermediate [7-B] (1.2 eq), Pd₂(dba)₃ (0.02 eq), SPhos (0.04 eq), and sodium tert-butoxide (1.6 eq) were added to a reaction container and suspended in toluene (0.17 M). The reaction mixture was heated and stirred at a temperature of 110 °C for 24 hours. After completion of the reaction, the resulting product was cooled to room temperature, and an extraction process was performed thereon using distilled water and ethyl acetate. An organic layer extracted therefrom was washed using a saturated NaCl aqueous solution, and then dried using anhydrous magnesium sulfate. A residue obtained by removing the solvent therefrom was separated by column chromatography to obtain Intermediate [7-C] (yield of 65%).

### Synthesis of Intermediate [7-D]

Intermediate [7-C] (1.0 eq) and iodomethane-d₃ (40.0 eq) were added to a reaction container and suspended in toluene (0.1 M). The reaction mixture was heated and stirred at a temperature of 110 °C for 24 hours. After completion of the reaction, the resulting product was cooled to room temperature, and an extraction process was performed thereon using distilled water and ethyl acetate. An organic layer extracted therefrom was dried using anhydrous magnesium sulfate, and the solvent was removed therefrom to obtain Intermediate [7-D] (yield of 91%).

### Synthesis of Intermediate [7-E]

Intermediate [7-D] (1.0 eq) was added to a reaction container and suspended in a mixed solution containing methanol and distilled water at a volume ratio of 2:1. In a sufficiently dissolved state, ammonium hexafluorophosphate (4.4 eq) was slowly added to the container, and the reaction solution was stirred at room temperature for 24 hours. A solid produced after completion of the reaction was filtered and washed using diethyl ether. The washed solid was dried to obtain Intermediate [7-E] (yield of 88%).

### Synthesis of Compound 7

Intermediate [7-E] (1.0 eq), dichloro(1,5-cyclooctadiene)platinum (2.2 eq), and sodium acetate (12.0 eq) were suspended in 1,4-dioxane (0.1 M). The reaction mixture was heated and stirred at a temperature of 120 °C for 72 hours. After completion of the reaction, the resulting product was cooled to room temperature, and an extraction process was performed thereon using distilled water and ethyl acetate. An organic layer extracted therefrom was washed using a saturated NaCl aqueous solution, and then dried using anhydrous magnesium sulfate. A residue obtained by removing the solvent therefrom was separated by column chromatography to obtain Compound 7 (yield of 34%).

### Synthesis Example 2: Synthesis of Compound 10

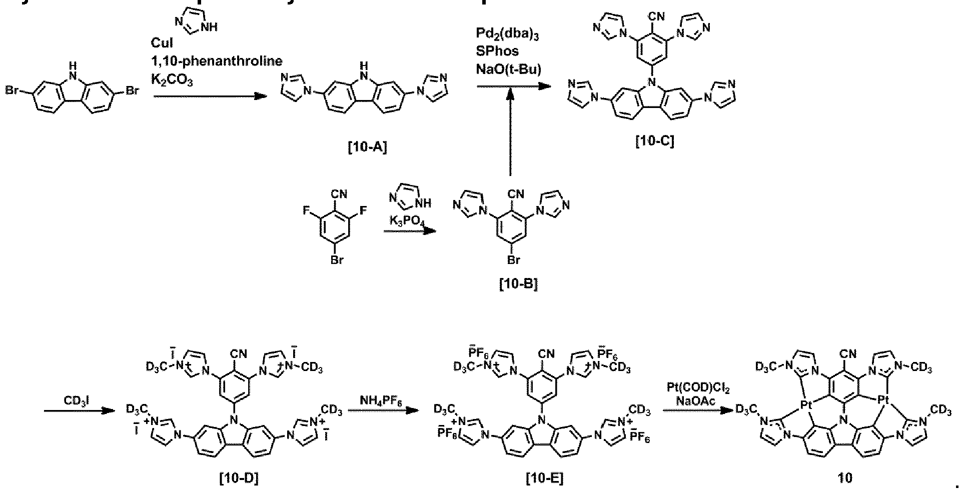

### Synthesis of Intermediate [10-A]

Intermediate [10-A] was synthesized in substantially the same manner as in the synthesis of Intermediate [7-A].

### Synthesis of Intermediate [10-B]

Intermediate [10-B] (yield of 63 %) was obtained in substantially the same manner as in the synthesis of Intermediate [7-B], except that 4-bromo-2,6-difluorobenzonitrile was used instead of 1-bromo-3,5-difluorobenzene.

### Synthesis of Intermediate [10-C]

Intermediate [10-C] (yield of 62 %) was obtained in substantially the same manner as in the synthesis of Intermediate [7-C], except that Intermediate [10-A] and Intermediate [10-B] were used instead of Intermediate [7-A] and Intermediate [7-B].

### Synthesis of Intermediate [10-D]

Intermediate [10-D] (yield of 91 %) was obtained in substantially the same manner as in the synthesis of Intermediate [7-D], except that Intermediate [10-C] was used instead of Intermediate [7-C].

### Synthesis of Intermediate [10-E]

Intermediate [10-E] (yield of 85 %) was obtained in substantially the same manner as in the synthesis of Intermediate [7-E], except that Intermediate [10-D] was used instead of Intermediate [7-D].

### Synthesis of Compound 10

Compound 10 (yield of 35 %) was obtained in substantially the same manner as in the synthesis of Compound 7, except that Intermediate [10-E] was used instead of Intermediate [7-E].

### Synthesis Example 3: Synthesis of Compound 22

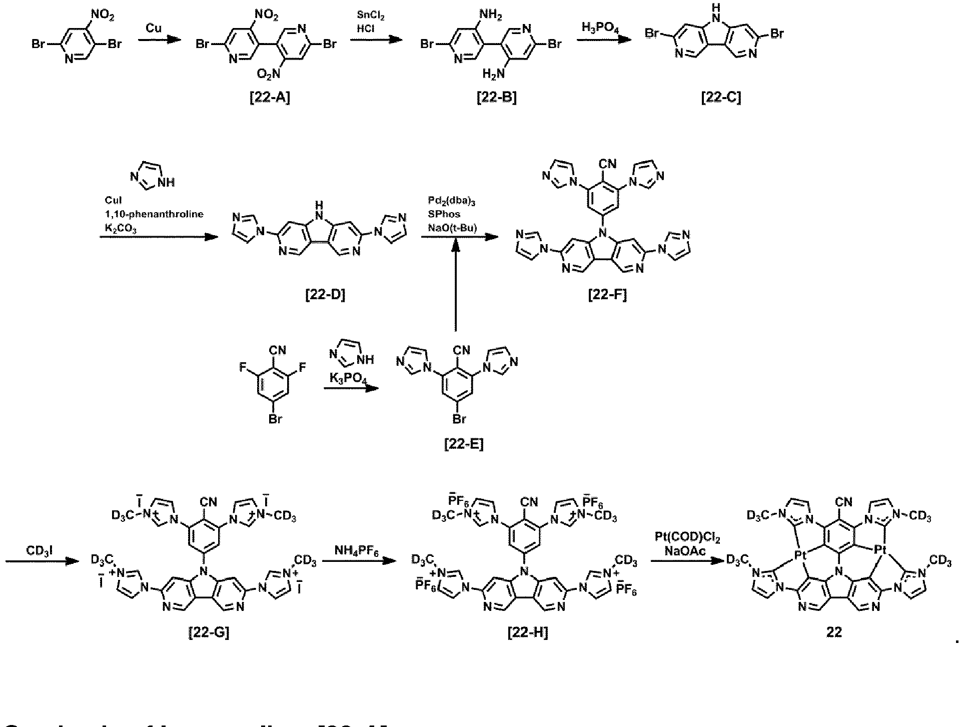

### Synthesis of Intermediate [22-A]

2,5-dibromo-4-nitropyridine (1.0 eq) and 50-mesh Cu (2.5 eq) were suspended in DMF (1 M). The reaction mixture was heated, and stirred at a temperature of 120 °C for 5 hours. After completion of the reaction, the resulting product was cooled to room temperature, and an excess of toluene was added thereto. After filtering a residue, an organic layer extracted therefrom was washed using a saturated NaCl aqueous solution, and then dried using anhydrous magnesium sulfate. A residue obtained by removing the solvent therefrom was separated by column chromatography to obtain Intermediate [22-A] (yield of 68 %).

### Synthesis of Intermediate [22-B]

Intermediate [22-A] (1.0 eq) and 37% HCl aqueous solution (2.0 eq) were suspended in ethanol (0.3 M). While the reaction mixture was stirred, SnCl₂ (8.5 eq) was slowly added thereto. The reaction mixture was heated and stirred under a nitrogen atmosphere at a temperature of 80 °C for 12 hours. After completion of the reaction, an excess of cold distilled water was added, and the resulting mixture was stirred for 10 minutes. When the mixture was completely cooled, the reaction container was placed in an ice bath, and a 2M NaOH solution was slowly added dropwise thereto to adjust the pH of the solution to about 8. An organic layer was extracted therefrom using diethyl ether, washed using distilled water, and dried using anhydrous magnesium sulfate. A residue obtained by removing the solvent therefrom was separated by column chromatography to obtain Intermediate [22-B] (yield of 65%).

### Synthesis of Intermediate [22-C]

Intermediate [22-B] (1.0 eq) was suspended in 85% H₃PO₄ (0.15 M). The reaction mixture was stirred under a nitrogen condition at a temperature of 190 °C for 26 hours. After completion of the reaction, the mixture was cooled, and an excess of distilled water was added thereto. A remaining residue after filtering the water layer was washed using distilled water, dissolved in toluene, and filtered through a silica pad. After removing the solvent, the filtrate was recrystallized using toluene/hexane (10:1) to obtain Intermediate [22-C] (yield of 41 %).

### Synthesis of Intermediate [22-D]

Intermediate [22-D] (yield of 60%) was obtained in substantially the same manner as in the synthesis of Intermediate [7-A], except that Intermediate [22-C] was used instead of 2,7-dibromo-9H-carbazole.

### Synthesis of Intermediate [22-E]

Intermediate [22-E] was synthesized in substantially the same manner as in the synthesis of Intermediate [10-B].

### Synthesis of Intermediate [22-F]

Intermediate [22-F] (yield of 58 %) was obtained in substantially the same manner as in the synthesis of Intermediate [7-C], except that Intermediate [22-D] and Intermediate [22-E] were used instead of Intermediate [7-A] and Intermediate [7-B].

### Synthesis of Intermediate [22-G]

Intermediate [22-G] (yield of 89 %) was obtained in substantially the same manner as in the synthesis of Intermediate [7-D], except that Intermediate [22-F] was used instead of Intermediate [7-C].

### Synthesis of Intermediate [22-H]

Intermediate [22-H] (yield of 87 %) was obtained in substantially the same manner as in the synthesis of Intermediate [7-E], except that Intermediate [22-G] was used instead of Intermediate [7-D].

### Synthesis of Compound 22

Compound 22 (yield of 31 %) was obtained in substantially the same manner as in the synthesis of Compound 7, except that Intermediate [22-H] was used instead of Intermediate [7-E].

### Synthesis Example 4: Synthesis of Compound 34

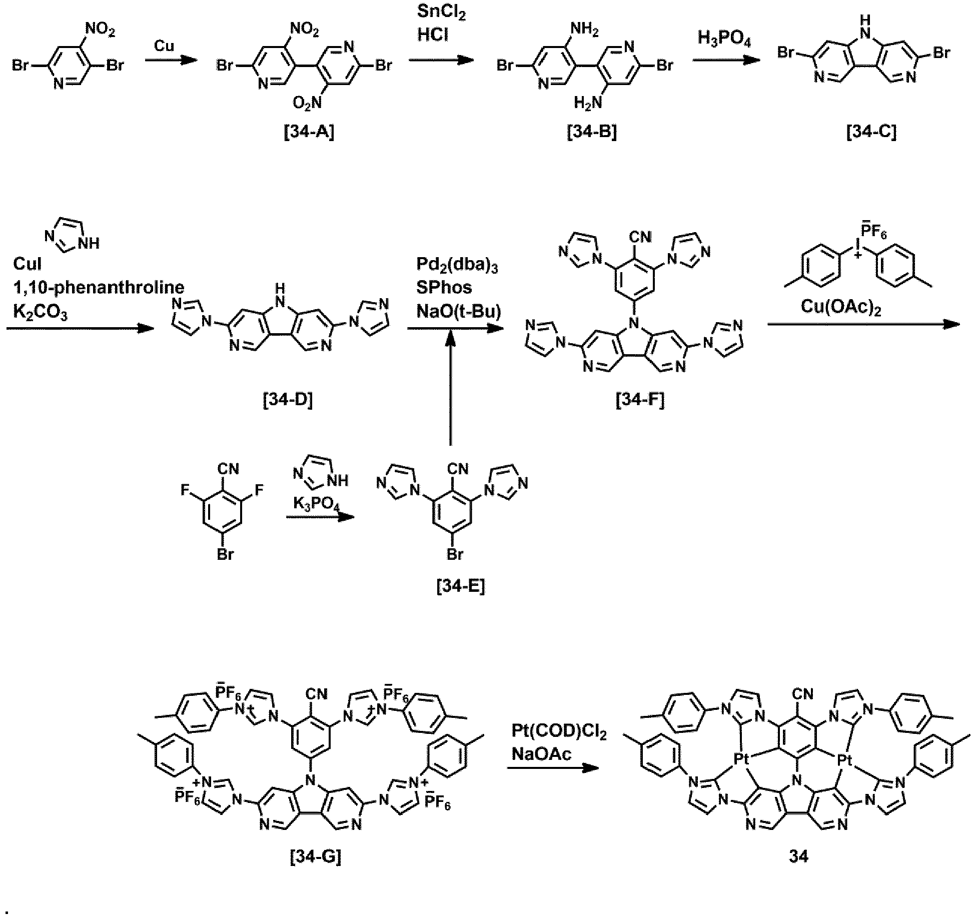

### Synthesis of Intermediate [34-A]

Intermediate [34-A] was synthesized in substantially the same manner as in the synthesis of Intermediate [22-A].

### Synthesis of Intermediate [34-B]

Intermediate [34-B] was synthesized in substantially the same manner as in the synthesis of Intermediate [22-B].

### Synthesis of Intermediate [34-C]

Intermediate [34-C] was synthesized in substantially the same manner as in the synthesis of Intermediate [22-C].

### Synthesis of Intermediate [34-D]

Intermediate [34-D] was synthesized in substantially the same manner as in the synthesis of Intermediate [22-D].

### Synthesis of Intermediate [34-E]

Intermediate [34-E] was synthesized in substantially the same manner as in the synthesis of Intermediate [10-B].

### Synthesis of Intermediate [34-F]

Intermediate [34-F] was synthesized in substantially the same manner as in the synthesis of Intermediate [22-F].

### Synthesis of Intermediate [34-G]

Intermediate [34-F] (1.0 eq), bis(4-methylphenyl)iodonium hexafluorophosphate (6.0 eq), and copper acetate (0.2 eq) were added to a reaction container, and suspended in DMF (0.25 M). The reaction mixture was heated and stirred at a temperature of 160 °C for 12 hours. After completion of the reaction, the resulting product was cooled to room temperature, the solvent was removed therefrom, and an extraction process was performed thereon using distilled water and ethyl acetate. An organic layer extracted therefrom was dried using anhydrous magnesium sulfate, and a residue obtained by removing the solvent therefrom was separated by column chromatography to obtain Intermediate [34-G] (yield of 85%).

### Synthesis of Compound 34

Compound 34 (yield of 30%) was obtained in substantially the same manner as in the synthesis of Compound 7, except that Intermediate [34-G] was used instead of Intermediate [7-E].

### Synthesis Example 5: Synthesis of Compound 43

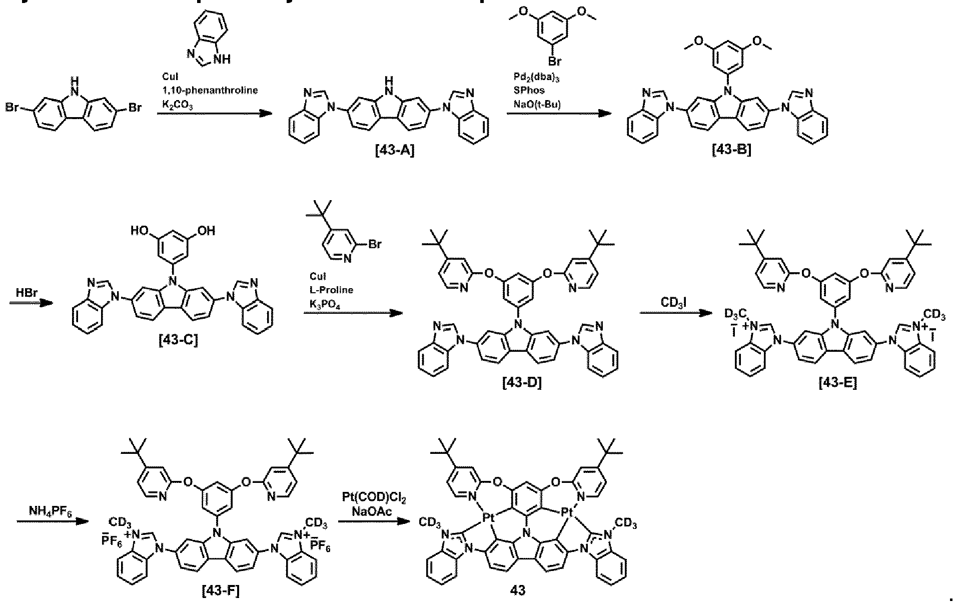

### Synthesis of Intermediate [43-A]

Intermediate [43-A] (yield of 62 %) was obtained in substantially the same manner as in the synthesis of Intermediate [7-A], except that benzimidazole was used instead of imidazole.

### Synthesis of Intermediate [43-B]

Intermediate [43-B] (yield of 61 %) was obtained in substantially the same manner as in the synthesis of Intermediate [7-C], except that 1-bromo-3,5-dimethoxybenzene was used instead of Intermediate [7-B].

### Synthesis of Intermediate [43-C]

Intermediate [43-B] was suspended in a solution containing excess HBr. The reaction mixture was heated and stirred at a temperature of 110 °C for 24 hours. After completion of the reaction, the mixture was cooled, and an excess of distilled water was added thereto. Then, the resulting solution was neutralized with an aqueous sodium hydroxide solution and ammonium chloride. A precipitated solid was filtered, dissolved in acetone, and dried using anhydrous magnesium sulfate. The solvent was removed therefrom to obtain Intermediate [43-C] (yield of 87 %).

### Synthesis of Intermediate [43-D]

Intermediate [43-C] (1.0 eq), 4-tert-butyl-2-bromopyridine (2.6 eq), K₃PO₄ (4.0 eq), Cul (0.2 eq), and L-proline (0.2 eq) were added to a reaction container, and suspended in DMF (0.25 M). The reaction mixture was heated and stirred at a temperature of 160 °C for 24 hours. After completion of the reaction, the resulting product was cooled to room temperature, and an extraction process was performed thereon using distilled water and ethyl acetate. An organic layer extracted therefrom was washed using a saturated NaCl aqueous solution, and then dried using anhydrous magnesium sulfate. A residue obtained by removing the solvent therefrom was separated by column chromatography to obtain Intermediate [43-D] (yield of 72%).

### Synthesis of Intermediate [43-E]

Intermediate [43-D] (1.0 eq) and iodomethane-D₃ (20.0 eq) were added to a reaction container, and suspended in toluene (0.1 M). The reaction mixture was heated, and stirred at a temperature of 110 °C for 24 hours. After completion of the reaction, the resulting product was cooled to room temperature, and an extraction process was performed thereon using distilled water and ethyl acetate. An organic layer extracted therefrom was dried using anhydrous magnesium sulfate, and the solvent was removed therefrom to obtain Intermediate [43-E] (yield of 93 %).

### Synthesis of Intermediate [43-F]

Intermediate [43-E] (1.0 eq) was added to a reaction container, and suspended in a mixed solution containing methanol and distilled water at a volume ratio of 2:1. In a sufficiently dissolved state, ammonium hexafluorophosphate (2.2 eq) was slowly added to the container, and the reaction solution was stirred at room temperature for 24 hours. A solid produced after completion of the reaction was filtered and washed using diethyl ether. The washed solid was dried to obtain Intermediate [43-F] (yield of 90 %).

### Synthesis of Compound 43

Compound 43 (yield of 39%) was obtained in substantially the same manner as in the synthesis of Compound 7, except that Intermediate [43-F] was used instead of Intermediate [7-E].

### Examples

### Example 1

As an anode, an ITO/Ag/ITO substrate was cut to a size of 50 mm x 50 mm x 0.7 mm, sonicated with acetone, isopropyl alcohol, and pure water each for 5 minutes, and then cleaned by exposure to ultraviolet rays and ozone for 30 minutes. Then, the ITO substrate was provided to a vacuum deposition apparatus.

Compound 2-TNATA was vacuum-deposited on the ITO substrate to form a hole injection layer having a thickness of 60 nm, and then, 4,4'-bis[*N*-(1-naphthyl)-*N-*phenyl amino]biphenyl (NPB) was vacuum-deposited on the hole injection layer to form a hole transport layer having a thickness of 30 nm.

On the hole transport layer, Compound 7 as a dopant was co-deposited with a mixed host including Compounds H2-2 and H3-2 (at a weight ratio of 5:5) at a ratio of 10 wt% to form an emission layer having a thickness of 30 nm. Then, Compound H2-2 was vacuum-deposited on the emission layer to form a hole blocking layer having a thickness of 5 nm. Next, Alq₃ was deposited on the hole blocking layer to form an electron transport layer having a thickness of 30 nm; LiF (which is an alkali metal halide) was deposited on the electron transport layer to form an electron injection layer having a thickness of 1 nm; and Al was vacuum-deposited to a thickness of 300 nm to form a LiF/AI cathode. Compound HT28 was vacuum-deposited on the cathode to form a capping layer having a thickness of 60 nm, thereby completing the manufacture of an organic light-emitting device.

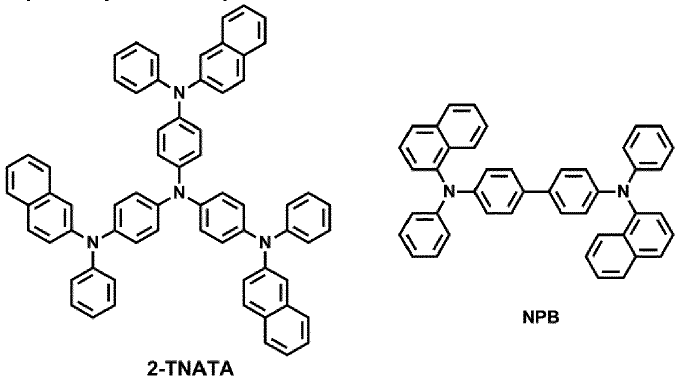

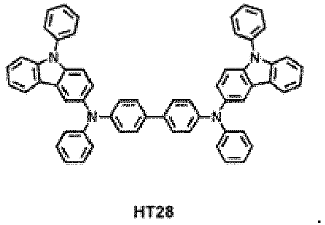

### Examples 2 to 5 and Comparative Examples 1 and 2

Additional organic light-emitting devices were manufactured in substantially the same manner as in Example 1, except that in forming an emission layer, corresponding compounds shown in Table 1 were used as a dopant instead of Compound 1.

### Evaluation Example 1

The driving voltage (V) at 1000 cd/m², current density (mA/cm²), luminescence efficiency (cd/A), maximum emission wavelength (nm), and lifespan (LT₈₀) of the organic light-emitting devices manufactured according to Examples 1 to 5 and Comparative Examples 1 and 2 were measured using a Keithley MU 236 and luminance meter PR650, and the results are shown in Table 1. In Table 1, the lifespan (LT₈₀) is a measure of the time elapsed when the luminance reaches 80% of the initial luminance.

**Table 1**

| | Emission layer compound | Driving voltage (V) | Current density (mA/cm²) | Luminance (cd/m') | Efficiency (cd/A) | Emission wavelength (nm) | Lifespan (LT₈₀) (h) |
|---|---|---|---|---|---|---|---|
| Example 1 | 7 | 5.80 | 50 | 4012 | 7.98 | 512 | 365 |
| Example 2 | 10 | 5.89 | 50 | 4042 | 8.02 | 502 | 386 |
| Example 3 | 22 | 6.02 | 50 | 4031 | 8.10 | 498 | 395 |
| Example 4 | 34 | 5.75 | 50 | 4054 | 8.23 | 507 | 399 |
| Example 5 | 43 | 5.74 | 50 | 4021 | 8.25 | 489 | 401 |
| Comparative Example 1 | A | 6.95 | 50 | 3854 | 6.87 | 551 | 330 |
| Comparative Example 2 | B | 7.11 | 50 | 3770 | 7.15 | 687 | 357 |

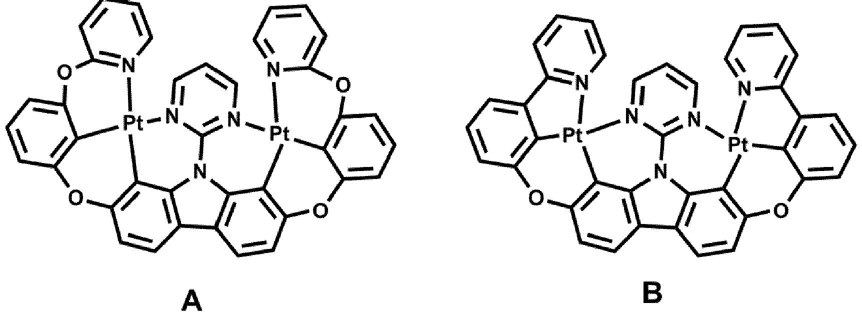

Referring to Table 1, it was confirmed that the organic light-emitting devices of Examples 1 to 5 each had a low driving voltage, a high level of luminance, a high level of luminescence efficiency, and a long lifespan compared to the organic light-emitting devices of Comparative Examples 1 and 2.

An organic light-emitting device including an organometallic compound according to embodiments of the present disclosure, may have a low driving voltage, high luminance, high efficiency, and a long lifespan.

## Claims

1. An organic light-emitting device comprising:
a first electrode;
a second electrode facing the first electrode; and
an emission layer between the first electrode and the second electrode,
wherein the emission layer comprises a first compound, a second compound, and a third compound,
the first compound, the second compound, and the third compound are different from each other,
the first compound is represented by Formula 1,
the second compound is represented by Formula 2-1 or 2-2, and
the third compound includes a group represented by Formula 3: 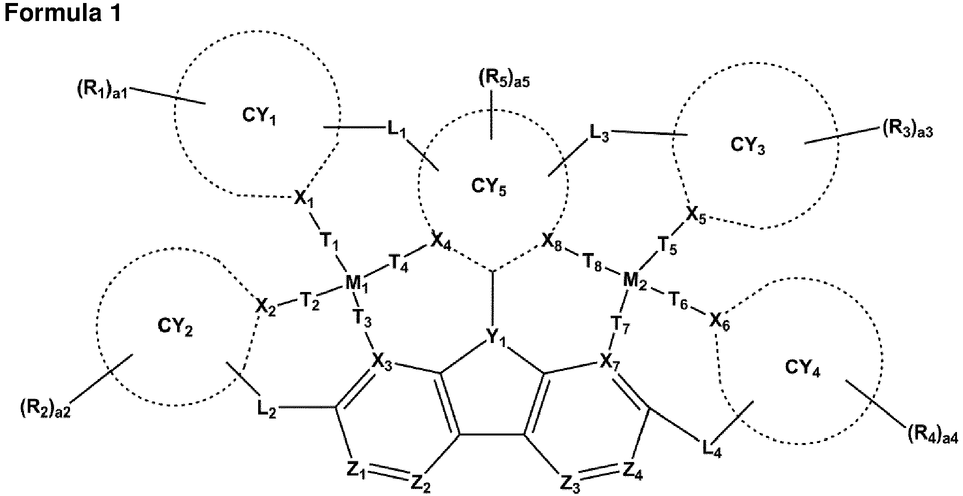 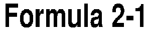 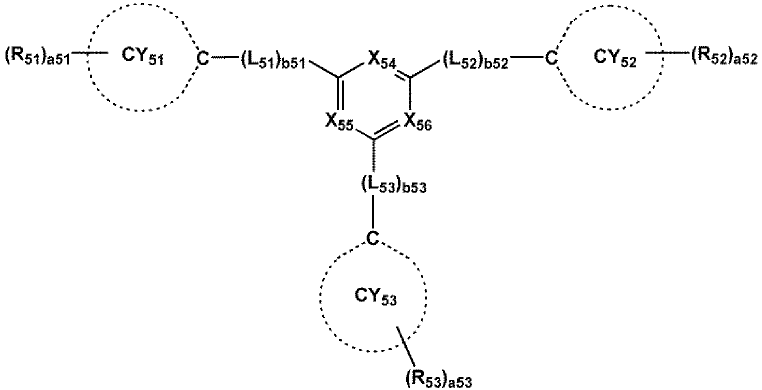 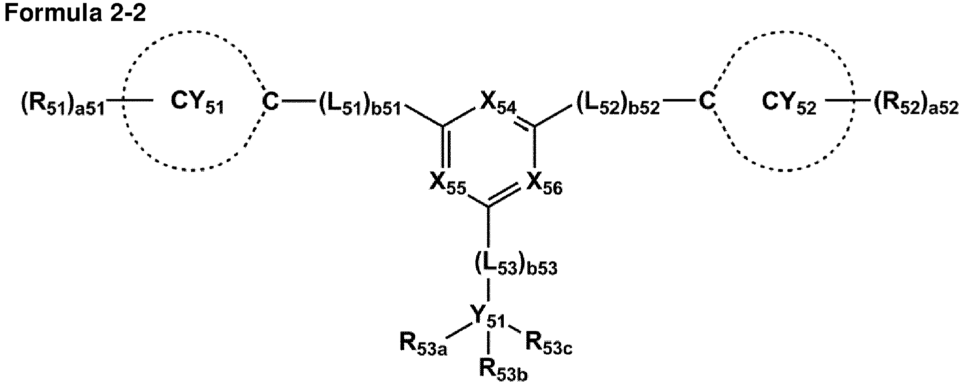 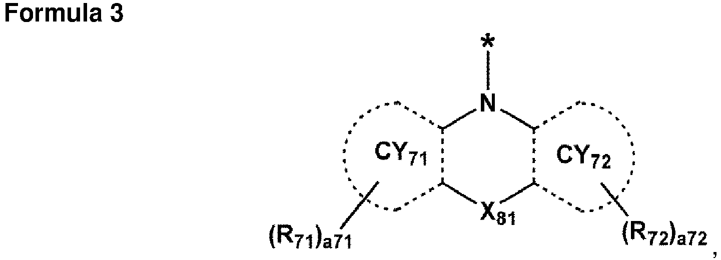
wherein, in Formulae 1 to 3,
M₁ and M₂ are each independently platinum (Pt) or palladium (Pd),
X₁ to X₈ are each independently N or C,
Y₁ is selected from C(R₆), Si(R₆), N, and P,
Z₁ to Z₄ are each independently N or C(R₇),
T₁ to T₈ are each independently a chemical bond, O, S, B(R'), N(R'), P(R'), C(R')(R"), Si(R')(R"), Ge(R')(R"), C(=O), B(R')(R"), N(R')(R"), or P(R')(R"), wherein, when T₁ is a chemical bond, X₁ and M₁ are directly linked to each other, when T₂ is a chemical bond, X₂ and M₁ are directly linked to each other, when T₃ is a chemical bond, X₃ and M₁ are directly linked to each other, when T₄ is a chemical bond, X₄ and M₁ are directly linked to each other, when T₅ is a chemical bond, X₅ and M₂ are directly linked to each other, when T₆ is a chemical bond, X₆ and M₂ are directly linked to each other, when T₇ is a chemical bond, X₇ and M₂ are directly linked to each other, and when T₈ is a chemical bond, X₈ and M₂ are directly linked to each other,
two bonds selected from a bond between M₁ and either X₁ or T₁, a bond between M₁ and either X₂ or T₂, a bond between M₁ and either X₃ or T₃, and a bond between M₁ and either X₄ or T₄ are each a coordination bond, and the other two bonds are each a covalent bond,
two bonds selected from a bond between M₂ and either X₅ or T₅, a bond between M₂ and either X₆ or Ts, a bond between M₂ and either X₇ or T₇, and a bond between M₂ and either X₈ or T₈ are each a coordination bond, and the other two bonds are each a covalent bond,
L₁ to L₄ are each independently selected from a single bond, a double bond, *-N(R8)-*', *-B(R₈)-*', *-P(R₈)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*', *-C(R₈)=*', *=C(Rs)-*', *-C(R₈ₐ)=C(R_{8b})-*', *-C(=S)-*', and *-C≡C-*',
ring CY₁ to ring CY₅, ring CY₅₁ to ring CY₅₃, ring CY₇₁, and ring CY₇₂ are each independently selected from a C₅-C₃₀ carbocyclic group and a C₁-C₃₀ heterocyclic group,
L₅₁ to L₅₃ are each independently selected from a substituted or unsubstituted C₅-C₃₀ carbocyclic group and a substituted or unsubstituted C₁-C₃₀ heterocyclic group,
a bond between L₅₁ and ring CY₅₁, a bond between L₅₂ and ring CY₅₂, a bond between L₅₃ and ring CY₅₃, a bond between two or more L₅₁(s), a bond between two or more L₅₂(s), a bond between two or more L₅₃(s), a bond between L₅₁ and carbon between X₅₄ and X₅₅ in Formulae 2-1 and 2-2, a bond between L₅₂ and carbon between X₅₄ and X₅₆ in Formulae 2-1 and 2-2, and a bond between L₅₃ and carbon between X₅₅ and X₅₆ in Formulae 2-1 and 2-2 are each a carbon-carbon single bond,
b51 to b53 are each independently an integer from 0 to 5, wherein, when b51 is 0, *-(L₅₁)_{b51}-*' is a single bond, when b52 is 0, *-(L₅₂)_{b52}-*' is a single bond, and when b53 is 0, *-(L₅₃)_{b53}-*' is a single bond,
X₅₄ is N or C(R₅₄), X₅₅ is N or C(R₅₅), and X₅₆ is N or C(R₅₆), wherein at least one selected from X₅₄ to X₅₆ is N,
Y₅₁ is C or Si,
X₈₁ is a single bond, O, S, N(R₈₁), B(R₈₁), C(R₈₁ₐ)(R_{81b}), or Si(R₈₁ₐ)(R_{81b}),
R₁ to R₈, R₈ₐ, R_{8b}, R', R", R₅₁ to R₅₆, R₅₃ₐ to R_{53c}, R₇₁, R₇₂, R₈₁, R₈₁ₐ, and R_{81b} are each independently selected from hydrogen, deuterium, -F, -Cl, -Br, -I, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -C(Q₁)(Q₂)(Q₃), -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂),
a1 to a5, a51 to a53, a71, and a72 are each independently an integer from 0 to 20,
i) two groups among R₁(s) in the number of a1, ii) two groups among R₂(s) in the number of a2, iii) two groups among R₃(s) in the number of a3, iv) two groups among R₄(s) in the number of a4, v) two groups among R₅(s) in the number of a5, vi) R₈ₐ and R_{8b}, and vii) two groups among R₁ to R₈, R₈ₐ, R_{8b}, R', and R" are each independently optionally linked to each other via a single bond, a double bond, or a first linking group, so as to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
R₁₀ₐ is the same as described in connection with R₁,
* and *' each indicate a binding site to a neighboring atom, and
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group is selected from:
deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, - Br, -I, a hydroxyl group, a cyano group, a nitro group, an amidino group, a hydrazine group, a hydrazone group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -O(Q₁₁), -S(Q₁₁), -Si(Q₁₁)(Q₁₂)(Q₁₃), -N(Q₁₁)(Q₁₂), -B(Q₁₁)(Q₁₂), -P(Q₁₁)(Q₁₂), - C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -O(Q₂₁), -S(Q₂₁), - Si(Q₂₁)(Q₂₂)(Q₂₃), -N(Q₂₁)(Q₂₂), -B(Q₂₁)(Q₂₂), -P(Q₂₁)(Q₂₂), -C(=O)(Q₂₁), -S(=O)₂(Q₂₁), and -P(=O)(Q₂₁)(Q₂₂); and
-O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), and -P(=O)(Q₃₁)(Q₃₂), and
Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a C₁-C₆₀ alkyl group that is substituted with at least one selected from deuterium, -F, a cyano group, a C₁-C₆₀ alkyl group, a phenyl group, and a biphenyl group, and a C₆-C₆₀ aryl group that is substituted with at least one selected from deuterium, -F, a cyano group, a C₁-C₁₀ alkyl group, a phenyl group, and a biphenyl group.

2. An organic light-emitting device according to claim 1, wherein, in Formulae 1 to 3, ring CY₁ to ring CY₅, ring CY₅₁ to ring CY₅₃, ring CY₇₁, and ring CY₇₂ are each independently i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,
the first ring is selected from a cyclopentane group, a cyclopentadiene group, a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group, and
the second ring is selected from an adamantane group, a norbornane group, a norbornene group, a cyclohexane group, a cyclohexene group, a benzene group, a pyridine group, a pyrimidine group, a pyrazine group, a pyridazine group, a triazine group, an oxasiline group, a thiasiline group, a dihydroazasiline group, a dihydrodisiline group, a dihydrosiline group, a dioxine group, an oxathiine group, an oxazine group, a pyran group, a dithiine group, a thiazine group, a thiopyran group, a cyclohexadiene group, a dihydropyridine group, and a dihydropyrazine group.

3. An organic light-emitting device according to claim 1 or claim 2, wherein in Formulae 2-1 and 2-2, a group represented by 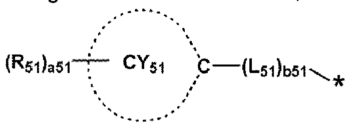 and a group represented by 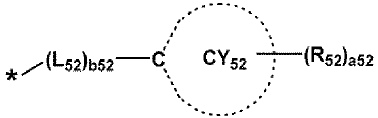 are each not a phenyl group, optionally wherein, in Formulae 2-1 and 2-2, a group represented by 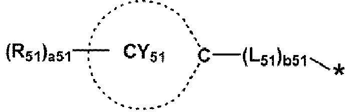 and a group represented by 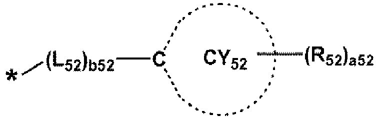 are identical to each other, optionally wherein a moiety represented by 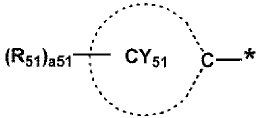 is selected from groups represented by Formulae CY51-1 to CY51-19, and/or
a moiety represented by 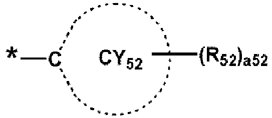 is selected from groups represented by Formulae CY52-1 to CY52-19, and/or
a moiety represented by 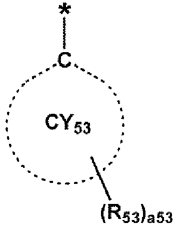 is selected from groups represented by Formulae CY53-1 to CY53-18: 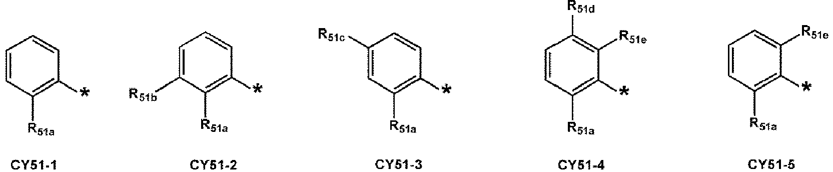 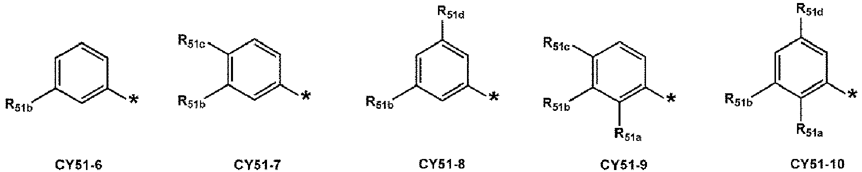 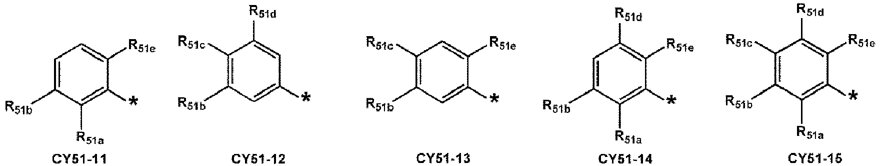 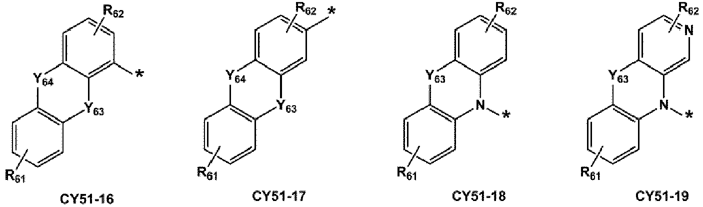 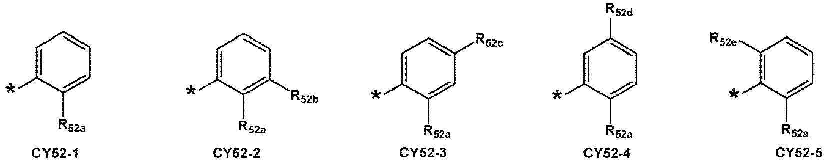 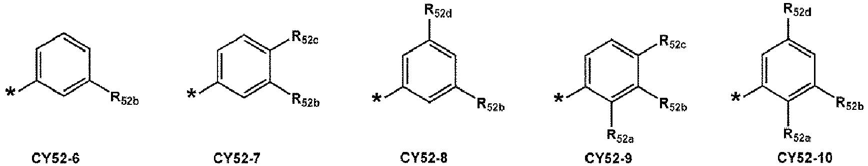 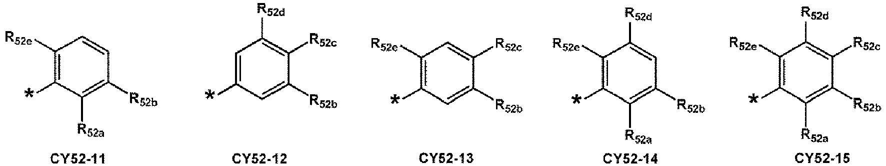 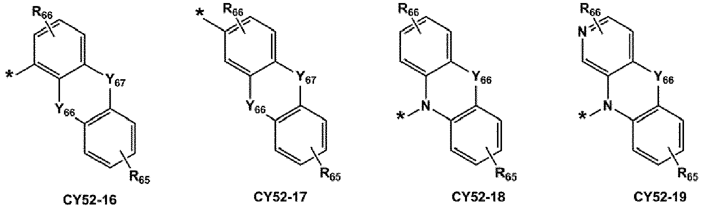 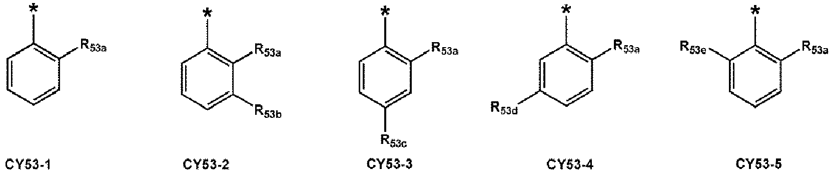 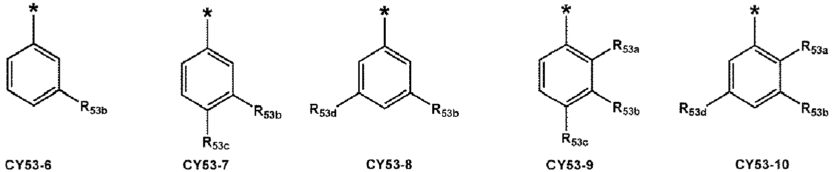 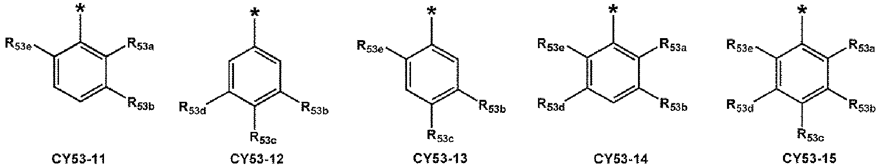 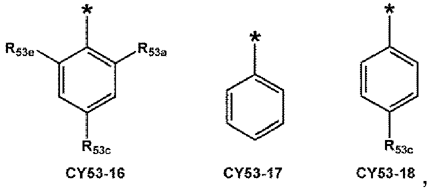
wherein, in Formulae CY51-1 to CY51-19, CY52-1 to CY52-19, and CY53-1 to CY53-18,
Y₆₃ is a single bond, O, S, N(R₆₃), B(R₆₃), C(R₆₃ₐ)(R_{63b}), or Si(R₆₃ₐ)(R_{63b}),
Y₆₄ is a single bond, O, S, N(R₆₄), B(R₆₄), C(R₆₄ₐ)(R_{64b}), or Si(R₆₄ₐ)(R_{64b}),
Y₆₆ is a single bond, O, S, N(R₆₆), B(R₆₆), C(R₆₆ₐ)(R_{66b}), or Si(R₆₆ₐ)(R_{66b}),
Y₆₇ is a single bond, O, S, N(R₆₇), B(R₆₇), C(R₆₇ₐ)(R_{67b}), or Si(R₆₇ₐ)(R_{67b}),
Y₆₃ and Y₆₄ in Formulae CY51-16 and CY51-17 are not each a single bond at the same time,
Y₆₆ and Y₆₇ in Formulae CY52-16 and CY52-17 are not each a single bond at the same time,
R₅₁ₐ to R₅₁ₑ, R₆₁ to R₆₄, R₆₃ₐ, R_{63b}, R₆₄ₐ, and R_{64b} are each independently the same as described in connection with R₅₁, and R₅₁ₐ to R₅₁ₑ are not each hydrogen,
R₅₂ₐ to R₅₂ₑ, R₆₅ to R₆₇, R₆₆ₐ, R_{66b}, R₆₇ₐ, and R_{67b} are each independently the same as described in connection with R₅₂, and R₅₂ₐ to R₅₂ₑ are not each hydrogen,
R₅₃ₐ to R₅₃ₑ are each independently the same as described in connection with R₅₃, and R₅₃ₐ to R₅₃ₑ are not each hydrogen, and
* indicates a binding site to an adjacent atom.

4. An organic light-emitting device according to any one of claims 1 to 3, wherein the third compound is represented by one selected from Formulae 3-1 to 3-5: 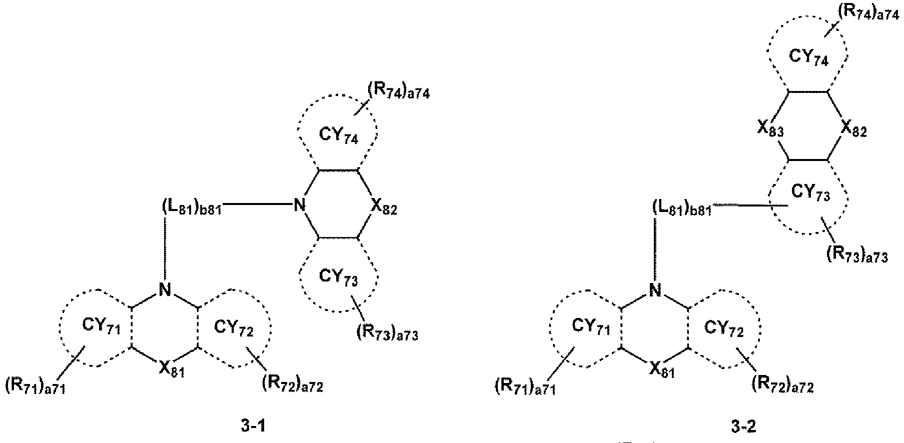 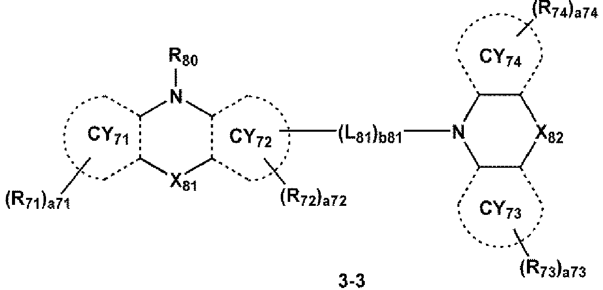 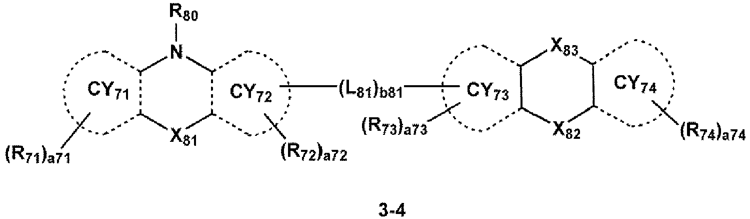 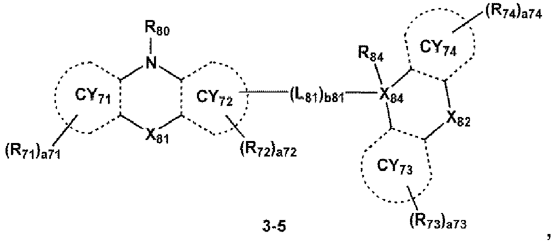 wherein, in Formulae 3-1 to 3-5,
ring CY₇₁, ring CY₇₂, X₈₁, R₇₁, R₇₂, a71, and a72 are the same as described above,
ring CY₇₃, ring CY₇₄, R₇₃, R₇₄, a73, and a74 are the same as described in connection with ring CY₇₁, ring CY₇₂, R₇₁, R₇₂, a71, and a72, respectively,
L₈₁ is selected from *-C(Q₄)(Q₅)-*', *-Si(Q₄)(Q₅)-*', a substituted or unsubstituted C₅-C₃₀ carbocyclic group, and a substituted or unsubstituted C₁-C₃₀ heterocyclic group, wherein Q₄ and Q₅ are each the same as described in connection with Q₁,
b81 is an integer from 0 to 5, wherein, when b81 is 0, *-(L₈₁)_{b81}-*' is a single bond, when b81 is 2 or more, two or more L₈₁(s) are identical to or different from each other,
X₈₂ is a single bond, O, S, N(R₈₂), B(R₈₂), C(R₈₂ₐ)(R_{82b}), or Si(R₈₂ₐ)(R_{82b}),
X₈₃ is a single bond, O, S, N(R₈₃), B(R₈₃), C(R₈₃ₐ)(R_{83b}), or Si(R₈₃ₐ)(R_{83b}),
in Formulae 3-2 and 3-4, X₈₂ and X₈₃ are not each a single bond at the same time,
X₈₄ is C or Si,
R₈₀, R₈₂, R₈₃, R₈₂ₐ, R_{82b}, R₈₃ₐ, R_{83b}, and R₈₄ are the same as described in connection with R₈₁, and
* and *' each indicate a binding site to a neighboring atom, optionally wherein a moiety represented by 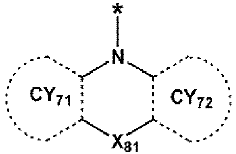 in Formulae 3-1 and 3-2 is selected from groups represented by Formulae CY71-1 (1) to CY71-1 (8),
a moiety represented by 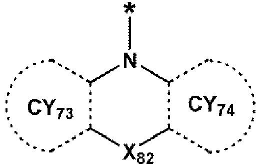 in Formulae 3-1 and 3-3 is selected from groups represented by Formulae CY71-2(1) to CY71-2(8),
a moiety represented by 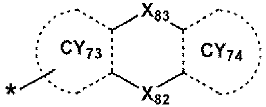 in Formulae 3-2 and 3-4 is selected from groups represented by Formulae CY71-3(1) to CY71-3(32),
a moiety represented by 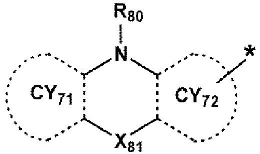 in Formulae 3-3 to 3-5 is selected from groups represented by Formulae CY71-4(1) to CY71-4(32), and
a moiety represented by 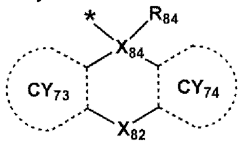 in Formula 3-5 is selected from groups represented by Formulae CY71-5(1) to CY71-5(8): 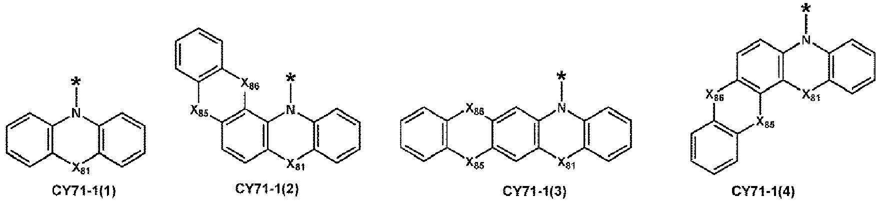 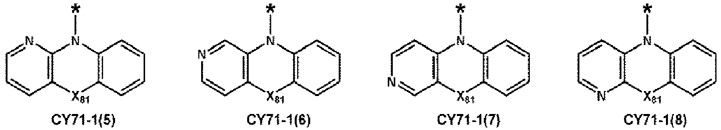 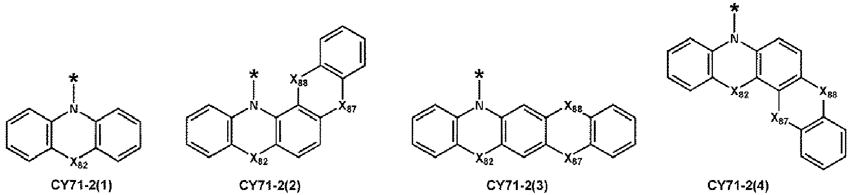 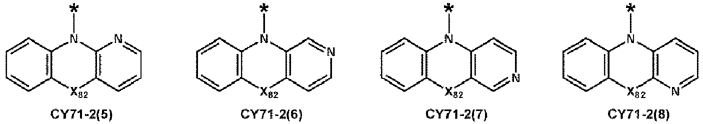 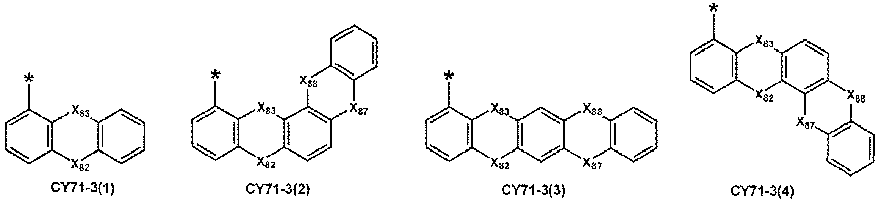 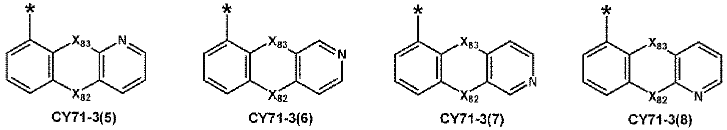 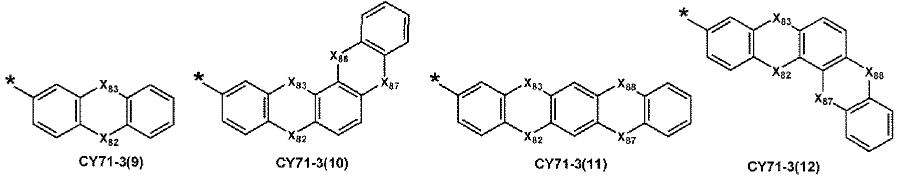 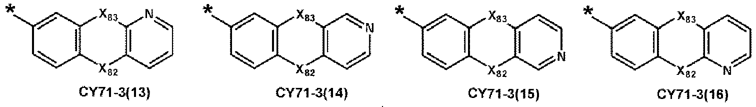 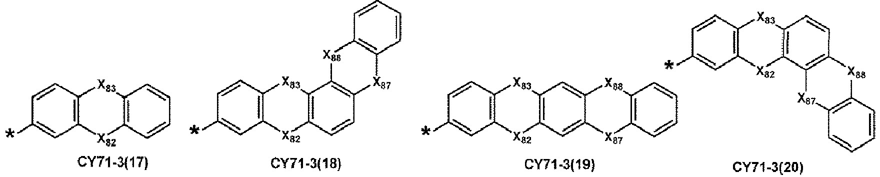 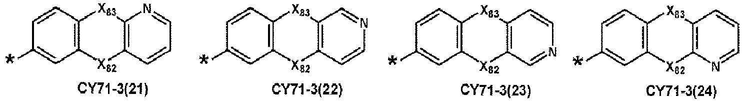 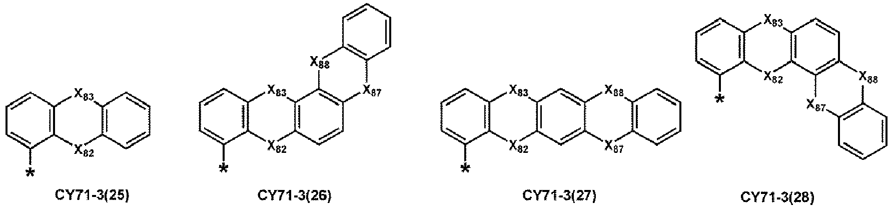 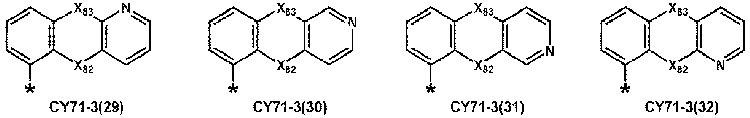 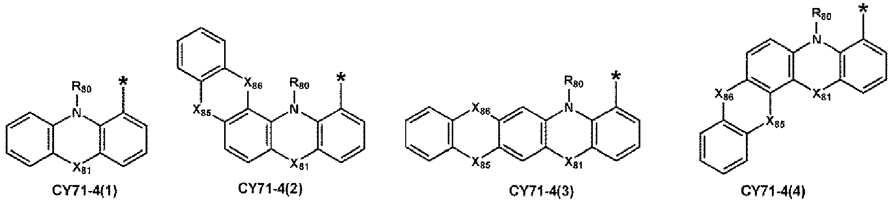 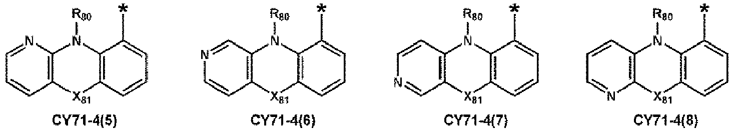 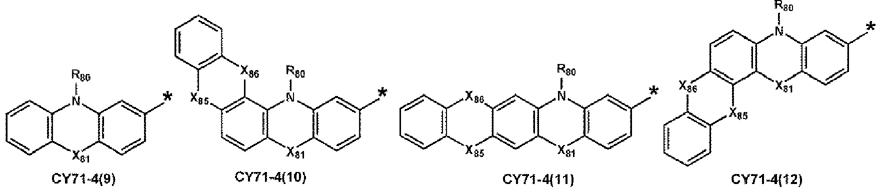 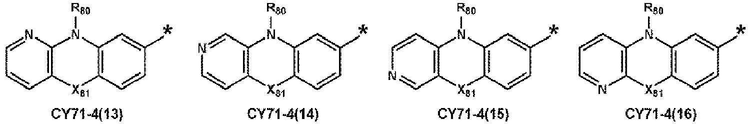 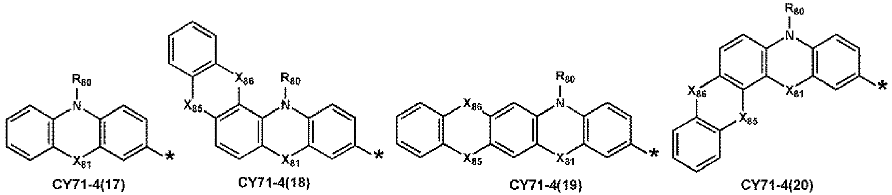 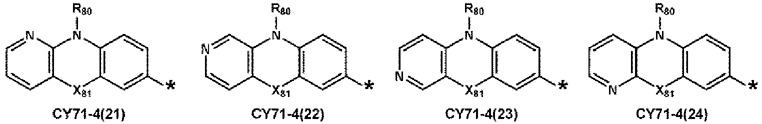 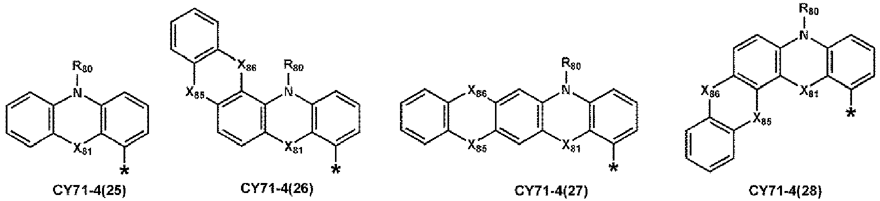 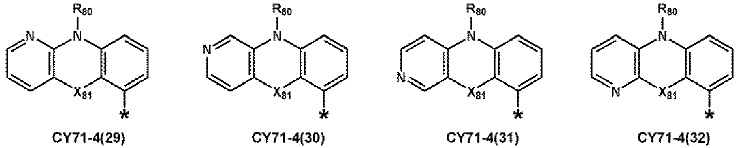 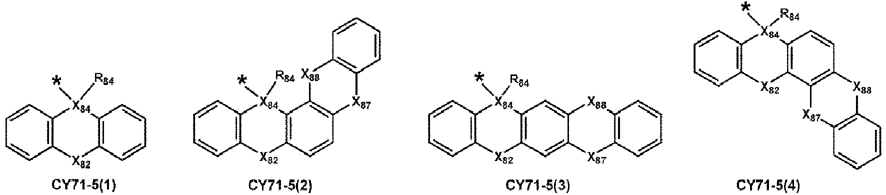 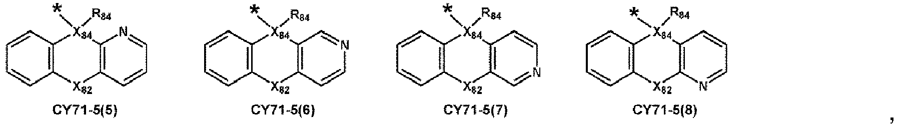
wherein, in Formulae CY71-1 (1) to CY71-1 (8), CY71-2(1) to CY71-2(8), CY71- 3(1) to CY71-3(32), CY71-4(1) to CY71-4(32), and CY71-5(1) to CY71-5(8),
X₈₁ to X₈₄, R₈₀, and R₈₄ are each independently the same as described above,
X₈₅ is a single bond, O, S, N(R₈₅), B(R₈₅), C(R₈₅ₐ)(R_{85b}), or Si(R₈₅ₐ)(R_{85b}), and
X₈₆ is a single bond, O, S, N(R₈₆), B(R₈₆), C(R₈₆ₐ)(R_{86b}), or Si(R₈₆ₐ)(R_{86b}),
in Formula CY71-1(1) to CY71-1(8) and CY71-4(1) to CY71-4(32), X₈₅ and X₈₆ are each not a single bond at the same time,
X₈₇ is a single bond, O, S, N(R₈₇), B(R₈₇), C(R₈₇ₐ)(R_{87b}), or Si(R₈₇ₐ)(R_{87b}), and
X₈₈ is a single bond, O, S, N(R₈₈), B(R₈₈), C(R₈₈ₐ)(R_{88b}), or Si(R₈₈ₐ)(R_{88b}), and
in Formulae CY71-2(1) to CY71-2(8), CY71-3(1) to CY71-3(32), and CY71-5(1) to CY71-5(8), X₈₇ and X₈₈ are not each a single bond at the same time, and
R₈₅ to R₈₈, R₈₅ₐ, R_{85b}, R₈₆ₐ, R_{86b}, R₈₇ₐ, R_{87b}, R₈₈ₐ, and R_{88b} are each independently the same as described in connection with R₈₁.

5. An organic light-emitting device according to claim 1, wherein the second compound is selected from Compounds H2-1 to H2-80, and
the third compound is selected from Compounds H3-1 to H3-28:

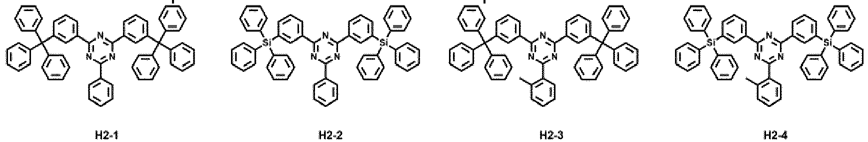

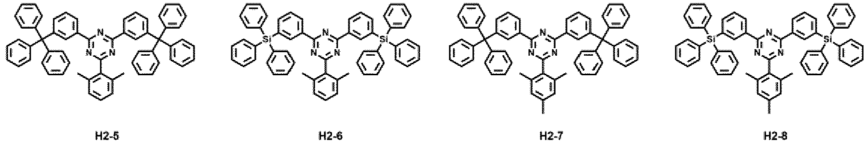

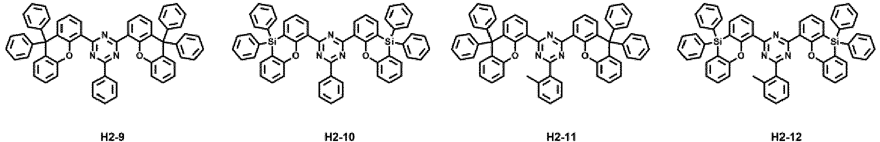

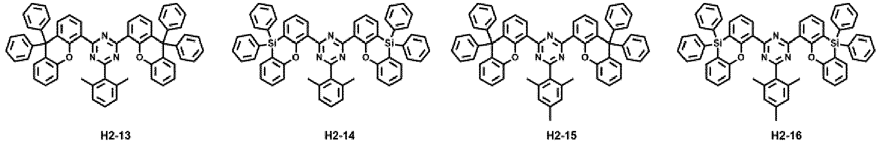

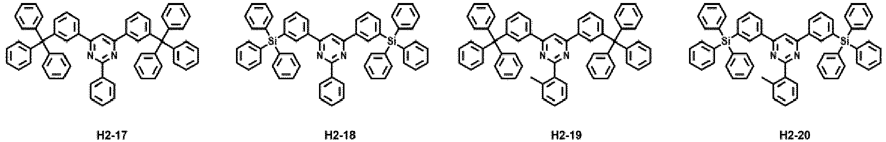

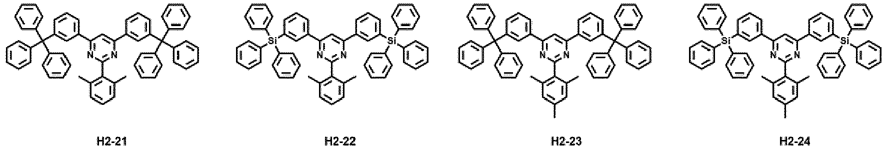

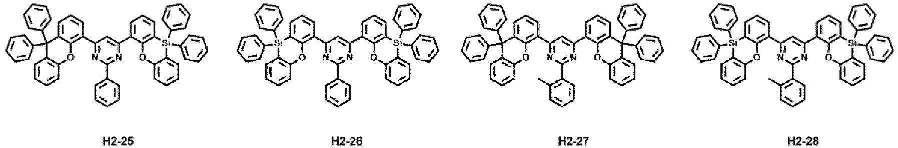

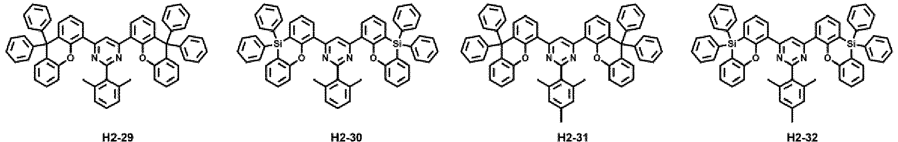

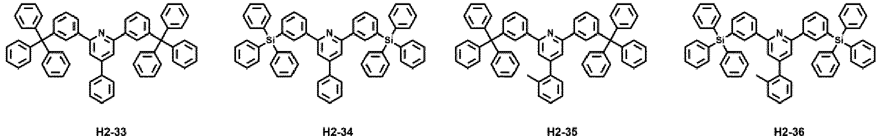

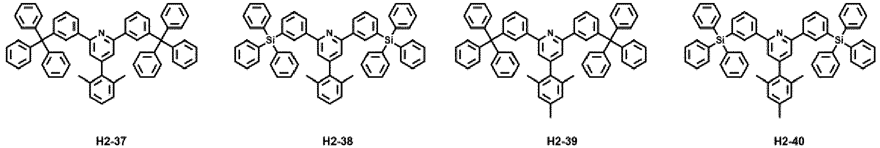

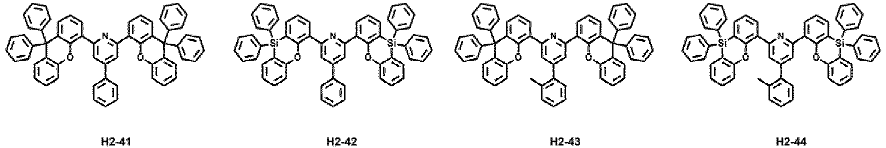

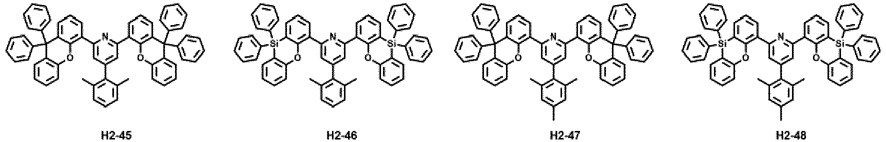

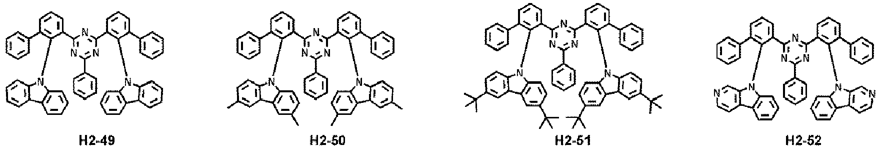

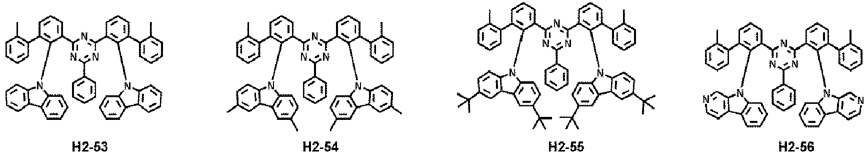

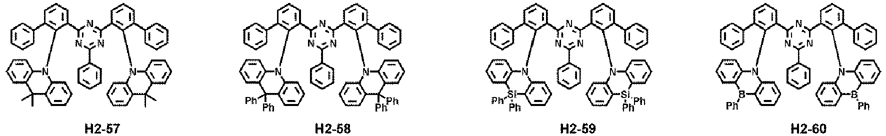

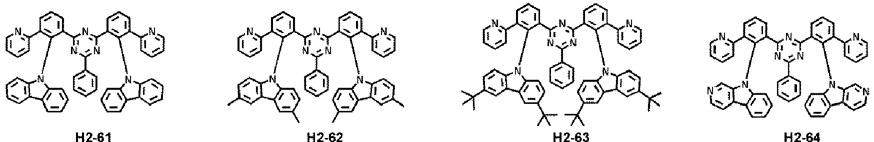

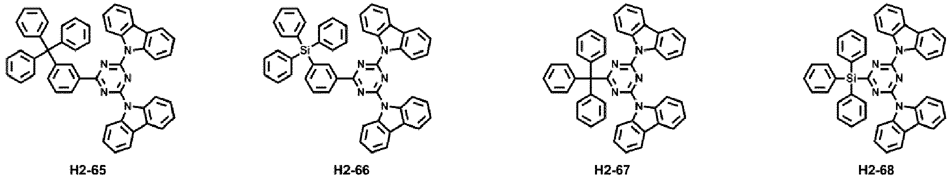

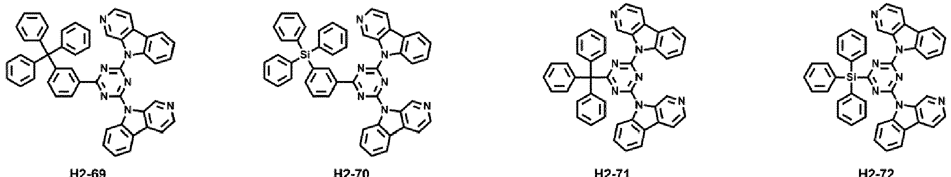

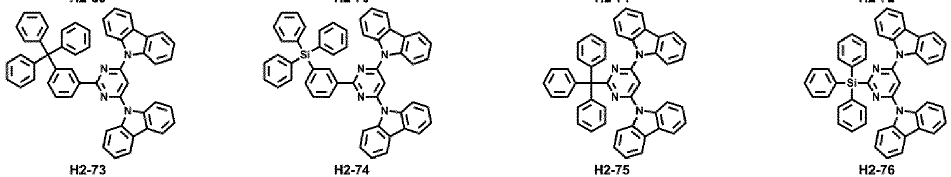

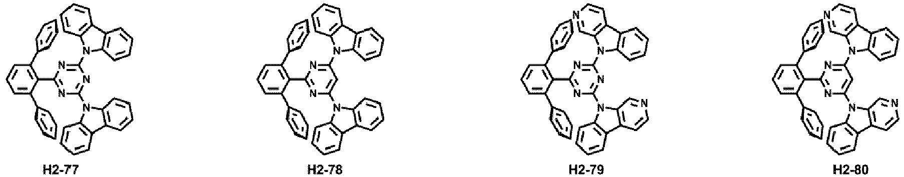

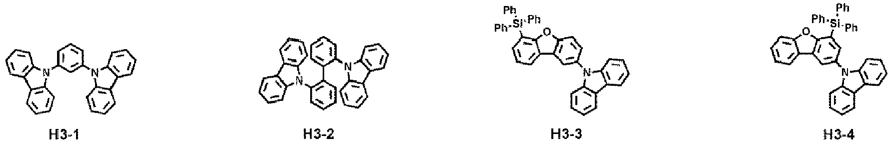

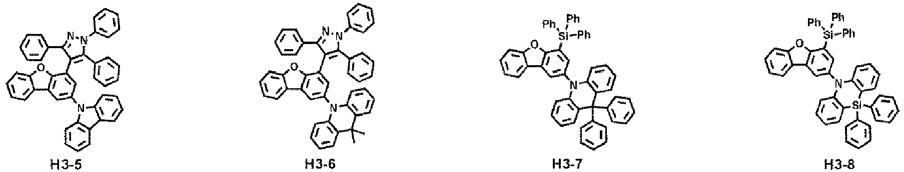

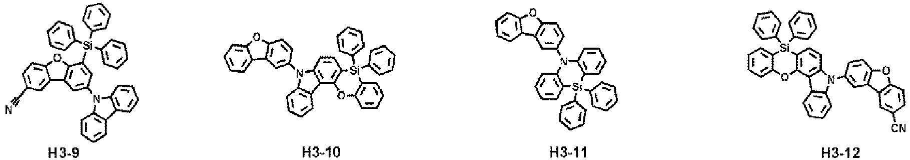

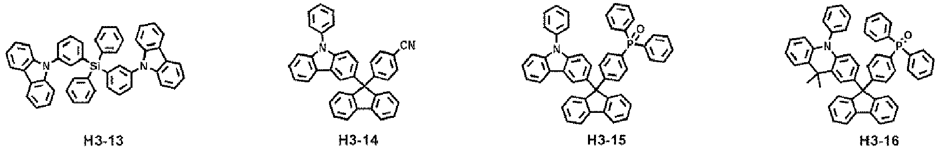

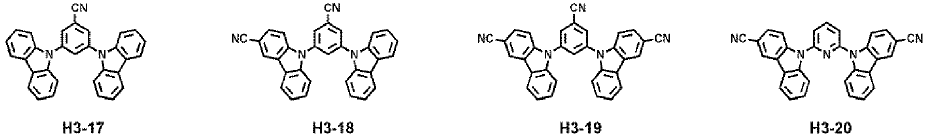

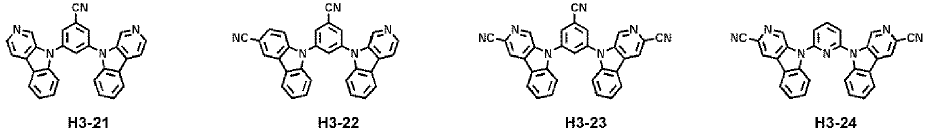

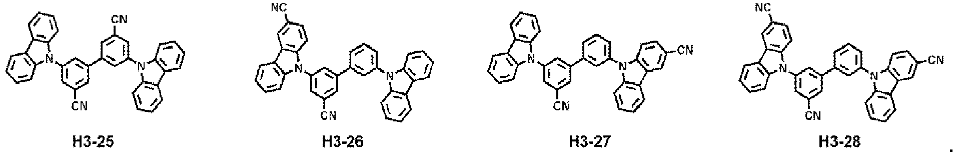

6. An organic light-emitting device according to any one of claims 1 to 5, wherein the second compound and the third compound form an exciplex.

7. An organic light-emitting device according to any one of claims 1 to 6, wherein the decay time of delayed fluorescence in the time-resolved electroluminescence (TREL) spectrum of the organic light-emitting device is 50 ns or more, optionally wherein the organic light-emitting device further includes a capping layer on the second electrode, and
the capping layer has a refractive index of 1.6 or more at a wavelength of 589 nm, optionally wherein the emission layer has a maximum emission wavelength of 390 nm or more and 520 nm or less.

8. An organometallic compound represented by Formula 1: 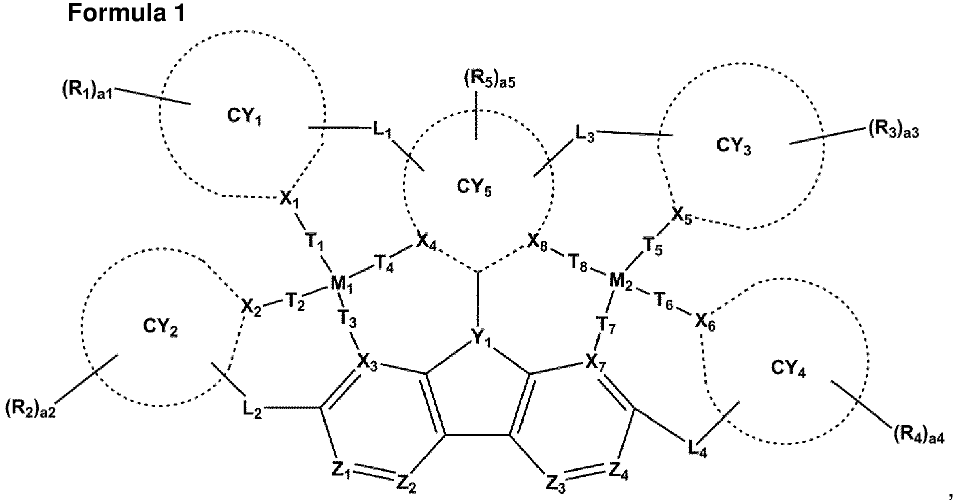 wherein, in Formula 1,
M₁ and M₂ are each independently platinum (Pt) or palladium (Pd),
X₁ to X₈ are each independently N or C,
Y₁ is selected from C(R₆), Si(R₆), N, and P,
Z₁ to Z₄ are each independently N or C(R₇),
T₁ to T₈ are each independently a chemical bond, O, S, B(R'), N(R'), P(R'), C(R')(R"), Si(R')(R"), Ge(R')(R"), C(=O), B(R')(R"), N(R')(R"), or P(R')(R"), wherein, when T₁ is a chemical bond, X₁ and M₁ are directly linked to each other, when T₂ is a chemical bond, X₂ and M₁ are directly linked to each other, when T₃ is a chemical bond, X₃ and M₁ are directly linked to each other, when T₄ is a chemical bond, X₄ and M₁ are directly linked to each other, when T₅ is a chemical bond, X₅ and M₂ are directly linked to each other, when T₆ is a chemical bond, X₆ and M₂ are directly linked to each other, when T₇ is a chemical bond, X₇ and M₂ are directly linked to each other, and when T₈ is a chemical bond, X₈ and M₂ are directly linked to each other,
two bonds selected from a bond between M₁ and either X₁ or T₁, a bond between M₁ and either X₂ or T₂, a bond between M₁ and either X₃ or T₃, and a bond between M₁ and either X₄ or T₄ are each a coordination bond, and the other two bonds are each a covalent bond,
two bonds selected from a bond between M₂ and either X₅ or T₅, a bond between M₂ and either X₆ or T₆, a bond between M₂ and either X₇ or T₇, and a bond between M₂ and either X₈ or T₈ are each a coordination bond, and the other two bonds are each a covalent bond,
L₁ to L₄ are each independently selected from a single bond, a double bond, *-N(R8)-*', *-B(R₈)-*', *-P(R₈)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*', *-C(R₈)=*', *=C(Rs)-*', *-C(R₈ₐ)=C(R_{8b})-*', *-C(=S)-*', and *-C=C-*',
ring CY₁ to ring CY₅ are each independently selected from a C₅-C₃₀ carbocyclic group and a C₁-C₃₀ heterocyclic group,
R₁ to R₈, R₈ₐ, R_{8b}, R', and R" are each independently selected from hydrogen, deuterium, -F, -Cl, -Br, -I, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂),
a1 to a5 are each independently an integer from 0 to 20,
i) two groups among R₁(s) in the number of a1, ii) two groups among R₂(s) in the number of a2, iii) two groups among R₃(s) in the number of a3, iv) two groups among R₄(s) in the number of a4, v) two groups among R₅(s) in the number of a5, vi) R₈ₐ and R_{8b}, and vii) two groups among R₁ to R₈, R₈ₐ, R_{8b}, R', and R" are each independently optionally linked to each other via a single bond, a double bond, or a first linking group, so as to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
R₁₀ₐ is the same as described in connection with R₁,
* and *' each indicate a binding site to a neighboring atom, and
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group is selected from:
deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, - Br, -I, a hydroxyl group, a cyano group, a nitro group, an amidino group, a hydrazine group, a hydrazone group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -O(Q₁₁), -S(Q₁₁), -Si(Q₁₁)(Q₁₂)(Q₁₃), -N(Q₁₁)(Q₁₂), -B(Q₁₁)(Q₁₂), -P(Q₁₁)(Q₁₂), - C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -O(Q₂₁), -S(Q₂₁), - Si(Q₂₁)(Q₂₂)(Q₂₃), -N(Q₂₁)(Q₂₂), -B(Q₂₁)(Q₂₂), -P(Q₂₁)(Q₂₂), -C(=O)(Q₂₁), -S(=O)₂(Q₂₁), and -P(=O)(Q₂₁)(Q₂₂); and
-O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), - C(=O)(Q₃₁), -S(=O)₂(Q₃₁), and -P(=O)(Q₃₁)(Q₃₂), and
Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a C₁-C₆₀ alkyl group that is substituted with at least one selected from deuterium, -F, a cyano group, a C₁-C₆₀ alkyl group, a phenyl group, and a biphenyl group, and a C₆-C₆₀ aryl group that is substituted with at least one selected from deuterium, -F, a cyano group, a C₁-C₁₀ alkyl group, a phenyl group, and a biphenyl group.

9. An organometallic compound according to claim 8, wherein ring CY₁ to ring CY₅ are each independently selected from a benzene group, a naphthalene group, an anthracene group, a phenanthrene group, an azulene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indenopyridine group, an indolopyridine group, a benzofuropyridine group, a benzothienopyridine group, a benzosilolopyridine group, an indenopyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isooxazole group, a thiazole group, an isothiazole group, an oxadiazole group, a thiadiazole group, a benzopyrazole group, a pyrazolopyridine group, a furopyrazole group, a thienopyrazole group, a benzimidazole group, a 2,3-dihydrobenzimidazole group, an imidazopyridine group, a 2,3-dihydroimidazopyridine group, a furanoimidazole group, a thienoimidazole group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline group.

10. An organometallic compound according to claim 8 or claim 9, wherein ring CY₁ to ring CY₄ are each independently selected from groups represented by Formulae 4-1 to 4-35: 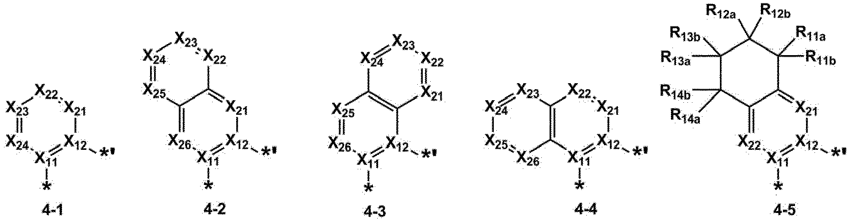 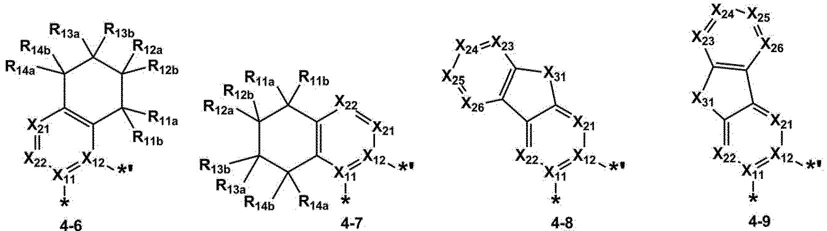 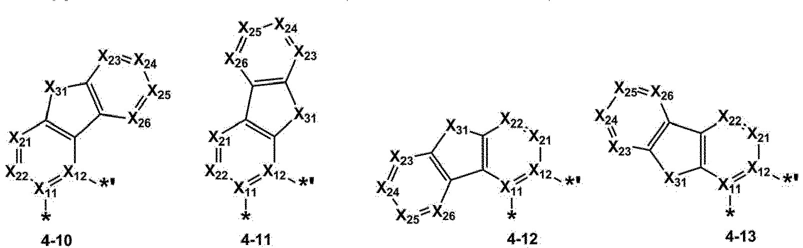 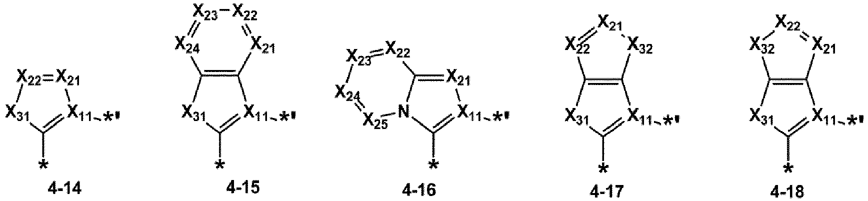 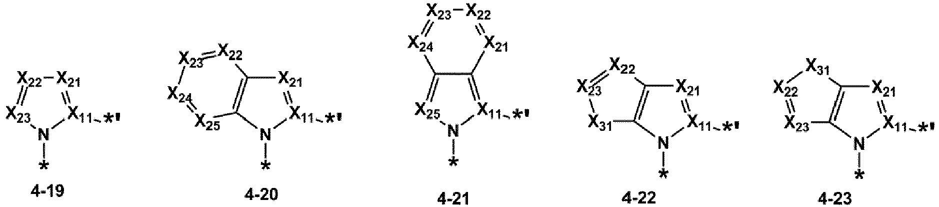 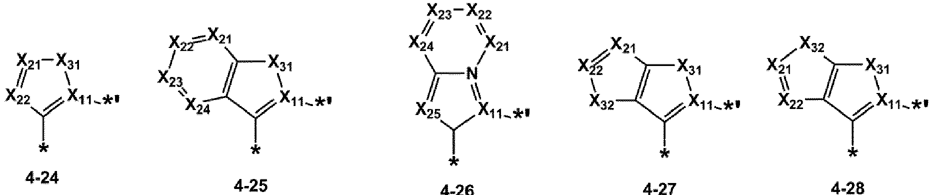 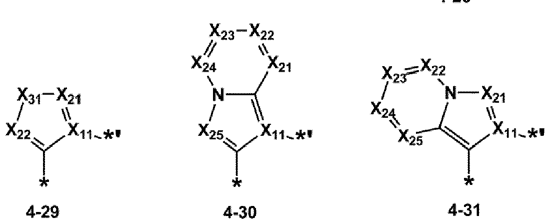 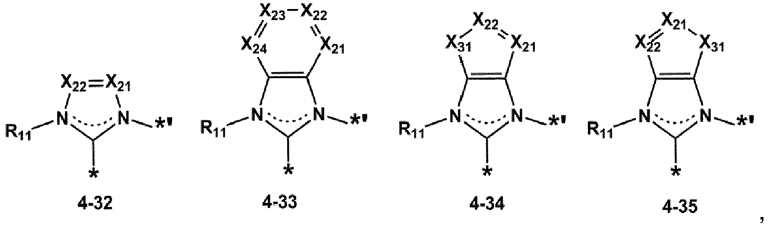 wherein, in Formulae 4-1 to 4-35,
X₁₁ and X₁₂ are each independently a carbon atom or a nitrogen atom,
X₂₁ is N or C(R₂₁), X₂₂ is N or C(R₂₂), X₂₃ is N or C(R₂₃), X₂₄ is N or C(R₂₄), X₂₅ is N or C(R₂₅), and X₂₆ is N or C(R₂₆),
X₃₁ is C(R₃₁ₐ)(R_{31b}), Si(R₃₁ₐ)(R_{31b}), N(R₃₁), O, or S,
X₃₂ is C(R₃₂ₐ)(R_{32b}), Si(R₃₂ₐ)(R_{32b}), N(R₃₂), O, or S,
R₁₁, R₁₁ₐ, R_{11b}, R₁₂ₐ, R_{12b}, R₁₃ₐ, R_{13b}, R₁₄ₐ, R_{14b}, R₂₁ to R₂₆, R₃₁ to R₃₂, R₃₁ₐ to R_{31b}, and R₃₂ₐ to R_{32b} are each independently the same as described in connection with R₁ to R₄ in Formula 1,
* indicates a binding site to T₁, T₂, T₃, T₄, T₅, T₆, T₇, or T₈, and
*' indicates a binding site to L₁, L₂, L₃, or L₄.

11. An organometallic compound according to any one of claims 8 to 10, wherein:
i) X₁ to X₈ are each C; or
ii) X₁ and X₅ are each N, and X₂ to X₄ and X₆ to X₈ are each C.

12. An organometallic compound according to any one of claims 8 to 11, wherein the organometallic compound is represented by Formula 1-1: 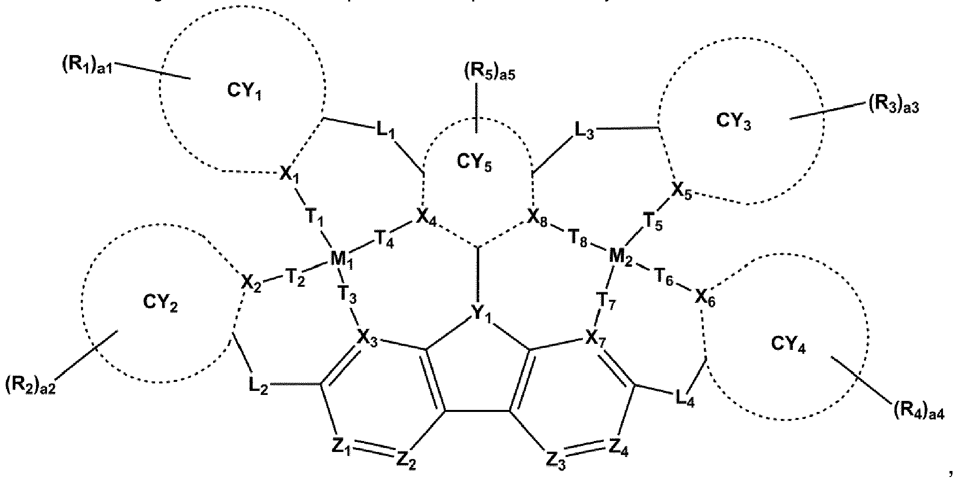 wherein, in Formula 1-1, M₁, M₂, X₁ to X₈, Y₁, Z₁ to Z₄, T₁ to T₈, L₁ to L₄, ring CY₁ to ring CY₅, R₁ to R₅, and a1 to a5 are each independently the same as described in connection with Formula 1.

13. An organometallic compound according to any one of claims 8 to 12, wherein the compound represented by Formula 1 has a symmetrical structure.

14. An organometallic compound according to claim 8, wherein the organometallic compound is selected from Compounds 1 to 120:

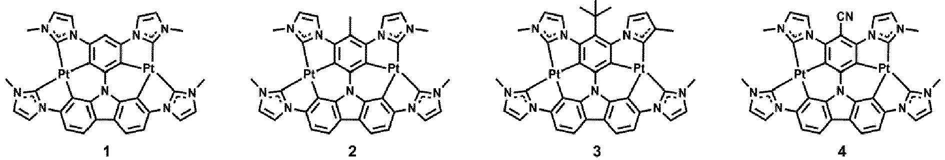

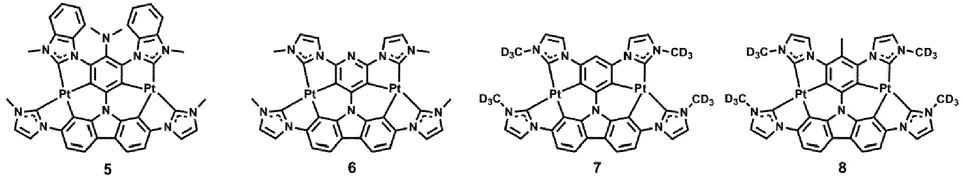

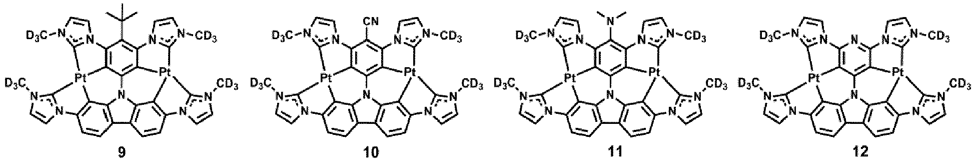

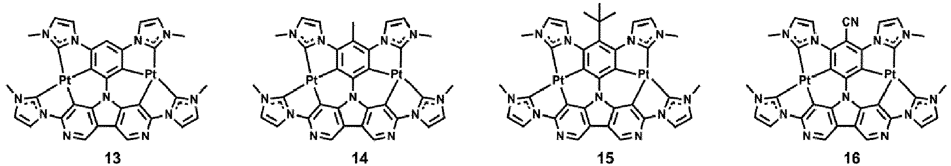

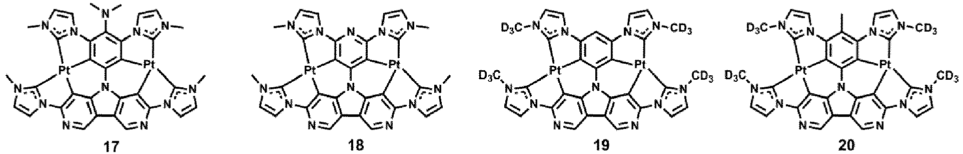

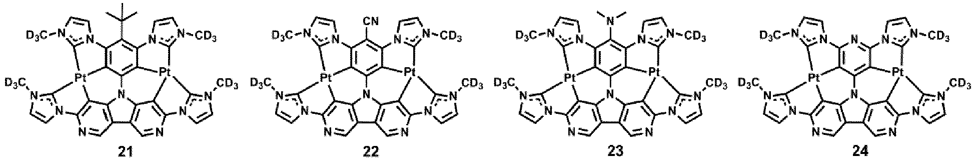

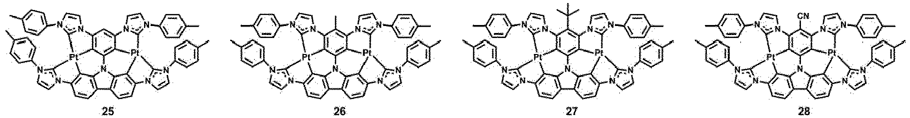

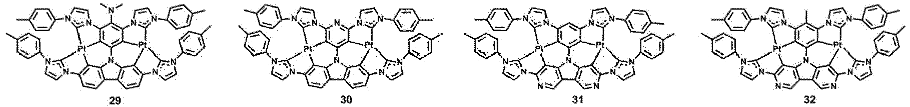

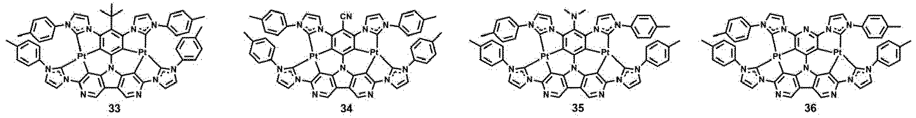

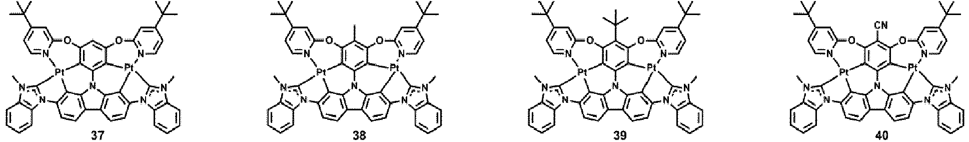

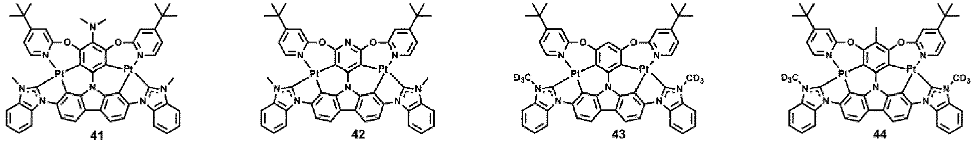

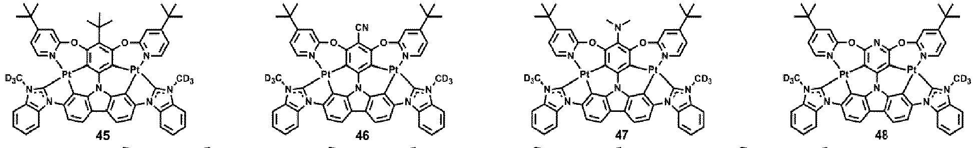

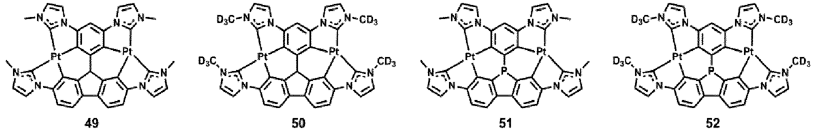

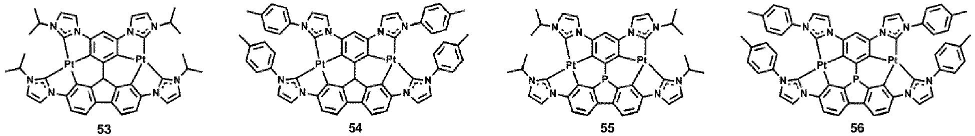

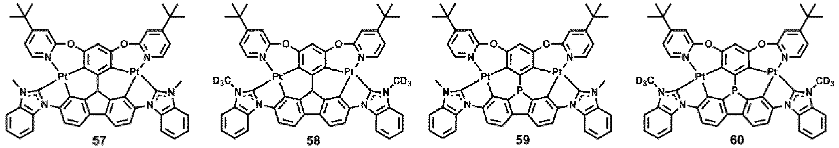

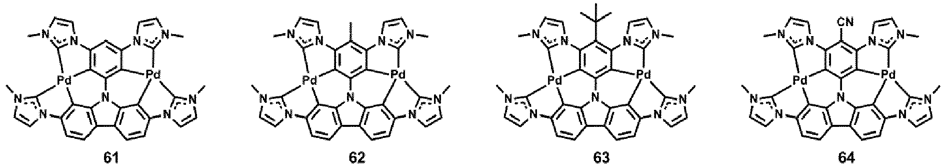

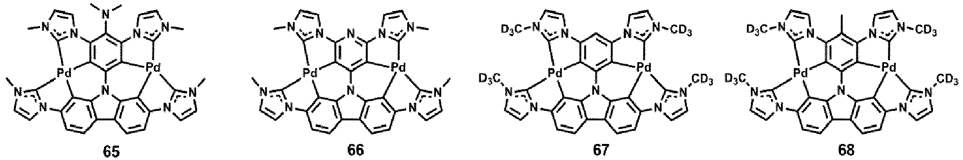

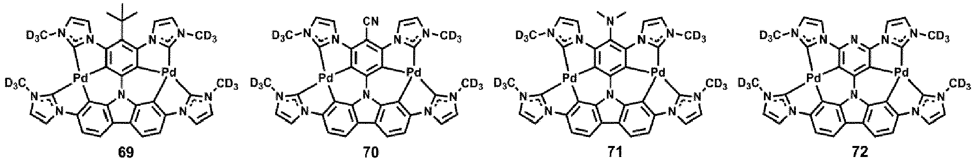

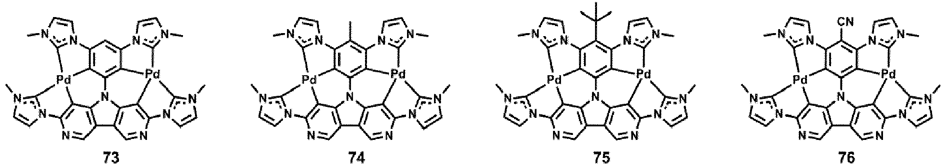

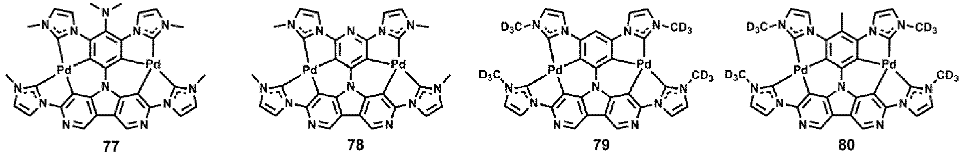

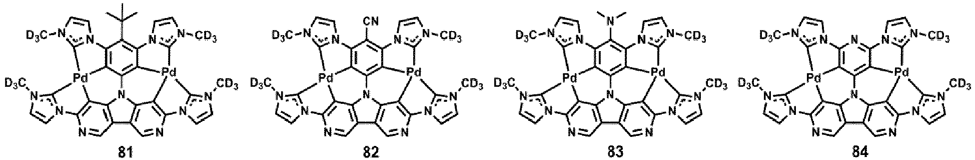

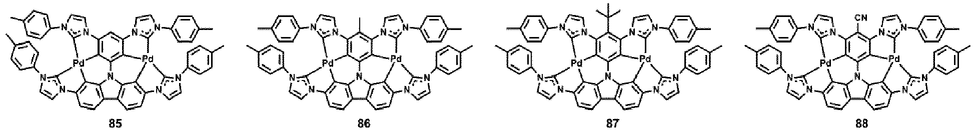

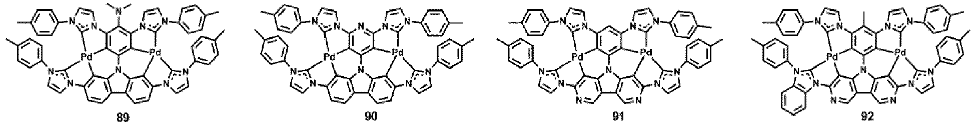

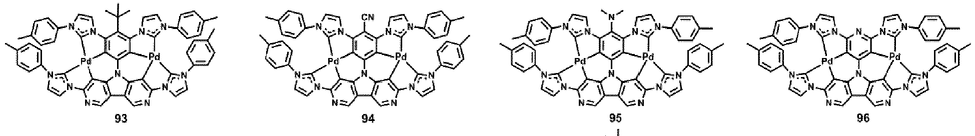

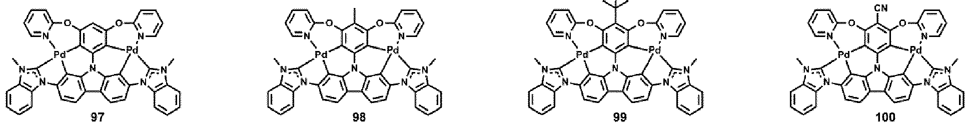

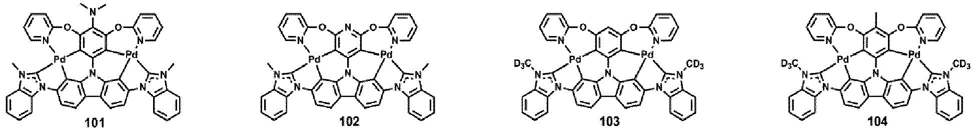

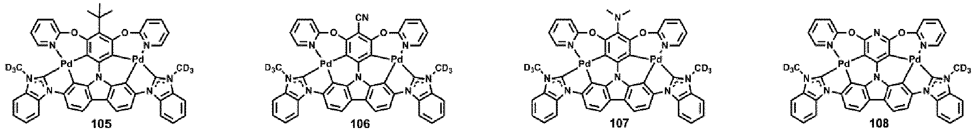

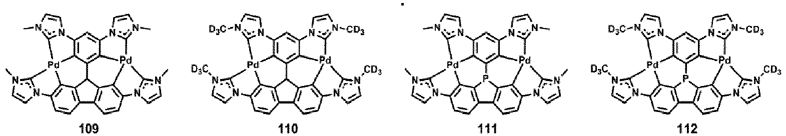

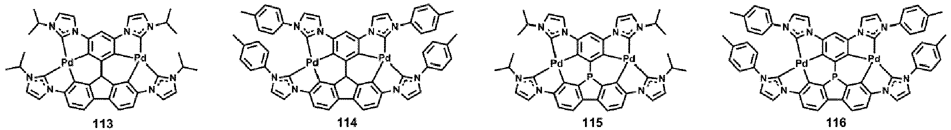

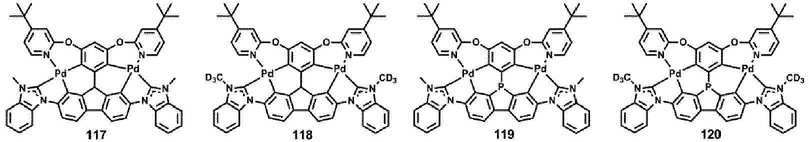

15. An organic light-emitting device comprising:
a first electrode;
a second electrode;
an organic layer between the first electrode and the second electrode and comprising an emission layer; and
an organometallic compound according to any one of claims 8 to 14.

## Patentansprüche

1. Organische, lichtemittierende Vorrichtung, Folgendes umfassend:
eine erste Elektrode;
eine zweite, der ersten Elektrode zugewandte Elektrode; und
eine Emissionsschicht zwischen der ersten Elektrode und der zweiten Elektrode,
wobei die Emissionsschicht eine erste Verbindung, eine zweite Verbindung und eine dritte Verbindung umfasst,
wobei die erste Verbindung, die zweite Verbindung und die dritte Verbindung voneinander verschieden sind,
die erste Verbindung durch die Formel 1 dargestellt ist,
die zweite Verbindung durch die Formel 2-1 oder 2-2 dargestellt ist, und
die dritte Verbindung eine Gruppe einschließt, die durch die Formel 3 dargestellt ist: 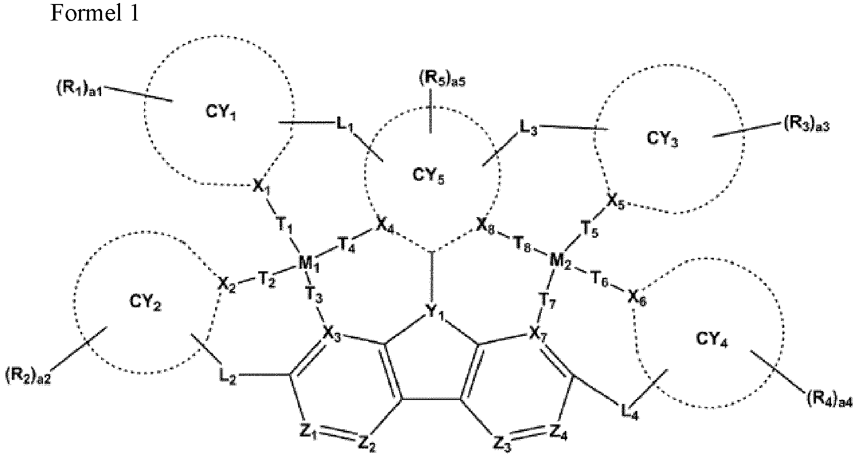 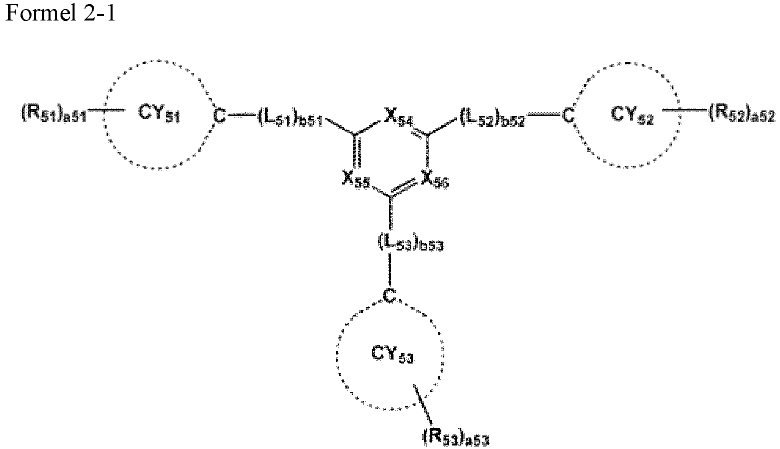 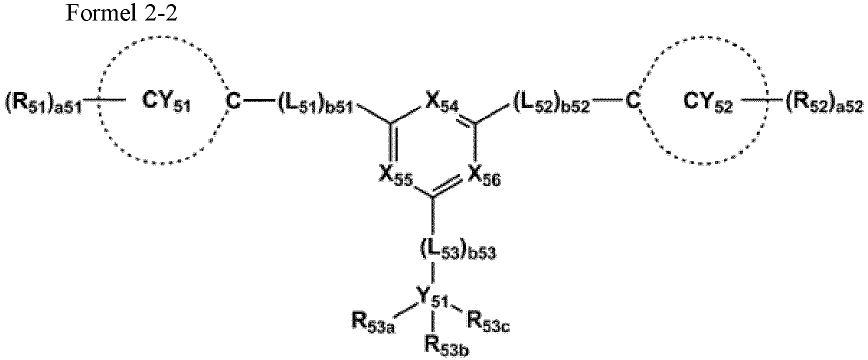 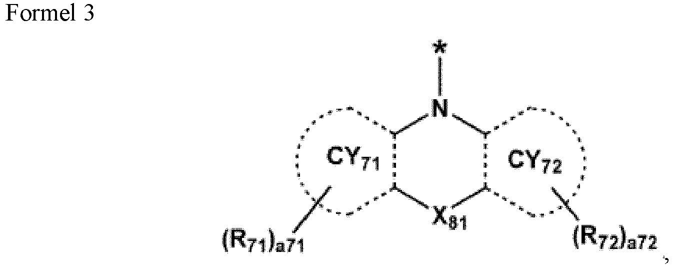
wobei in den Formeln 1 bis 3,
M₁ und M₂ jeweils unabhängig Platin (Pt) oder Palladium (Pd), sind,
X₁ bis X₈ jeweils unabhängig N oder C sind,
Y₁ aus C(R₆), Si(R₆), N und P ausgewählt ist,
Z₁ bis Z₄ jeweils unabhängig N oder C(R₇) sind,
T₁ bis T₈ jeweils unabhängig eine chemische Bindung, O, S, B(R'), N(R'), P(R'), C(R')(R"), Si(R')(R"), Ge(R')(R"), C(=O), B(R')(R"), N(R')(R") oder P(R')(R") sind, wobei, wenn T₁ eine chemische Bindung ist, X₁ und M₁ direkt miteinander verbunden sind, wenn T₂ eine chemische Bindung ist, X₂ und M₁ direkt miteinander verbunden sind, wenn T₃ eine chemische Bindung ist, X₃ und M₁ direkt miteinander verbunden sind, wenn T₄ eine chemische Bindung ist, X₄ und M₁ direkt miteinander verbunden sind, wenn T₅ eine chemische Bindung ist, X₅ und M₂ direkt miteinander verbunden sind, wenn T₆ eine chemische Bindung ist, X₆ und M₂ direkt miteinander verbunden sind, wenn T₇ eine chemische Bindung ist, X₇ und M₂ direkt miteinander verbunden sind, und wenn T₈ eine chemische Bindung ist, X₈ und M₂ direkt miteinander verbunden sind,
zwei Bindungen, ausgewählt aus einer Bindung zwischen M₁ und X₁ oder T₁, einer Bindung zwischen M₁ und X₂ oder T₂, einer Bindung zwischen M₁ und X₃ oder T₃ und einer Bindung zwischen M₁ und X₄ oder T₄, jeweils eine Koordinationsbindung sind, und die beiden anderen Bindungen jeweils eine kovalente Bindung sind,
zwei Bindungen, ausgewählt aus einer Bindung zwischen M₂ und X₅ oder T₅, einer Bindung zwischen M₂ und X₆ oder T₆, einer Bindung zwischen M₂ und X₇ oder T₇ und einer Bindung zwischen M₂ und X₈ oder T₈, jeweils eine Koordinationsbindung sind, und die beiden anderen Bindungen jeweils eine kovalente Bindung sind,
L₁ bis L₄ jeweils unabhängig voneinander ausgewählt sind aus einer Einfachbindung, einer Doppelbindung, *-N(R₈)-*', *-B(R₈)-*', *-P(R₈)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*', *-C(R₈)=*', *=C(R₈)-*', *-C(R₈ₐ)=C(R_{8b})-*', *-C(=S)-*' und *-C≡C-*'
Ring CY₁ bis Ring CY₅, Ring CY₅₁ bis Ring CY₅₃, Ring CY₇₁ und Ring CY₇₂ jeweils unabhängig voneinander ausgewählt sind aus einer C₅-C₃₀ carbozyklischen Gruppe und einer C₁-C₃₀ heterozyklischen Gruppe,
L₅₁ bis L₅₃ jeweils unabhängig voneinander ausgewählt sind aus einer substituierten oder unsubstituierten C₅-C₃₀ carbozyklischen Gruppe und einer substituierten oder unsubstituierten C₁-C₃₀ heterozyklische Gruppe,
eine Bindung zwischen L₅₁ und Ring CY₅₁, eine Bindung zwischen L₅₂ und Ring CY₅₂, eine Bindung zwischen L₅₃ und Ring CY₅₃, eine Bindung zwischen zwei oder mehr L₅₁(s), eine Bindung zwischen zwei oder mehr L₅₂(s), eine Bindung zwischen zwei oder mehr L₅₃(s), eine Bindung zwischen L₅₁ und dem Kohlenstoff zwischen X₅₄ und X₅₅ in den Formeln 2-1 und 2-2, eine Bindung zwischen L₅₂ und dem Kohlenstoff zwischen X₅₄ und X₅₆ in den Formeln 2-1 und 2-2 und eine Bindung zwischen L₅₃ und dem Kohlenstoff zwischen X₅₅ und X₅₆ in den Formeln 2-1 und 2-2 jeweils eine Kohlenstoff-Kohlenstoff-Einfachbindung sind,
b51 bis b53 jeweils unabhängig voneinander eine Ganzzahl von 0 bis 5 sind, wobei, wenn b51 0 ist, *-(L₅₁)_{b51}-*' eine Einfachbindung ist, wenn b52 0 ist, *-(L₅₂)_{b52}-*' eine Einfachbindung ist, und wenn b53 0 ist, *-(L₅₃)_{b53}-*' eine Einfachbindung ist,
X₅₄ N oder C(R₅₄) ist, X₅₅ N oder C(R₅₅) ist und X₅₆ N oder C(R₅₆) ist, wobei mindestens eines, ausgewählt aus X₅₄ bis X₅₆, N ist,
Y₅₁ C oder Si ist,
X₈₁ eine Einfachbindung, O, S, N(R₈₁), B(R₈₁), C(R₈₁ₐ)(R_{81b}) oder Si(R₈₁ₐ)(R_{81b}) ist,
R₁ bis R₈, R₈ₐ, R_{8b}, R', R", R₅₁ bis R₅₆, R₅₃ₐ bis R_{53c}, R₇₁, R₇₂, R₈₁, R₈₁ₐ und R_{81b} jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₇-C₆₀-Alkylarylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten C₂-C₆₀-Alkylheteroarylgruppe, einer substituierten oder unsubstituierten einwertigen, nicht aromatischen, kondensierten polyzyklischen Gruppe, einer substituierten oder unsubstituierten einwertigen, nicht aromatischen, kondensierten heteropolyzyklischen Gruppe, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂),
a1 bis a5, a51 bis a53, a71 und a72 jeweils unabhängig eine Ganzzahl von 0 bis 20 sind,
i) zwei Gruppen aus R₁(s) in der Anzahl von a1, ii) zwei Gruppen aus R₂(s) in der Anzahl von a2, iii) zwei Gruppen aus R₃(a) in der Anzahl von a3, iv) zwei Gruppen aus R₄(s) in der Anzahl von a4, v) zwei Gruppen aus R₅(s) in der Anzahl von a5, vi) R₈ₐ und R_{8b}, und vii) zwei Gruppen aus R₁ bis R₈, R₈ₐ, R_{8b}, R', und R" jeweils unabhängig voneinander wahlweise über eine Einfachbindung, eine Doppelbindung oder eine erste Verbindungsgruppe miteinander verbunden sind, sodass sie eine C₅-C₃₀ carbozyklische Gruppe, die unsubstituiert oder mit mindestens einem R₁₀ₐ substituiert ist, oder eine C₁-C₃₀ heterozyklische Gruppe, die unsubstituiert oder mit mindestens einem R₁₀ₐ substituiert ist, bilden,
R₁₀ₐ das gleiche ist wie in Verbindung mit der R₁ beschrieben,
* und *' jeweils eine Bindungsstelle an einem benachbarten Atom angeben, und
mindestens ein Substituent der substituierten C₅-C₃₀ carbozyklischen Gruppe, der substituierten C₁-C₃₀ heterozyklischen Gruppe, der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten einwertigen, nicht aromatischen, kondensierten polyzyklischen Gruppe, und der substituierten einwertigen, nicht aromatischen, kondensierten heteropolyzyklischen Gruppe ausgewählt ist aus:
Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkynylgruppe und einer C₁-C₆₀-Alkoxygruppe;
einer C₁-C₆₀-Alkylgruppe, einer C₂-C₆₀-Alkenylgruppe, einer C₂-C₆₀-Alkynylgruppe und einer C₁-C₆₀-Alkoxygruppe, jeweils substituiert mit mindestens einer Gruppe, ausgewählt aus Deuterium, -F, Cl, -Br, -I, einer Hydroxylgruppe, einer Cyanogruppe, einer Nitrogruppe, einer Amidinogruppe, einer Hydrazingruppe, einer Hydrazongruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer einwertigen nicht aromatischen kondensierten polyzyklischen Gruppe, einer einwertigen nicht aromatischen kondensierten heteropolyzyklischen Gruppe, -O(Q₁₁), -S(Q₁₁), -Si(Q₁₁)(Q₁₂)(Q₁₃), -N(Q₁₁)(Q₁₂), -B(Q₁₁)(Q₁₂), -P(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆- C₆₀-Arylthiogruppe, einer C₁-C₆₀-Heteroarylgruppe, einer C₂-C₆₀-Alkylheteroarylgruppe, einer einwertigen, nicht aromatischen, kondensierten polyzyklischen Gruppe und einer einwertigen, nicht aromatischen, kondensierten heteropolyzyklischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆- C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer einwertigen, nicht aromatischen, kondensierten polyzyklischen Gruppe und einer einwertigen, nicht aromatischen, kondensierten heteropolyzyklischen Gruppe, jeweils substituiert mit mindestens einer Gruppe, ausgewählt aus Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer einwertigen, nicht aromatischen, kondensierten polyzyklischen Gruppe, einer einwertigen, nicht aromatischen, kondensierten heteropolyzyklischen Gruppe, -O(Q₂₁), -S(Q₂₁), -Si(Q₂₁)(Q₂₂)(Q₂₃), -N(Q₂₁)(Q₂₂), -B(Q₂₁)(Q₂₂), -P(Q₂₁)(Q₂₂), -C(=O)(Q₂₁), -S(=O)₂(Q₂₁) und -P(=O)(Q₂₁)(Q₂₂); und
-O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁) und -P(=O)(Q₃₁)(Q₃₂), und
Q₁ bis Q₃, Q₁₁ bis Q₁₃, Q₂₁ bis Q₂₃ und Q₃₁ bis Q₃₃ jeweils unabhängig ausgewählt sind aus Wasserstoff, Deuterium, -F, -Cl, -Br, I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen, nicht aromatischen, kondensierten polyzyklischen Gruppe, einer einwertigen, nicht aromatischen, kondensierten heteropolyzyklischen Gruppe, einer C₁-C₆₀-Alkylgruppe, die mit mindestens einer Gruppe substituiert ist, ausgewählt aus Deuterium, -F, einer Cyanogruppe, einer C₁-C₆₀-Alkylgruppe, einer Phenylgruppe und einer Biphenylgruppe, und einer C₆-C₆₀-Arylgruppe, die mit mindestens einer Gruppe substitutiert ist, ausgewählt aus Deuterium, -F, einer Cyanogruppe, einer C₁-C_{10-Alk}ylgruppe, einer Phenylgruppe und einer Biphenylgruppe.

2. Organische, lichtemittierende Vorrichtung nach Anspruch 1, wobei in den Formeln 1 bis 3 Ring CY₁ bis Ring CY₅, Ring CY₅₁ bis Ring CY₅₃, Ring CY₇₁ und Ring CY₇₂ jeweils unabhängig voneinander Folgendes sind: i) ein erster Ring, ii) ein zweiter Ring, iii) ein kondensierter Ring, in dem zwei oder mehr erste Ringe miteinander kondensiert sind, iv) ein kondensierter Ring, in dem zwei oder mehr zweite Ringe miteinander kondensiert sind, oder v) ein kondensierter Ring, in dem ein oder mehrere erste Ringe und ein oder mehrere zweite Ringe miteinander kondensiert sind,
wobei der erste Ring ausgewählt ist aus einer Cyclopentangruppe, einer Cyclopentadiengruppe, einer Furangruppe, einer Thiophengruppe, einer Pyrrolgruppe, einer Silolgruppe, einer Oxazolgruppe, einer Isoxazolgruppe, einer Oxadiazolgruppe, einer Isoxadiazolgruppe, einer Oxatriazolgruppe, einer Isoxatriazolgruppe einer Thiazolgruppe, einer Isothiazolgruppe, einer Thiadiazolgruppe, einer Isothiadiazolgruppe, einer Thiatriazolgruppe, einer Isothiatriazolgruppe, einer Pyrazolgruppe, einer Imidazolgruppe, einer Triazolgruppe, einer Tetrazolgruppe, einer Azasilolgruppe, einer Diazasilolgruppe und einer Triazasilolgruppe, und
der zweite Ring ausgewählt ist aus einer Adamantangruppe, einer Norbomangruppe, einer Norbornengruppe, einer Cyclohexangruppe, einer Cyclohexengruppe, einer Benzolgruppe, einer Pyridingruppe, einer Pyrimidingruppe, einer Pyrazingruppe, einer Pyridazingruppe, einer Triazingruppe, einer Oxasilingruppe, einer Thiasilingruppe, einer Dihydroazasilingruppe, einer Dihydrodisilingruppe, einer Dihydrosilingruppe, einer Dioxingruppe, einer Oxathiingruppe, einer Oxazingruppe, einer Pyrangruppe, einer Dithiingruppe, einer Thiazingruppe, einer Thiopyrangruppe, einer Cyclohexadiengruppe, einer Dihydropyridingruppe, und einer Dihydropyrazingruppe.

3. Organische, lichtemittierende Vorrichtung nach Anspruch 1 oder 2, wobei in den Formeln 2-1 und 2-2, eine Gruppe, dargestellt durch 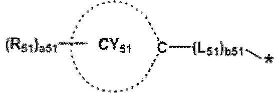 und eine Gruppe, dargestellt durch 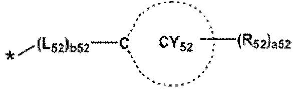 jeweils keine Phenylgruppe sind, wobei wahlweise in den Formeln 2-1 und 2-2 eine Gruppe, dargestellt durch 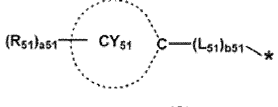 und eine Gruppe, dargestellt durch 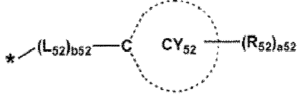 miteinander identisch sind, wobei wahlweise ein Anteil, dargestellt durch 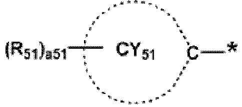 ausgewählt ist aus die Gruppen, dargestellt durch die Formeln CY51-1 bis CY51-19, und/oder
ein Anteil, dargestellt durch 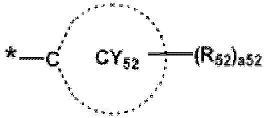 ausgewählt ist aus die Gruppen, dargestellt durch die Formeln CY52-1 bis CY52-19, und/oder
ein Anteil, dargestellt durch 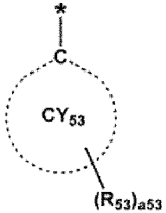 ausgewählt ist aus die Gruppen, dargestellt durch die Formeln CY53-1 bis CY53-18; 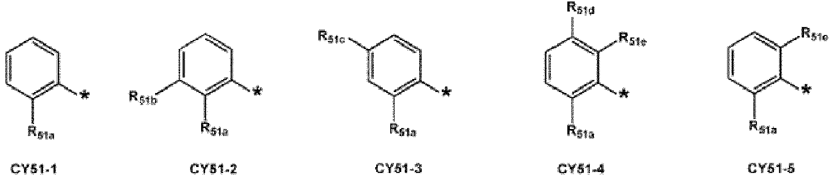 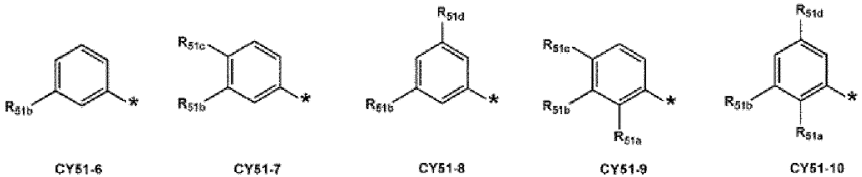 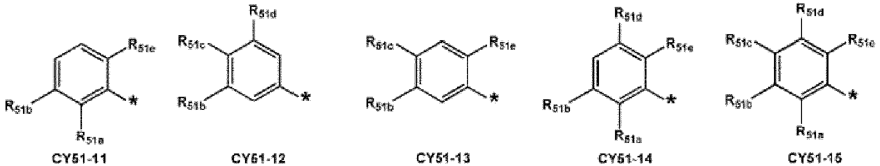 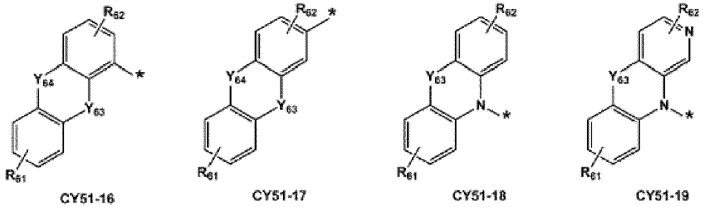 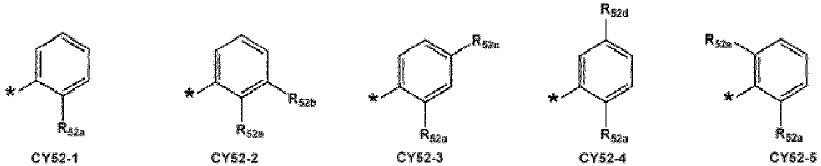 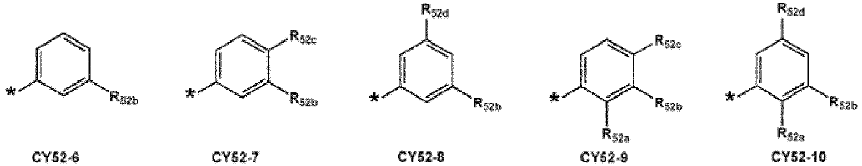 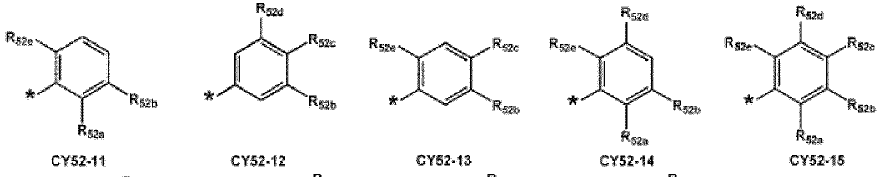 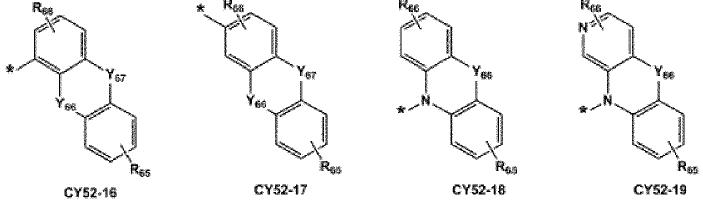 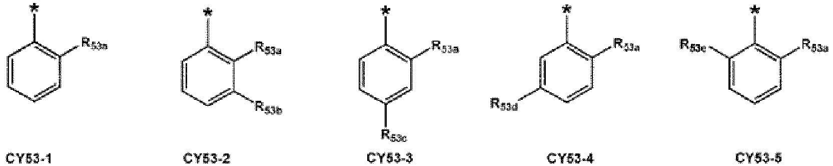 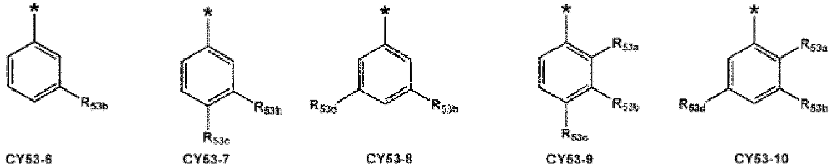 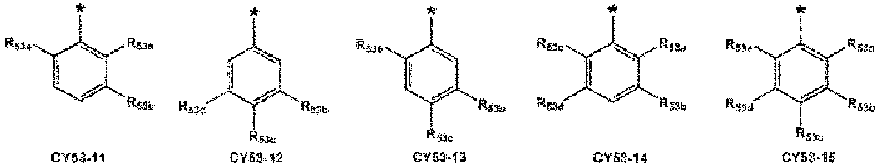 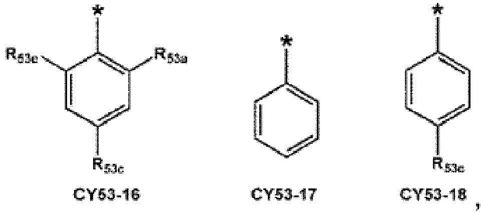
wobei, in den Formeln CY51-1 bis CY51-19, CY52-1 bis CY52-19 und CY53-1 bis CY53-18
Y₆₃ eine Einfachbindung, O, S, N(R₆₃), B(R₆₃), C(R₆₃ₐ)(R_{63b}) oder Si(R₆₃ₐ)(R_{63b}) ist,
Y₆₄ eine Einfachbindung, O, S, N(R₆₄), B(R₆₄), C(R₆₄ₐ)(R_{64b}) oder Si(R₆₄ₐ)(R_{64b}) ist,
Y₆₆ eine Einfachbindung, O, S, N(R₆₆), B(R₆₆), C(R₆₆ₐ)(R_{66b}) oder Si(R₆₆ₐ)(R_{66b}) ist,
Y₆₇ eine Einfachbindung, O, S, N(R₆₇), B(R₆₇), C(R₆₇ₐ)(R_{67b}) oder Si(R₆₇ₐ)(R_{67b}) ist,
Y₆₃ und Y₆₄ in den Formeln CY51-16 und CY51-17 nicht gleichzeitig eine Einfachbindung sind,
Y₆₆ und Y₆₇ in den Formeln CY52-16 und CY52-17 nicht gleichzeitig eine Einfachbindung sind,
R₅₁ₐ bis R₅₁ₑ, R₆₁ bis R₆₄, R₆₃ₐ, R_{63b}, R₆₄ₐ und R_{64b} jeweils unabhängig voneinander die gleichen sind, wie in Verbindung mit R₅₁ beschrieben, und R₅₁ₐ bis R₅₁ₑ nicht jeweils Wasserstoff sind,
R₅₂ₐ bis R₅₂ₑ, R₆₅ bis R₆₇, R₆₆ₐ, R_{66b}, R₆₇ₐ und R_{67b} jeweils unabhängig voneinander die gleichen sind, wie in Verbindung mit R₅₂ beschrieben, und R₅₂ₐ bis R₅₂ₑ nicht jeweils Wasserstoff sind,
R₅₃ₐ bis R₅₃ₑ jeweils unabhängig voneinander die gleichen sind, wie in Verbindung mit R₅₃ beschrieben, und R₅₃ₐ bis R₅₃ₑ nicht jeweils Wasserstoff sind,
* eine Bindungsstelle an einem angrenzenden Atom angibt.

4. Organische, lichtemittierende Vorrichtung nach einem der Ansprüche 1 bis 3, wobei die dritte Verbindung durch eine aus den Formeln 3-1 bis 3-5 ausgewählte Verbindung dargestellt ist: 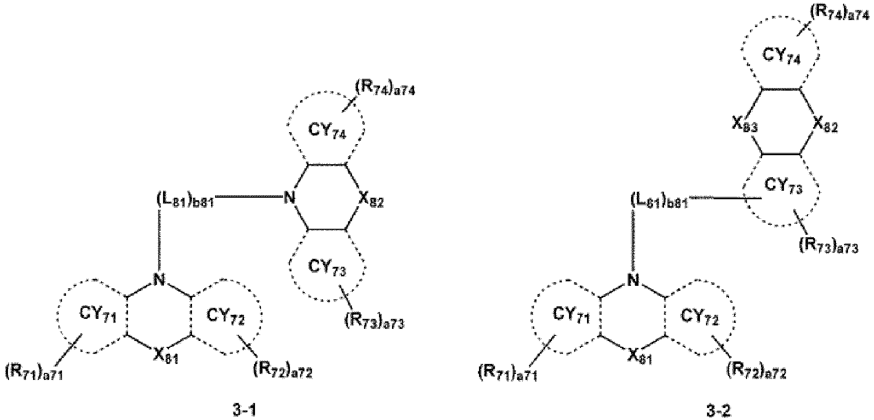 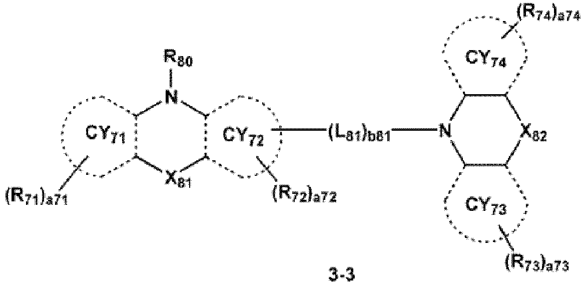 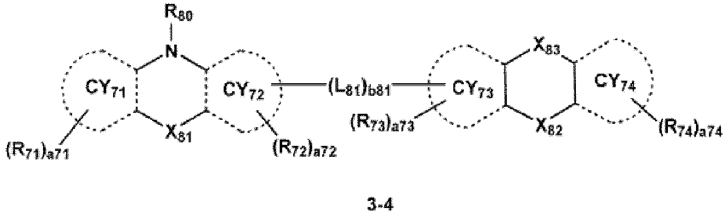 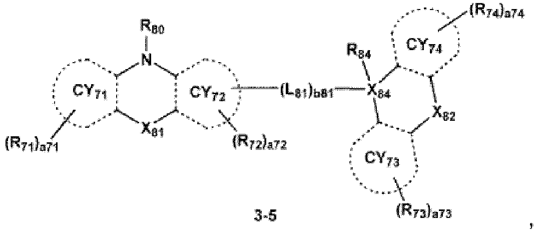 wobei, in den Formeln 3-1 bis 3-5,
Ring CY₇₁, Ring CY₇₂, X₈₁, R₇₁, R₇₂, a71 und a72 die gleichen sind wie oben beschrieben,
Ring CY₇₃, Ring CY₇₄, R₇₃, R₇₄, a73 und a74 die gleichen sind wie jeweils in Verbindung mit Ring CY₇₁, Ring CY₇₂, R₇₁, R₇₂, a71 und a72 beschrieben,
L₈₁ ausgewählt ist aus *-C(Q₄)(Q₅)-*', *-Si(Q₄)(Q₅)-*', einer substituierten oder unsubstituierten C₅-C₃₀ carbozyklischen Gruppe und einer substituierten oder unsubstituierten C₁-C₃₀ heterozyklischen Gruppe, wobei Q₄ und Q₅ jeweils die gleichen sind, wie in Verbindung mit Q₁ beschrieben,
b81 eine Ganzzahl von 0 bis 5 ist, wobei, wenn b81 0 ist, *-(L₈₁)_{b81}-*' eine Einfachbindung ist, wenn b81 2 oder mehr ist, zwei oder mehr L₈₁(s) gleich oder voneinander verschieden sind,
X₈₂ eine Einfachbindung, O, S, N(R₈₂), B(R₈₂), C(R₈₂ₐ)(R_{82b}) oder Si(R₈₂ₐ)(R_{82b}) ist,
X₈₃ eine Einfachbindung, O, S, N(R₈₃), B(R₈₃), C(R₈₃ₐ)(R_{83b}) oder Si(R₈₃ₐ)(R_{83b}) ist,
in den Formeln 3-2 und 3-4, X₈₂ und X₈₃ nicht jeweils gleichzeitig eine Einfachbindung sind,
X₈₄ C oder Si ist,
R₈₀, R₈₂, R₈₃, R₈₂ₐ, R_{82b}, R₈₃ₐ, R_{83b} und R₈₄ die gleichen sind wie in Verbindung mit R₈₁ beschrieben, und
* und *' jeweils eine Bindungsstelle an einem benachbarten Atom angeben, wobei wahlweise ein Anteil, dargestellt durch 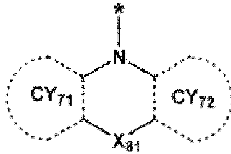 in den Formeln 3-1 und 3-2 aus Gruppen ausgewählt ist, dargestellt durch die Formeln CY71-1(1) bis CY71-1(8),
ein Anteil, dargestellt durch 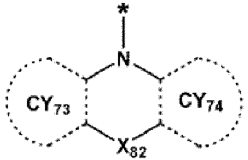 in den Formeln 3-1 und 3-3 aus Gruppen ausgewählt ist, dargestellt durch die Formeln CY71-2(1) bis CY71-2(8),
ein Anteil, dargestellt durch 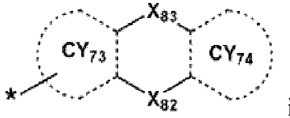 in den Formeln 3-2 und 3-4 aus Gruppen ausgewählt ist, dargestellt durch die Formeln CY71-3(1) bis CY71-3(32),
ein Anteil, dargestellt durch 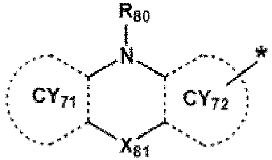 in den Formeln 3-3 bis 3-5 aus Gruppen ausgewählt ist, dargestellt durch die Formeln CY71-4(1) bis CY71-4(32), und
ein Anteil, dargestellt durch 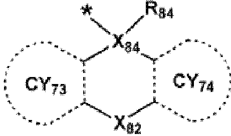 in der Formel 3-5 aus Gruppen ausgewählt ist, dargestellt durch die Formeln CY71-5(1) bis CY71-5(8): 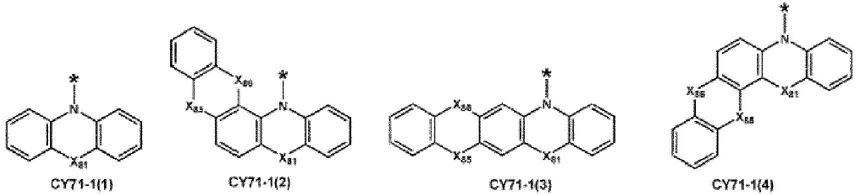 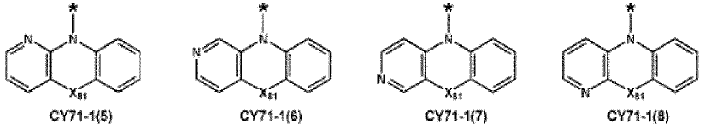 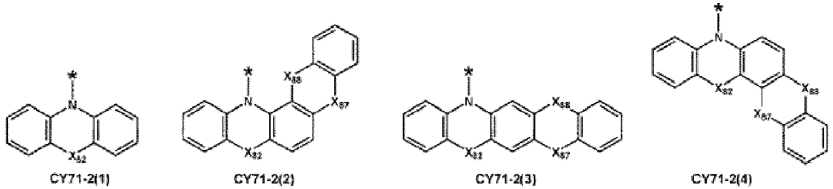 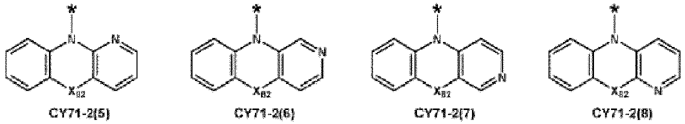 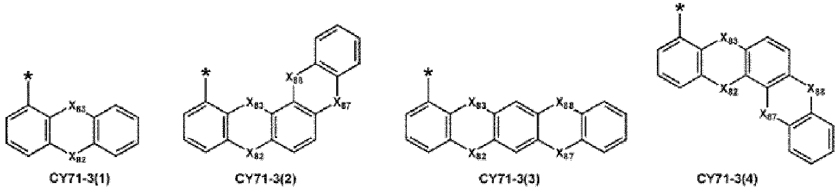 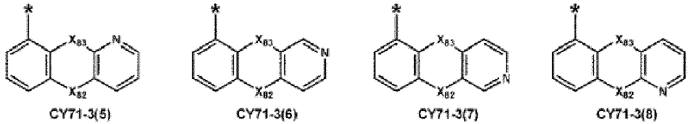 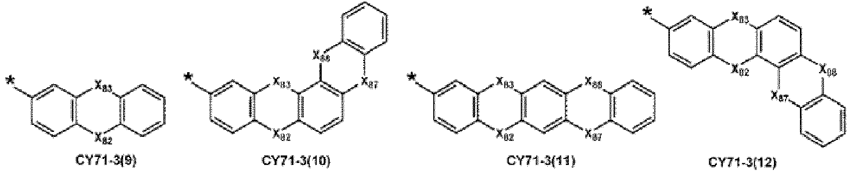 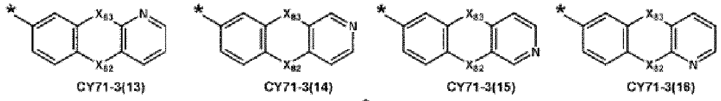 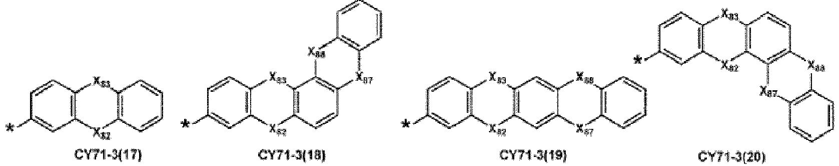 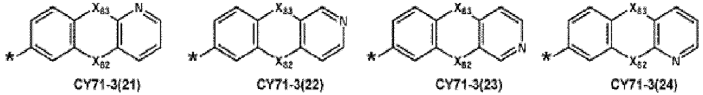 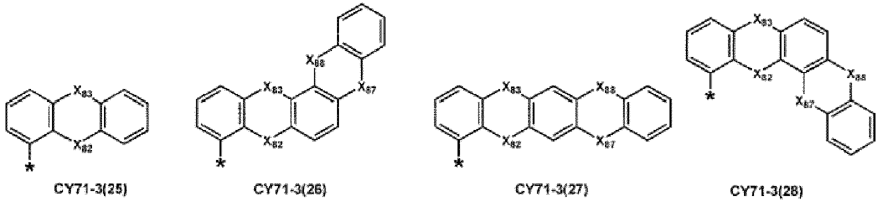 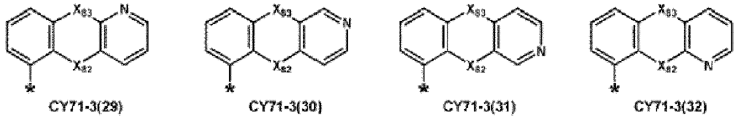 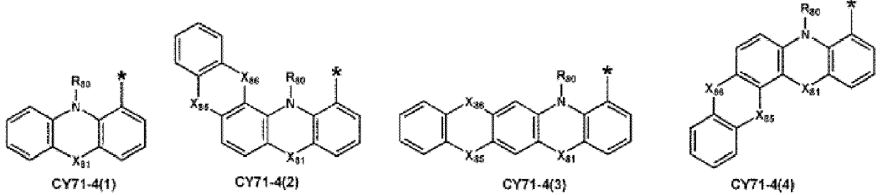 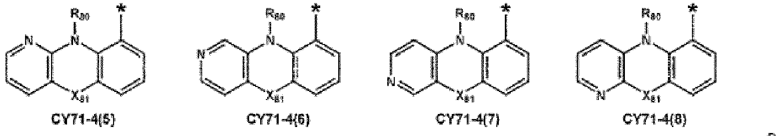 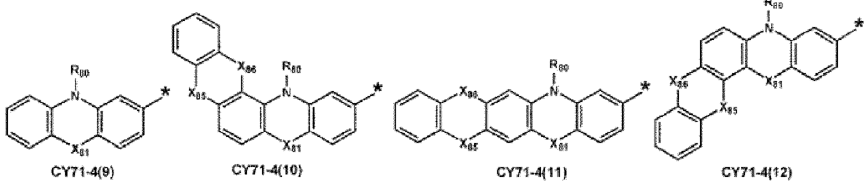 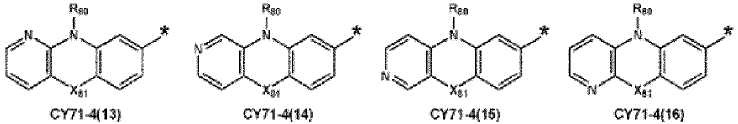 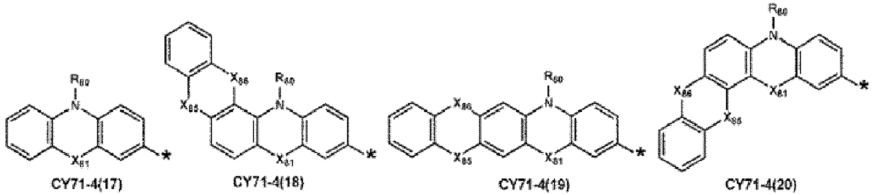 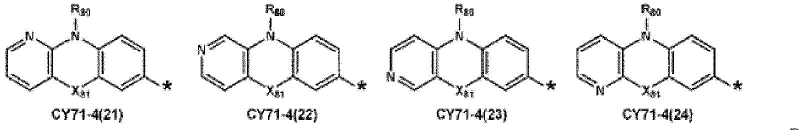 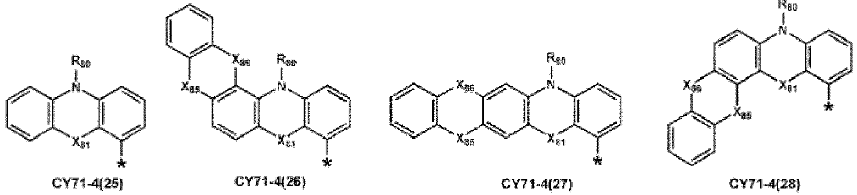 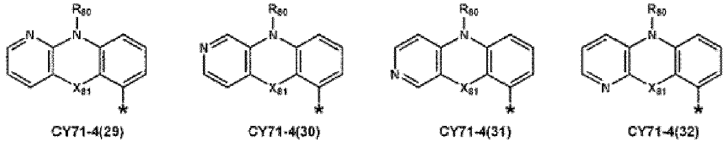 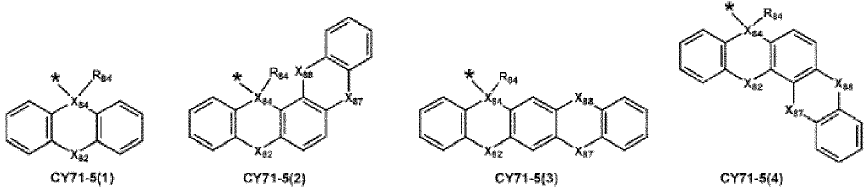 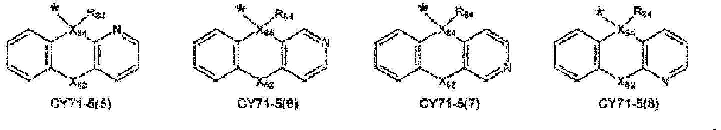
wobei, in den Formeln CY71-1(1) bis CY71-1(8), CY71-2(1) bis CY71-2(8), CY71-3(1) bis CY71-3(32), CY71-4(1) bis CY71-4(32) und CY71-5(1) bis CY71-5(8),
X₈₁ bis X₈₄, R₈₀ und R₈₄ jeweils unabhängig die gleichen sind wie oben beschrieben,
X₈₅ eine Einfachbindung, O, S, N(R₈₅), B(R₈₅), C(R₈₅ₐ)(R_{85b}) oder Si(R₈₅ₐ)(R_{85b}) ist, und
X₈₆ eine Einfachbindung, O, S, N(R₈₆), B(R₈₆), C(R₈₆ₐ)(R_{86b}) oder Si(R₈₆ₐ)(R_{86b}) ist,
in den Formeln CY71-1(1) bis CY71-1(8) und CY71-4(1) bis CY71-4(32), X₈₅ und X₈₆ nicht jeweils gleichzeitig eine Einfachbindung sind,
X₈₇ eine Einfachbindung, O, S, N(R₈₇), B(R₈₇), C(R₈₇ₐ)(R_{87b}) oder Si(R₈₇ₐ)(R_{87b}) ist, und
X₈₈ eine Einfachbindung, O, S, N(R₈₈), B(R₈₈), C(R₈₈ₐ)(R_{88b}) oder Si(R₈₈ₐ)(R_{88b}) ist, und
in den Formeln CY71-2(1) bis CY71-2(8), CY71-3(1) bis CY71-3(32), und CY71-5(1) bis CY71-5(8), X₈₇ und X₈₈ nicht jeweils gleichzeitig eine Einfachbindung sind,
R₈₅ bis R₈₈, R₈₅ₐ, R_{85b}, R₈₆ₐ, R_{86b}, R₈₇ₐ, R_{87b}, R₈₈ₐ und R_{88b} jeweils unabhängig voneinander die gleichen sind, wie in Verbindung mit R₈₁ beschrieben.

5. Organische, lichtemittierende Vorrichtung nach Anspruch 1, wobei die zweite Verbindung ausgewählt ist aus den Verbindungen H2-1 bis H2-80 und die dritte Verbindung ausgewählt ist aus den Verbindungen H3-1 bis H3-28:

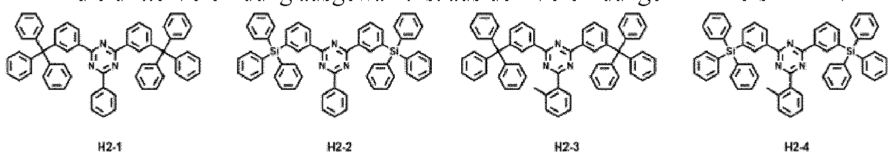

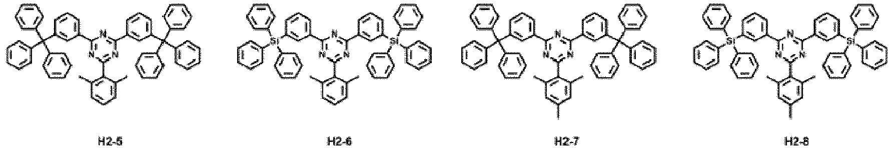

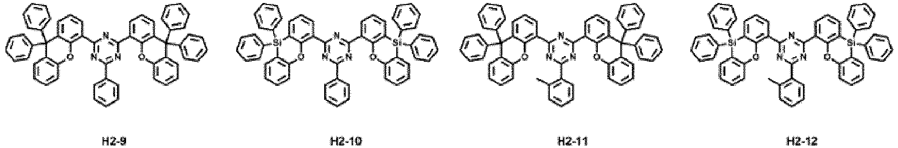

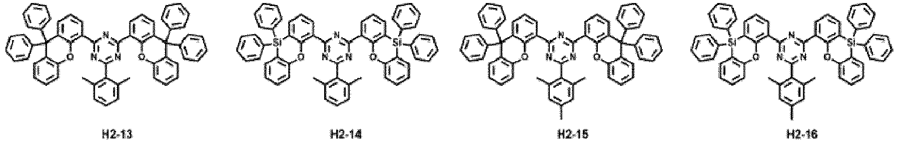

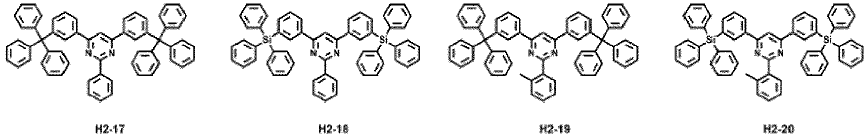

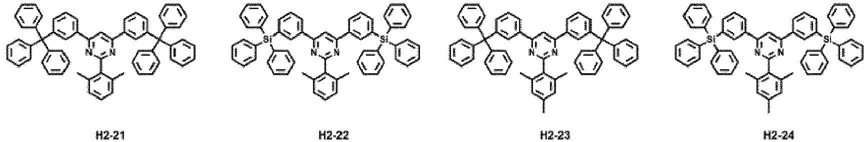

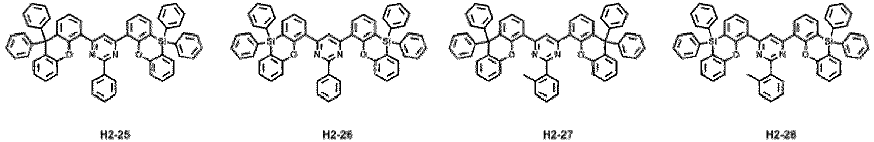

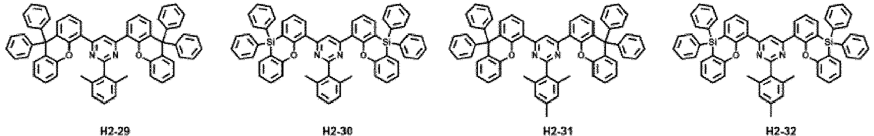

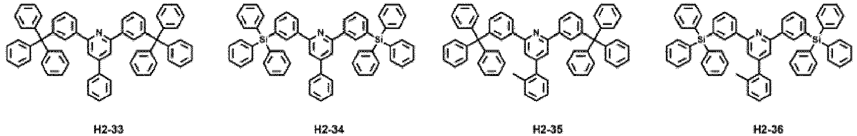

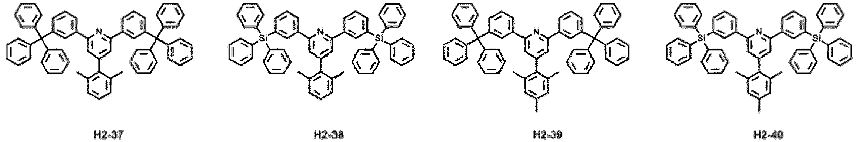

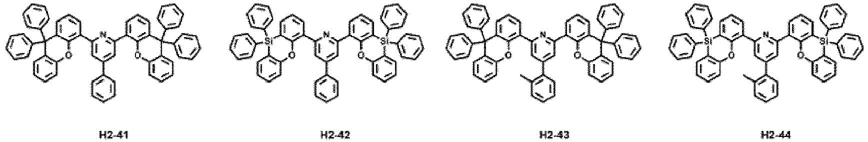

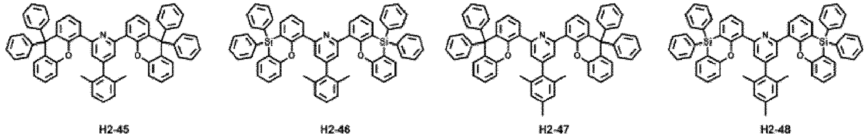

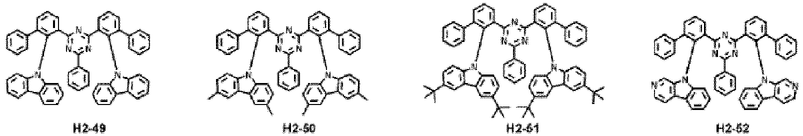

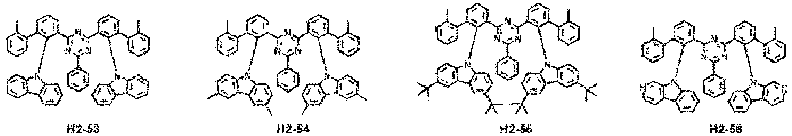

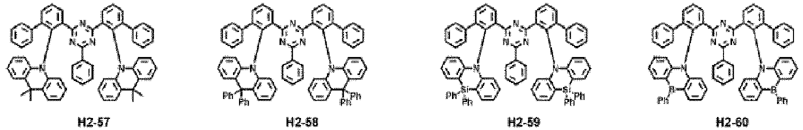

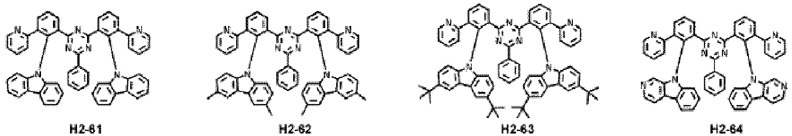

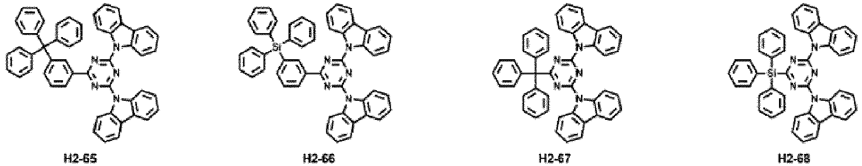

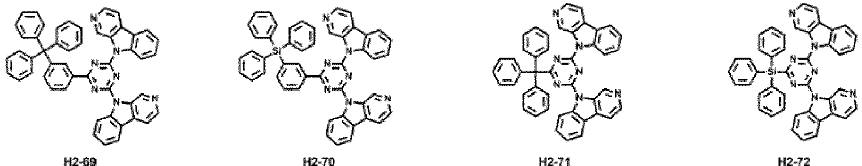

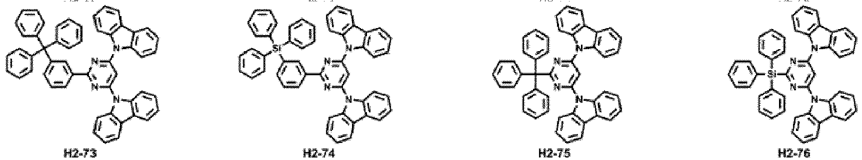

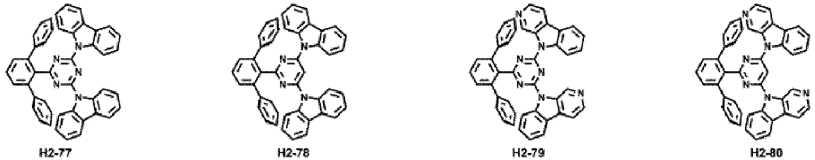

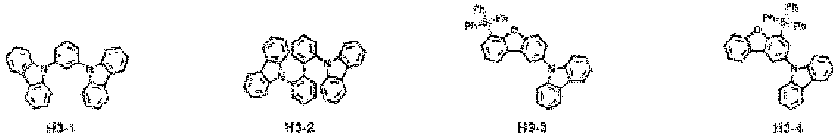

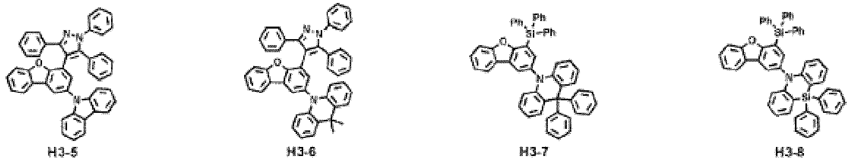

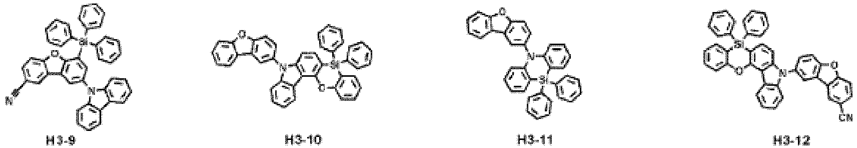

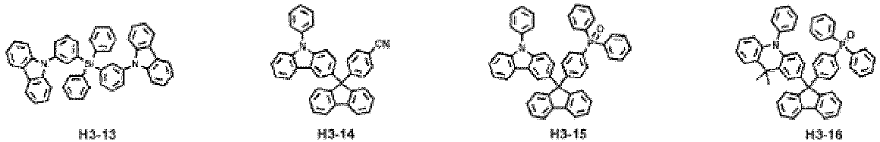

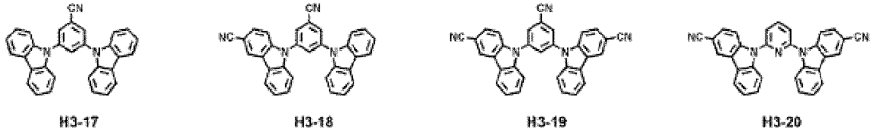

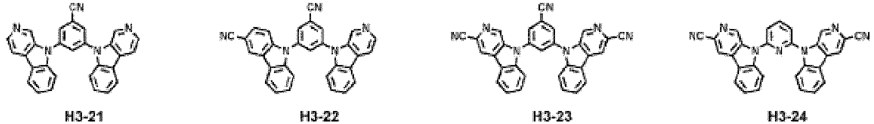

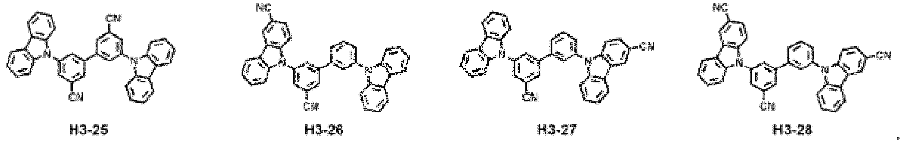

6. Organische, lichtemittierende Vorrichtung nach einem der Ansprüche 1 bis 5, wobei die zweite Verbindung und die dritte Verbindung einen Exziplex bilden.

7. Organische, lichtemittierende Vorrichtung nach einem der Ansprüche 1 bis 6, wobei die Abklingzeit der verzögerten Fluoreszenz im zeitaufgelösten Elektrolumineszenz (TREL)-Spektrum der organischen lichtemittierenden Vorrichtung 50 ns oder mehr beträgt, wobei wahlweise die organische, lichtemittierende Vorrichtung ferner eine Kappenschicht auf der zweiten Elektrode einschließt, und
die Kappenschicht einen Brechungsindex von 1,6 oder mehr bei einer Wellenlänge von 589 nm aufweist, wobei wahlweise die Emissionsschicht eine maximale Emissionswellenlänge von 390 nm oder mehr und 520 nm oder weniger aufweist.

8. Organometallische Verbindung, dargestellt durch Formel 1: 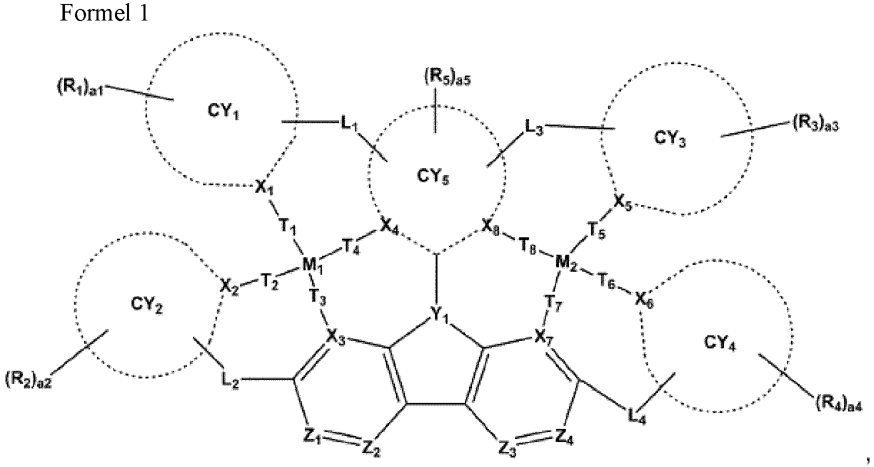 wobei, in Formel 1,
M₁ und M₂ jeweils unabhängig Platin (Pt) oder Palladium (Pd), sind,
X₁ bis X₈ jeweils unabhängig N oder C sind,
Y₁ aus C(R₆), Si(R₆), N und P ausgewählt ist,
Z₁ bis Z₄ jeweils unabhängig N oder C(R₇) sind,
T₁ bis T₈ jeweils unabhängig eine chemische Bindung, O, S, B(R'), N(R'), P(R'), C(R')(R"), Si(R')(R"), Ge(R')(R"), C(=O), B(R')(R"), N(R')(R") oder P(R')(R") sind, wobei, wenn T₁ eine chemische Bindung ist, X₁ und M₁ direkt miteinander verbunden sind, wenn T₂ eine chemische Bindung ist, X₂ und M₁ direkt miteinander verbunden sind, wenn T₃ eine chemische Bindung ist, X₃ und M₁ direkt miteinander verbunden sind, wenn T₄ eine chemische Bindung ist, X₄ und M₁ direkt miteinander verbunden sind, wenn T₅ eine chemische Bindung ist, X₅ und M₂ direkt miteinander verbunden sind, wenn T₆ eine chemische Bindung ist, X₆ und M₂ direkt miteinander verbunden sind, wenn T₇ eine chemische Bindung ist, X₇ und M₂ direkt miteinander verbunden sind, und wenn T₈ eine chemische Bindung ist, X₈ und M₂ direkt miteinander verbunden sind,
zwei Bindungen, ausgewählt aus einer Bindung zwischen M₁ und X₁ oder T₁, einer Bindung zwischen M₁ und X₂ oder T₂, einer Bindung zwischen M₁ und X₃ oder T₃ und einer Bindung zwischen M₁ und X₄ oder T₄, jeweils eine Koordinationsbindung sind, und die beiden anderen Bindungen jeweils eine kovalente Bindung sind,
zwei Bindungen, ausgewählt aus einer Bindung zwischen M₂ und X₅ oder T₅, einer Bindung zwischen M₂ und X₆ oder T₆, einer Bindung zwischen M₂ und X₇ oder T₇ und einer Bindung zwischen M₂ und X₈ oder T₈, jeweils eine Koordinationsbindung sind, und die beiden anderen Bindungen jeweils eine kovalente Bindung sind,
L₁ bis L₄ jeweils unabhängig voneinander ausgewählt sind aus einer Einfachbindung, einer Doppelbindung, *-N(R₈)-*', *-B(R₈)-*', *-P(R₈)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*', *-C(R₈)=*', *=C(R₈)-*', *-C(R₈ₐ)=C(R_{8b})-*', *-C(=S)-*' und *-C=C-*',
Ring CY₁ bis Ring CY₅ jeweils unabhängig ausgewählt sind aus einer C₅-C₃₀ carbozyklischen Gruppe und einer C₁-C₃₀ heterozyklischen Gruppe,
R₁ bis R₈, R₈ₐ, R_{8b}, R' und R" jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituiereten C₇-C₆₀-Alkylarylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten C₂-C₆₀-Alkylheteroarylgruppe, einer substituierten oder unsubstituierten einwertigen, nicht aromatischen, kondensierten polyzyklischen Gruppe, einer substituierten oder unsubstituierten einwertigen, nicht aromatischen, kondensierten heteropolyzyklischen Gruppe, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁) und - P(=O)(Q₁)(Q₂),
a1 bis a5 jeweils unabhängig eine Ganzzahl von 0 bis 20 sind,
i) zwei Gruppen aus R₁(s) in der Anzahl von a1, ii) zwei Gruppen aus R₂(s) in der Anzahl von a2, iii) zwei Gruppen aus R₃(a) in der Anzahl von a3, iv) zwei Gruppen aus R₄(s) in der Anzahl von a4, v) zwei Gruppen aus R₅(s) in der Anzahl von a5, vi) R₈ₐ und R_{8b}, und vii) zwei Gruppen aus R₁ bis R₈, R₈ₐ, R_{8b}, R', und R" jeweils unabhängig voneinander wahlweise über eine Einfachbindung, eine Doppelbindung oder eine erste Verbindungsgruppe miteinander verbunden sind, sodass sie eine C₅-C₃₀ carbozyklische Gruppe, die unsubstituiert oder mit mindestens einem R₁₀ₐ substituiert ist, oder eine C₁-C₃₀ heterozyklische Gruppe, die unsubstituiert oder mit mindestens einem R₁₀ₐ substituiert ist, bilden,
R₁₀ₐ das gleiche ist wie in Verbindung mit R₁ beschrieben,
* und *' jeweils eine Bindungsstelle an einem benachbarten Atom angeben, und
mindestens ein Substituent der substituierten C₅-C₃₀ carbozyklischen Gruppe, der substituierten C₁-C₃₀ heterozyklischen Gruppe, der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten einwertigen, nicht aromatischen, kondensierten polyzyklischen Gruppe, der substituierten einwertigen, nicht aromatischen, kondensierten heteropolyzyklischen Gruppe ausgewählt ist aus:
Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkynylgruppe und einer C₁-C₆₀-Alkoxygruppe;
einer C₁-C₆₀-Alkylgruppe, einer C₂-C₆₀-Alkenylgruppe, einer C₂-C₆₀-Alkynylgruppe und einer C₁-C₆₀-Alkoxygruppe, jeweils substituiert mit mindestens einem, ausgewählt aus Deuterium, -F, Cl, -Br, -I, einer Hydroxylgruppe, einer Cyanogruppe, einer Nitrogruppe, einer Amidinogruppe, einer Hydrazingruppe, einer Hydrazongruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer einwertigen nicht aromatischen kondensierten polyzyklischen Gruppe, einer einwertigen nicht aromatischen kondensierten heteropolyzyklischen Gruppe, -O(Q₁₁), -S(Q₁₁), -Si(Q₁₁)(Q₁₂)(Q₁₃), -N(Q₁₁)(Q₁₂), -B(Q₁₁)(Q₁₂), -P(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer einwertigen, nich aromatischen, kondensierten polyzyklischen Gruppe und einer einwertigen, nicht aromatischen, kondensierten heteropolyzyklischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer einwertigen, nicht aromatischen, kondensierten polyzyklischen Gruppe, und einer einwertigen, nicht aromatischen, kondensierten heteropolyzyklischen Gruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer einwertigen, nich aromatischen, kondensierten polyzyklischen Gruppe, einer einwertigen, nicht aromatischen, kondensierten heteropolyzyklischen Gruppe, -O(Q₂₁), -S(Q₂₁), -Si(Q₂₁)(Q₂₂)(Q₂₃), -N(Q₂₁)(Q₂₂), -B(Q₂₁)(Q₂₂), -P(Q₂₁)(Q₂₂), -C(=O)(Q₂₁), -S(=O)2(Q₂₁) und -P(=O)(Q₂₁)(Q₂₂); und
-O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁) und -P(=O)(Q₃₁)(Q₃₂), und
Q₁ bis Q₃, Q₁₁ bis Q₁₃, Q₂₁ bis Q₂₃ und Q₃₁ bis Q₃₃ jeweils unabhängig ausgewählt sind aus Wasserstoff, Deuterium, -F, -Cl, -Br, I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen, nicht aromatischen, kondensierten polyzyklischen Gruppe, einer einwertigen, nicht aromatischen, kondensierten heteropolyzyklischen Gruppe, einer C₁-C₆₀-Alkylgruppe, die mit mindestens einem substituiert ist, ausgewählt aus Deuterium, -F, einer Cyanogruppe, einer C₁-C₆₀-Alkylgruppe, einer Phenylgruppe und einer Biphenylgruppe, und einer C₆-C₆₀-Arylgruppe, die mit mindestens einem substituiert ist, ausgewählt aus Deuterium, -F, einer Cyanogruppe, einer C₁-C₁₀-Alkylgruppe, einer Phenylgruppe und einer Biphenylgruppe.

9. Organometallische Verbindung nach Anspruch 8, wobei die Ringe CY₁ bis CY₅ jeweils unabhängig voneinander ausgewählt sind aus einer Benzolgruppe, einer Naphthalingruppe, einer Anthracengruppe, einer Phenanthrengruppe, einer Azulengruppe, einer Triphenylengruppe, einer Pyrengruppe, einer Chrysengruppe, einer Cyclopentadiengruppe, einer 1,2,3,4-Tetrahydronaphthalingruppe, einer Furangruppe, einer Thiophengruppe, einer Silolgruppe, einer Indengruppe, einer Fluorengruppe, einer Indolgruppe, einer Carbazolgruppe, einer Benzofurangruppe, einer Dibenzofurangruppe, einer Benzothiophengruppe, einer Dibenzothiophengruppe, einer Benzosilolgruppe, einer Dibenzosilolgruppe, einer Indenopyridingruppe, einer Indolopyridingruppe, einer Benzofuropyridingruppe, einer Benzothienopyridingruppe, einer Benzosilolopyridingruppe einer Indenopyrimidingruppe, einer Indolopyrimidingruppe, einer Benzofuropyrimidingruppe, einer Benzothienopyrimidingruppe, einer Benzosilolopyrimidingruppe, einer Dihydropyridingruppe, einer Pyridingruppe, einer Pyrimidingruppe, einer Pyrazingruppe einer Pyridazingruppe, einer Triazingruppe, einer Chinolingruppe, einer Isochinolingruppe, einer Chinoxalingruppe, einer Chinazolingruppe, einer Phenanthrolingruppe, einer Pyrrolgruppe, einer Pyrazolgruppe, einer Imidazolgruppe, einer 2,3-Dihydroimidazolgruppe, einer Triazolgruppe, einer 2,3-Dihydrotriazolgruppe, einer Oxazolgruppe, einer Isooxazolgruppe, einer Thiazolgruppe, einer Isothiazolgruppe, einer Oxadiazolgruppe, einer Thiadiazolgruppe, einer Benzopyrazolgruppe, einer Pyrazolopyridingruppe, einer Furopyrazolgruppe, einer Thienopyrazolgruppe, einer Benzimidazolgruppe, einer 2,3-Dihydrobenzimidazolgruppe, einer Imidazopyridingruppe, einer 2,3-Dihydroimidazopyridingruppe, einer Furanoimidazolgruppe, einer Thienoimidazolgruppe, einer Imidazopyrimidingruppe, einer 2,3-Dihydroimidazopyrimidingruppe einer Imidazopyrazingruppe, einer 2,3-Dihydroimidazopyrazingruppe, einer Benzoxazolgruppe, einer Benzothiazolgruppe, einer Benzoxadiazolgruppe, einer Benzothiadiazolgruppe, einer 5,6,7,8-Tetrahydroisochinolingruppe und einer 5,6,7,8-Tetrahydrochinolingruppe.

10. Organometallische Verbindung nach Anspruch 8 oder 9, wobei Ring CY₁ bis Ring CY₄ jeweils unabhängig voneinander aus Gruppen ausgewählt sind, dargestellt durch die Formeln 4-1 bis 4-35: 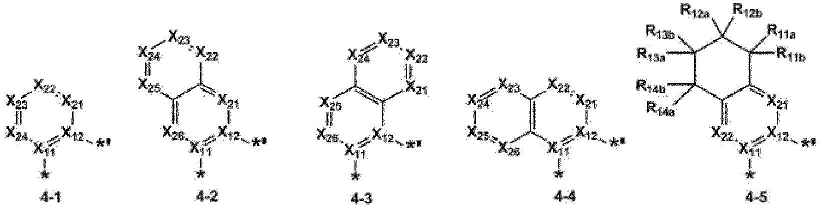 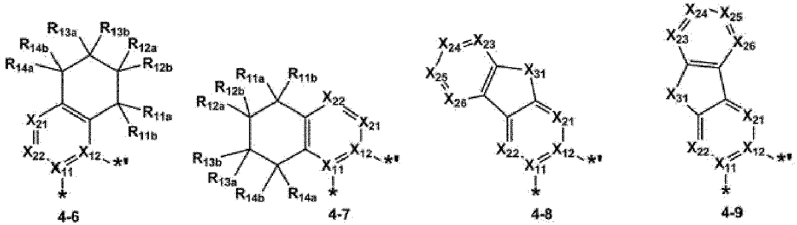 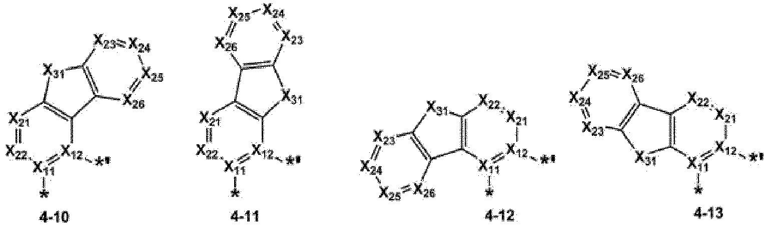 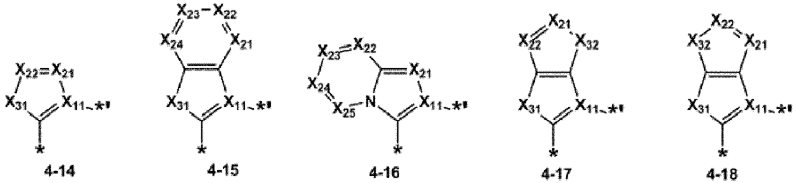 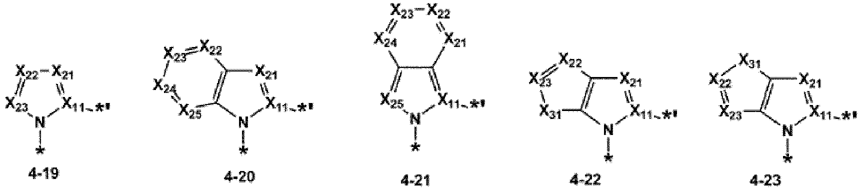 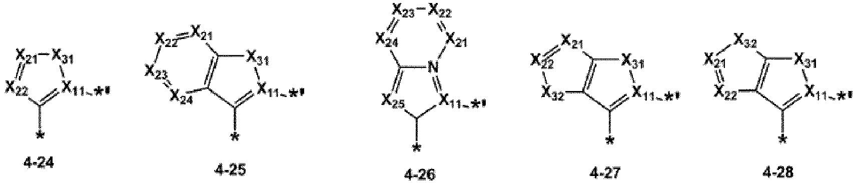 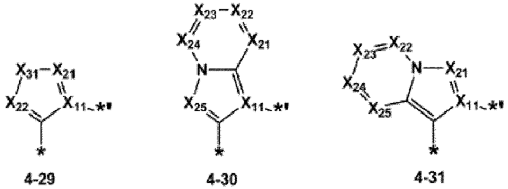 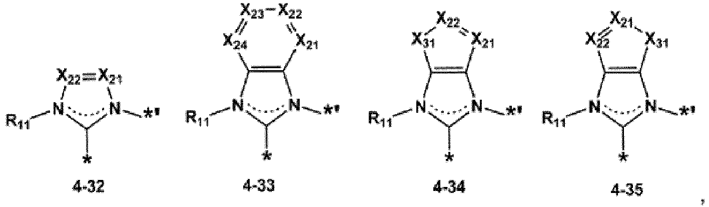 wobei, in den Formeln 4-1 bis 4-35,
X₁₁ und X₁₂ jeweils unabhängig voneinander ein Kohlenstoffatom oder ein Stickstoffatom sind,
X₂₁ N oder C(R₂₁) ist, X₂₂ N oder C(R₂₂) ist, X₂₃ N oder C(R₂₃) ist, X₂₄ N oder C(R₂₄) ist, X₂₅ N oder C(R₂₅) ist, und X₂₆ N oder C(R₂₆) ist,
X₃₁ C(R₃₁ₐ)(R_{31b}), Si(R₃₁ₐ)(R_{31b}), N(R₃₁), O oder S ist,
X₃₂ C(R₃₂ₐ)(R_{32b}), Si(R₃₂ₐ)(R_{32b}), N(R₃₂), O oder S ist,
R₁₁, R₁₁ₐ, R_{11b}, R₁₂ₐ, R_{12b}, R₁₃ₐ, R_{13b}, R₁₄ₐ, R_{14b}, R₂₁ bis R₂₆, R₃₁ bis R₃₂, R₃₁ₐ bis R_{31b} und R₃₂ₐ bis R_{32b} jeweils unabhängig voneinander die gleichen sind, wie in Verbindung mit R₁ bis R₄ in Formel 1 beschrieben,
* eine Bindungsstelle an T₁, T₂, T₃, T₄, T₅, T₆, T₇ oder T₈ angibt, und
*' eine Bindungsstelle an L₁, L₂, L₃ oder L₄ angibt.

11. Organometallische Verbindung nach einem der Ansprüche 8 bis 10, wobei:
i) X₁ bis X₈ jeweils C sind; oder
ii) X₁ und X₅ jeweils N sind, und X₂ bis X₄ und X₆ bis X₈ jeweils C sind.

12. Organometallische Verbindung nach einem der Ansprüche 8 bis 11, wobei die organometallische Verbindung durch Formel 1-1 dargestellt ist: 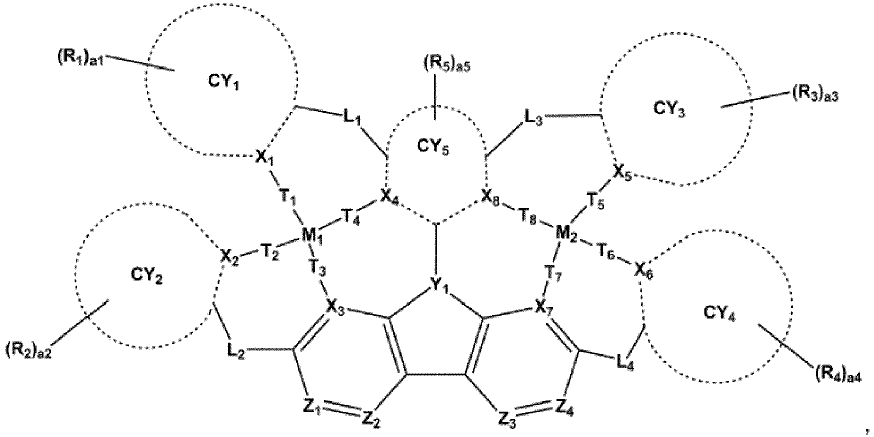 wobei in der Formel 1-1, M₁, M₂, X₁ bis X₈, Y₁, Z₁ bis Z₄, T₁ bis T₈, L₁ bis L₄, Ring CY₁ bis Ring CY₅, R₁ bis R₅ und a1 bis a5 jeweils unabhängig voneinander die gleichen sind, wie in Verbindung mit Formel 1 beschrieben.

13. Organometallische Verbindung nach einem der Ansprüche 8 bis 12, wobei die durch Formel 1 dargestellte Verbindung eine symmetrische Struktur aufweist.

14. Organometallische Verbindung nach Anspruch 8, wobei die organometallische Verbindung aus den Verbindungen 1 bis 120 ausgewählt ist:

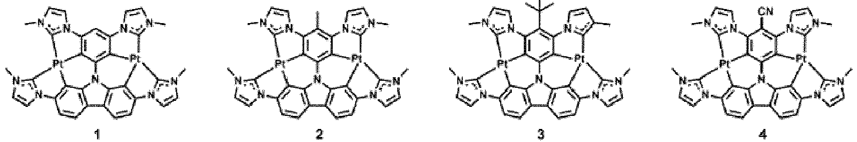

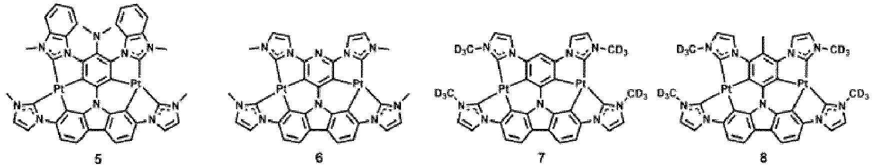

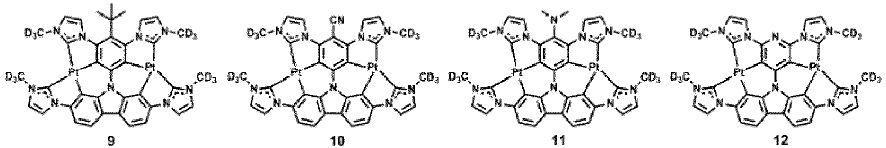

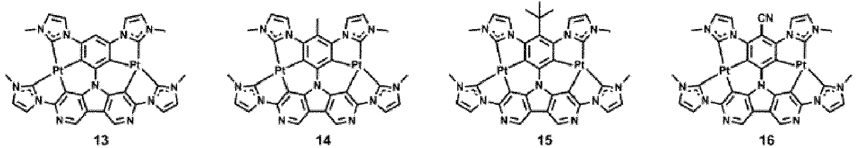

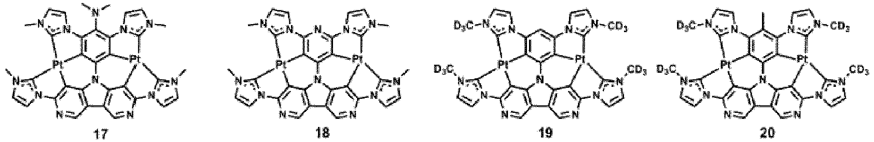

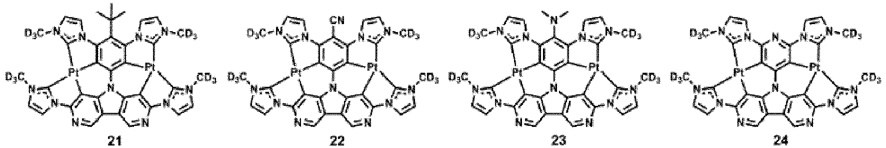

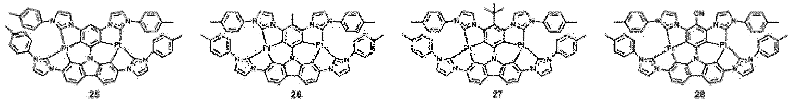

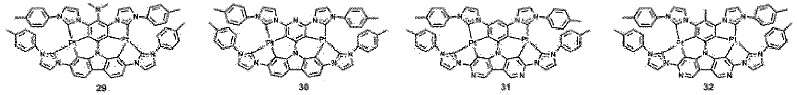

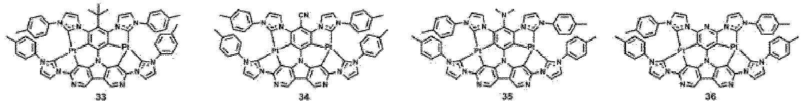

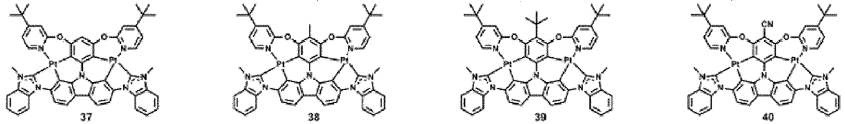

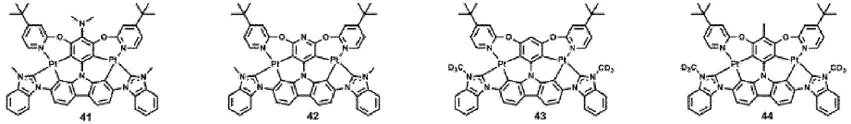

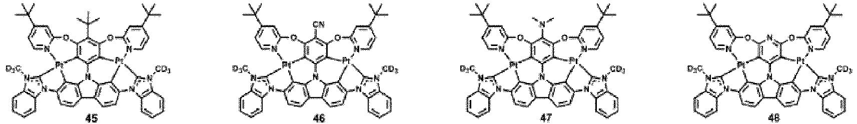

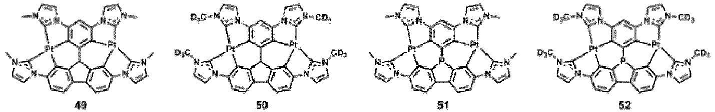

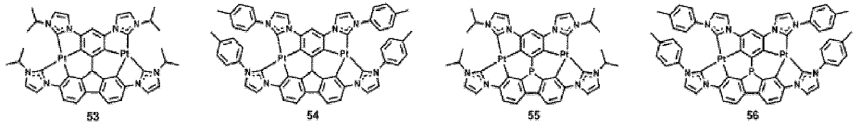

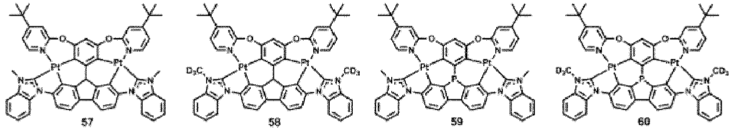

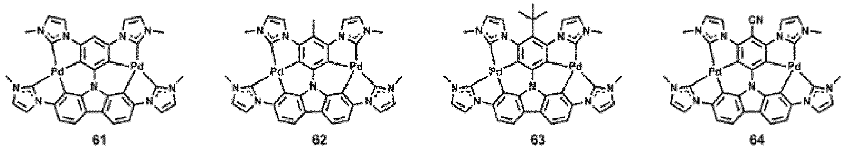

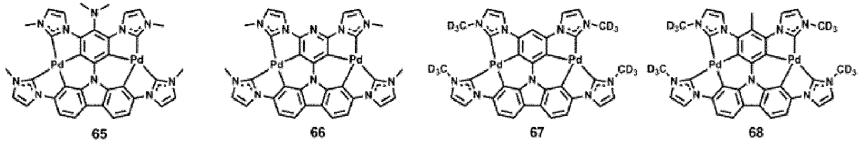

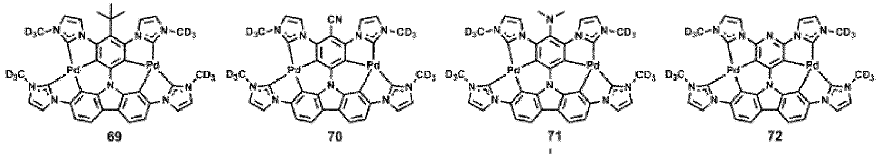

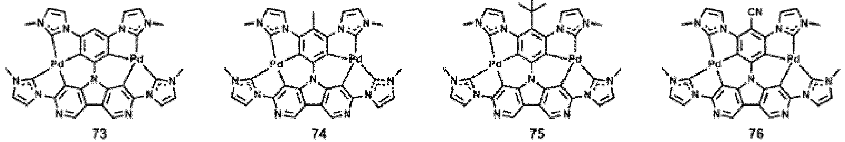

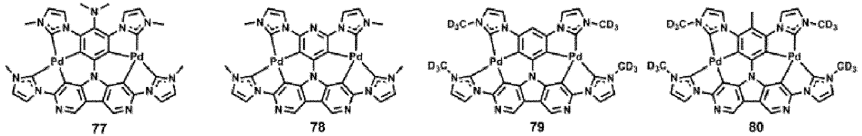

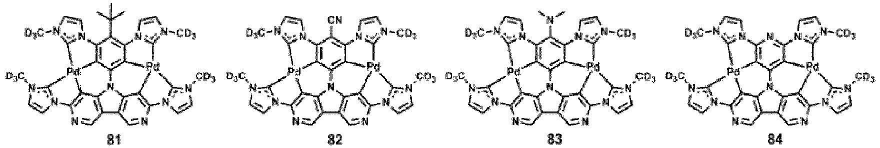

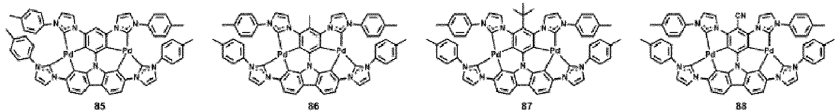

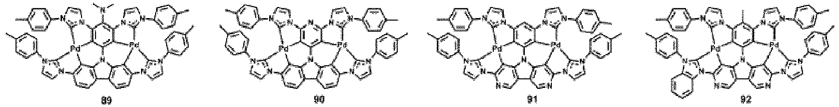

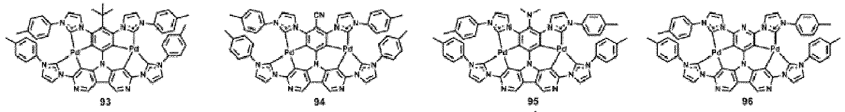

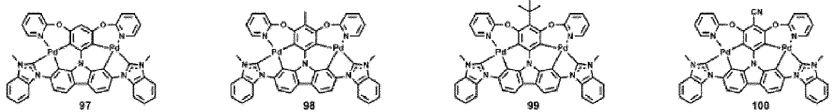

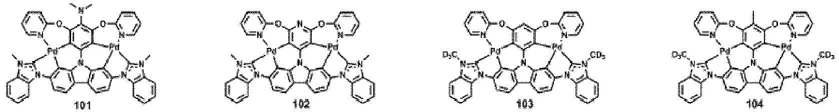

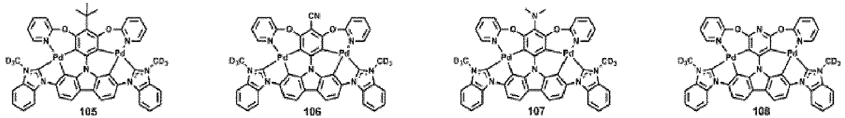

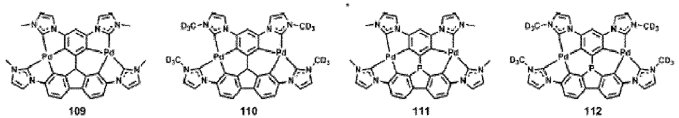

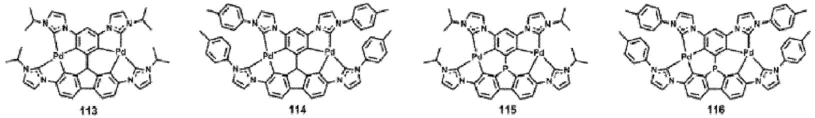

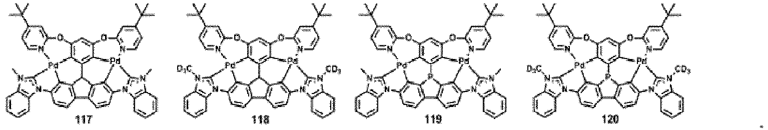

15. Organische, lichtemittierende Vorrichtung, Folgendes umfassend:
eine erste Elektrode;
eine zweite Elektrode;
eine organische Schicht zwischen der ersten Elektrode und der zweiten Elektrode und umfassend eine Emissionsschicht, und
eine organometallische Verbindung nach einem der Ansprüche 8 bis 14.

## Revendications

1. Dispositif électroluminescent organique comprenant :
une première électrode,
une deuxième électrode faisant face à la première électrode, et
une couche d'émission entre la première électrode et la deuxième électrode ;
ladite couche d'émission comprenant un premier composé, un deuxième composé et un troisième composé,
le premier composé, le deuxième composé et le troisième composé étant différents les uns des autres,
le premier composé étant représenté par la Formule 1,
le deuxième composé étant représenté par la Formule 2-1 ou 2-2, et
le troisième composé incluant un groupe représenté par la Formule 3 : 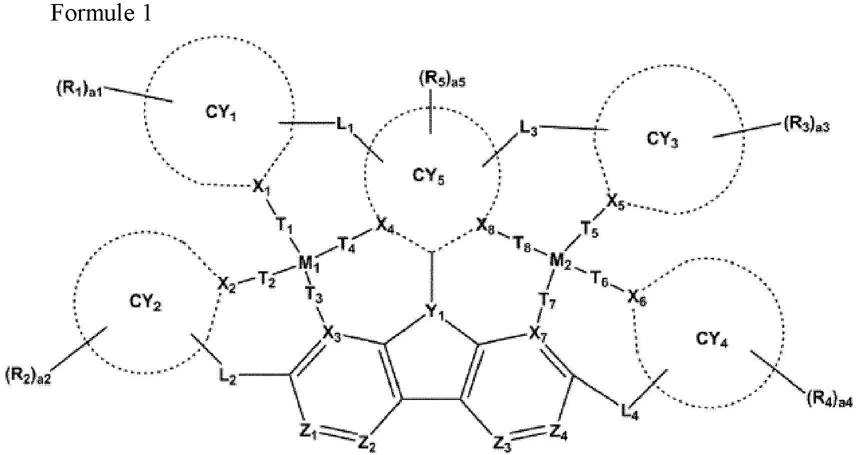 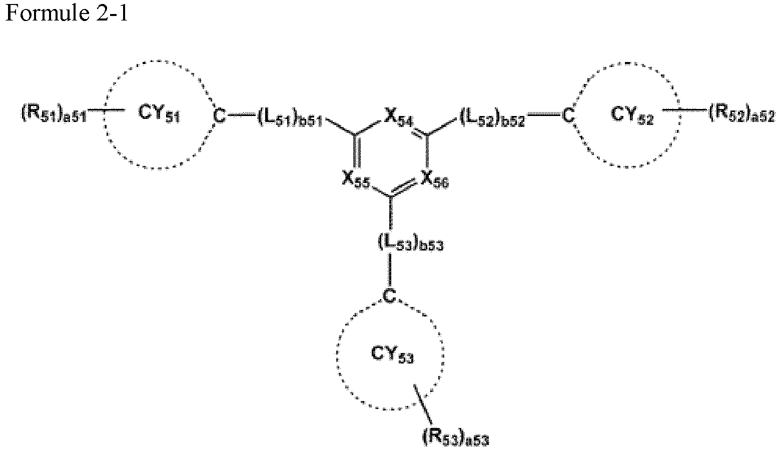 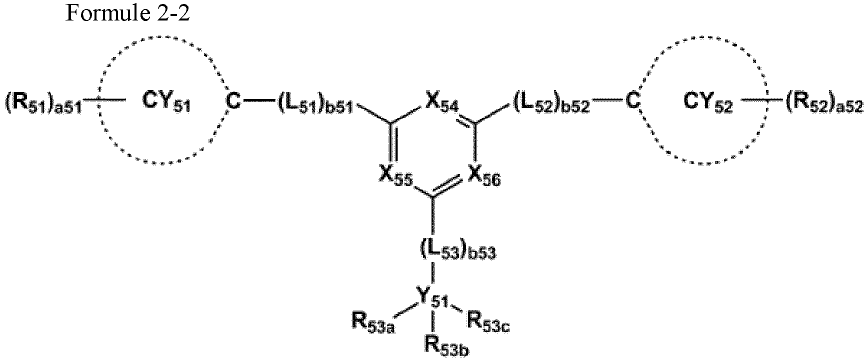 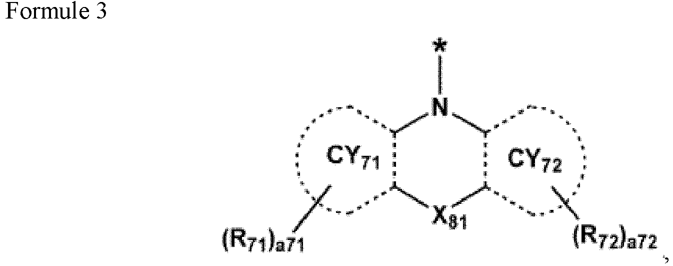
où, dans les formules 1 à 3 :
M₁ et M₂ représentent chacun indépendamment du platine (Pt) ou du palladium, (Pd),
X₁ à X₈ représentent chacun indépendamment N ou C,
Y₁ est choisi parmi C(R₆), Si(R₆), N et P,
Z₁ à Z₄ représentent chacun indépendamment N ou C(R₇),
T₁ à T₈ représentent chacun indépendamment une liaison chimique, O, S, B(R'), N(R'), P(R'), C(R')(R"), Si(R')(R"), Ge(R')(R"), C(=O), B(R')(R"), N(R')(R") ou P(R')(R"), dans lequel, lorsque T₁ est une liaison chimique, alors X₁ et M₁ sont directement liés l'un à l'autre, lorsque T₂ est une liaison chimique, alors X₂ et M₁ sont directement liés l'un à l'autre, lorsque T₃ est une liaison chimique, alors X₃ et M₁ sont directement liés l'un à l'autre, lorsque T₄ est une liaison chimique, alors X₄ et M₁ sont directement liés l'un à l'autre, lorsque T₅ est une liaison chimique, alors X₅ et M₂ sont directement liés à l'un l'autre, lorsque T₆ est une liaison chimique, alors X₆ et M₂ sont directement liés l'un à l'autre, lorsque T₇ est une liaison chimique, alors X₇ et M₂ sont directement liés l'un à l'autre, et lorsque T₈ est une liaison chimique liaison, X₈ et M₂ sont directement liés l'un à l'autre,
deux liaisons choisies parmi une liaison entre M₁ et X₁ ou T₁, une liaison entre M₁ et X₂ ou T₂, une liaison entre M₁ et X₃ ou T₃, et une liaison entre M₁ et X₄ ou T₄ sont chacune une liaison de coordination, et les deux autres liaisons sont chacune une liaison covalente,
deux liaisons choisies parmi une liaison entre M₂ et X₅ ou T₅, une liaison entre M₂ et X₆ ou T₆, une liaison entre M₂ et X₇ ou T₇, et une liaison entre M₂ et X₈ ou T₈ sont chacune une liaison de coordination, et les deux autres liaisons sont chacune une liaison covalente,
L₁ à L₄ sont chacun indépendamment choisis parmi une liaison simple, une liaison double, *-N(R₈)-*', *-B(R₈)-*', *-P(R₈)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*', *-C(R₈)=*', *=C(R₈)-*', *-C(R₈ₐ)=C(R_{8b})-*', *-C(=S)-*' et *-C=C-*'
les cycles CY₁ à CY₅, les cycles CY₅₁ à CY₅₃, le cycle CY₇₁ et le cycle CY₇₂ sont chacun indépendamment choisis parmi un groupe carbocyclique en C₅-C₃₀ et un groupe hétérocyclique en C₁-C₃₀,
L₅₁ à L₅₃ sont chacun indépendamment choisis parmi un groupe carbocyclique en C₅-C₃₀ substitué ou non substitué et un groupe hétérocyclique en C₁-C₃₀ substitué ou non substitué,
une liaison entre L₅₁ et le cycle CY₅₁, une liaison entre L₅₂ et le cycle CY₅₂, une liaison entre L₅₃ et le cycle CY₅₃, une liaison entre deux L₅₁ ou plus, une liaison entre deux L₅₂ ou plus, une liaison entre deux L₅₃ ou plus, une liaison entre L₅₁ et un carbone entre X₅₄ et X₅₅ dans les Formules 2-1 et 2-2, une liaison entre L₅₂ et un carbone entre X₅₄ et X₅₆ dans les Formules 2-1 et 2-2, et une liaison entre L₅₃ et un carbone entre X₅₅ et X₅₆ dans les Formules 2-1 et 2-2 sont chacune une liaison simple carbone-carbone,
b51 à b53 sont chacun indépendamment un nombre entier de 0 à 5, où, lorsque b51 vaut 0, alors *-(L₅₁)_{b51}-*' est une liaison simple, où, lorsque b52 vaut 0, alors *-(L₅₂)_{b52}-*' est une liaison simple, et lorsque b53 vaut 0, alors *-(L₅₃)_{b53}-*' est une liaison simple,
X₅₄ représente N ou C(R₅₄), X₅₅ représente N ou C(R₅₅), et X₅₆ représente N ou C(R₅₆), où au moins un élément choisi parmi X₅₄ à X₅₆ représente N,
Y₅₁ représente C ou Si,
X₈₁ représente une liaison simple, O, S, N(R₈₁), B(R₈₁), C(R₈₁ₐ)(R_{81b}) ou Si(R₈₁ₐ)(R_{81b}),
R₁ à R₈, R₈ₐ, R_{8b}, R', R", R₅₁ à R₅₆, R₅₃ₐ à R_{53c}, R₇₁, R₇₂, R₈₁, R₈₁ₐ et R_{81b} sont chacun indépendamment choisis parmi hydrogène, deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe polycyclique condensé non aromatique monovalent substitué ou non substitué, un groupe hétéropolycyclique condensé non aromatique monovalent substitué ou non substitué, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁) et -P(=O)(Q₁)(Q₂),
a1 à a5, a51 à a53, a71 et a72 sont chacun indépendamment un nombre entier de 0 à 20,
i) deux groupes parmi les R₁ au nombre de a1, ii) deux groupes parmi les R₂ au nombre de a2, iii) deux groupes parmi les R₃ au nombre de a3, iv) deux groupes parmi les R₄ au nombre de a4, v) deux groupes parmi les R₅ au nombre de a5, vi) R₈ₐ et R_{8b}, et vii) deux groupes parmi R₁ à R₈, R₈ₐ, R_{8b}, R' et R" sont chacun indépendamment facultativement liés les uns aux autres par une liaison simple, une liaison double ou un premier groupe de liaison, de manière à former un groupe carbocyclique en C₅-C₃₀ qui est non substitué ou substitué par au moins un R_{10a,} ou un groupe hétérocyclique en C₁-C₃₀ qui est non substitué ou substitué par au moins un R_{10a,}
R₁₀ₐ a la même description que celle donnée en lien avec R₁,
* et *' indiquent chacun site de liaison à un atome voisin, et
au moins un substituant du groupe carbocyclique en C₅-C₃₀ substitué, du groupe hétérocyclique en C₁-C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe alkylaryle en C₇-C₆₀ substitué, du groupe aryloxy en C₆-C₆₀ substitué, du groupe arylthio en C₆-C₆₀ substitué, du groupe hétéroaryle en C₁-C₆₀ substitué, du groupe alkylhétéroaryle en C₂-C₆₀ substitué, du groupe polycyclique condensé non aromatique monovalent substitué et du groupe hétéropolycyclique condensé non aromatique monovalent substitué est choisi parmi :
deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀, un groupe alcényle en C₂-C₆₀, un groupe alcynyle en C₂-C₆₀ et un groupe alcoxy en C₁-C₆₀ ;
un groupe alkyle en C₁-C₆₀, un groupe alcényle en C₂-C₆₀, un groupe alcynyle en C₂-C₆₀ et un groupe alcoxy en C₁-C₆₀, chacun substitué par au moins un groupe choisi parmi deutérium, -F, -Cl, -Br, -I, un groupe hydroxyle, un groupe cyano, un groupe nitro, un groupe amidino, un groupe hydrazine, un groupe hydrazone, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe arylalkyle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe polycyclique condensé non aromatique monovalent, un groupe hétéropolycyclique condensé non aromatique monovalent, -O(Qn), -S(Q₁₁), -Si(Q₁₁)(Q₁₂)(Q₁₃), -N(Q₁₁)(Q₁₂), -B(Q₁₁)(Q₁₂), -P(Q₁₁)(Q₁₂), -C(=O)(Q₁₁), -S(=O)₂(Q₁₁) et -P(=O)(Q₁₁)(Q₁₂) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe polycyclique condensé non aromatique monovalent et un groupe hétéropolycyclique condensé non aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe polycyclique condensé non aromatique monovalent et un groupe hétéropolycyclique condensé non aromatique monovalent, chacun substitué par au moins un groupe choisi parmi deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe polycyclique condensé non aromatique monovalent, un groupe hétéropolycyclique condensé non aromatique monovalent, -O(Q₂₁), -S(Q₂₁), -Si(Q₂₁)(Q₂₂)(Q₂₃), -N(Q₂₁)(Q₂₂), -B(Q₂₁)(Q₂₂), -P(Q₂₁)(Q₂₂), -C(=O)(Q₂₁), -S(=O)₂(Q₂₁) et -P(=O)(Q₂₁)(Q₂₂) ; et
-O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁) et -P(=O)(Q₃₁)(Q₃₂), et
Q₁ à Q₃, Q₁₁ à Q₁₃, Q₂₁ à Q₂₃ et Q₃₁ à Q₃₃ sont chacun indépendamment choisis parmi hydrogène, deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, un groupe alkyle en C₁-C₆₀ qui est substitué par au moins un groupe choisi parmi deutérium, -F, un groupe cyano, un groupe alkyle en C₁-C₆₀, un groupe phényle, et un groupe biphényle, et un groupe aryle en C₆-C₆₀ qui est substitué par au moins un groupe choisi parmi deutérium, -F, un groupe cyano, un groupe alkyle en C₁-C₁₀, un groupe phényle et un groupe biphényle.

2. Dispositif électroluminescent organique selon la revendication 1, dans lequel, dans les formules 1 à 3, les cycles CY₁ à CY₅, CY₅₁ à CY₅₃, le cycle CY₇₁ et le cycle CY₇₂ sont chacun indépendamment i) un premier cycle, ii) un deuxième cycle, iii) un cycle condensé dans lequel deux premiers cycles ou plus sont condensés les uns avec les autres, iv) un cycle condensé dans lequel deux deuxièmes cycles ou plus sont condensés les uns avec les autres, ou v) un cycle condensé dans lequel un ou plusieurs premiers cycles et un ou plusieurs deuxièmes cycles sont condensés les uns avec les autres,
le premier cycle étant choisi parmi un groupe cyclopentane, un groupe cyclopentadiène, un groupe furane, un groupe thiophène, un groupe pyrrole, un groupe silole, un groupe oxazole, un groupe isoxazole, un groupe oxadiazole, un groupe isoxadiazole, un groupe oxatriazole, un groupe isoxatriazole, un groupe thiazole, un groupe isothiazole, un groupe thiadiazole, un groupe isothiadiazole, un groupe thiatriazole, un groupe isothiatriazole, un groupe pyrazole, un groupe imidazole, un groupe triazole, un groupe tétrazole, un groupe azasilole, un groupe diazasilole et un groupe triazasilole, et
le deuxième cycle est choisi parmi un groupe adamantane, un groupe norbornane, un groupe norbornène, un groupe cyclohexane, un groupe cyclohexène, un groupe benzène, un groupe pyridine, un groupe pyrimidine, un groupe pyrazine, un groupe pyridazine, un groupe triazine, un groupe oxasiline, un groupe thiasiline, un groupe dihydroazasiline, un groupe dihydrodisiline, un groupe dihydrosiline, un groupe dioxine, un groupe oxathiine, un groupe oxazine, un groupe pyrane, un groupe dithiine, un groupe thiazine, un groupe thiopyrane, un cyclohexadiène, un groupe dihydropyridine et un groupe dihydropyrazine.

3. Dispositif électroluminescent organique selon la revendication 1 ou la revendication 2, dans lequel, dans les Formules 2-1 et 2-2, un groupe représenté par 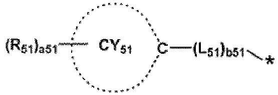 et un groupe représenté par 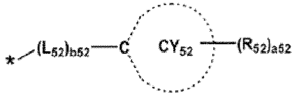 ne représentent pas un groupe phényle, facultativement dans lequel, dans les Formules 2-1 et 2-2, un groupe représenté par 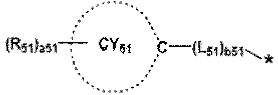 et un groupe représenté par 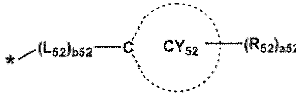 sont identiques, facultativement dans lequel une fraction représentée par 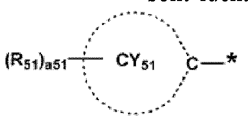 est choisie parmi les groupes représentés par les Formules CY51-1 à CY51-19, et/ou
une fraction représentée par 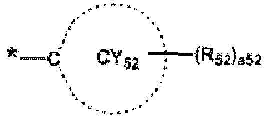 est choisie parmi les groupes représentés par les formules CY52-1 à CY52-19, et/ou
une fraction représentée par 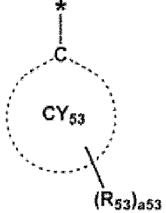 est choisie parmi les groupes représentés par les formules CY53-1 à CY53-18 : 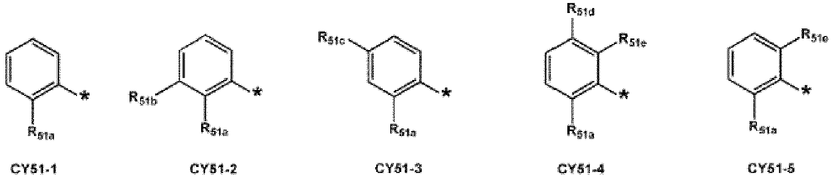 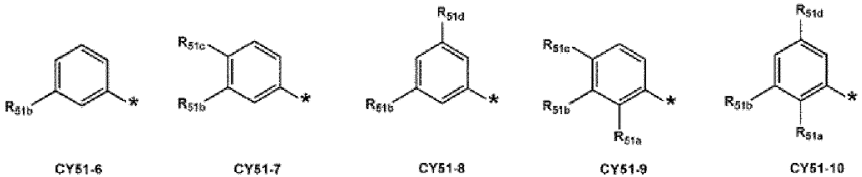 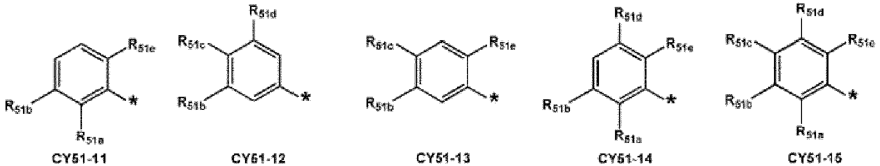 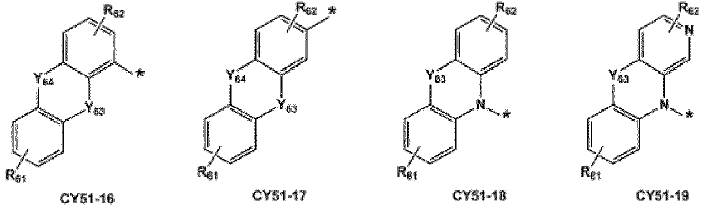 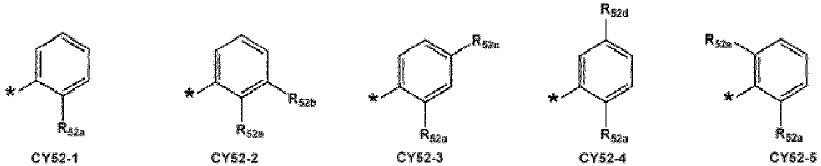 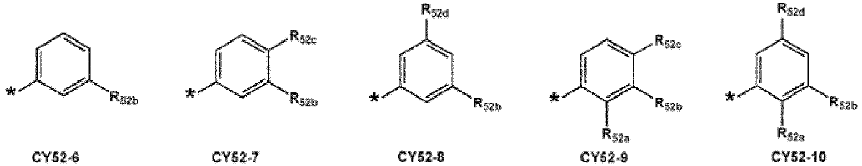 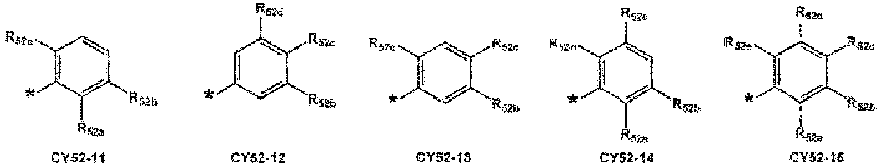 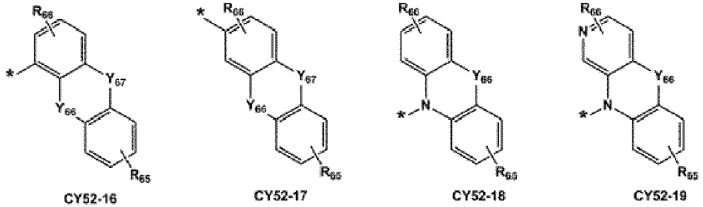 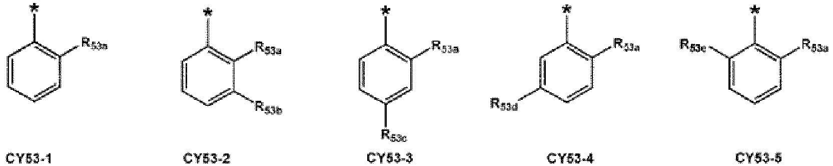 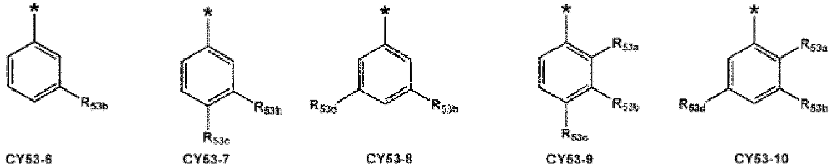 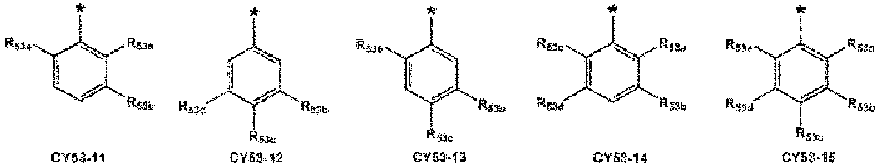 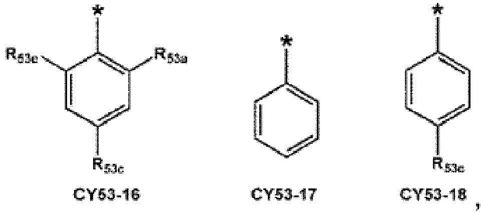
où, dans les formules CY51-1 à CY51-19, CY52-1 à CY52-19 et CY53-1 à CY53-18 :
Y₆₃ représente une liaison simple, O, S, N(R₆₃), B(R₆₃), C(R₆₃ₐ)(R_{63b}) ou Si(R₆₃ₐ)(R_{63b}),
Y₆₄ représente une liaison simple, O, S, N(R₆₄), B(R₆₄), C(R₆₄ₐ)(R_{64b}) ou Si(R₆₄ₐ)(R_{64b}),
Y₆₆ représente une liaison simple, O, S, N(R₆₆), B(R₆₆), C(R₆₆ₐ)(R_{66b}) ou Si(R₆₆ₐ)(R_{66b}),
Y₆₇ représente une liaison simple, O, S, N(R₆₇), B(R₆₇), C(R₆₇ₐ)(R_{67b}) ou Si(R₆₇ₐ)(R_{67b}),
Y₆₃ et Y₆₄ dans les formules CY51-16 et CY51-17 ne représentent pas chacun, simultanément, une liaison simple,
Y₆₆ et Y₆₇ dans les formules CY52-16 et CY52-17 ne représentent pas chacun, simultanément, une liaison simple,
R₅₁ₐ à R₅₁ₑ, R₆₁ à R₆₄, R₆₃ₐ, R_{63b}, R₆₄ₐ et R_{64b} ont chacun indépendamment la même description que celle donnée en lien avec R₅₁, et R₅₁ₐ à R₅₁ₑ ne représentent pas chacun un hydrogène,
R₅₂ₐ à R₅₂ₑ, R₆₅ à R₆₇, R₆₆ₐ, R_{66b}, R₆₇ₐ et R_{67b} ont chacun indépendamment la même description que celle donnée en lien avec R₅₂, et R₅₂ₐ à R₅₂ₑ ne représentent pas chacun un hydrogène,
R₅₃ₐ à R₅₃ₑ ont chacun indépendamment la même description que celle donnée en lien avec R₅₃, et R₅₃ₐ à R₅₃ₑ ne représentent pas chacun hydrogène, et
* indique un site de liaison à un atome adjacent.

4. Dispositif électroluminescent organique selon l'une quelconque des revendications 1 à 3, dans lequel le troisième composé est représenté par un composé choisi parmi les Formules 3-1 à 3-5 : 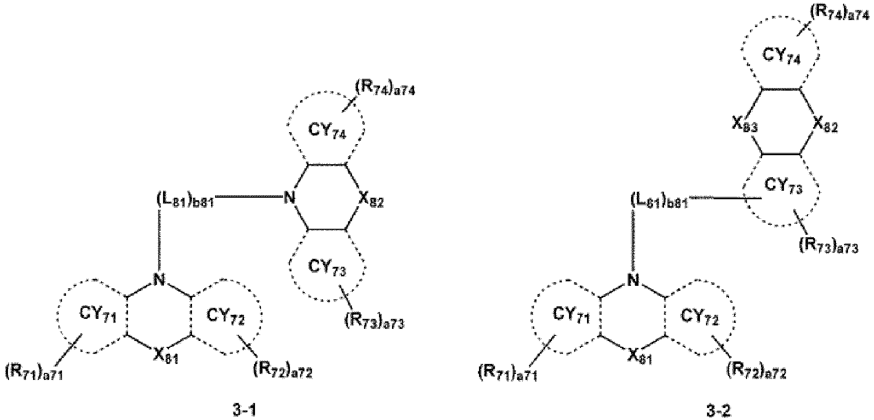 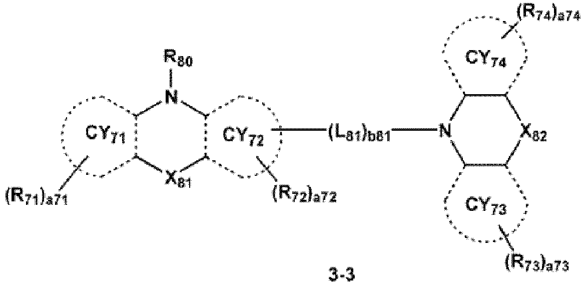 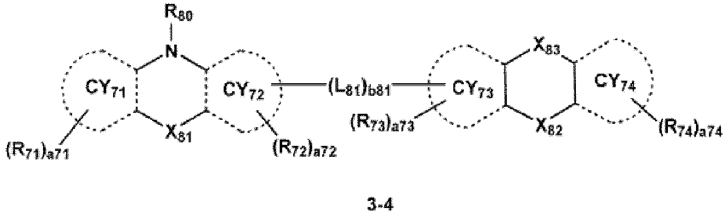 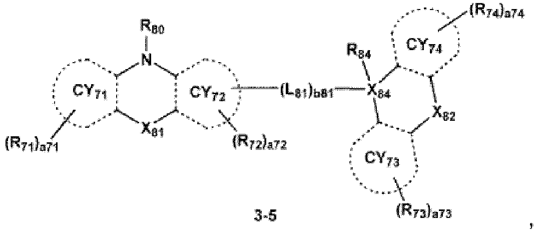 où, dans les formules 3-1 à 3-5 :
le cycle CY₇₁, le cycle CY₇₂, X₈₁, R₇₁, R₇₂, a71 et a72 sont identiques à ceux décrits ci-dessus,
le cycle CY₇₃, le cycle CY₇₄, R₇₃, R₇₄, a73 et a74 sont respectivement identiques à ceux décrits en lien avec le cycle CY₇₁, le cycle CY₇₂, R₇₁, R₇₂, a71 et a72,
L₈₁ est choisi parmi *-C(Q₄)(Q₅)-*', *-Si(Q₄)(Q₅)-*', un groupe carbocyclique en C₅-C₃₀ substitué ou non substitué et un groupe hétérocyclique en C₁-C₃₀ substitué ou non substitué, Q₄ et Q₅ étant chacun identiques à ceux décrits en lien avec Q₁,
b81 est un nombre entier de 0 à 5, où, lorsque b81 vaut 0, alors *-(L₈₁)_{b81}-*' est une liaison simple, lorsque b81 vaut 2 ou plus, alors deux ou plusieurs L₈₁ sont identiques ou différents l'un de l'autre,
X₈₂ représente une liaison simple, O, S, N(R₈₂), B(R₈₂), C(R₈₂ₐ)(R_{82b}) ou Si(R₈₂ₐ)(R_{82b}),
X₈₃ représente une liaison simple, O, S, N(R₈₃), B(R₈₃), C(R₈₃ₐ)(R_{83b}) ou Si(R₈₃ₐ)(R_{83b}),
dans les formules 3-2 et 3-4, X₈₂ et X₈₃ ne représentent pas chacun, simultanément, une liaison simple,
X₈₄ représente C ou Si,
R₈₀, R₈₂, R₈₃, R₈₂ₐ, R_{82b}, R₈₃ₐ, R_{83b} et R₈₄ sont identiques à ceux décrits en lien avec R₈₁, et
* et *' indiquent chacun site de liaison à un atome voisin ; facultativement où dans lequel une fraction représentée par 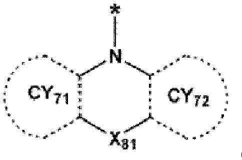 dans les Formules 3-1 et 3-2 est choisie dans les groupes représentés par les Formules CY71-1(1) à CY71-1(8),
une fraction représentée par 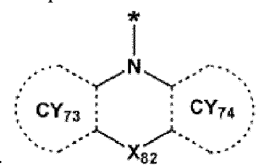 dans les Formules 3-1 et 3-3 est choisie dans les groupes représentés par les Formules CY71-2(1) à CY71-2(8),
une fraction représentée par 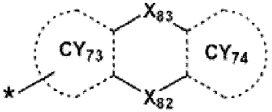 dans les Formules 3-2 et 3-4 est choisie dans les groupes représentés par les Formules CY71-3(1) à CY71-3(32),
une fraction représentée par 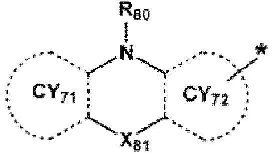 dans les Formules 3-3 à 3-5, est choisie dans les groupes représentés par les Formules CY71-4(1) à CY71-4(32), et
une fraction représentée par 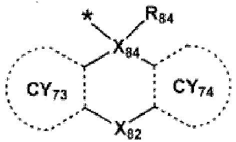 dans la Formule 3-5 est choisie parmi les groupes représentés par les Formules CY71-5(1) à CY71-5(8) : 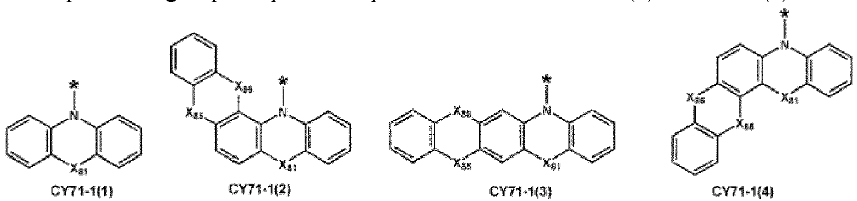 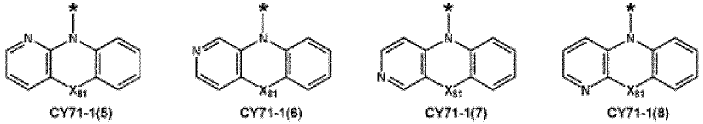 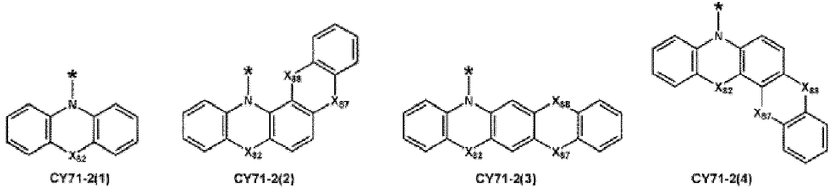 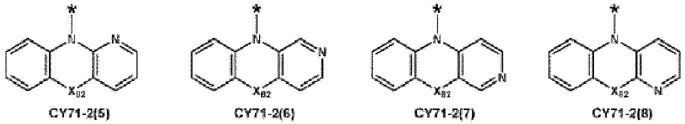 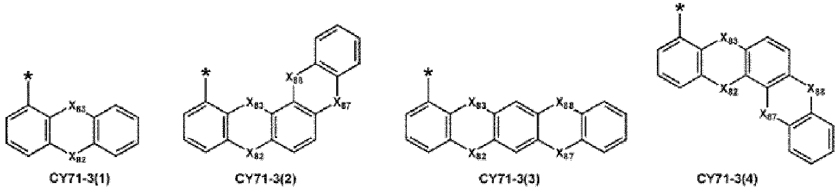 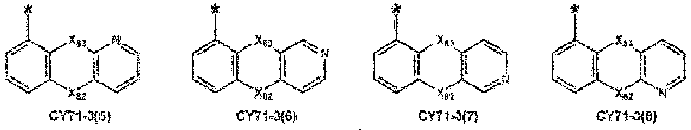 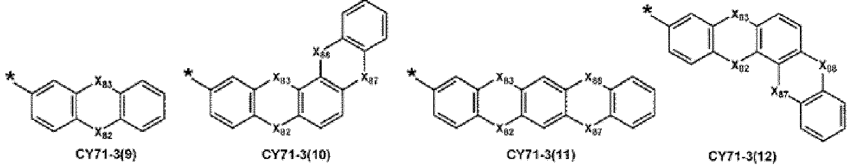 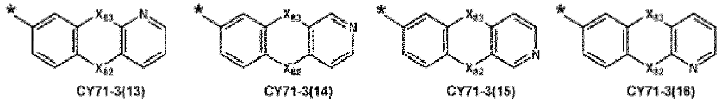 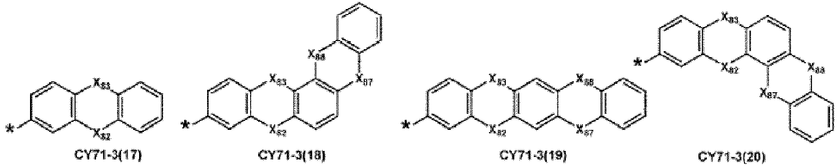 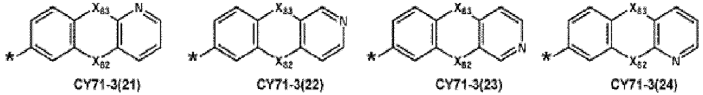 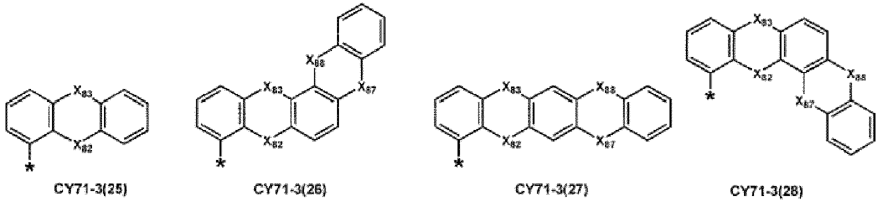 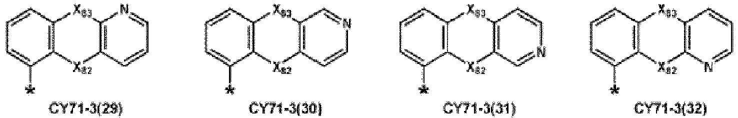 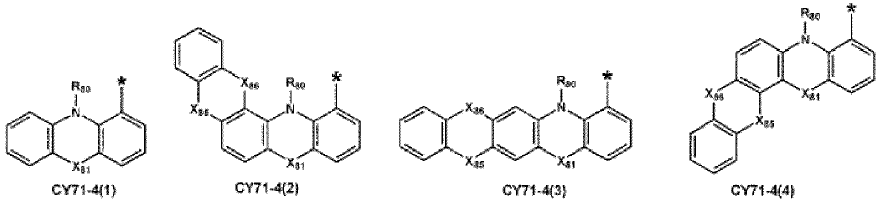 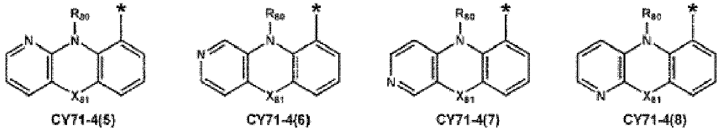 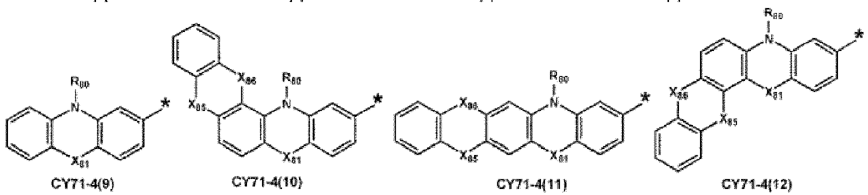 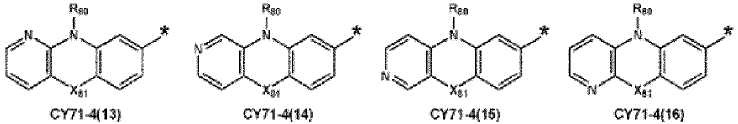 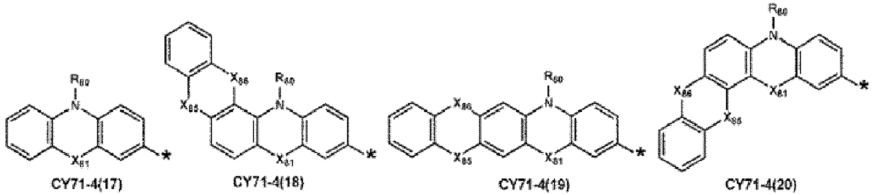 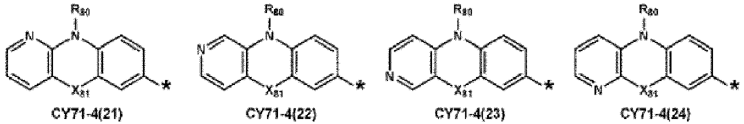 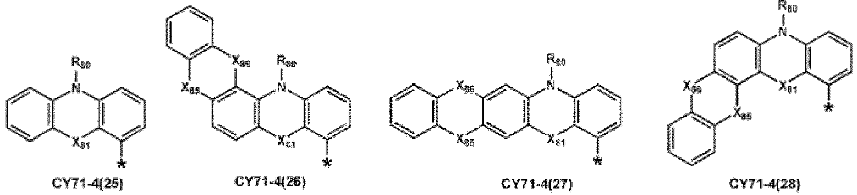 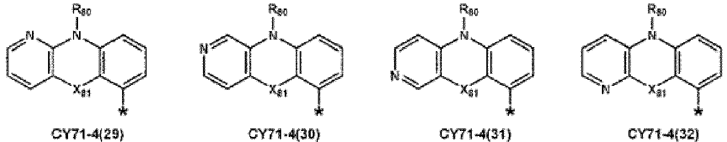 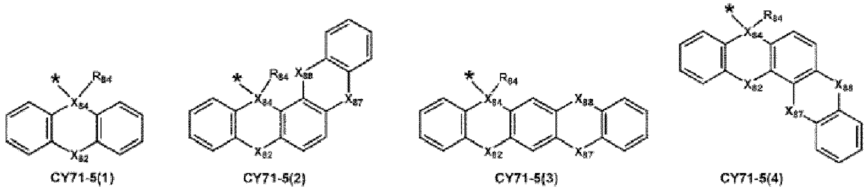 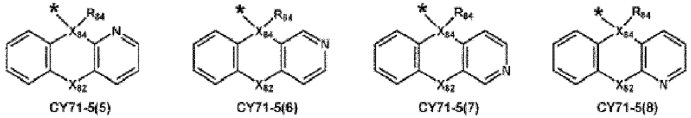
où, dans les formules CY71-1(1) à CY71-1(8), CY71-2(1) à CY71-2(8), CY71-3(1) à CY71-3(32), CY71-4(1) à CY71-4(32) et CY71-5(1) à CY71-5(8) :
X₈₁ à X₈₄, R₈₀ et R₈₄ sont chacun indépendamment identiques à ceux décrits ci-dessus,
X₈₅ représente une liaison simple, O, S, N(R₈₅), B(R₈₅), C(R₈₅ₐ)(R_{85b}) ou Si(R₈₅ₐ)(R_{85b}), et
X₈₆ représente une liaison simple, O, S, N(R₈₆), B(R₈₆), C(R₈₆ₐ)(R_{86b}) ou Si(R₈₆ₐ)(R_{86b}),
dans les Formules CY71-1(1) à CY71-1(8) et CY71-4(1) à CY71-4(32), X₈₅ et X₈₆ ne représentent pas chacun, simultanément, une liaison simple,
X₈₇ représente une liaison simple, O, S, N(R₈₇), B(R₈₇), C(R₈₇ₐ)(R_{87b}) ou Si(R₈₇ₐ)(R_{87b}), et
X₈₈ représente une liaison simple, O, S, N(R₈₈), B(R₈₈), C(R₈₈ₐ)(R_{88b}) ou Si(R₈₈ₐ)(R_{88b}), et
dans les Formules CY71-2(1) à CY71-2(8), CY71-3(1) à CY71-3(32) et CY71-5(1) à CY71-5(8), X₈₇ et X₈₈ ne représentent pas chacun simultanément une liaison simple, et
R₈₅ à R₈₈, R₈₅ₐ, R_{85b}, R₈₆ₐ, R_{86b}, R₈₇ₐ, R_{87b}, R₈₈ₐ et R_{88b} ont chacun indépendamment la même description que celle donnée en lien avec R₈₁.

5. Dispositif électroluminescent organique selon la revendication 1, dans lequel le deuxième composé est choisi parmi les Composés H2-1 à H2-80, et
le troisième composé est choisi parmi les Composés H3-1 à H3-28 :

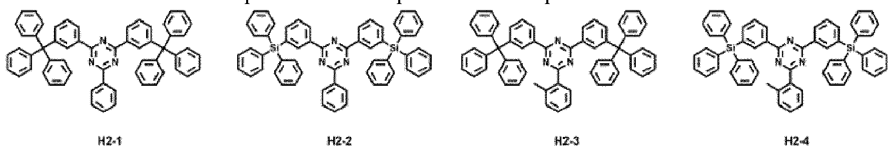

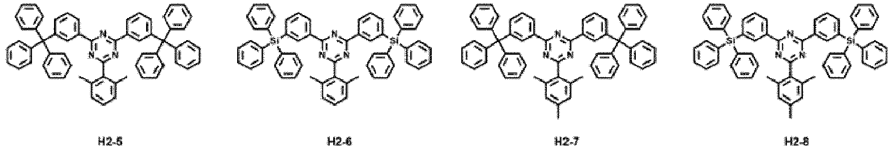

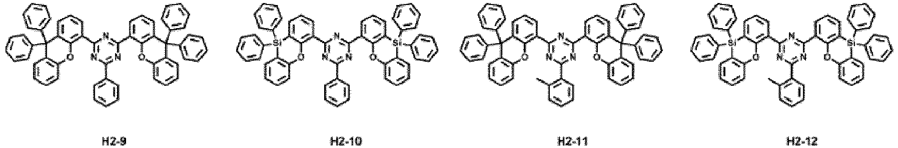

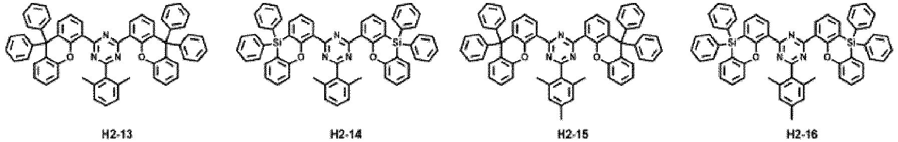

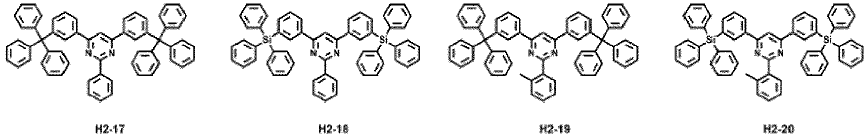

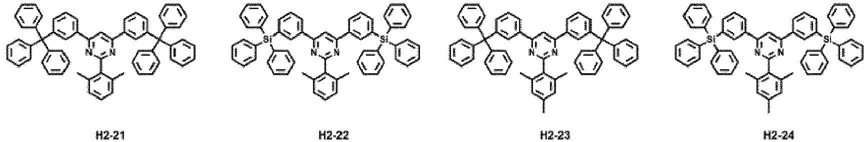

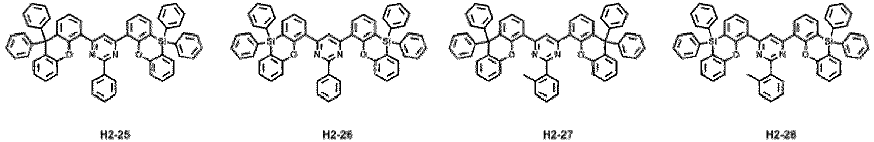

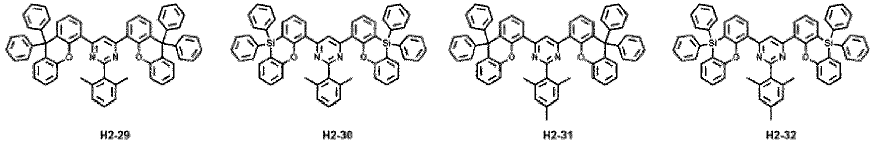

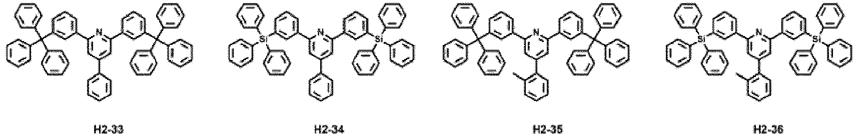

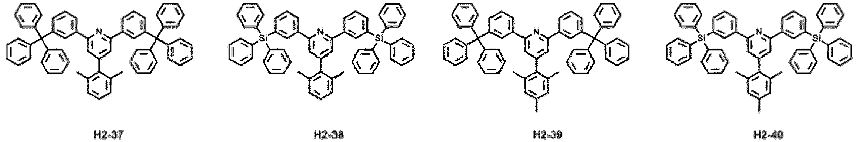

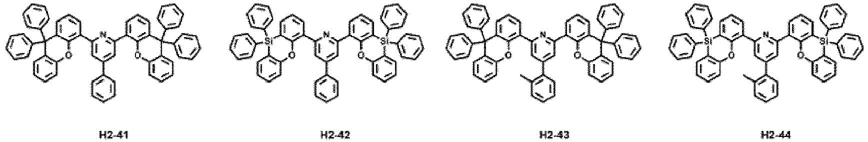

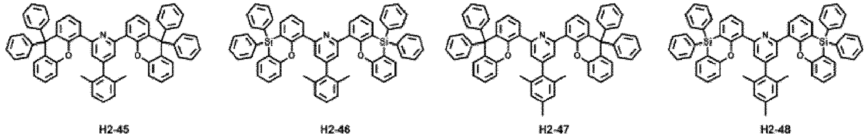

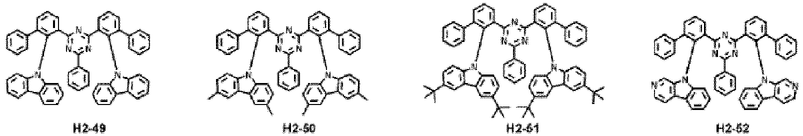

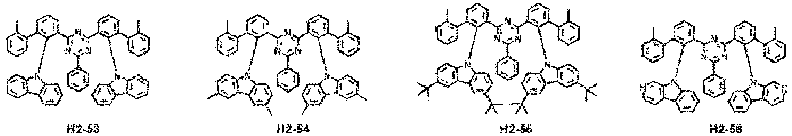

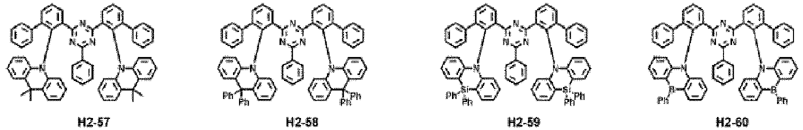

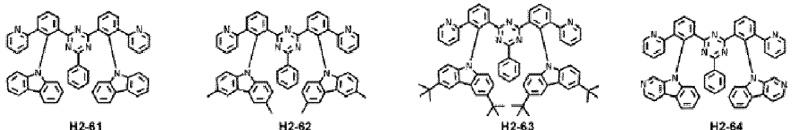

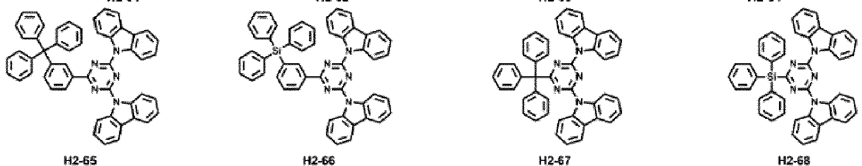

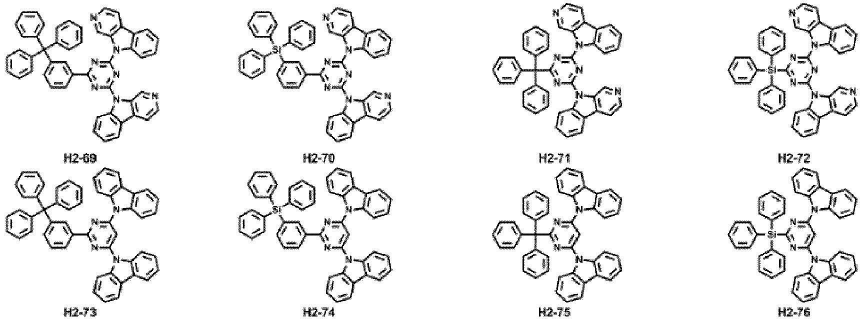

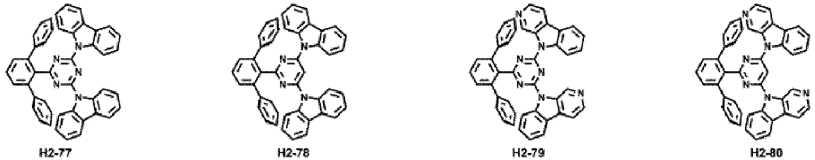

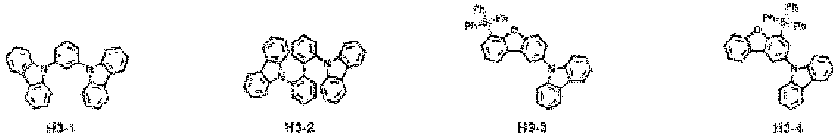

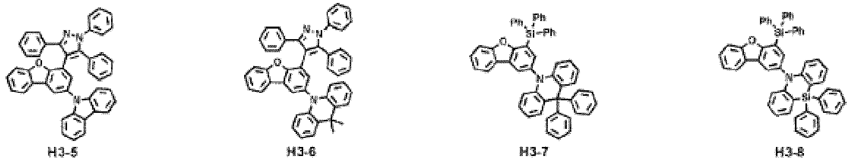

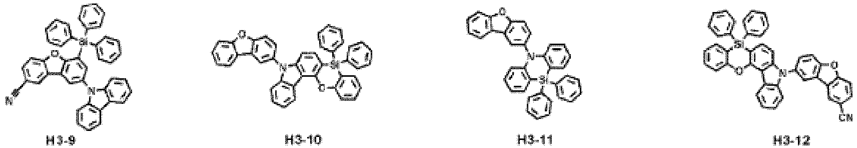

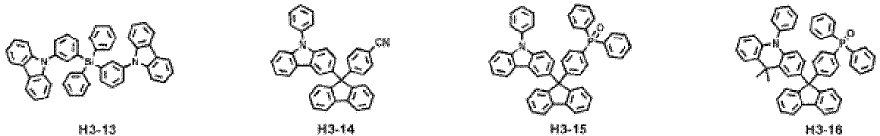

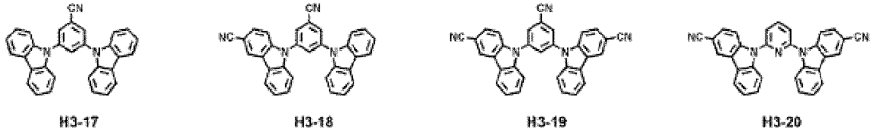

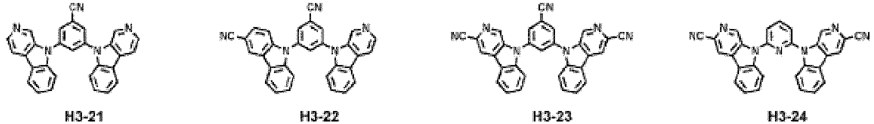

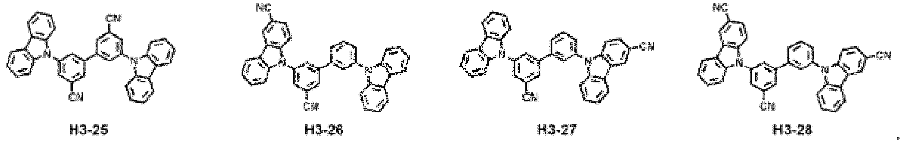

6. Dispositif électroluminescent organique selon l'une quelconque des revendications 1 à 5, dans lequel le deuxième composé et le troisième composé forment un exciplexe.

7. Dispositif électroluminescent organique selon l'une quelconque des revendications 1 à 6, dans lequel le temps de déclin de la fluorescence retardée dans le spectre d'électroluminescence résolue dans le temps (TREL) du dispositif électroluminescent organique est de 50 ns ou plus, ledit dispositif électroluminescent organique incluant facultativement en outre une couche de recouvrement sur la deuxième électrode, et
la couche de recouvrement a un indice de réfraction de 1,6 ou plus à une longueur d'onde de 589 nm, la couche d'émission ayant facultativement une longueur d'onde d'émission maximale de 390 nm ou plus et de 520 nm ou moins.

8. Composé organométallique représenté par la formule 1 : 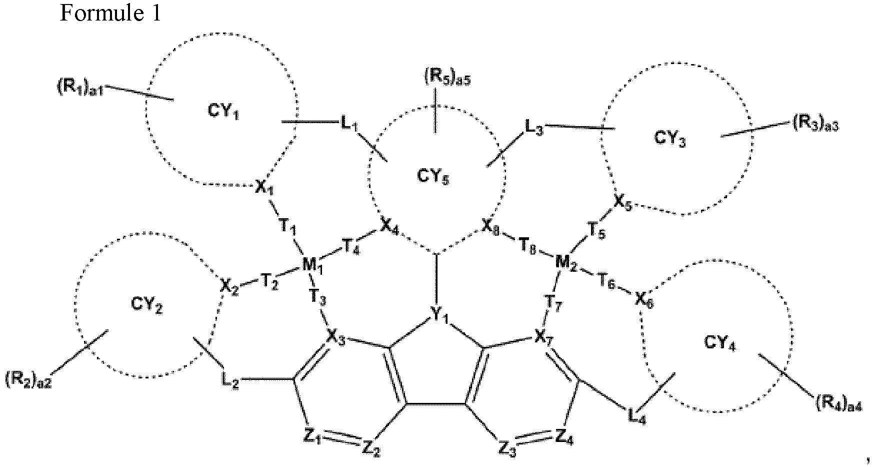 où, dans la formule 1,
M₁ et M₂ représentent chacun indépendamment le platine (Pt) ou le palladium. (Pd),
X₁ à X₈ représentent chacun indépendamment N ou C,
Y₁ est choisi parmi C(R₆), Si(R₆), N et P,
Z₁ à Z₄ représentent chacun indépendamment N ou C(R₇),
T₁ à T₈ représentent chacun indépendamment une liaison chimique, O, S, B(R'), N(R'), P(R'), C(R')(R"), Si(R')(R"), Ge(R')(R"), C(=O), B(R')(R"), N(R')(R") ou P(R')(R"), où lorsque T₁ est une liaison chimique, alors X₁ et M₁ sont directement liés l'un à l'autre, lorsque T₂ est une liaison chimique, alors X₂ et M₁ sont directement liés l'un à l'autre, lorsque T₃ est une liaison chimique, alors X₃ et M₁ sont directement liés l'un à l'autre, lorsque T₄ est une liaison chimique, alors X₄ et M₁ sont directement liés l'un à l'autre, lorsque T₅ est une liaison chimique, alors X₅ et M₂ sont directement liés l'un à l'autre, lorsque T₆ est une liaison chimique, alors X₆ et M₂ sont directement liés l'un à l'autre, lorsque T₇ est une liaison chimique, alors X₇ et M₂ sont directement liés l'un à l'autre, et lorsque T₈ est une liaison chimique, alors X₈ et M₂ sont directement liés l'un à l'autre,
deux liaisons choisies parmi une liaison entre M₁ et X₁ ou T₁, une liaison entre M₁ et X₂ ou T₂, une liaison entre M₁ et X₃ ou T₃, et une liaison entre M₁ et X₄ ou T₄ sont chacune une liaison de coordination, et les deux autres liaisons sont chacune une liaison covalente,
deux liaisons choisies parmi une liaison entre M₂ et X₅ ou T₅, une liaison entre M₂ et X₆ ou T₆, une liaison entre M₂ et X₇ ou T₇, et une liaison entre M₂ et X₈ ou T₈ sont chacune une liaison de coordination, et les deux autres liaisons sont chacune une liaison covalente,
L₁ à L₄ sont chacun indépendamment choisis parmi une liaison simple, une liaison double, *-N(R₈)-*', *-B(R₈)-*', *-P(R₈)-*', *-C(R₈ₐ)(R_{8b})-*', *-Si(R₈ₐ)(R_{8b})-*', *-Ge(R₈ₐ)(R_{8b})-*', *-S-*', *-Se-*', *-O-*', *-C(=O)-*', *-S(=O)-*', *-S(=O)₂-*', *-C(R₈)=*', *=C(R₈)-*', *-C(R₈ₐ)=C(R_{8b})-*', *-C(=S)-*' et *-C≡C-*',
les cycles allant de CY₁ à CY₅ sont chacun indépendamment choisis parmi un groupe carbocyclique en C₅-C₃₀ et un groupe hétérocyclique en C₁-C₃₀,
R₁ à R₈, R₈ₐ, R_{8b}, R' et R" sont chacun indépendamment choisis parmi hydrogène, deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe polycyclique condensé non aromatique monovalent substitué ou non substitué, un groupe hétéropolycyclique condensé non aromatique monovalent substitué ou non substitué, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁) et -P(=O)(Q₁)(Q₂),
a1 à a5 sont chacun indépendamment un nombre entier de 0 à 20,
i) deux groupes parmi les R₁ au nombre de a1, ii) deux groupes parmi les R₂ au nombre de a2, iii) deux groupes parmi les R₃ au nombre de a3, iv) deux groupes parmi les R₄ au nombre de a4, v) deux groupes parmi les R₅ au nombre de a5, vi) R₈ₐ et R_{8b}, et vii) deux groupes parmi R₁ à R₈, R₈ₐ, R_{8b}, R' et R" sont chacun indépendamment facultativement liés les uns aux autres par une liaison simple, une liaison double ou un premier groupe de liaison, de manière à former un groupe carbocyclique en C₅-C₃₀ non substitué ou substitué par au moins un R₁₀ₐ, ou un groupe hétérocyclique en C₁-C₃₀ non substitué ou substitué par au moins un R₁₀ₐ,
R₁₀ₐ a la même description que celle donnée en lien avec R₁,
* et *' indiquent chacun site de liaison à un atome voisin, et
au moins un substituant du groupe carbocyclique en C₅₋C₃₀ substitué, du groupe hétérocyclique en C₁₋C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe alkylaryle en C₇-C₆₀ substitué, du groupe aryloxy en C₆-C₆₀ substitué, du groupe arylthio en C₆-C₆₀ substitué, du groupe hétéroaryle en C₁-C₆₀ substitué, du groupe alkylhétéroaryle en C₂-C₆₀ substitué, du groupe polycyclique condensé non aromatique monovalent substitué et du groupe hétéropolycyclique condensé non aromatique monovalent substitué est choisi parmi :
deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀, un groupe alcényle en C₂-C₆₀, un groupe alcynyle en C₂-C₆₀ et un groupe alcoxy en C₁-C₆₀ ;
un groupe alkyle en C₁-C₆₀, un groupe alcényle en C₂-C₆₀, un groupe alcynyle en C₂-C₆₀ et un groupe alcoxy en C₁-C₆₀, chacun substitué par au moins un groupe choisi parmi deutérium, -F, -Cl, -Br, -I, un groupe hydroxyle, un groupe cyano, un groupe nitro, un groupe amidino, un groupe hydrazine, un groupe hydrazone, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe arylalkyle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe polycyclique condensé non aromatique monovalent, un groupe hétéropolycyclique condensé non aromatique monovalent, -O(Q₁₁), -S(Q₁₁), -Si(Q₁₁)(Q₁₂)(Q₁₃), -N(Q₁₁)(Q₁₂), -B(Q₁₁)(Q₁₂),-P(Q₁₁)(Q₁₂), -C(=O)(Q₁₁), -S(=O)₂(Q₁₁) et -P(=O)(Q₁₁)(Q₁₂) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe polycyclique condensé non aromatique monovalent et un groupe hétéropolycyclique condensé non aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe polycyclique condensé non aromatique monovalent et un groupe hétéropolycyclique condensé non aromatique monovalent, chacun substitué par au moins un groupe choisi parmi deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe polycyclique condensé non aromatique monovalent, un groupe hétéropolycyclique condensé non aromatique monovalent,-O(Q₂₁), -S(Q₂₁), -Si(Q₂₁)(Q₂₂)(Q₂₃), -N(Q₂₁)(Q₂₂), -B(Q₂₁)(Q₂₂), -P(Q₂₁)(Q₂₂), -C(=O)(Q₂₁), -S(=O)₂(Q₂₁) et -P(=O)(Q₂₁)(Q₂₂) ; et
-O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁) et -P(=O)(Q₃₁)(Q₃₂), et
Q₁ à Q₃, Q₁₁ à Q₁₃, Q₂₁ à Q₂₃ et Q₃₁ à Q₃₃ sont chacun indépendamment choisis parmi hydrogène, deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, un groupe alkyle en C₁-C₆₀ qui est substitué par au moins un groupe choisi parmi deutérium, -F, un groupe cyano, un groupe alkyle en C₁-C₆₀, un groupe phényle, et un groupe biphényle, et un groupe aryle en C₆-C₆₀ qui est substitué par au moins un groupe choisi parmi deutérium, -F, un groupe cyano, un groupe alkyle en C₁-C₁₀, un groupe phényle et un groupe biphényle.

9. Composé organométallique selon la revendication 8, dans lequel les cycles CY₁ à CY₅ sont chacun indépendamment choisis parmi un groupe benzène, un groupe naphtalène, un groupe anthracène, un groupe phénanthrène, un groupe azulène, un groupe triphénylène, un groupe pyrène, un groupe un groupe chrysène, un groupe cyclopentadiène, un groupe 1,2,3,4-tétrahydronaphtalène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe indénopyridine, un groupe indolopyridine, un groupe benzofuropyridine, un groupe benzothiénopyridine, un groupe benzosilolopyridine, un groupe indénopyrimidine, un groupe indolopyrimidine, un groupe benzofuropyrimidine, un groupe benzothiénopyrimidine, un groupe benzosilolopyrimidine, un groupe dihydropyridine, un groupe pyridine, un groupe pyrimidine, un groupe pyrazine, un groupe pyridazine, un groupe triazine, un groupe quinoléine, un groupe isoquinoline, un groupe quinoxaline, un groupe quinazoline, un groupe phénanthroline, un groupe pyrrole, un groupe pyrazole, un groupe imidazole, un groupe 2,3-dihydroimidazole, un groupe triazole, un groupe 2,3-dihydrotriazole, un groupe oxazole, un groupe isooxazole, un groupe thiazole, un isothiazole un groupe oxadiazole, un groupe thiadiazole, un groupe benzopyrazole, un groupe pyrazolopyridine, un groupe furopyrazole, un groupe thiénopyrazole, un groupe benzimidazole, un groupe 2,3-dihydrobenzimidazole, un groupe imidazopyridine, un groupe 2,3-dihydroimidazopyridine, un groupe furanoimidazole, un groupe thiénoimidazole, un groupe imidazopyrimidine, un groupe 2,3-dihydroimidazopyrimidine, un groupe imidazopyrazine, un groupe 2,3-dihydroimidazopyrazine, un groupe benzoxazole, un groupe benzothiazole, un groupe benzoxadiazole, un groupe benzothiadiazole, un groupe 5,6,7,8-tétrahydroisoquinoléine et un groupe 5,6,7,8-tétrahydroquinoléine.

10. Composé organométallique selon la revendication 8 ou la revendication 9, dans lequel les cycles CY₁ à CY₄ sont chacun indépendamment choisis parmi les groupes représentés par les Formules 4-1 à 4-35 : 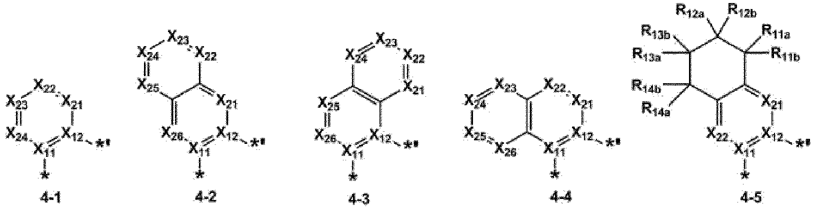 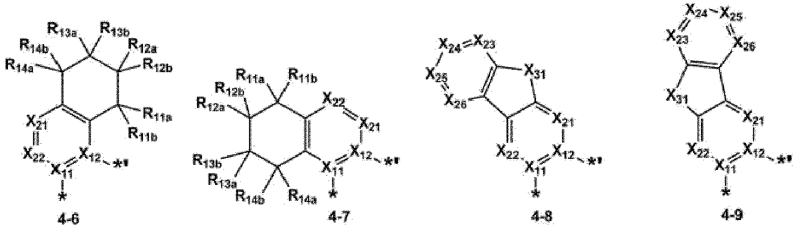 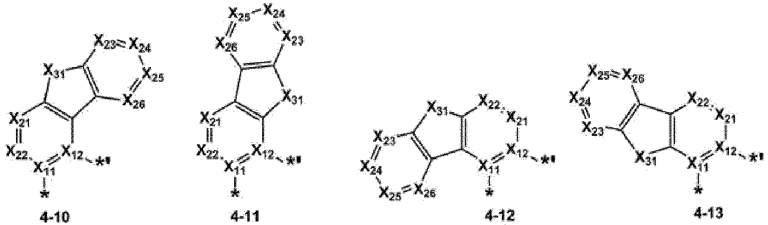 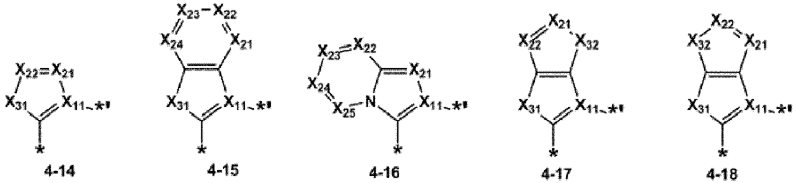 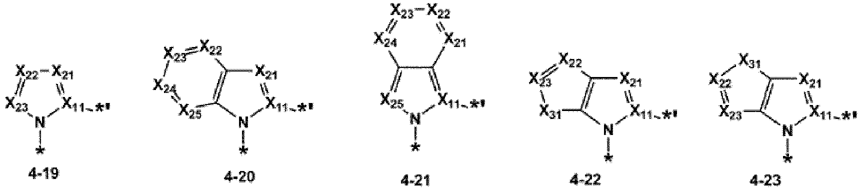 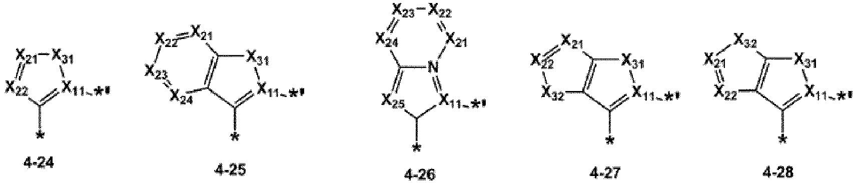 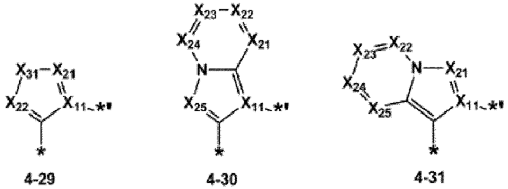 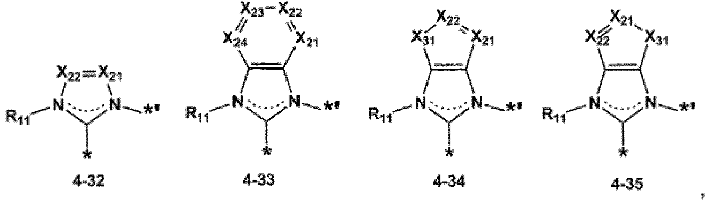 où, dans les formules 4-1 à 4-35 :
X₁₁ et X₁₂ représentent chacun indépendamment un atome de carbone ou un atome d'azote,
X₂₁ représente N ou C(R₂₁), X₂₂ représente N ou C(R₂₂), X₂₃ représente N ou C(R₂₃), X₂₄ représente N ou C(R₂₄), X₂₅ représente N ou C(R₂₅) et X₂₆ représente N ou C(R₂₆),
X₃₁ représente C(R₃₁ₐ)(R_{31b}), Si(R₃₁ₐ)(R_{31b}), N(R₃₁), O ou S,
X₃₂ représente C(R₃₂ₐ)(R_{32b}), Si(R₃₂ₐ)(R_{32b}), N(R₃₂), O ou S,
R₁₁, R₁₁ₐ, R_{11b}, R₁₂ₐ, R_{12b}, R₁₃ₐ, R_{13b}, R₁₄ₐ, R_{14b}, R₂₁ à R₂₆, R₃₁ à R₃₂, R₃₁ₐ à R_{31b} et R₃₂ₐ à R_{32b} ont chacun indépendamment la même description que celle donnée en lien avec R₁ à R₄ dans la Formule 1,
* indique un site de liaison à T₁, T₂, T₃, T₄, T₅, T₆, T₇ ou T₈, et
*' indique un site de liaison à L₁, L₂, L₃ ou L₄.

11. Composé organométallique selon l'une quelconque des revendications 8 à 10, dans lequel :
i) X₁ à X₈ représentent chacun C ; ou
ii) X₁ à X₅ représentent chacun N, et X₂ à X₄ et X₆ à X₈ représentent chacun C.

12. Composé organométallique selon l'une quelconque des revendications 8 à 11, ledit composé organométallique étant représenté par la formule 1-1 : 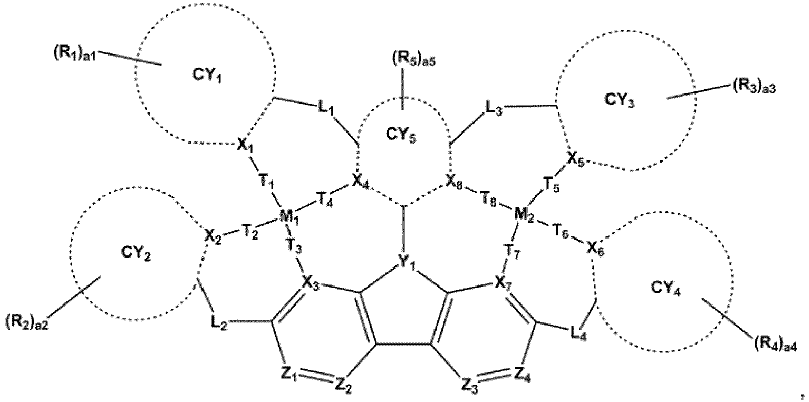 où, dans la Formule 1-1, M₁, M₂, X₁ à X₈, Y₁, Z₁ à Z₄, T₁ à T₈, L₁ à L₄, les cycles CY₁ à CY₅, R₁ à R₅ et al à a5 ont chacun indépendamment la même description que celle donnée en lien avec la formule 1.

13. Composé organométallique selon l'une quelconque des revendications 8 à 12, le composé représenté par la formule 1 ayant une structure symétrique.

14. Composé organométallique selon la revendication 8, le composé organométallique étant choisi parmi les composés 1 à 120 :

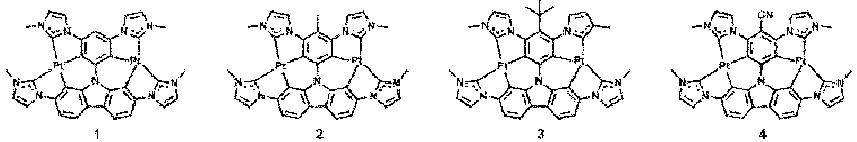

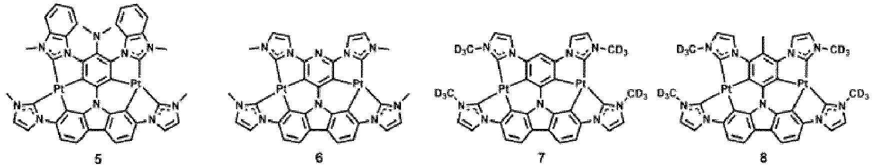

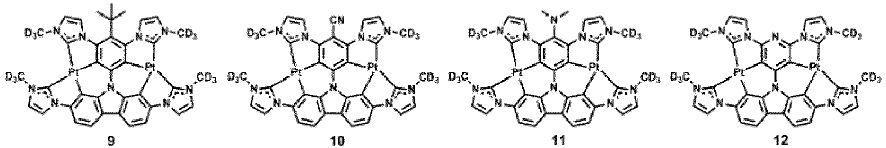

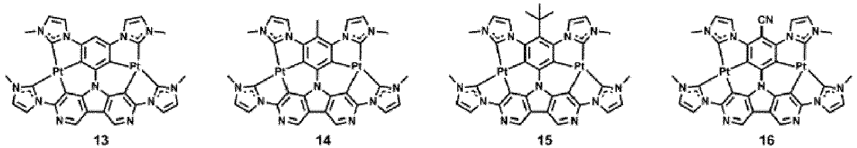

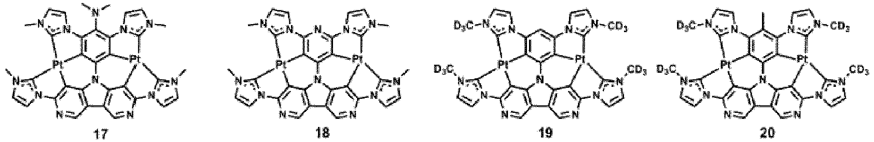

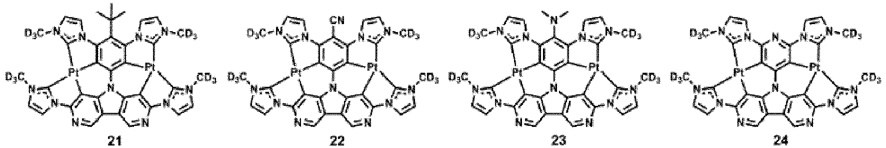

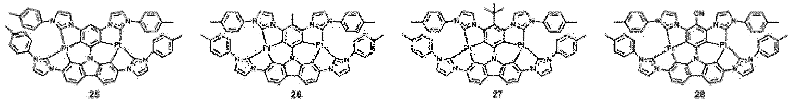

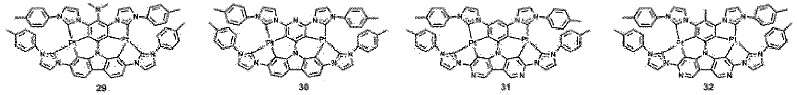

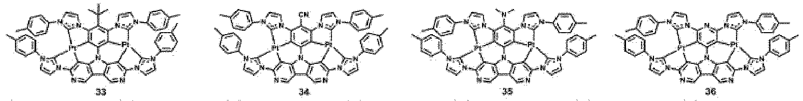

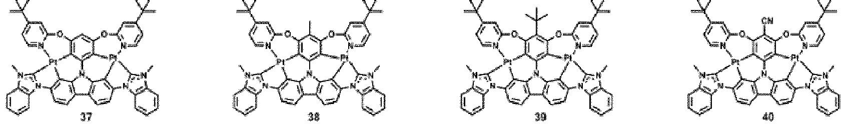

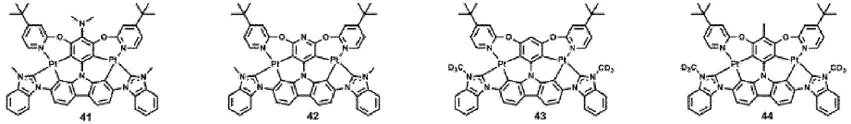

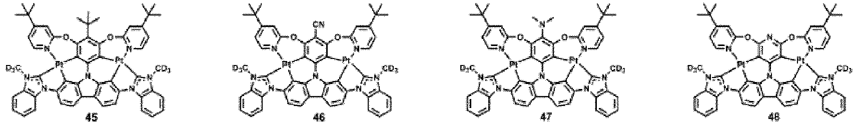

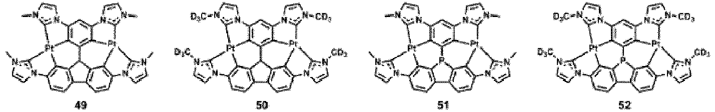

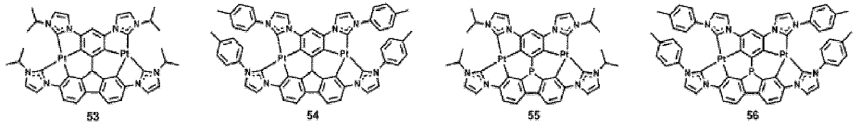

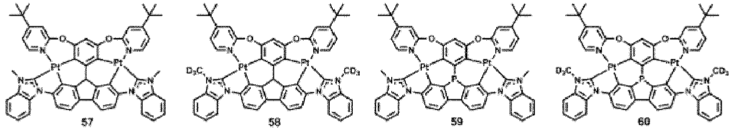

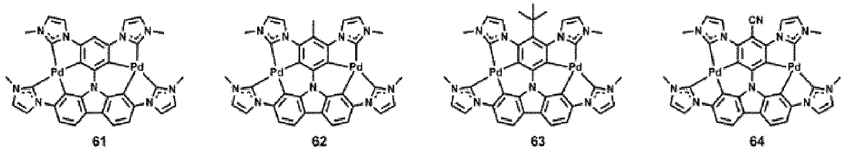

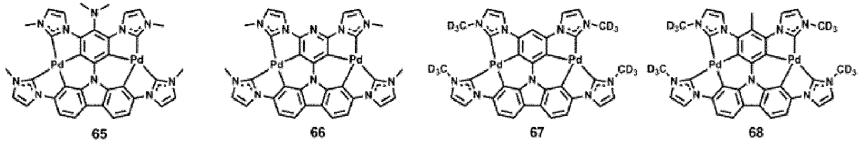

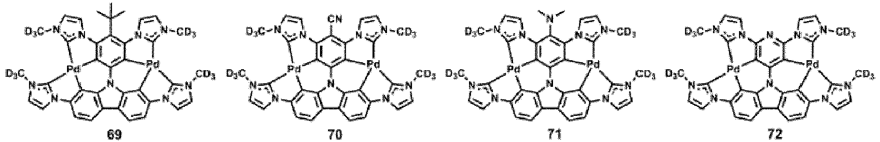

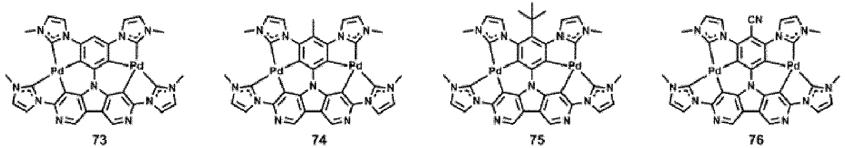

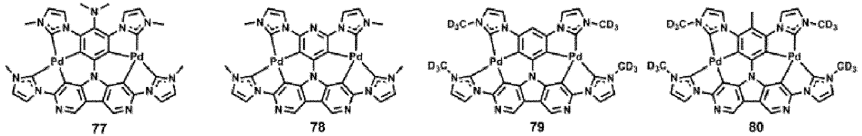

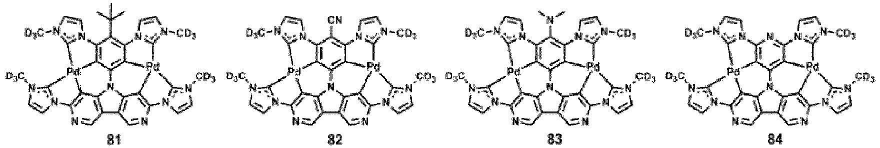

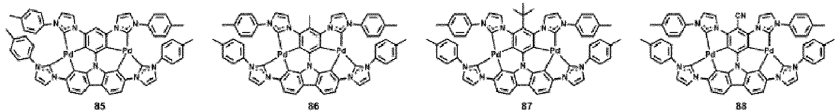

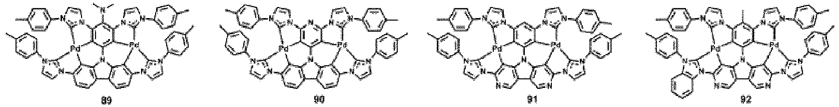

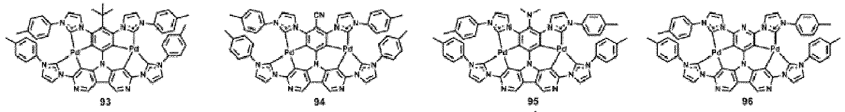

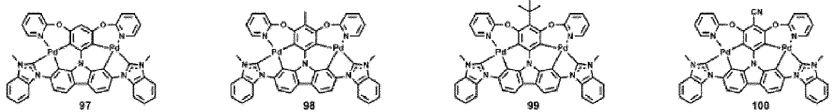

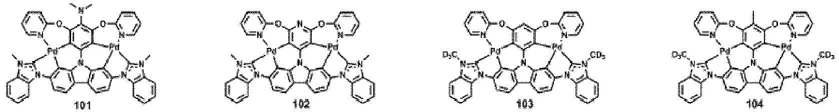

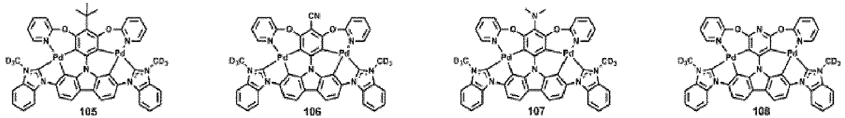

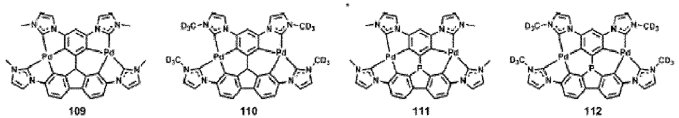

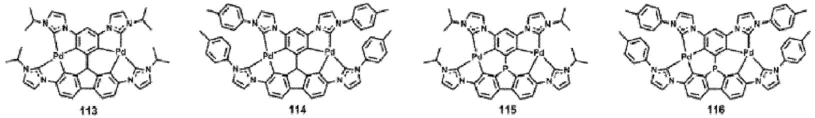

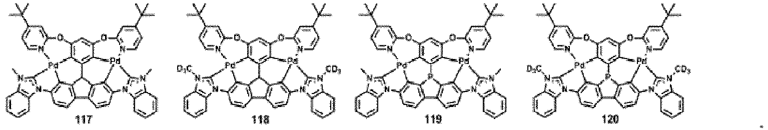

15. Dispositif électroluminescent organique comprenant :
une première électrode,
une deuxième électrode,
une couche organique entre la première électrode et la deuxième électrode et comprenant une couche d'émission, et
un composé organométallique selon l'une quelconque des revendications 8 à 14.
